Europäisches Patentamt

European Patent Office

Office européen des brevets

(19)

(11) **EP 1 331 742 A2**

(12) **EUROPEAN PATENT APPLICATION**

(43) Date of publication:
**30.07.2003 Bulletin 2003/31**

(51) Int Cl.7: **H04B 1/40**

(21) Application number: **03001462.5**

(22) Date of filing: **22.01.2003**

| | |
|---|---|
| (84) Designated Contracting States:<br>**AT BE BG CH CY CZ DE DK EE ES FI FR GB GR HU IE IT LI LU MC NL PT SE SI SK TR**<br>Designated Extension States:<br>**AL LT LV MK RO** | (71) Applicant: **Broadcom Corporation**<br>**Irvine, California 92618-7013 (US)** |
| (30) Priority: **22.01.2002 US 350660 P**<br>**23.01.2002 US 55581**<br>**12.02.2002 US 74537**<br>**12.02.2002 US 74572**<br>**03.05.2002 US 138605**<br>**03.05.2002 US 138678**<br>**03.05.2002 US 138801**<br>**03.05.2002 US 138752**<br>**03.05.2002 US 138601**<br>**03.05.2002 US 138602**<br>**25.11.2002 US 303384**<br>**31.05.2002 US 159365**<br>**08.03.2002 US 94587**<br>**08.03.2002 US 94495**<br>**15.02.2002 US 77571**<br>**12.02.2002 US 74294**<br>**21.03.2002 US 103365** | (72) Inventors:<br>• **Pan, Meng-An**<br>**Cerritos, CA 90703 (US)**<br>• **Wu, Stephen**<br>**Los Angeles, CA 90024 (US)**<br>• **Ibrahim, Brima B.**<br>**Los Angeles, 90025 (US)**<br><br>(74) Representative: **Jehle, Volker Armin, Dipl.-Ing.**<br>**Patentanwälte**<br>**Bosch, Graf von Stosch, Jehle,**<br>**Flüggenstrasse 13**<br>**80639 München (DE)** |

(54) **Radio frequency integrated circuit**

(57)    A radio frequency (RF) integrated circuit (IC) includes a local oscillation module, analog radio receiver, analog radio transmitter, digital receiver module, digital transmitter module, and digital optimization module. The local oscillation module is operably coupled to produce at least one local oscillation. The analog radio receiver is operably coupled to directly convert inbound RF signals into inbound low intermediate frequency signals based on the local oscillation. The digital receiver module is operably coupled to process the inbound low IF signals in accordance with one of a plurality of radio transceiving standards to produce inbound data. The digital transmitter is operably coupled to produce an outbound low intermediate frequency signal by processing outbound data in accordance with the one of the plurality of radio transceiving standards. The analog radio transmitter is operably coupled to directly convert the outbound low IF signals into outbound RF signals based on the local oscillation. The digital optimization module is operably coupled to the local oscillation module, the analog radio receiver and/or the analog radio transmitter to optimize performance of at least one aspect of the local oscillation module, the analog radio receiver and/or the analog radio transmitter for the given radio transceiving standard being implemented.

FIG. 1

EP 1 331 742 A2

## Description

## TECHNICAL FIELD OF THE INVENTION

This invention relates generally to communication systems and more particularly to radio transceivers used within such communication systems.

## BACKGROUND OF THE INVENTION

Communication systems are known to support wireless and wire lined communications between wireless and/or wire lined communication devices. Such communication systems range from national and/or international cellular telephone systems to the Internet to point-to-point in-home wireless networks. Each type of communication system is constructed, and hence operates, in accordance with one or more communication standards. For instance, wireless communication systems may operate in accordance with one or more standards including, but not limited to, IEEE 802.11, Bluetooth, advanced mobile phone services (AMPS), digital AMPS, global system for mobile communications (GSM), code division multiple access (CDMA), local multi-point distribution systems (LMDS), multi-channel-multi-point distribution systems (MMDS), and/or variations thereof.

Such standards dictate the type of communication, type of encoding, type of modulation, channel access protocols, intercommunication between components of a wireless communication device, etc. The specifying of intercommunications between components, such as digital signal processors and radio transceivers, primarily limits the data exchanged between such components to standard compliant data. Thus, the standardization of wireless communications enables multiple manufacturers equipment to interoperation with each others equipment, which helps reduce the cost of wireless communications, the standards leave little room for optimization of inter-component performance.

Depending on the type of wireless communication system, a wireless communication device, such as a cellular telephone, two-way radio, personal digital assistant (PDA), personal computer (PC), laptop computer, home entertainment equipment, et cetera, communicates directly or indirectly with other wireless communication devices. For direct communications (also known as point-to-point communications), the participating wireless communication devices tune their receivers and transmitters to the same channel or channel pair (e.g., one of the plurality of radio frequency (RF) carriers of the wireless communication system) and communicate over that channel. For indirect wireless communications, each wireless communication device communicates directly with an associated base station (e.g., for cellular services) and/or an associated access point (e.g., for an in-home or in-building wireless network) via an assigned channel. To complete a communication session between the wireless communication devices, the associated base stations and/or associated access points communicate with each other directly, via a system controller, via the public switch telephone network, via the internet, and/or via some other wide area network.

For each wireless communication device to participate in wireless communications, it includes a built-in radio transceiver (i.e., receiver and transmitter) or is coupled to an associated radio transceiver (e.g., a station for in-home and/or in-building wireless communication networks, RF modem, etc.). As is known, the receiver receives RF signals, removes the RF carrier frequency from the RF signals directly or via one or more intermediate frequency stages, and demodulates the signals in accordance with a particular wireless communication standard to recapture the transmitted data. The transmitter converts data into RF signals by modulating the data in accordance with the particular wireless communication standard and adds an RF carrier to the modulated data directly or in one or more intermediate frequency stages to produce the RF signals.

As the demand for enhanced performance (e. g., reduced interference and/or noise, improved quality of service, compliance with multiple standards, increased broadband applications, et cetera), smaller sizes, lower power consumption, and reduced costs increases, wireless communication device engineers are faced with a very difficult design challenge to develop such a wireless communication device. Typically, an engineer is forced to compromise one or more of these demands to adequately meet the others. For instance, an engineer may choose a direct conversion topology (i.e., convert directly from an RF signal to a base-band signal or directly from a base-band signal to an RF signal) to meet size requirements and/or broadband application requirements. However, for direct conversion transceivers, DC offset, IQ mismatch, and local oscillation leakage are more detrimental to overall performance.

Costs of manufacturing a radio frequency integrated circuit (IC) may be reduced by switching from one integrated circuit manufacturing process to another. For example, a CMOS process may be used instead of a GaAs, silicon bipolar or bi-CMOS process since it is a more cost affective method of IC manufacture and is typically the technology choice for digital ICs. Such a CMOS process, however, increases temperature and process related variations. As such, noise, gain variation, mismatches and other factors that negatively impact an RF IC performance are increased for a CMOS process. Thus, in many RF IC applications, a designer chooses between cost savings and performance.

Therefore, a need exists for a low power, reduced size, reduced cost, and robust performance radio, radio transmitter, radio receiver, and/or components thereof.

## SUMMARY OF THE INVENTION

These needs and others are substantially met by the radio frequency (RF) integrated circuit (IC) disclosed herein. Such an RFIC includes a local oscillation module, analog radio receiver, analog radio transmitter, digital receiver module, digital transmitter module, and digital optimization module. The local oscillation module is operably coupled to produce at least one local oscillation (e.g., a local oscillation that is shared by the analog radio receiver and analog radio transmitter or separate local oscillations for the analog radio receiver and analog radio transmitter).

The analog radio receiver is operably coupled to directly convert inbound RF signals, which are received via an antenna, into inbound I-Q represented low intermediate frequency (IF) signals. Note that the low intermediate frequency signal may be a baseband signal having a carrier frequency of 0 or having a carrier frequency of up to a few megahertz. The digital receiver module is operably coupled to process the inbound low IF signals, which may be baseband signals or signals having a carrier frequency up to a few mega-Hertz, in accordance with one of a plurality of radio modulation standards to produce inbound data. The inbound data is then provided to a DSP or host processor.

The digital transmitter is operably coupled to produce an outbound low intermediate frequency signal by processing outbound data in accordance with the one of the plurality of radio modulation standards. The digital transmitter module receives the outbound data from a DSP or the host processor and produces the outbound I-Q represented low IF signal to have a carrier frequency of 0 hertz to a few megahertz. The analog radio transmitter is operably coupled to directly convert the outbound low IF signals into outbound RF signals based on the local oscillation.

The digital optimization module is operably coupled to the local oscillation module, the analog radio receiver and/or the analog radio transmitter. As coupled, the digital optimization module optimizes performance of at least one aspect of the local oscillation module, the analog radio receiver and/or the analog radio transmitter for the given communication standard being implemented. For instance, the digital optimization module may calibrate components of the radio to reduce local oscillation leakage, DC offset, noise, gain imbalances, circuit process variations, and/or to provide for a high level of integration between analog portions of the radio system and digital portions of the radio system, et cetera.

In an alternate embodiment, the RFIC includes a radio chip set. The radio chip set comprises a 1st integrated circuit and a 2nd integrated circuit. The 1st integrated circuit includes a local oscillation module, an analog radio receiver, an analog radio transmitter, a compensation module, and a proprietary interface. The 2nd integrated circuit includes a digital receiver module, digital transmitter module, digital optimization module, and 2nd proprietary interface.

The compensation module of the 1st integrated circuit is operably coupled to the local oscillation module, the analog receiver, and/or the analog transmitter to monitor operations of one or more of these elements to produce monitoring data. In addition, the compensation module compensates for at least one of DC offset, local oscillation leakage, noise, non-linearity, power consumption, and/or performance limits of the local oscillation module, analog receiver, and/or the analog transmitter based on a compensation control signal. The proprietary interface of the 1st integrated circuit is used to convey the monitoring data to the 2nd integrated circuit and to receive the compensation control signals from the 2nd integrated circuit.

The digital optimization module of the 2nd integrated circuit is operably coupled to produce the compensation control signal by interpreting the monitoring data to determine optimal performance for the local oscillation module, the analog radio receiver, and/or the analog radio transmitter in accordance with the particular radio transceiver standard being implemented. The 2nd proprietary interface of the 2nd integrated circuit is used to receive the monitoring data from the 1st integrated circuit and to provide the compensation control signals to the 1st integrated circuit.

## BRIEF DESCRIPTION OF THE DRAWINGS

Figure 1 illustrates a schematic block diagram of a communication system that includes wireless communication devices having radio frequency integrated circuits in accordance with the present invention;

Figure 2 illustrates a schematic block diagram of a host device and corresponding radio in accordance with the present invention;

Figures 3 and 4 illustrate a local oscillation module and digital optimization module in accordance with the present invention;

Figure 5 illustrates a schematic block diagram of a digital transmitter section in accordance with the present invention;

Figure 6 illustrates a schematic block diagram of an alternate embodiment of a digital transmitter section in accordance with the present invention;

Figure 7 illustrates a schematic block diagram of a digital receiver section in accordance with the present invention;

Figure 8 illustrates a schematic block diagram of an alternate digital receiver section in accordance with the present invention;

Figure 9 illustrates a schematic block diagram of an analog receiver and digital optimization module in accordance with the present invention;

Figure 10 illustrates a schematic block diagram of an alternate embodiment of an analog receiver and digital optimization module in accordance with the present invention;

Figure 11 illustrates a schematic block diagram of an analog radio transmitter and digital optimization module in accordance with the present invention;

Figure 12 illustrates a schematic block diagram of a host and an alternate embodiment of the corresponding radio in accordance with the present invention;

Figure A1 illustrates a schematic block diagram of a wireless communication system in accordance with the present invention;

Figure A2 illustrates a graphical representation of a cell pattern in accordance with the present invention;

Figure A3 illustrates a frequency spectrum of channels that may be used by the wireless communication system in accordance with the present invention;

Figure A4 illustrates a logic diagram of a method for dynamic frequency selection in a wireless communication system in accordance with the present invention;

Figures A5 through A7 illustrate logic diagrams that further define steps within the method of Figure A4;

Figure B1 illustrates a schematic block diagram of an integrated radio in accordance with the present invention;

Figure B2 illustrates a schematic block diagram of a fractional-N synthesizer in accordance with the present invention;

Figure B3 illustrates a schematic block diagram of an alternate fractional-N synthesizer in accordance with the present invention;

Figure B4 illustrates a schematic block diagram of another fractional-N synthesizer in accordance with the present invention;

Figure B5 illustrates a schematic block diagram of yet another fractional-N synthesizer in accordance with the present invention;

Figures B6 through B9 illustrate a logic diagram of a method for fractional-N synthesis in accordance with the present invention;

Figure B10 illustrates a logic diagram of an alternate method for fractional-N synthesis in accordance with the present invention;

Figure C1 illustrates a schematic block diagram of an integrated radio receiver in accordance with the present invention;

Figure C2 illustrates a schematic block diagram of a self-correcting local oscillator in accordance with the present invention;

Figure C3 illustrates a schematic block diagram of an auxiliary frequency control module in accordance with the present invention;

Figure C4 illustrates a schematic block diagram of a mixing module in accordance with the present invention;

Figure C5 illustrates a schematic block diagram of an integrated radio receiver in accordance with the present invention;

Figure C6 illustrates a schematic block diagram of the radio receiver of Figure C5 in a test mode in accordance with the present invention;

Figure C7 illustrates a frequency response of the radio receiver of Figure C6;

Figure C8 illustrates a schematic block diagram of an alternate self-correcting local oscillator in accordance with the present invention;

Figures C9 through C11 illustrate a logic diagram of generating a self-correcting local oscillation in accordance with the present invention;

Figure D1 illustrates a schematic block diagram of a radio receiver in accordance with the present invention;

Figure D2 illustrates a schematic block diagram of an FSK demodulator in accordance with the present invention;

Figure D3 illustrates a schematic block diagram of an alternate FSK demodulator in accordance with the present invention;

Figure D4 illustrates a timing diagram corresponding to the demodulation performed by the FSK demodulator of Figure D2;

Figure D5 illustrates a schematic block diagram of an alternate FSK demodulator in accordance with the present invention;

Figures D6 through D10 illustrate a logic diagram of methods for FSK demodulation in accordance with the present invention;

Figure E1 illustrates a schematic block diagram of a radio receiver in accordance with the present invention;

Figure E2 illustrates a schematic block diagram of an alternate radio receiver in accordance with the present invention;

Figure E3 illustrates a schematic block diagram of a further alternate radio receiver in accordance with the present invention;

Figure E4 illustrates a schematic block diagram of yet another radio receiver in accordance with the present invention;

Figure E5 illustrates a schematic block diagram of the mixing module utilized in the radio receivers of Figures E1 through E3;

Figure E6 illustrates a schematic block diagram of a digital demodulator that may be utilized in one or more of the radio receivers in Figures E1 through E4;

Figure E7 illustrates a schematic block diagram of a low pass filter/equalizer that may be utilized in the digital demodulator of one or more of the radio receivers of Figures E1 through E4;

Figure E8 illustrates a frequency response of the low pass filter/equalizer of Figure E7;

Figure E9 illustrates a logic diagram of a method for digital demodulation in accordance with the present invention;

Figure E10 illustrates a graphical diagram of a Bluetooth packet that may be processed by a radio receiver in accordance with the present invention;

Figure E11 illustrates a graphical representation of DC offset correction in accordance with the present invention;

Figure E12 illustrates a logic diagram that further describes Step 192 of Figure E9;

Figure E13 illustrates a logic diagram of a method that further describes the determination of a peak value at Step 220 of Figure E12;

Figure E14 illustrates a logic diagram of a method that further describes the determination of a valley value of Step 224 of Figure E12;

Figure E15 illustrates a logic diagram that expands on the logic diagram of Figure E12 by detecting false peaks and false valleys in accordance with the present invention;

Figure E16 illustrates a logic diagram of a method that expands on the logic diagram of Figure E12 by detecting peaks and valleys in accordance with the present invention;

Figures E17 and E18 illustrate a graphical representation of determining peak and valley values during acquisition mode and tracking mode in accordance with the present invention;

Figure E19 illustrates a logic diagram that further describes Step 196 of Figure E9;

Figure E20 illustrates a logic diagram that further describes Step 296 of Figure E19;

Figure E21 illustrates a logic diagram of a method for adjusting the sampling position in accordance with the present invention;

Figure E22 illustrates a graphical representation of the sampling of a data packet in accordance with the present invention;

Figure F1A is a system diagram illustrating a cellular system within which the present invention is deployed;

Figure F1B is a block diagram generally illustrating the structure of a wireless device constructed according to the present invention;

Figure F2 is a block diagram illustrating a subscriber unit constructed according to the present invention;

Figure F3 is a functional schematic diagram of an amplifier system;

Figure F4 is an amplifier formed to have programmable gain;

Figure F5 is a functional schematic block diagram of an RF processing unit of a radio receiver implemented according to one embodiment of the present invention;

Figure F6 is a functional schematic diagram illustrating one embodiment of the programmable gain amplifiers used in the present invention;

Figure F7 is a functional schematic diagram of an amplifier that provides gain in 3 dB steps;

Figure F8 is a functional block diagram that illustrates one embodiment of the present invention for controlling the programmable gain amplifiers for the I and Q channels;

Figure F9 is a functional schematic block diagram that illustrates an analog peak detector circuit formed according to one embodiment of the present invention;

Figure F10 is a functional schematic block diagram that illustrates one embodiment of the present invention;

Figures F11A and F11B are signal response curves illustrating the operation of a MOSFET when biased properly in the inventive peak detector;

Figure F12 is a functional block diagram that illustrates a system and method for extracting a peak amplitude of a received signal in one embodiment of the present invention;

Figure F13 is a schematic diagram of one embodiment of the present invention;

Figure G3 is a functional schematic block diagram of an RF processing unit of a radio transceiver formed according to one embodiment of the present invention;

Figure G4 is a functional schematic block diagram illustrating a method for removing a DC offset;

Figure G5 is a functional schematic block diagram illustrating circuitry for rejecting or removing a DC offset signal formed according to one embodiment of the present invention;

Figure G6 is a functional schematic block diagram of the integrator circuitry that is for coupling in a feedback loop across a variable gain amplifier formed according to one embodiment of the present invention;

Figure G7 is a flowchart that illustrates a method for removing a DC component from a signal that is to be amplified according to one embodiment of the present invention;

Figure H3 is a functional schematic block diagram of an RF processing unit of a radio transceiver implemented according to one embodiment of the present invention;

Figure H4 is a schematic diagram of a prior art operational amplifier configured as an RC filter that provides fast response and good attenuation above a specified frequency corner;

Figure H5 is a prior art schematic diagram of a two-stage differential amplifier, wherein the second stage comprises a source follower configuration;

Figure H6 is a schematic diagram of a two-stage differential amplifier formed according to one embodiment of the present invention;

Figure I4 is a functional schematic diagram that illustrates one embodiment of the present invention;

Figure I5 is a functional schematic diagram that illustrates another embodiment of the described invention;

Figure I6 is a functional schematic block diagram of an RF processing unit of a radio transceiver formed according to one embodiment of the present invention;

Figure J3 illustrates a schematic block diagram of a transmitter in accordance with the present invention;

Figure J4 illustrates a logic diagram of a method for determining gain of a programmable multi-stage amplifier based on a desired power level in accordance with the present invention;

Figure J5 illustrates a logic diagram of a method for determining gain of a programmable multi-stage amplifier based on a desired noise level in accordance with the present invention;

Figure J6 illustrates a logic diagram of a method for determining gain based on linearity of a multi-stage power amplifier in accordance with the present invention;

Figure J7 illustrates a logic diagram of a method for balancing gain of a programmable multi-stage amplifier based on a desired noise level, desired output power and desired linearity in accordance with the present invention;

Figure J8 illustrates a schematic block diagram of an alternate transmitter in accordance with the present invention;

Figure J9 illustrates a schematic block diagram of multi-embodiments of a highly linear power amplifier in accordance with the present invention;

Figure K3 illustrates a schematic block diagram of a self-calibrating transmitter in accordance with the present invention;

Figure K4 illustrates a schematic block diagram of the calibration determination module and calibration execution module in accordance with the present invention;

Figure K5 illustrates a graphical representation of the frequency spectrum for a base-band representation of a modulated RF signal when performing a DC offset calibration in accordance with the present invention;

Figure K6 illustrates a graphical representation of the frequency spectrum for a base-band representation of a modulated RF signal when performing a gain offset calibration in accordance with the present invention;

Figure K7 illustrates a logic diagram of a method for generating a calibration signal to minimize DC offset levels within the self-calibrating transmitter in accordance with the present invention;

Figure K8 illustrates a logic diagram of a method for generating a calibration signal to optimize gain within a self-calibrating transmitter in accordance with the present invention;

Figure K9 illustrates a schematic block diagram of an alternate self-calibrating transmitter in accordance with the present invention;

Figure K10 illustrates a logic diagram of a method for self-calibrating a transmitter in accordance with the present invention;

Figure K11 illustrates an alternate schematic block diagram of a radio in accordance with the present invention;

Figure K12 illustrates a schematic block diagram of calibration circuitry within the radio of Figure K11;

Figure K13 illustrates a schematic block diagram of an alternate radio in accordance with the present invention;

Figure K14 illustrates a logic diagram for transceiving signals utilizing a self-calibrating transmitter in accordance with the present invention;

Figure L3 illustrates a schematic block diagram of an up-conversion module in accordance with the present invention;

Figure L4 illustrates a schematic block diagram of a down-conversion module in accordance with the present invention;

Figure L5 illustrates a schematic block diagram of a programmable mixer in accordance with the present invention;

Figure L6 illustrates a schematic block diagram of an alternate programmable mixer in accordance with the present invention;

Figure L7 illustrates a schematic block diagram of a programmable mixer including an alternate embodiment of the compensation module in accordance with the present invention;

Figure L8 illustrates a schematic block diagram of a programmable mixer having another alternate embodiment of the compensation module in accordance with the present invention;

Figure L9 illustrates a logic diagram of a method for determining the control signal that adjusts the compensation module in accordance with the present invention;

Figure L10 illustrates a logic diagram of an alternate method for determining the control signal that adjusts the compensation module in accordance with the present invention;

Figure M1 illustrates a schematic block diagram of a radio receiver in accordance with the present invention;

Figure M2 illustrates a graphical representation of a typical DC offset encoded signal in accordance with the present invention;

Figure M3 illustrates a graphical representation of a DC offset compensated encoded signal in accordance with the present invention;

Figure M4 illustrates an expanded view of a portion of the encoded signal of Figure M3;

Figures M5 and M6 illustrate a graphical representation of adjusting the sampling phase in accordance with the present invention;

Figures M7 and M8 illustrate a graphical representation of an alternate adjustment of the sampling phase in accordance with the present invention; and

Figures M9-M11 illustrate a logic diagram of a method for data recovery in accordance with the present invention.

## DETAIL DESCRIPTION OF A PREFERRED EMBODIMENT

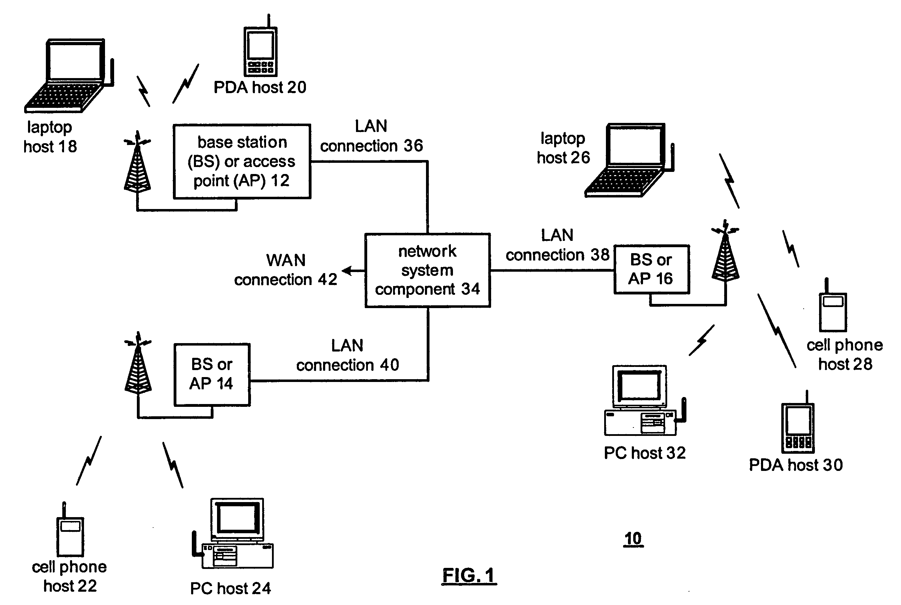

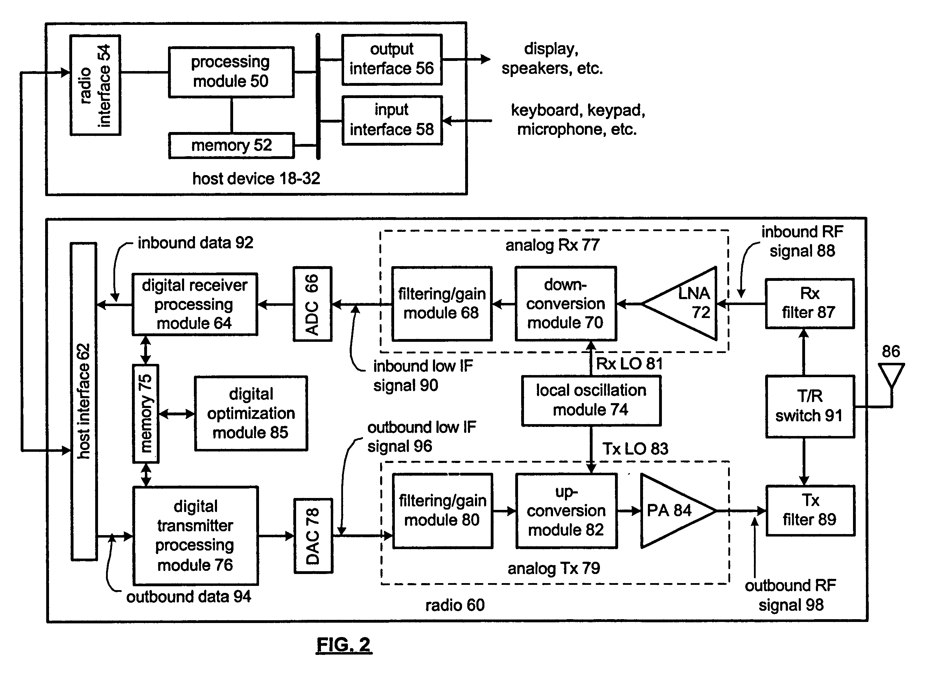

Figure 1 illustrates a schematic block diagram of a communication system 10 that includes a plurality of base stations and/or access points 12-16, a plurality of wireless communication devices 18-32 and a network system component 34. The wireless communication devices 18-32 may be laptop host computers 18 and 26, personal digital assistant hosts 20 and 30, personal computer hosts 24 and 32 and/or cellular telephone hosts 22 and 28. The details of the wireless communication devices will be described in greater detail with reference to Figure 2.

The base stations or access points 12 are operably coupled to the network system component 34 via local area network connections 36, 38 and 40. The network system component 34, which may be a router, switch, bridge, modem, system controller, et cetera provides a wide area network connection 42 for the communication system 10. Each of the base stations or access points 12-16 has an associated antenna or antenna array to communicate with the wireless communication devices in its area. Typically, the wireless communication devices register with a particular base station or access point 12-14 to receive services from the communication system 10. For direct connections (i.e., point-to-point communications), wireless communication devices communicate directly via an allocated channel.

Typically, base stations are used for cellular telephone systems and like-type systems, while access points are used for in-home or in-building wireless networks. Regardless of the particular type of communication system, each wireless communication device includes a built-in radio and/or is coupled to a radio.

Figure 2 illustrates a schematic block diagram of a wireless communication device that includes the host device 18-32 and an associated radio 60. For cellular telephone hosts, the radio 60 is a built-in component. For personal digital assistants hosts, laptop hosts, and/or personal computer hosts, the radio 60 may be built-in or an externally coupled component.

As illustrated, the host device 18-32 includes a processing module 50, memory 52, radio interface 54, input interface 58 and output interface 56. The processing module 50 and memory 52 execute the corresponding instructions that are typically done by the host device. For example, for a cellular telephone host device, the processing module 50 performs the corresponding communication functions in accordance with a particular cellular telephone standard.

The radio interface 54 allows data to be received from and sent to the radio 60. For data received from the radio 60 (e.g., inbound data), the radio interface 54 provides the data to the processing module 50 for further processing and/or routing to the output interface 56. The output interface 56 provides connectivity to an output display device such as a display, monitor, speakers, et cetera such that the received inbound data may be displayed and/or rendered audible. The radio interface 54 also provides outbound data from the processing module 50 to the radio 60. The processing module 50 may receive the outbound data from an input device such as a keyboard, keypad, microphone, et cetera via the input interface 58 or generate the data itself. For data received via the input interface 58, the processing module 50 may perform a corresponding host function on the data and/or route it to the radio 60 via the radio interface 54.

Radio 60 includes a host interface 62, digital receiver processing module 64, analog-to-digital converter 66, filtering/gain module 68, down conversion module 70, low noise amplifier 72, local oscillation module 74, memory 75, digital transmitter processing module 76, digital-to-analog converter 78, filtering/gain module 80, up-conversion module 82, power amplifier 84, digital optimization module 85, an antenna 86, a receiver filter 87, a transmitter filter 89, and a transmit/receive switch 91. The antenna 86 may be a single antenna that is shared, via the transmit/receiver switch 91, by the transmit and receive paths or may include separate antennas for the transmit path and receive path. The antenna implementation will depend on the particular standard to which the wireless communication device is compliant.

The digital receiver processing module 64 and the digital transmitter processing module 76, in combination with operational instructions stored in memory 75, execute digital receiver functions and digital transmitter functions of one or more of a plurality of wireless transceiver standards, respectively. The digital receiver functions include, but are not limited to, digital intermediate frequency to baseband conversion, demodulation, constellation demapping, decoding, and/or descrambling. The digital transmitter functions include, but are not limited to, scrambling, encoding, constellation mapping, modulation, and/or digital baseband to IF conversion.

The digital optimization module 85 monitors the performance of the local oscillation module 74, the analog receiver section 77, and/or the analog transmitter section 79 in accordance with one or more of the plurality of wireless transceiver standards. If the digital optimization module 85 determines that the performance of the local oscillation module 74, the analog receiver 77, and/or the analog transmitter 79 may be improved, the digital optimization module 85 generates a corresponding control signal and provides it the appropriate analog module.

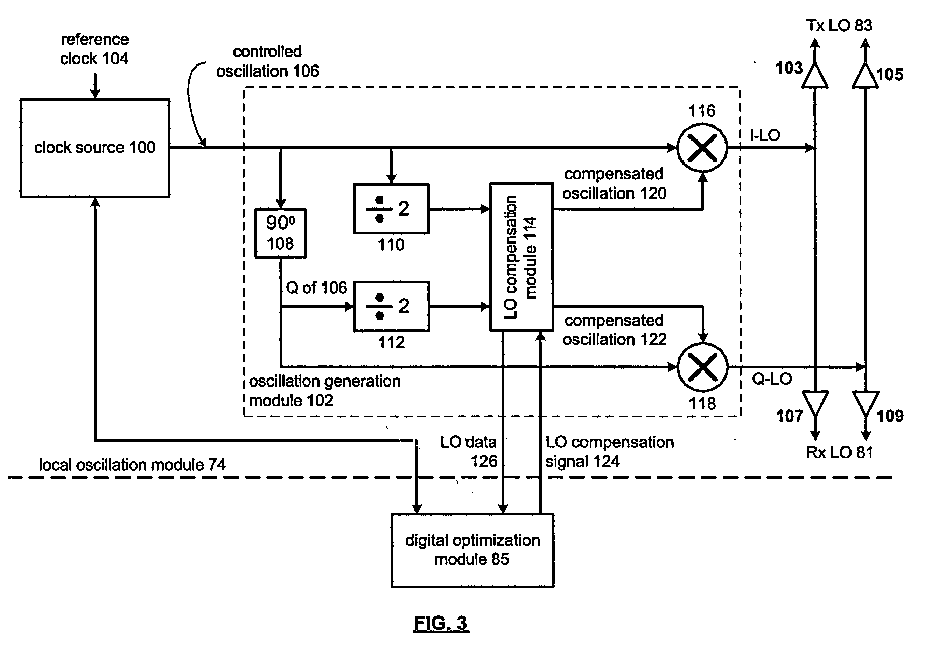

The digital receiver 64, the transmitter processing modules 76, and the digital optimization module 85 may be implemented using a shared processing device, individual processing devices, or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on operational instructions. The memory 75 may be a single memory device or a plurality of memory devices. Such a memory device may be a read-only memory, random access memory, volatile memory, non-volatile memory, static memory, dynamic memory, flash memory, and/or any device that stores digital information. Note that when the processing module 64, 76 and/or 85 implements one or more of its functions via a state machine, analog circuitry, digital circuitry, and/or logic circuitry, the memory storing the corresponding operational instructions is embedded with the circuitry comprising the state machine, analog circuitry, digital circuitry, and/or logic circuitry. The memory 75 stores, and the processing module 64, 76 and/or 85 executes, operational instructions corresponding to at least some of the functions illustrated in Figures 3 - 12.

In operation, the radio 60 receives outbound data 94 from the host device via the host interface 62. The host interface 62 routes the outbound data 94 to the digital transmitter processing module 76, which processes the outbound data 94 in accordance with a particular wireless communication standard (e.g., IEEE 802.11a, IEEE 802.11b, Bluetooth, et cetera) to produce digital transmission formatted data 96. The digital transmission formatted data 96 will be a digital base-band signal or a digital low IF signal, where the low IF will be in the frequency range of zero to a few megahertz.

The digital-to-analog converter 78 converts the digital transmission formatted data 96 from the digital domain to the analog domain. The filtering/gain module 80 filters and/or adjusts the gain of the analog signal prior to providing it to the up-conversion module 82. The up-conversion module 82 directly converts the analog baseband or low IF signal into an RF signal based on a transmitter local oscillation provided by local oscillation module 74. The power amplifier 84 amplifies the RF signal to produce outbound RF signal 98. The Tx filter 89, which may be a bandpass filter, filters the outbound RF signal 98 and provides the filtered outbound RF signal to the T/R switch 91. The antenna 86 transmits the outbound RF signal 98 to a targeted device such as a base station, an access point and/or another wireless communication device.

The radio 60 also receives an inbound RF signal 88 via the antenna 86, which was transmitted by a base station, an access point, or another wireless communication device. The antenna 86 provides the inbound RF signal 88 to the T/R switch 91, which, in turn, forwards the signal 88 to the Rx filter 87. The Rx filter 87, which may be a bandpass filter, filters the inbound RF signal and provides the filtered RF signal to the low noise amplifier 72, which amplifies the signal 88 to produce an amplified inbound RF signal. The low noise amplifier 72 provide the amplified inbound RF signal to the down conversion module 70, which directly converts the amplified inbound RF signal into an inbound low IF signal based on a receiver local oscillation provided by local oscillation module 74. The down conversion module 70 provides the inbound low IF signal to the filtering/gain module 68, which filters and/or adjusts the gain of the signal before providing it to the analog to digital converter 66.

The analog-to-digital converter 66 converts the filtered inbound low IF signal from the analog domain to the digital domain to produce digital reception formatted data 90. The digital receiver processing module 64 decodes, descrambles, demaps, and/or demodulates the digital reception formatted data 90 to recapture inbound data 92 in accordance with the particular wireless communication standard being implemented by radio 60. The host interface 62 provides the recaptured inbound data 92 to the host device 18-32 via the radio interface 54.

The digital optimization module 85 is operably coupled to the analog receiver 77, the local oscillation module 74, and/or the analog transmitter 79. In general, the analog receiver 77, the local oscillation module 74, and/or the analog transmitter 79 produce monitoring data that indicates performance of the respective module. The digital optimization module 85 receives the monitoring data and interprets it to determine how the respective module can be optimized. Based on the interpretation, the digital optimization module 85 generates compensation control signals and provides them to the analog receiver 77, the local oscillation module 74, and/or the analog transmitter 79. The modules 74, 77 and/or 79 adjust there operation in accordance with the compensation control signals such that local oscillation leakage is reduced, DC offset is reduced, noise is reduced, gain imbalances are reduced, adverse affects due to integrated circuit process variations are reduced, increase integration between analog portions of the radio system and digital portions of the radio system, et cetera.

Figure 3 illustrates a schematic block diagram of the local oscillation module 74 operably coupled to the digital optimization module 85. The local oscillation module 74 includes a clock source 100, oscillation generation module 102 and a plurality of buffers 103, 105, 107, and 109. The oscillation generation module 102 includes a phase-shift module 108, a 1st divider 110, a 2nd divider 112, a local oscillation compensation module

114, a 1st mixing module 116, and a 2nd mixing module 118.

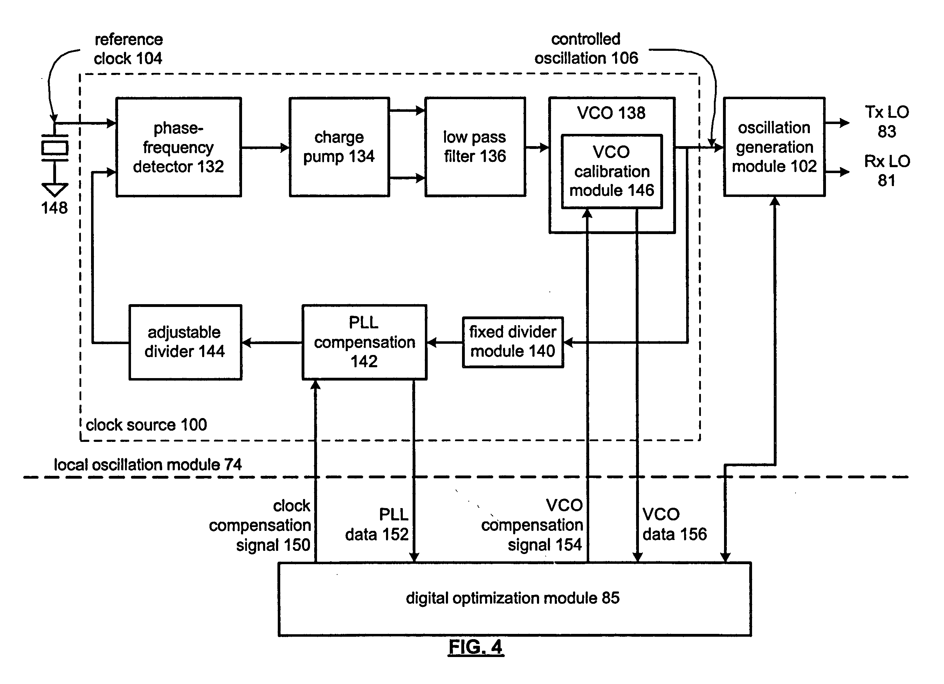

In operation, the clock source 100 generates a controlled oscillation 106 from a reference clock 104. One embodiment of the clock source 100 will be described in greater detail with reference to Figure 4. The clock source 100 may be optimized based on information exchanged with the digital optimization module 85 as will also be discussed with reference to Figure 4.

The oscillation generation module 102 receives the controlled oscillation 106 and produces an I component and a Q component of a local oscillation. To achieve this, the phase-shift module 108, the 1st divider 110, and the 1st mixing module 116 receive the controlled oscillation 108. Note that the frequency of the controlled oscillation 106 for this embodiment of the oscillation generation module 102 is 2/3rds that of the desired frequency of the local oscillation 81 or 83.

The 1st divider 110, divides the frequency of the controlled oscillation 106 by a factor of 2 to produce a 1st divided frequency. The local oscillation compensation module 114, which may be further described in Section C, compensates the divided frequency to produce a compensated oscillation 120. The local oscillation compensation module 114 monitors the 1st and 2nd divided signals to produce local oscillation data 126, which is provided to digital optimization module 85. The digital optimization module 85 interprets the local oscillation data 126 to produce a local oscillation compensation signal 124. The functionality performed by the digital optimization module 85 may be further described in Section C. As such, the local oscillation compensation module 114 compensates for DC offsets, integrated circuit process variations, temperature variations, noise and/or excess power consumption to produce the compensated oscillation 120. The 1st mixing module 116 mixes the controlled oscillation 106, which has a 2/3rds frequency of the local oscillation, with the compensated oscillation 120, which has a 1/3rd frequency of local oscillation, to produce an I component of the local oscillation.

The phase-shift module 108 shifts the phase of the controlled oscillation 106 by 90° to produce a Q component of the controlled oscillation 106. The 2nd divider 112 divides the frequency of the Q component of controlled oscillation 106 to produce a 2nd divided frequency. The local oscillation compensation module 114 adjusts the 2nd divided frequency to compensate for DC offset, IC process variations, temperature variations, noise, and/or power consumption to produce a 2nd compensated oscillation 122. The 2nd mixing module 118 mixes the compensated oscillation 122 with the Q component of the controlled oscillation 106 to produce a Q component of the local oscillation.

Buffers 103 and 105 buffer the I and Q components of the local oscillation to produce the transmitter local oscillation 83. Buffers 107 and 109 buffer the I and Q components of the local oscillation to produce the receiver local oscillation 81.

Figure 4 illustrates the local oscillation 74 and digital optimization module 85. In this illustration, the clock source 100 is shown to include a phase and frequency detector 132, charge pump 134, low pass filter 136, voltage controlled oscillator 138, fixed divider module 140, phase lock loop compensation module 142 and adjustable divider 144. The voltage control oscillator 138 may include a voltage control calibration module 146.

A crystal 148 generates the reference clock 104 and provides it to the phase and frequency detector 132. The phase and frequency detector 132 generates a difference signal based on a phase and/or frequency difference between the reference clock 104 and the feedback received from the adjustable divider 144. The charge pump 134, which may be implemented as disclosed in Section J, produces a charge-up or charge-down signal from the difference signal. The low pass filter 136 filters the charge-up or charge-down signal and then provides the filtered signal to the voltage control oscillator 138.

The voltage control oscillator 138 generates the controlled oscillation 106 from the received filtered signal. In addition, the voltage control oscillator may include voltage control calibration module 146 to fine-tune the generation of the controlled oscillation 106. In general, the voltage control calibration module 146, which is further described in Section J, generates VCO data 156 and provides it to the digital optimization module 85. The digital optimization module 85 interprets the VCO data 156 and generates VCO compensation signal 154 and provides it to the VCO calibration module 146. Based on the compensation signal 154, the VCO calibration module 146 compensates the generation of the controlled oscillation 106 to reduce noise, power, et cetera.

The fixed divider module 140 divides the controlled oscillation 106 by a fixed value. The phase lock loop compensation module 142 interprets the fixed divided feedback to produce phase lock loop data 152, which is provided to the digital optimization module 85. The digital optimization module 85 interprets the phase lock loop data 152 to produce clock compensation signals 150, which are provided back to the phase lock loop compensation module 142. Based on the compensation signal 150, the phase lock loop compensation module 142 compensates for noise, power consumption, et cetera contained within the fixed divided feedback. The functionality of the phase lock loop compensation module 142 and corresponding operations performed by the digital optimization module 85 are further described in Section B.

The adjustable divider 144, which may include a Delta Sigma modulator, further divides the compensated fixed divider to produce the feedback signal provided to the phase frequency detector 132. As known, by adjusting the adjustable divider 144, the controlled oscillation 106 may be adjusted. By adjusting the controlled oscillation 106, the resulting local oscillations 81 and 83 are correspondingly adjusted.

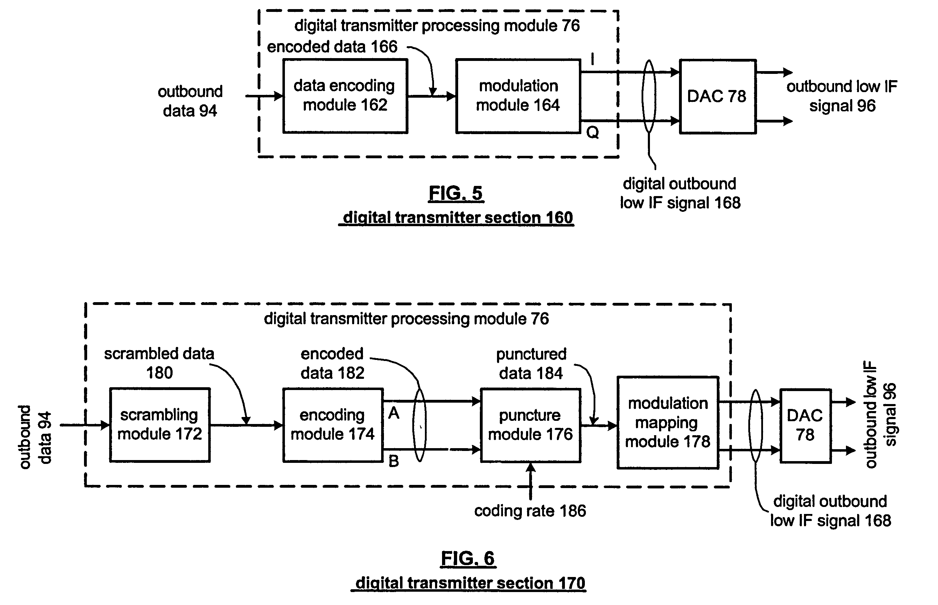

Figure 5 illustrates a schematic block diagram of a digital transmitter section 160 that includes the digital transmitter processing module 76, which is configured to include a data encoding module 162 and modulation module 164. In this embodiment, the data encoding module 162 receives outbound data 94 from the host device and produces therefrom encoded data 166. Depending on the particular radio transceiver standard being implemented by the radio (e.g., Bluetooth, IEEE 802.11, etc.), the data encoding module 162 may perform a variety of encoding functions.

The modulation module 164 receives the encoded data 166 and produces therefrom I and Q components of digital outbound low IF signal 168. Depending on the particular radio transceiver standard being implemented, the modulation module 164 may produce a baseband I and Q outbound signal 168 or an intermediate frequency signal having an intermediate frequency of up to a few megahertz. In addition, the type of modulation performed by modulation module 164 is dependent on the particular type of radio transceiver standard being implemented. For example, for Bluetooth, the modulation scheme is frequency shift keying (FSK). As such, the modulation module 164 frequency shift keys the encoded data 166 to produce the digital outbound low IF signal 168. The digital-to-analog converter 78 converts the digital outbound low IF signal 168 into the outbound low IF signal 96.

Figure 6 illustrates a digital transmitter section 170 that is implemented to be compliant with at least one of the IEEE 802.11 radio transceiver standards. In this embodiment, the digital transmitter processing module 76 is configured to include a scrambling module 172, an encoding module 174, a puncture module 176 and a modulation mapping module 178. In this embodiment, the scrambling module 172 scrambles outbound data 94 to produce scrambled data 180. The particular type of scrambling is in accordance with the IEEE 802.11 specification.

The encoding module 174 encodes the scrambled data 180 to produce A and B encoded data 182 in accordance with the IEEE 802 specification. The puncture module 176, based on a coding rate 186, removes bits from the A and B encoded data 182 to produce punctured data 184, i.e., compressed data.

The modulation mapping module 178, in accordance with the IEEE 802.11B standard, maps the punctured data 184 into binary phase shift keying (BPSK), quadrature phase shift keying (QPSK) symbols. The symbols are outputted as the I component and Q component of the digital outbound low IF signal 168. The digital-to-analog converter 78 converts the digital outbound low IF signal 168 into the outbound low IF signal 96.

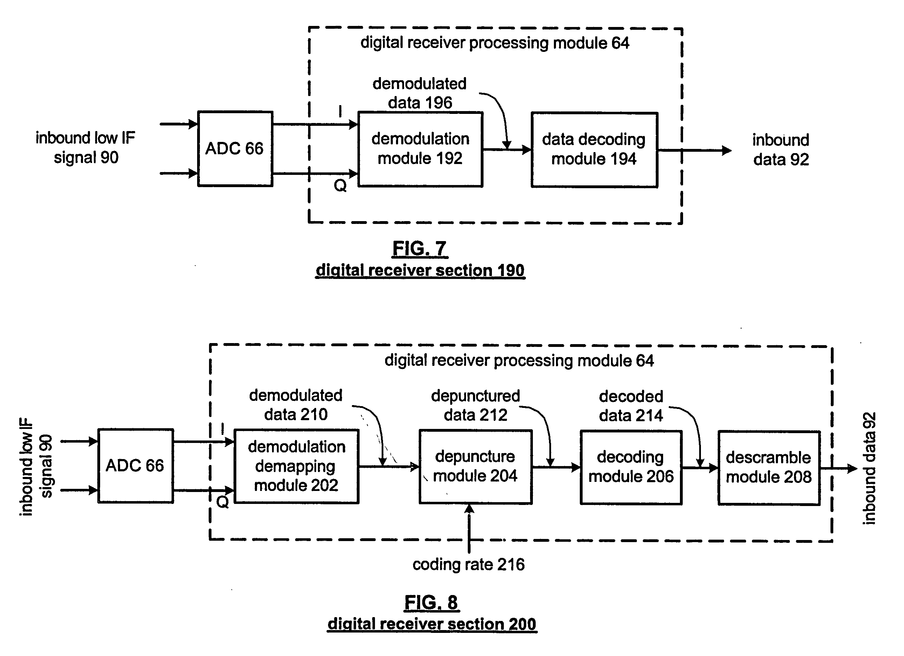

Figure 7 illustrates a schematic block diagram of a digital receiver section 190 that includes the digital receiver processing module 64. The digital receiver processing module 64 is configured to include a demodulation module 192 and a data decoding module 194.

In operation, the analog-to-digital converter 66 receives the inbound low IF signal 90 and produces a digital representation thereof. The digital demodulation module 192 receives an I and Q component of the digital low IF signal generated by the ADC 66 and produces therefrom demodulated data 196. The particular type of demodulation performed by demodulation module 192 is dependent on the particular physical layer communication standard being implemented. In particular, if the physical layer communication standard is in accordance with Bluetooth, the demodulation module 192 is demodulating FSK signals. As such, the demodulation module 192 may include functionality as disclosed in Sections D and/or E.

The data decoding module 194 receives the demodulated data 196 and produces therefrom the inbound data 92. The functionality of the data decoding module 194 is dependent on the particular radio transceiver standard being implemented. If the standard is Bluetooth, the data decoding module 194 interprets the demodulated data 196 in accordance with that standard. In particular, the data decoding module 194 may include enhancements as disclosed in Section D and/or T.

Figure 8 illustrates a schematic block diagram of a digital receiver section 200 that is constructed to be compliant with an IEEE 802.11B standard. In this embodiment, the digital receiver processing module 64 is configured to include a demodulation demapping module 202, depuncture module 204, decoding module 206 and descramble module 208.

The demodulation demapping module 202 receives an I and Q component from the analog-to-digital converter 66. Based on the particular modulation (e.g., BPSK, QPSK), the demodulation demapping module 202 interprets the symbols represented by the I and Q components to produce the demodulated data 210. The depuncture module 204, based on decoding rate 216, adds bits back to the demodulated data 210 to produce depunctured data 212, or decompressed data. The decoding module 206 decodes the depunctured data 212 to produce decoded data 214. The descrambling module 202 descrambles the decoded data 214 to produce the inbound data 92.

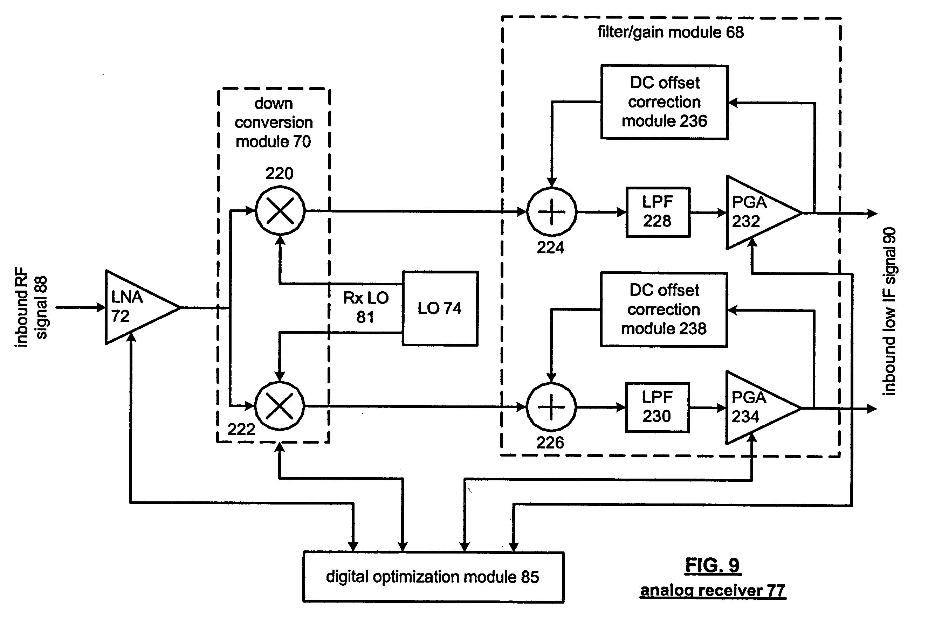

Figure 9 illustrates a schematic block diagram of the analog receiver 77 that is constructed as a direct conversion receiver. In such an embodiment, the analog receiver 77 may be compliant with an IEEE 802.11B standard. As illustrated, the analog receiver 77 includes a low noise amplifier 72 a down-conversion module 70, and the filter/gain module 68. The down-conversion module 70 includes a 1st mixing module 220 and a 2nd mixing module 222. The filter/gain module 66 includes a 1st summing module 224, 2nd summing module 226, 1st low pass filter 228, 2nd low pass filter 230, 1st programmable gain amplifier 232, 2nd programmable gain

amplifier 234, 1st DC offset correction module 236 and 2nd DC offset correction module 238. Note that various embodiments of the filter/gain module 68 may omit the DC offset correction modules and corresponding summing modules, may replace the programmable gain amplifiers with regular amplifiers, and/or the low pass filters 228 and 230 may include high speed operational amplifiers as disclosed in Section H.

In operation, the analog receiver 77 receives an inbound RF signal 88 via the low noise amplifier 72. The low noise amplifier 72 may be a programmable low noise amplifier as disclosed in Section I. If the low noise amplifier 72 is programmable, information regarding its performance is collected and provided to the digital optimization module 85. The digital optimization module 85 interprets the data and provides feedback to optimize the performance of the low noise amplifier by reducing noise, reducing power consumption, reducing the effects of IC process variations, temperature variations, et cetera. Regardless of its particular implementation, the low noise amplifier provides an amplified input RF signal 88 to the down-conversion module 70.

The down-conversion module 70, via the 1st and 2nd mixing modules 220 and 222, mixes the inbound RF signal with the receiver local oscillation 81 to produce a 1st baseband signal and 2nd baseband signal, which may correspond to an I component and a Q component of the baseband signal. Note that the 1st and 2nd mixing modules 220 and 222 may be programmable mixing modules as disclosed in Section L. If the mixing modules 220 and 222 are programmable, information regarding their performance is collected and provided to the digital optimization module 85. The digital optimization module 85 interprets the data and provides feedback to optimize the performance of the mixing modules 220 and 222 by reducing noise, reducing power consumption, reducing the adverse effects of IC process variations and temperature variations, et cetera, which may lead to local oscillation leakage.

The 1st summing module 224 sums a DC offset corrected signal with the 1st baseband signal to provide a 1st summed signal. The low pass filter 228, which may include a high-speed operational amplifier, low pass filters the signal and provides the filtered signal to the programmable gain amplifier 232. Similarly, the 2nd summing module 226 mixes the 2nd baseband signal with the DC offset correction signal from module 238 to produce a 2nd summed signal. Low pass filter 230, which may also include a high-speed operational amplifier, produces a low pass filtered signal, which is provided to a programmable gain amplifier 234.

Programmable gain amplifier 232 and programmable gain amplifier 234 amplify their respective signals to produce the I and Q components of the inbound low IF signal 90. The programmable gain amplifiers may be constructed in accordance with the teachings of Section G, J, and/or K. In general, the programmable gain amplifiers 232 and 234 collect data regarding their performance and provide the data to the digital optimization module 85. The digital optimization module 85 interprets the data and provides compensation signals to programmable gain amplifier 232 and/or to programmable gain amplifier 234. Such compensation signals cause the programmable gain amplifiers 232 and/ or 234 to modify its performance to compensate for noise, power consumption, and/or effects caused by IC process variations, temperature variations, et cetera.

The DC offset correction modules 236 and 238 are operably coupled to monitor the outputs of programmable gain amplifiers 232 and 234, respectively. If a DC offset is detected, the DC offset correction modules 236 and 238 provide a compensation signal to the corresponding summing modules 224 and 226. The DC offset correction modules 236 and 238 may be constructed as disclosed in Section G.

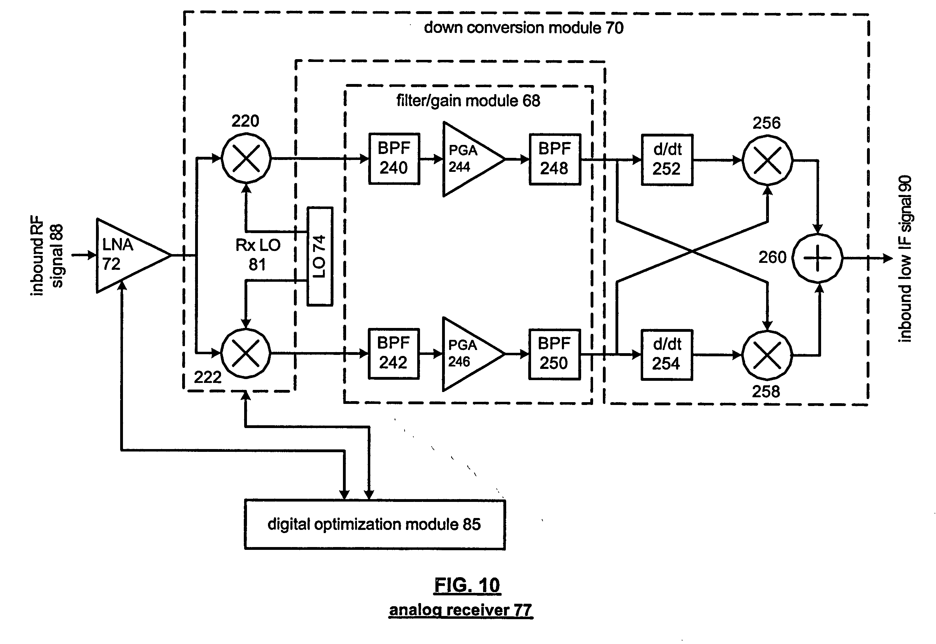

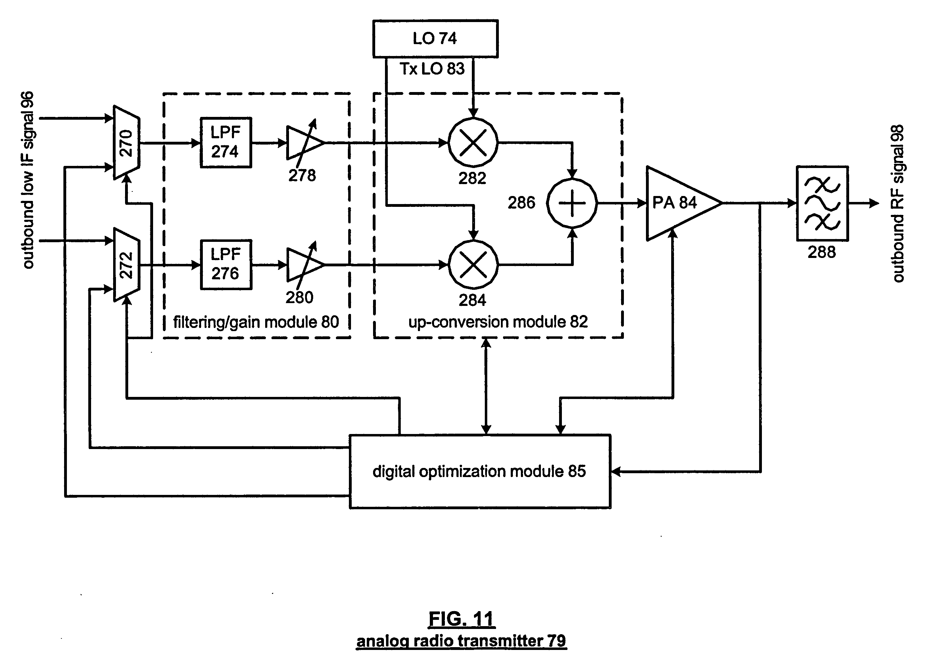

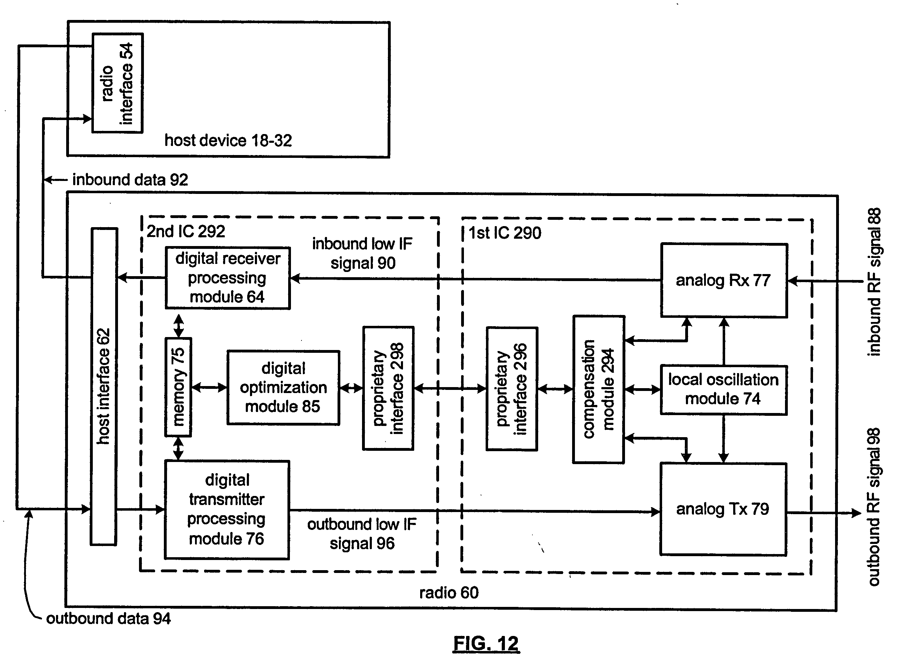

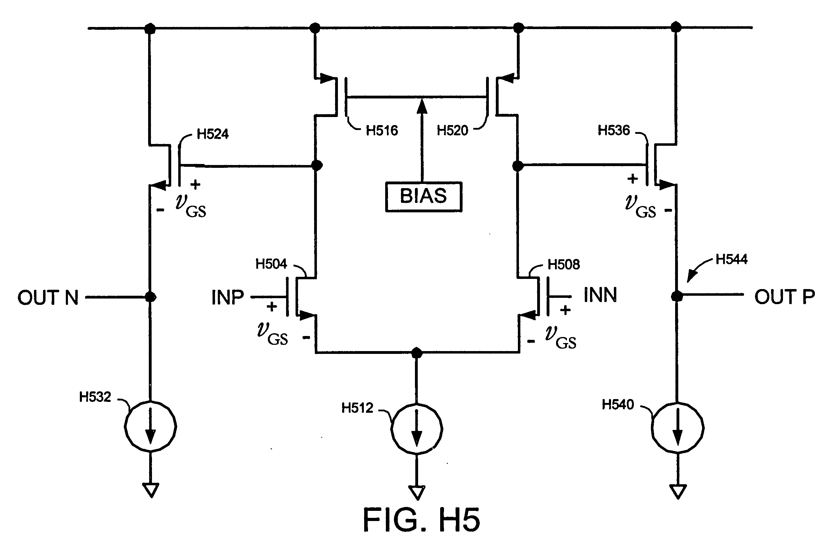

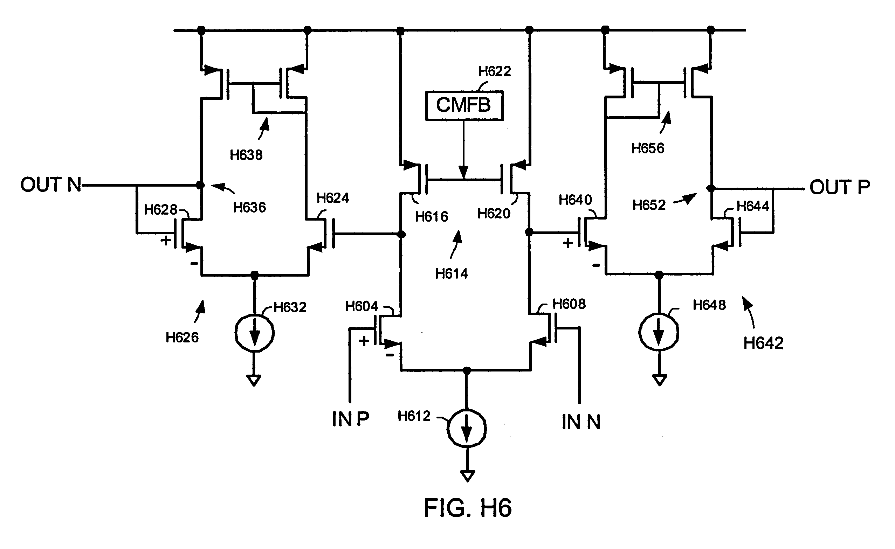

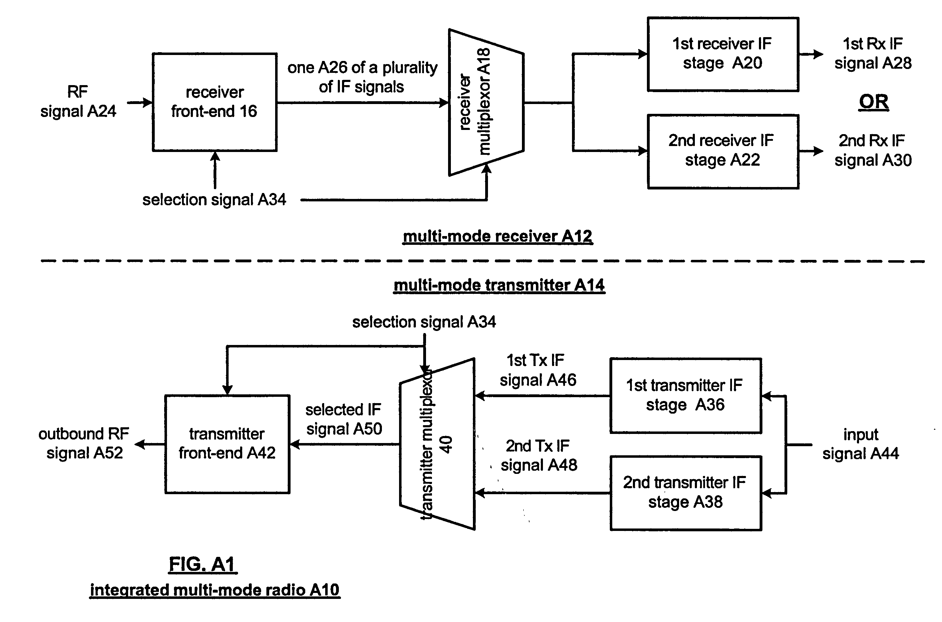

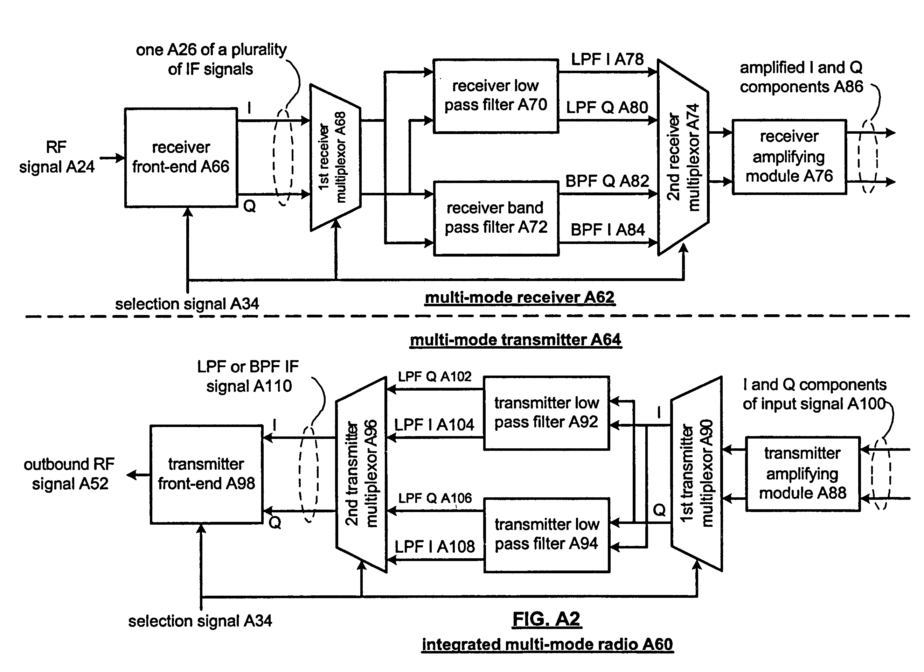

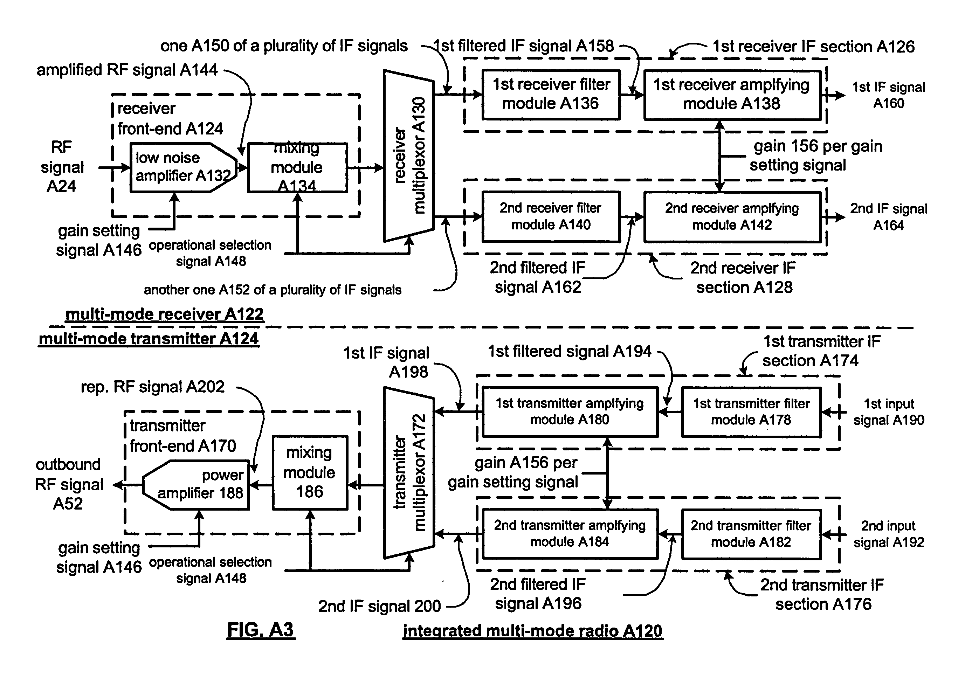

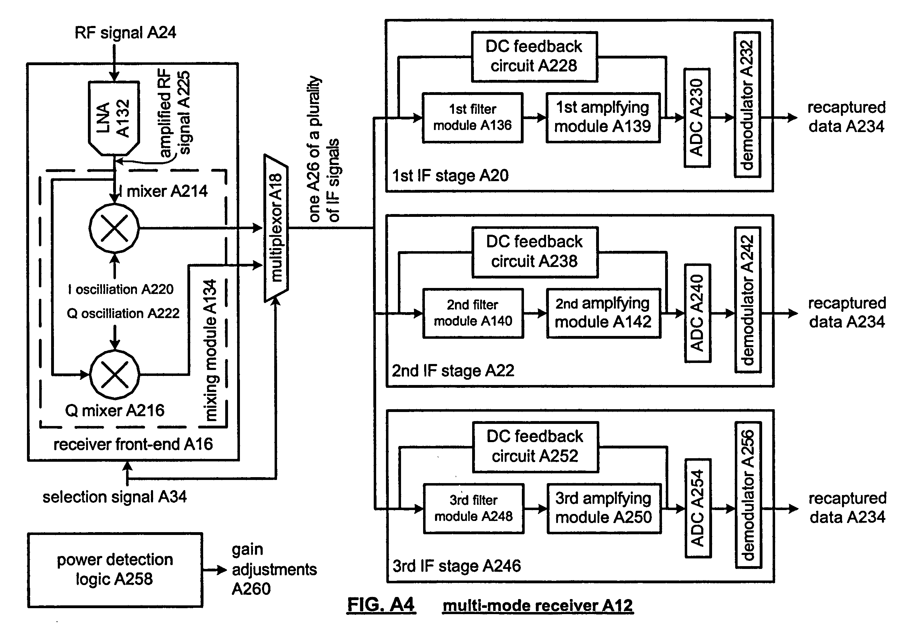

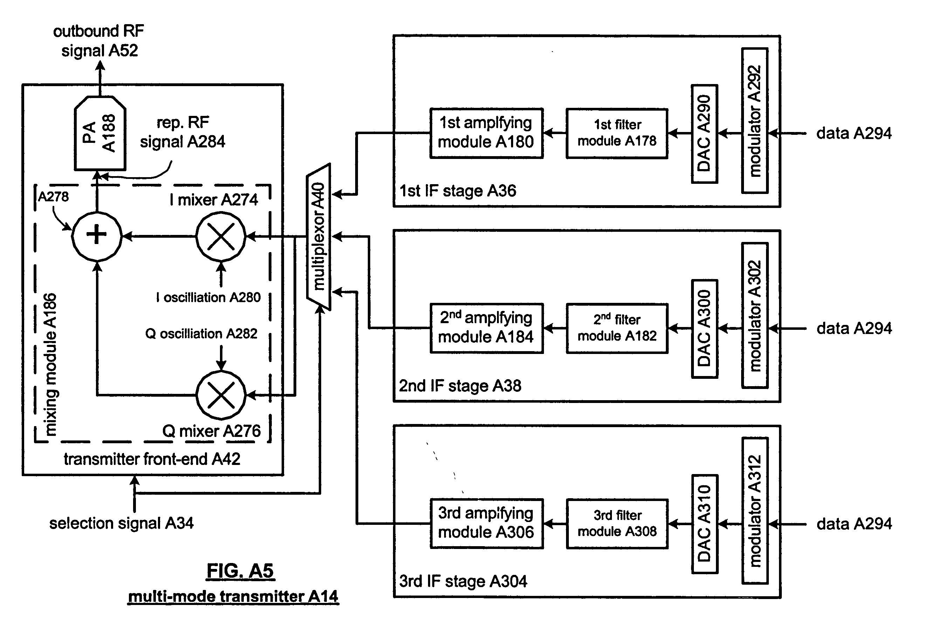

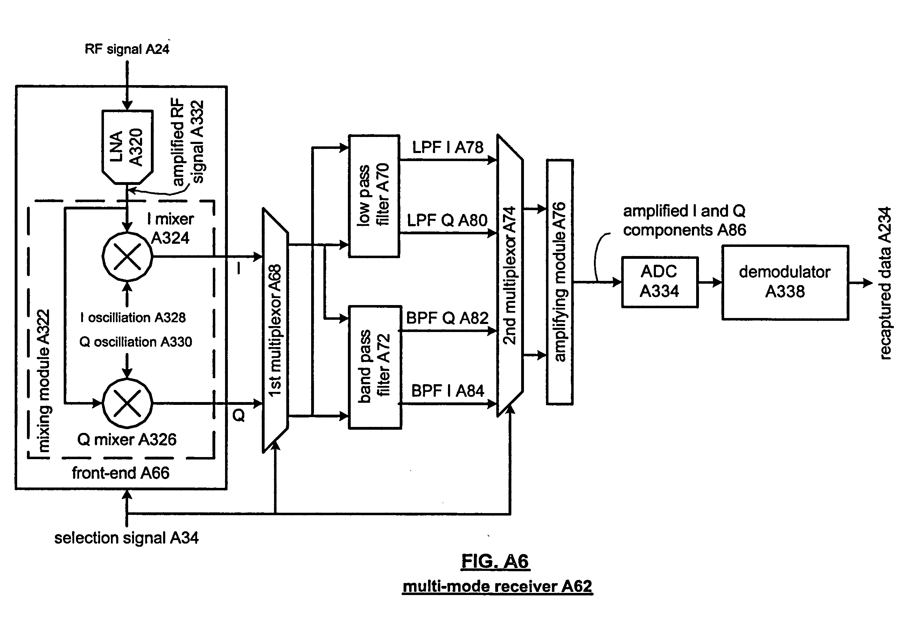

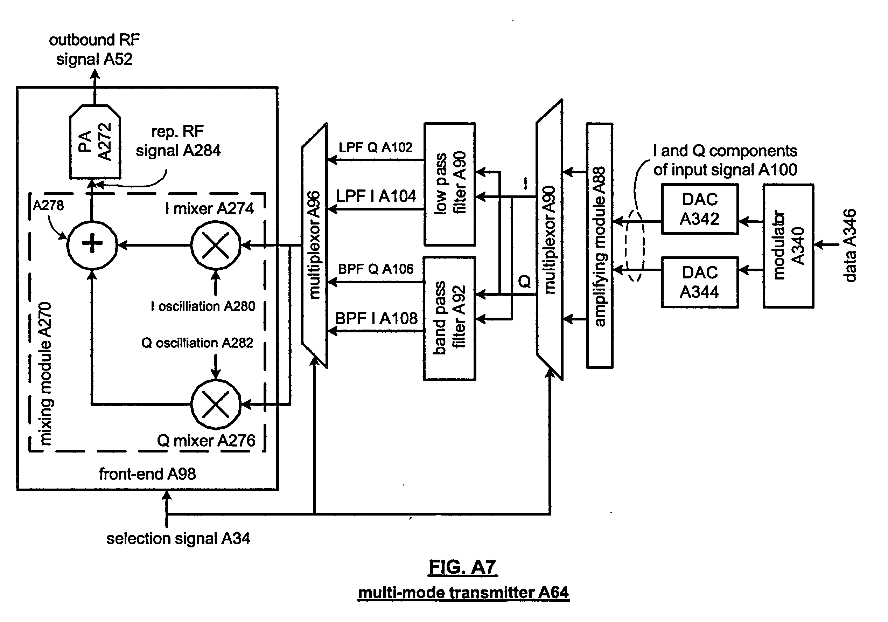

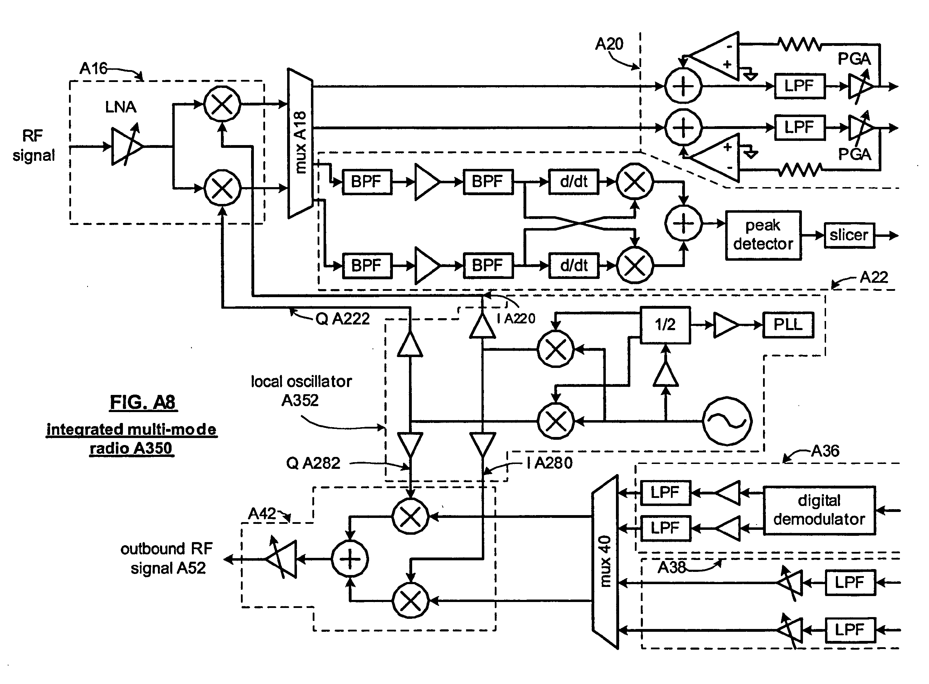

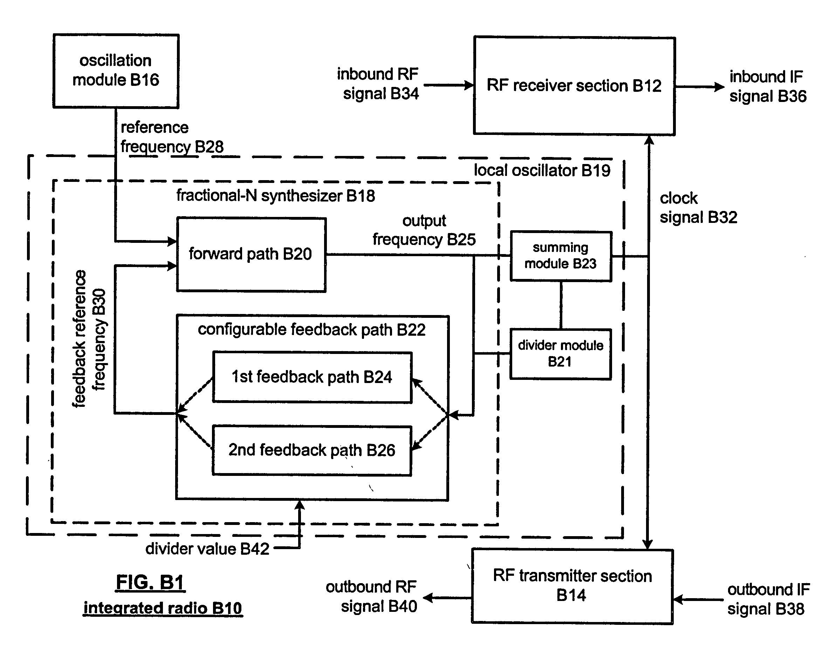

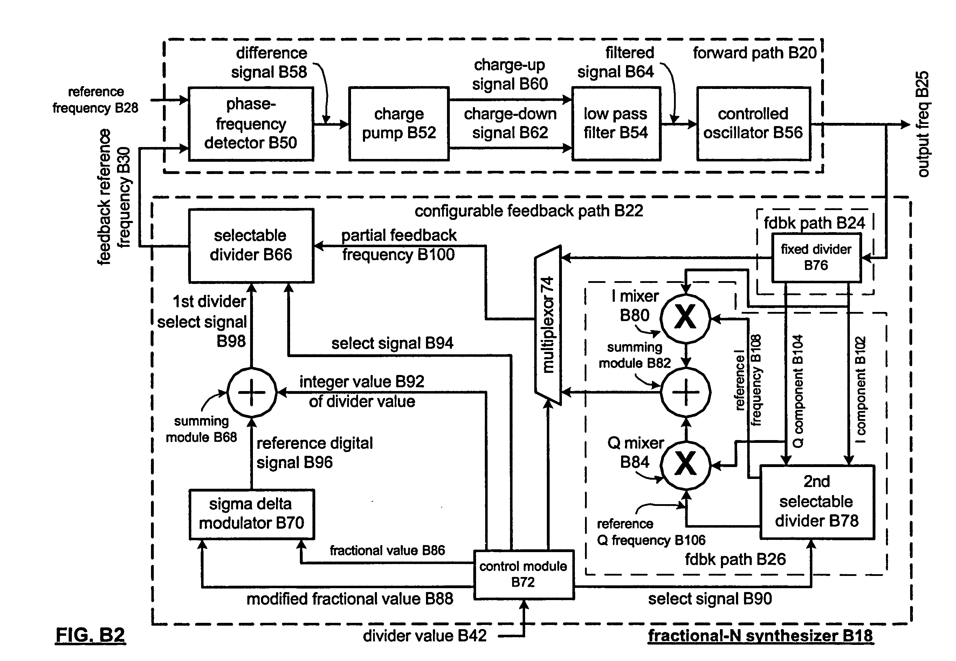

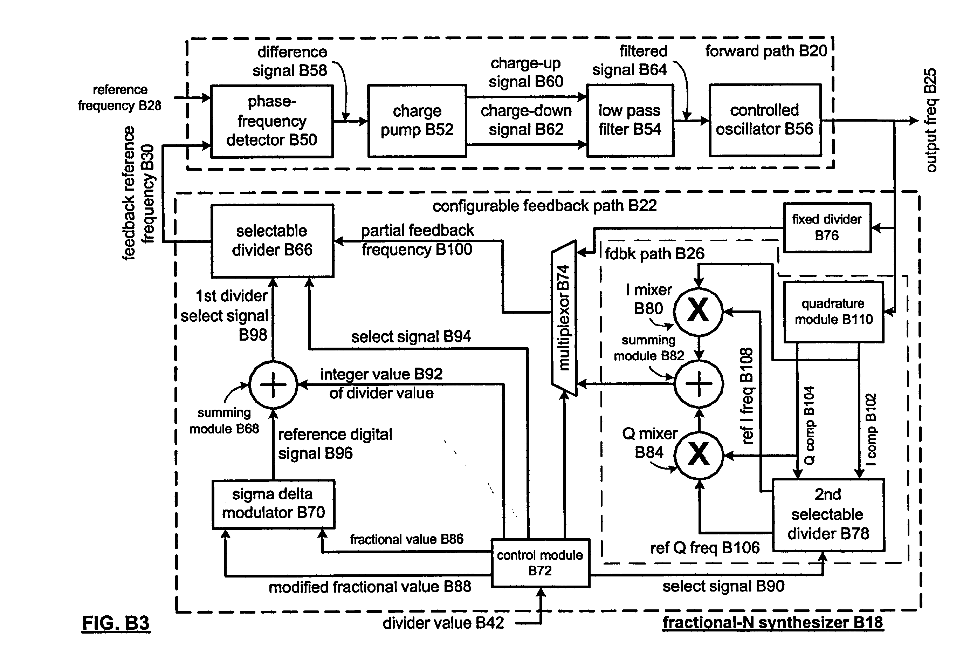

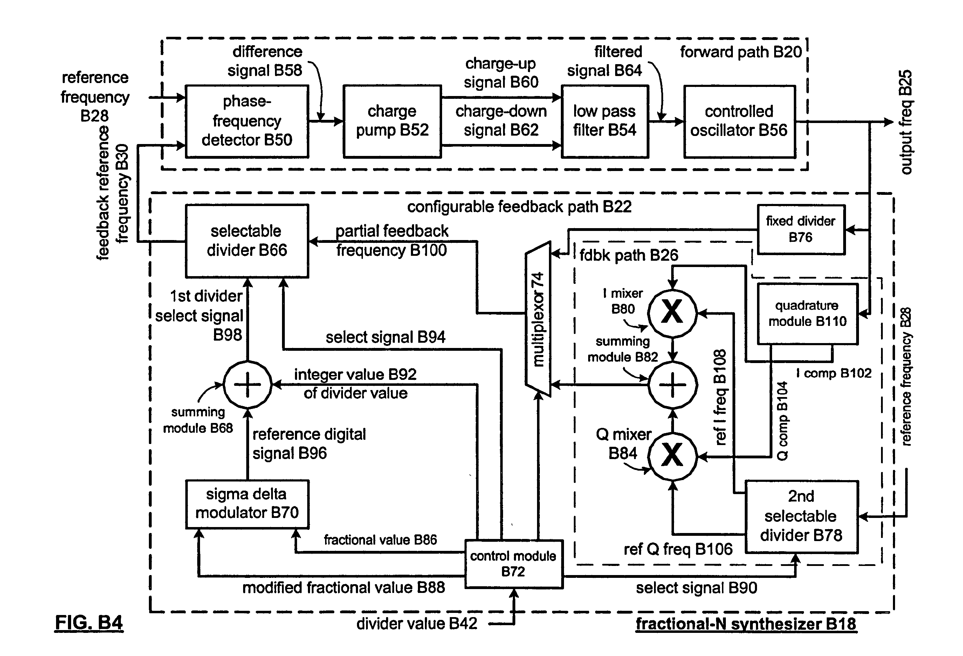

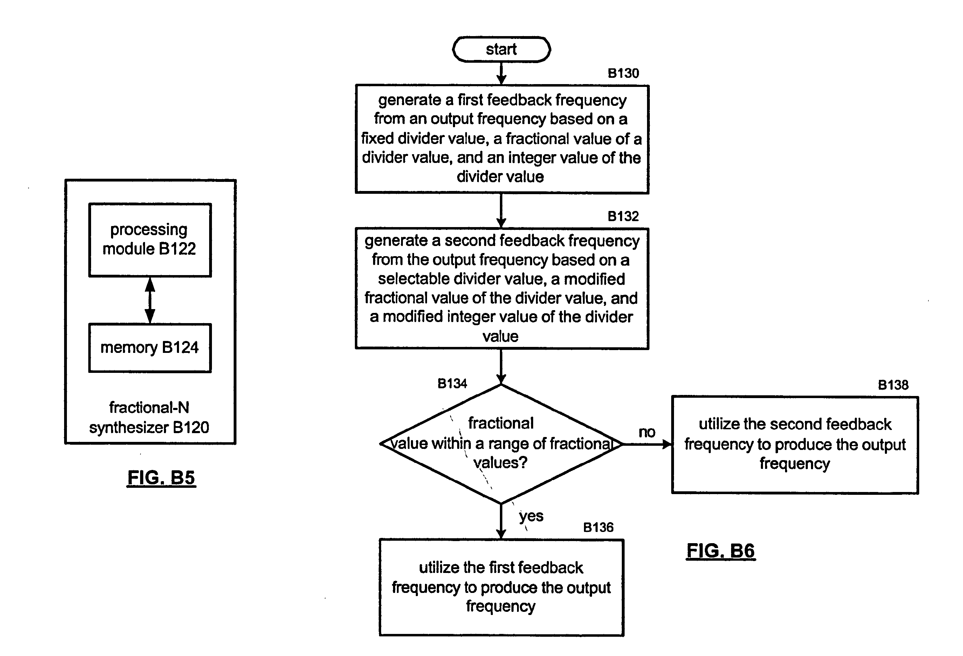

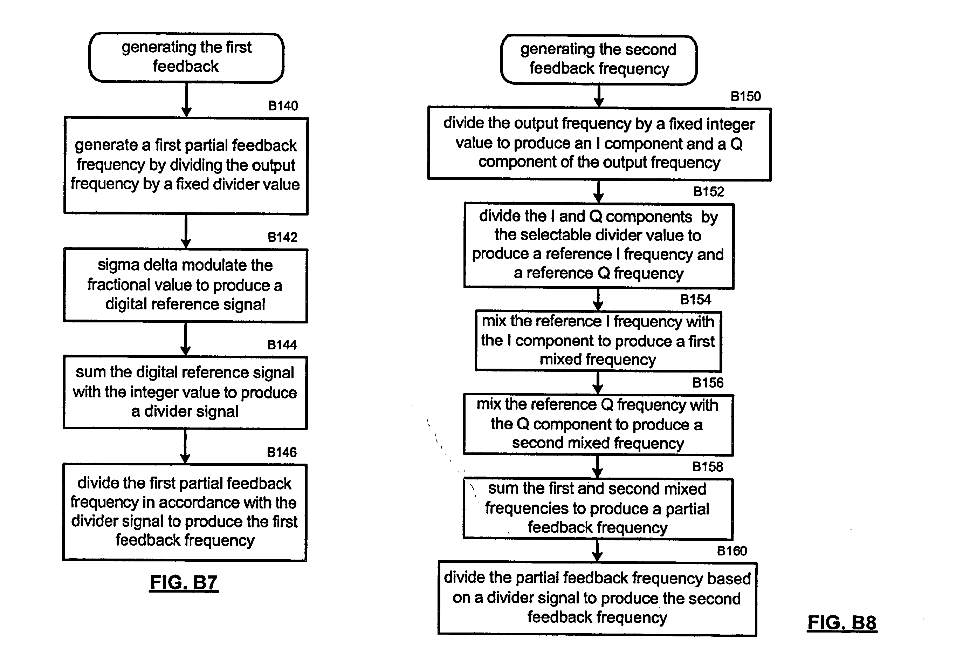

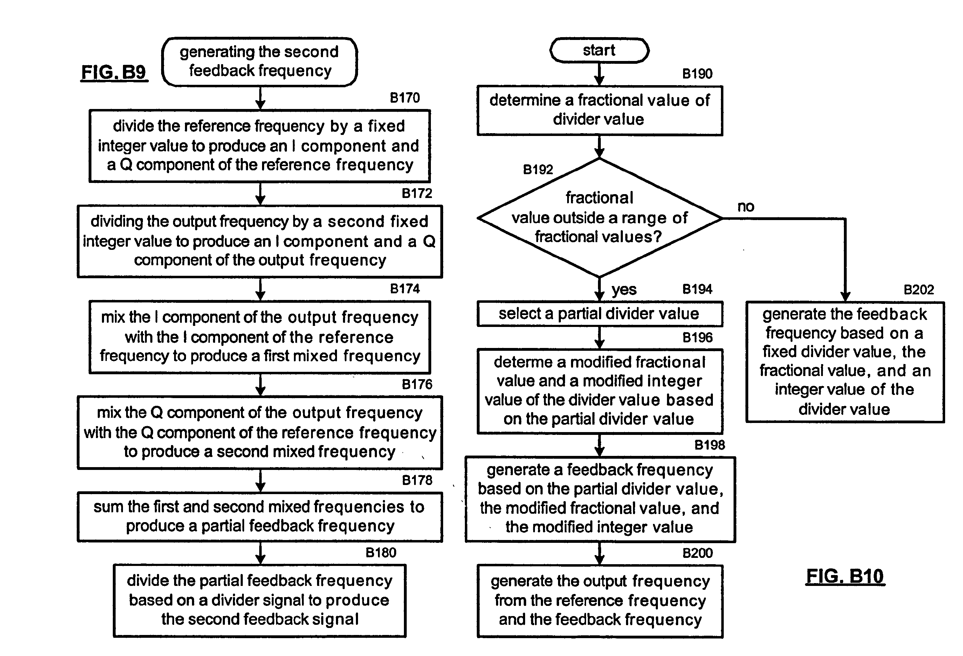

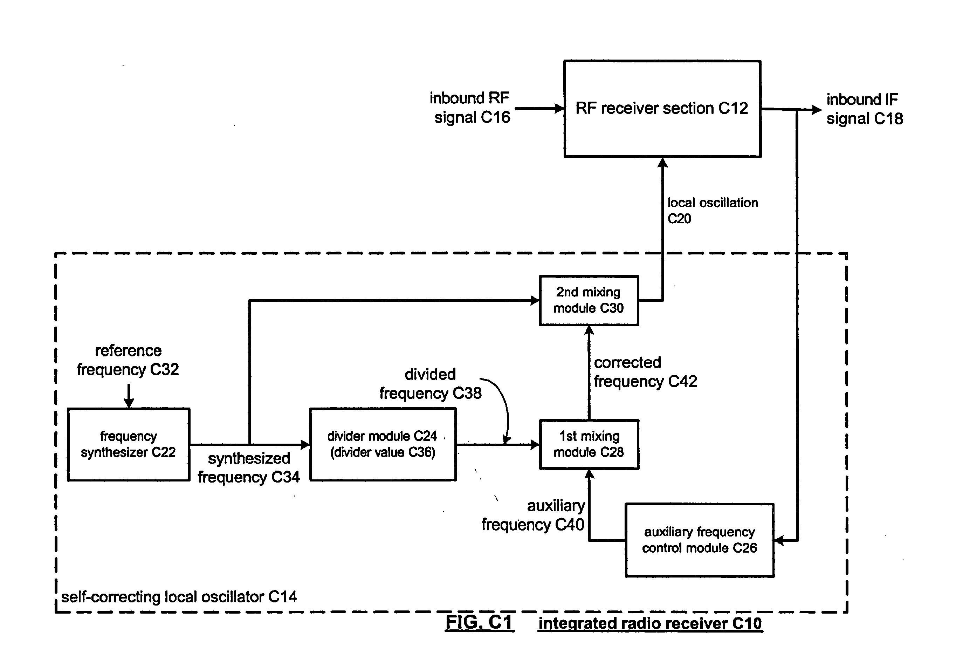

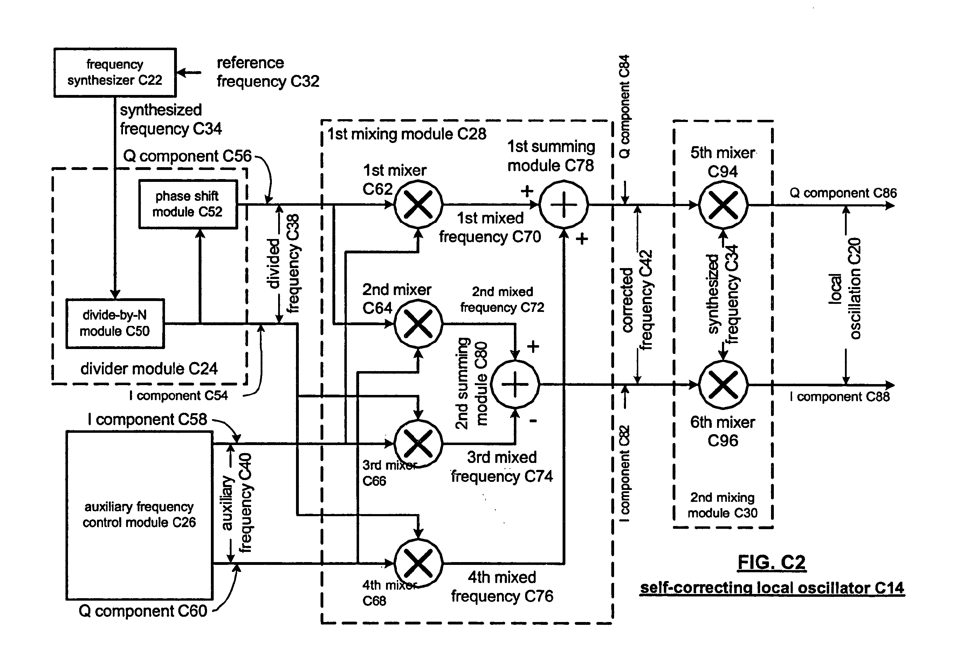

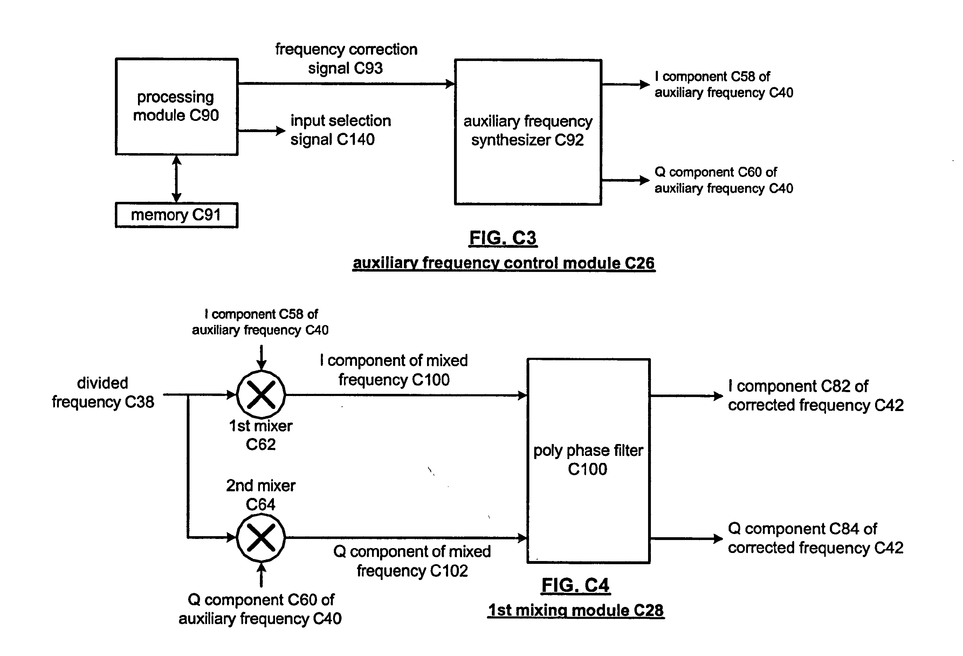

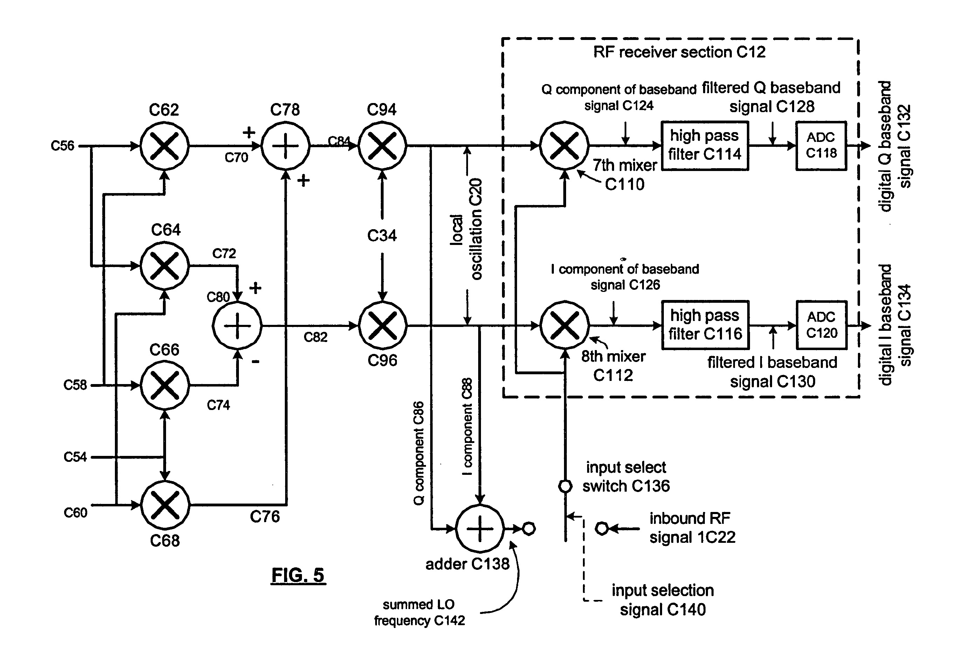

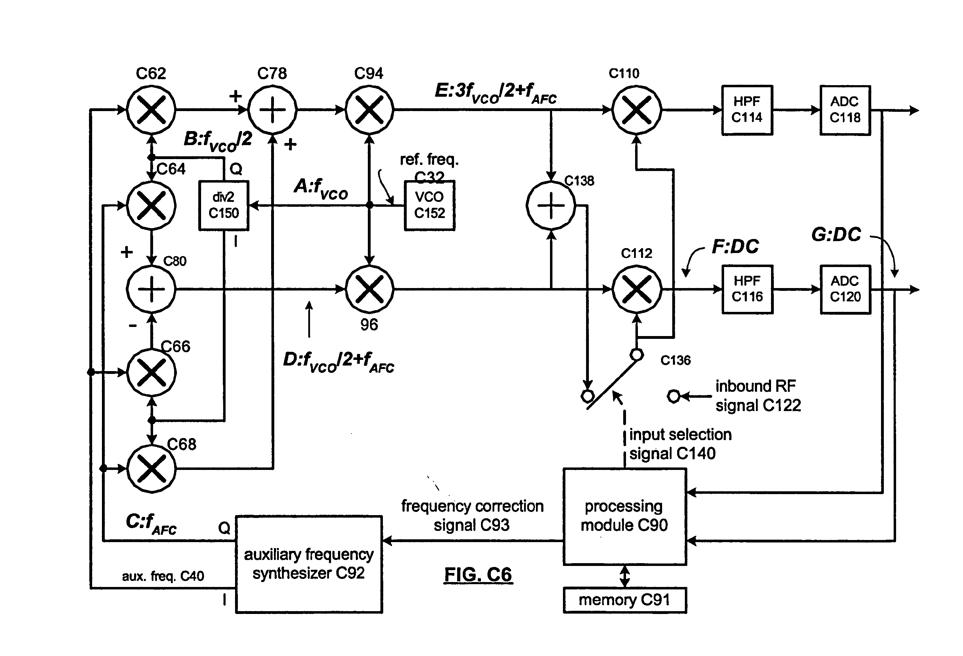

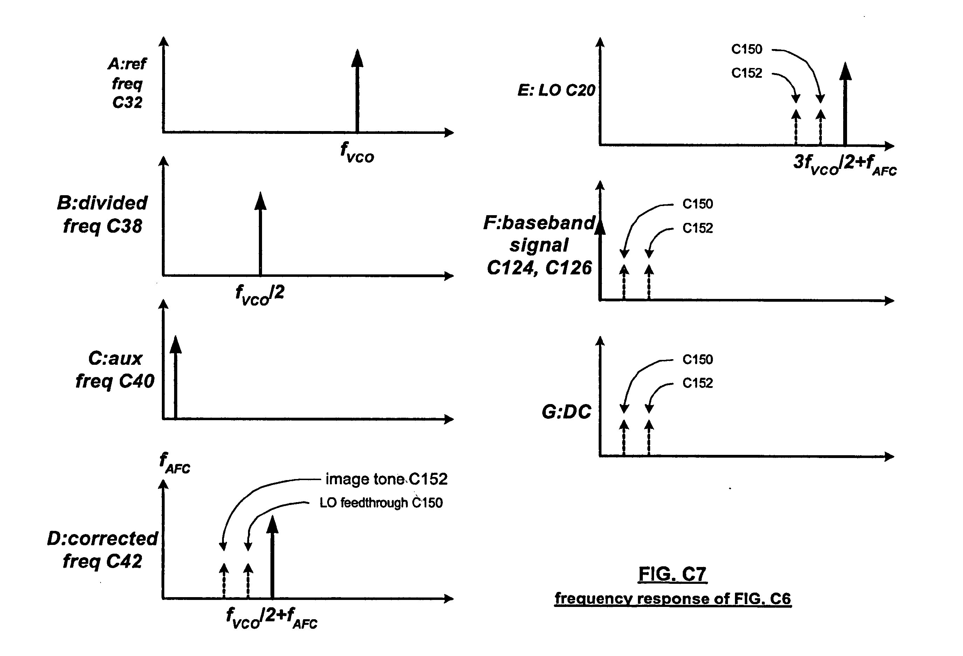

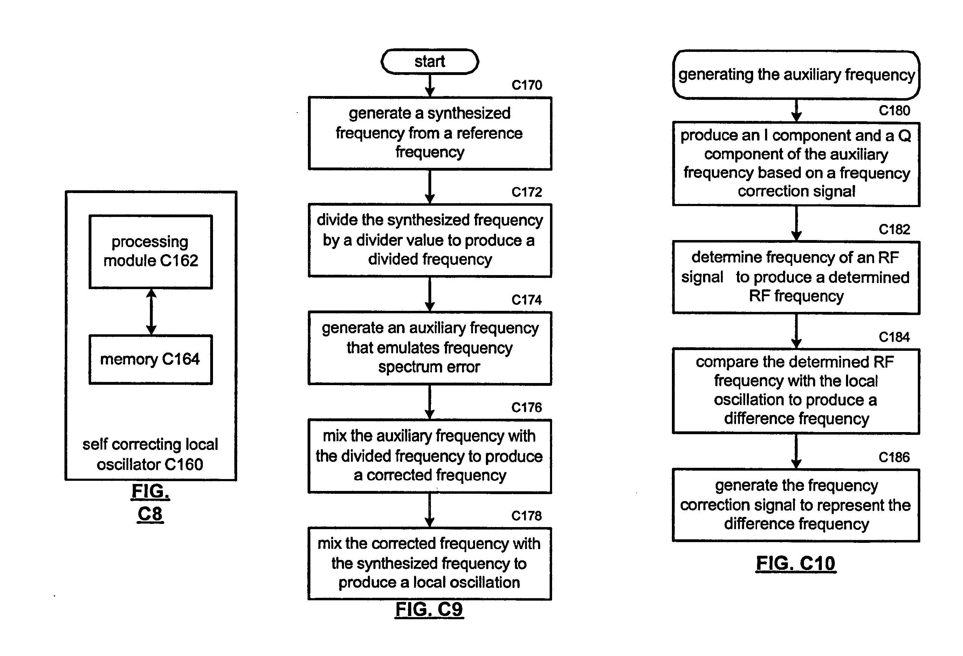

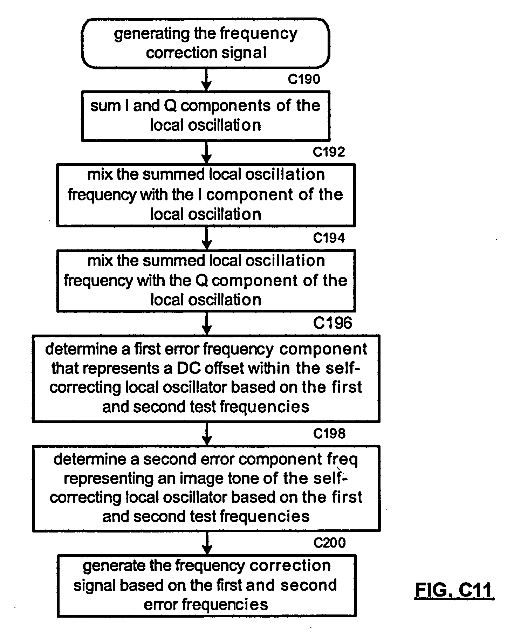

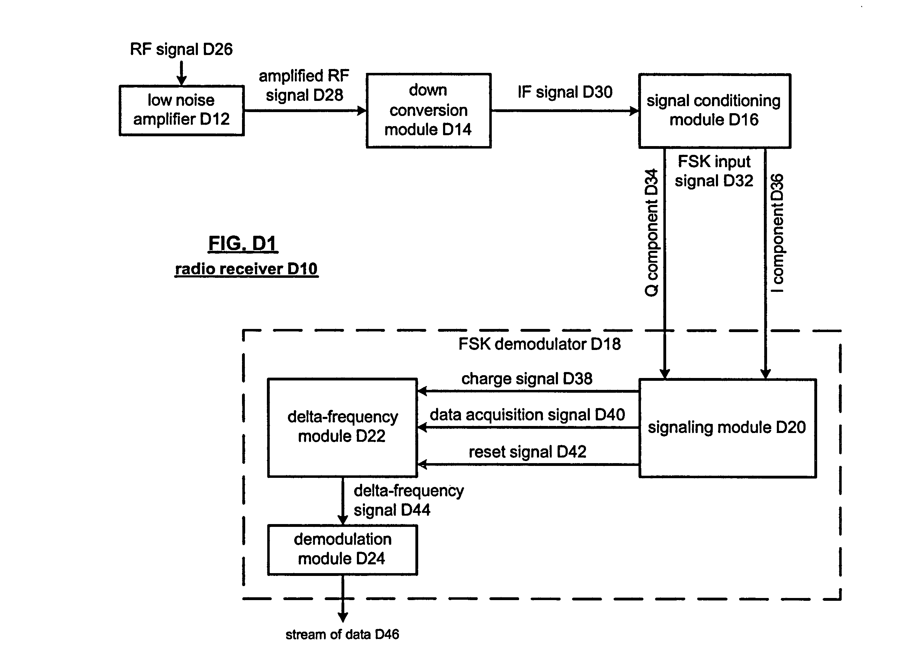

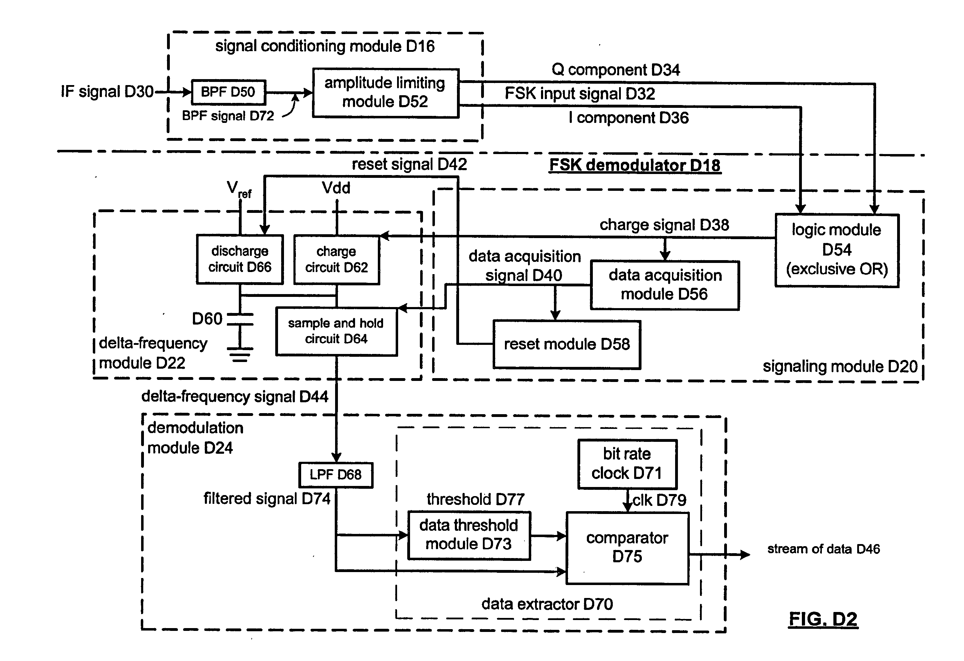

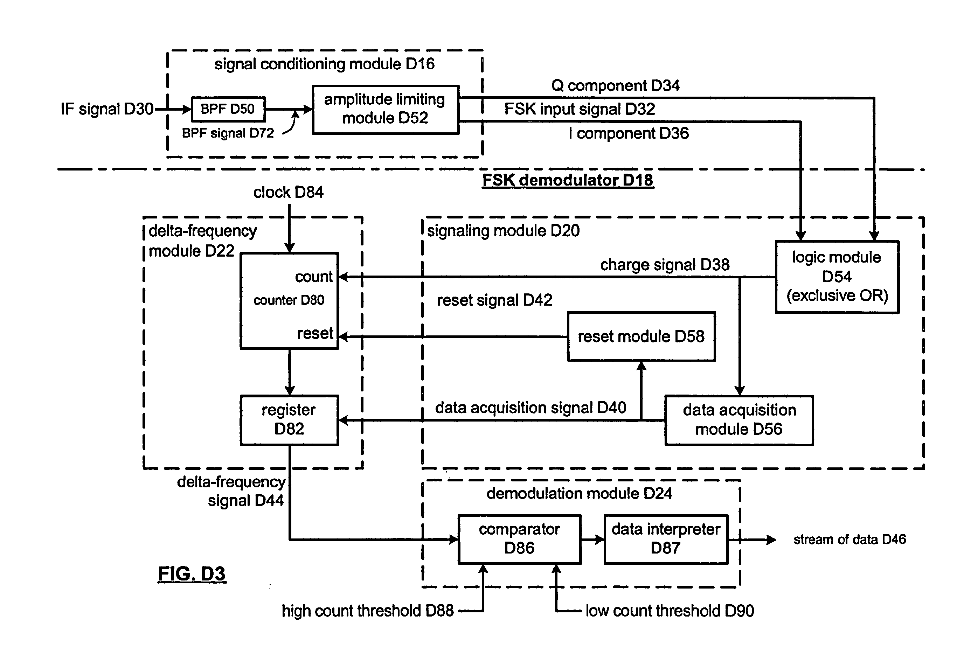

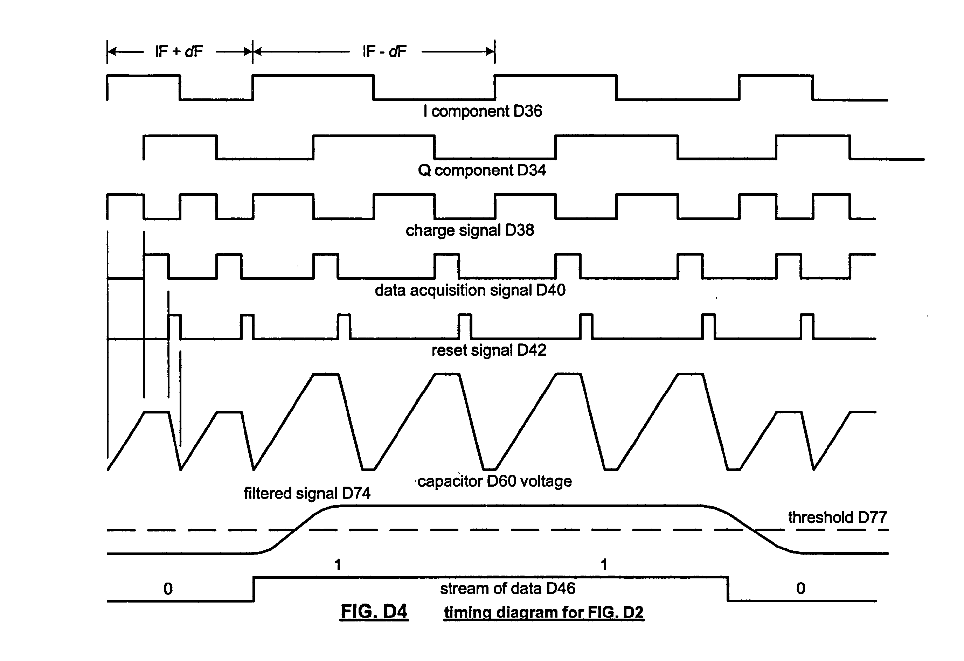

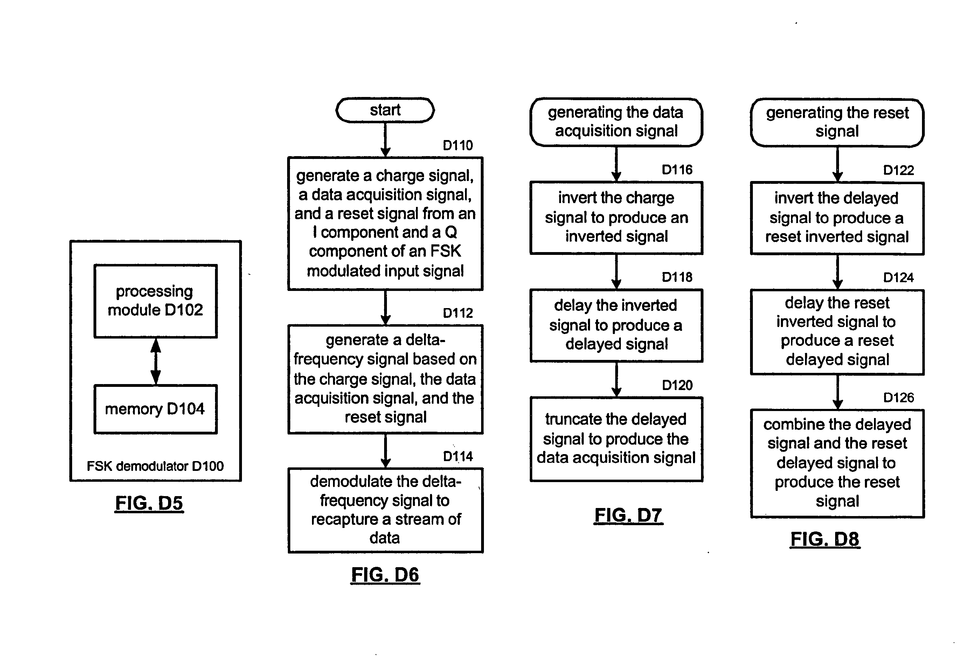

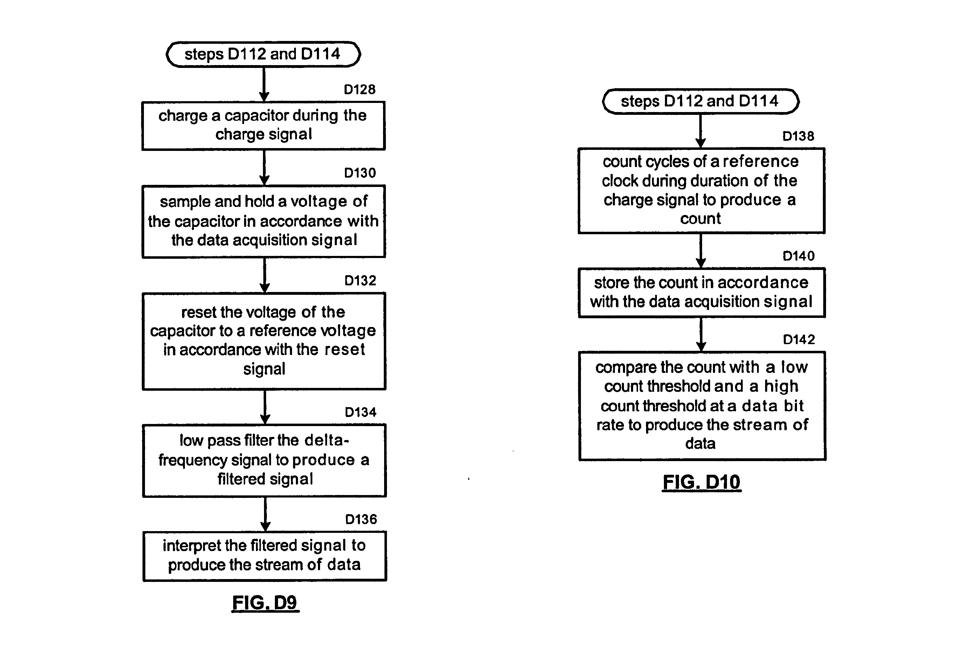

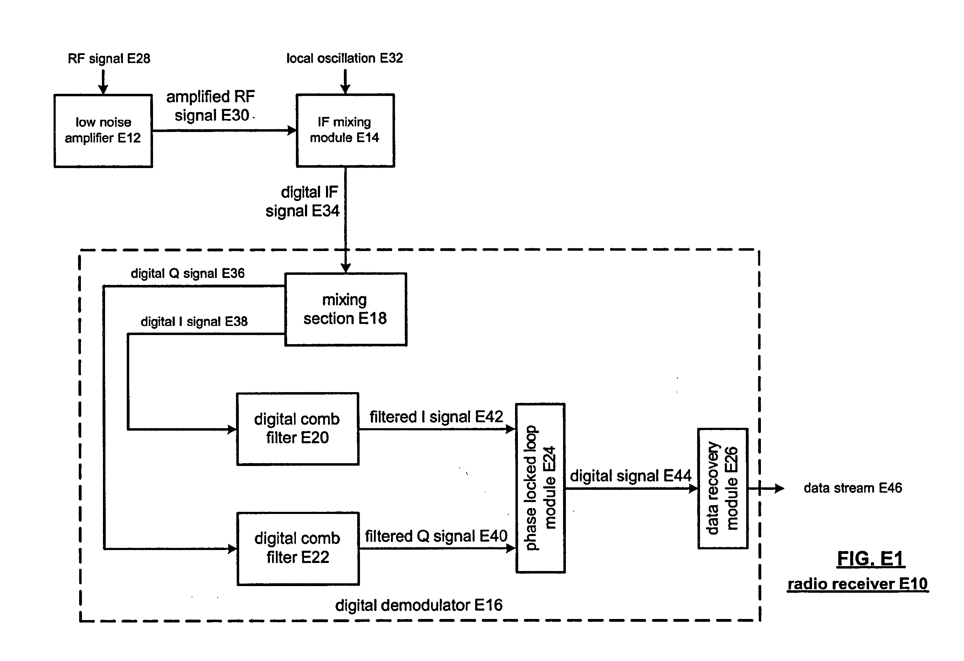

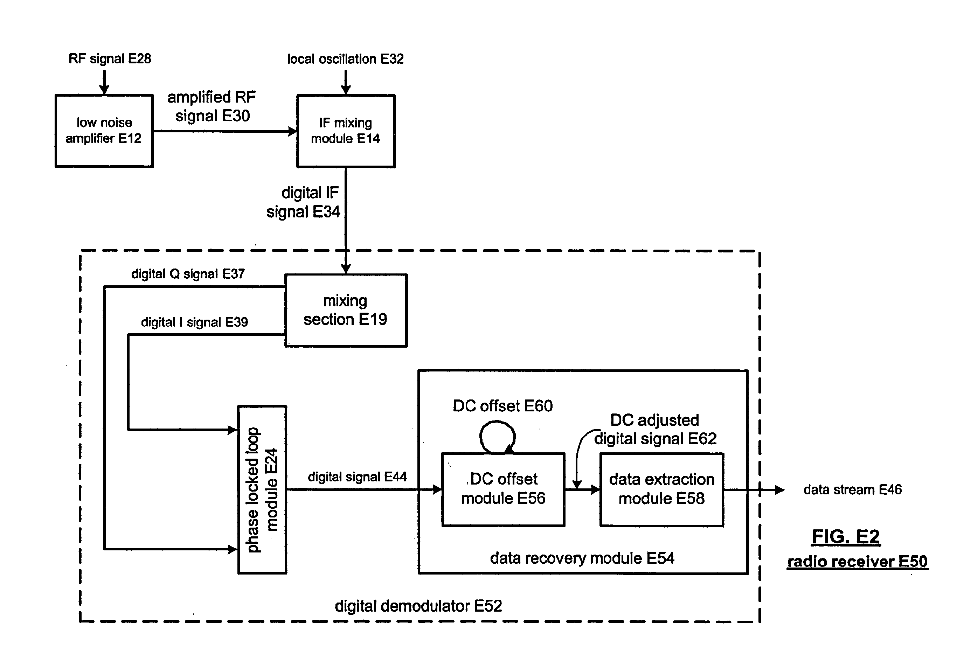

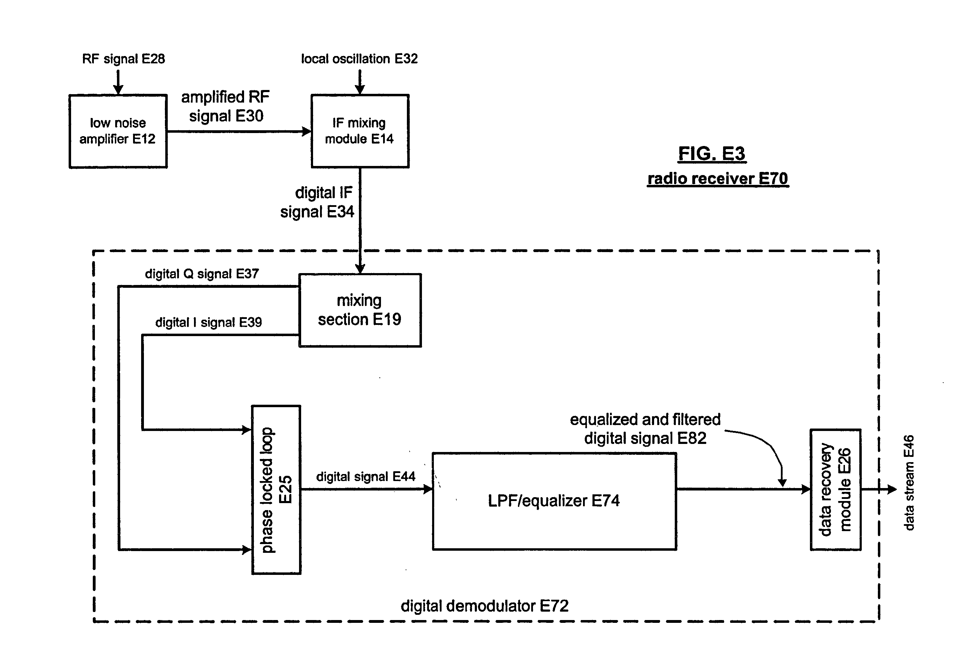

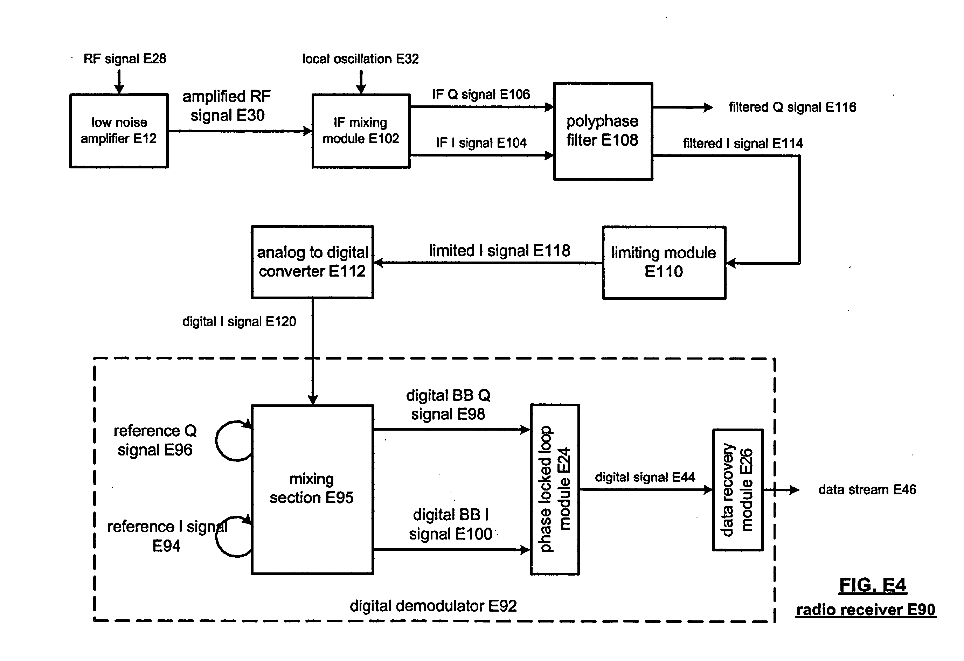

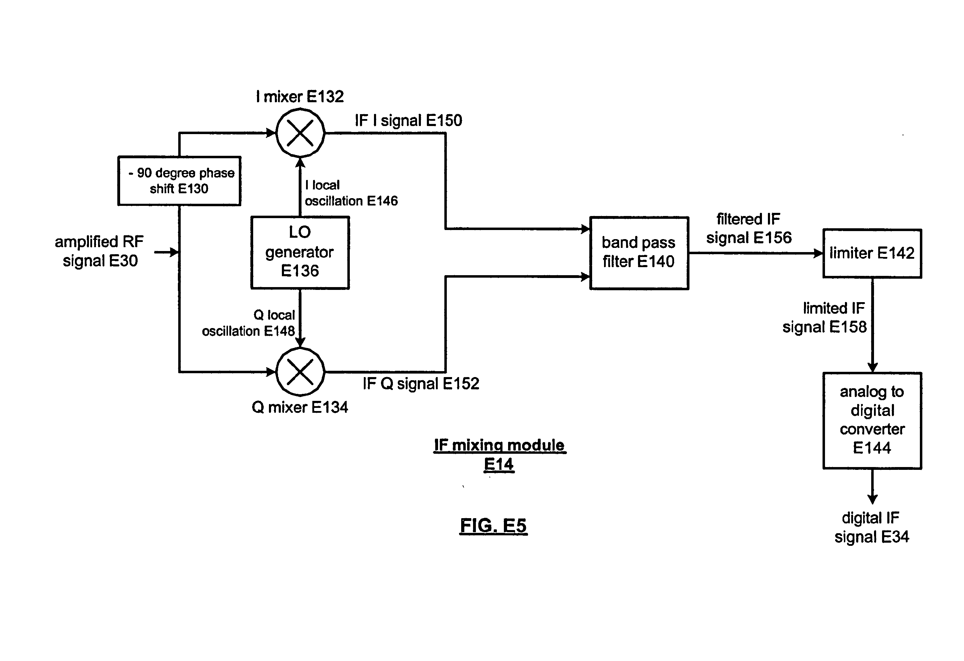

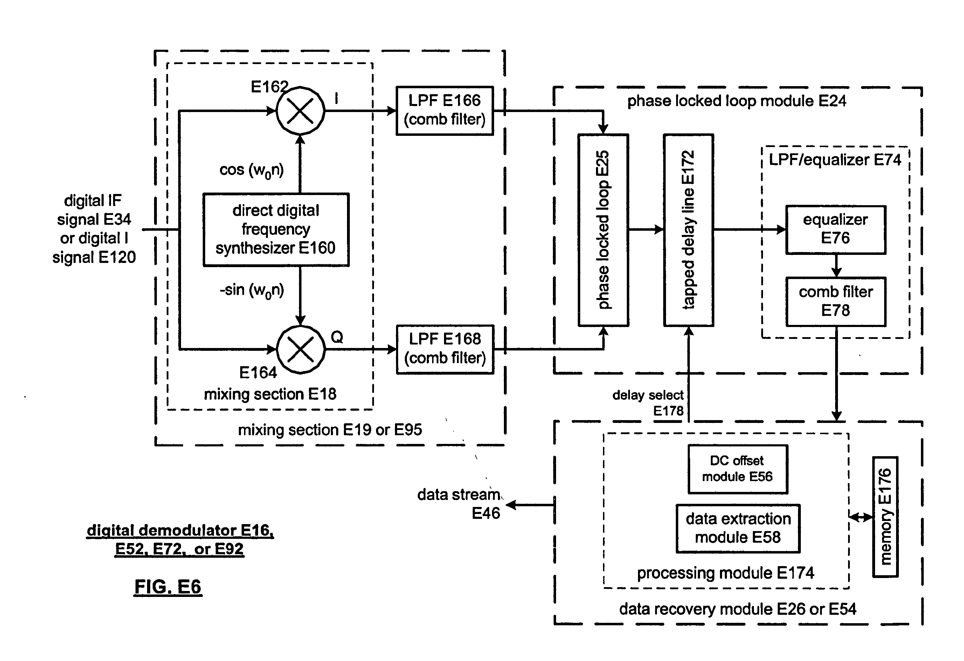

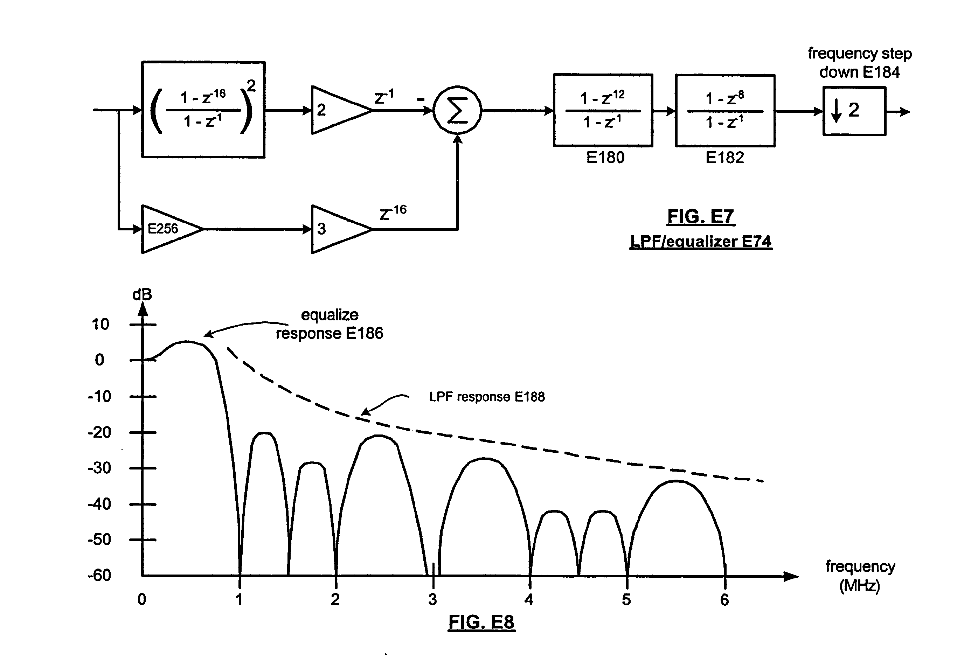

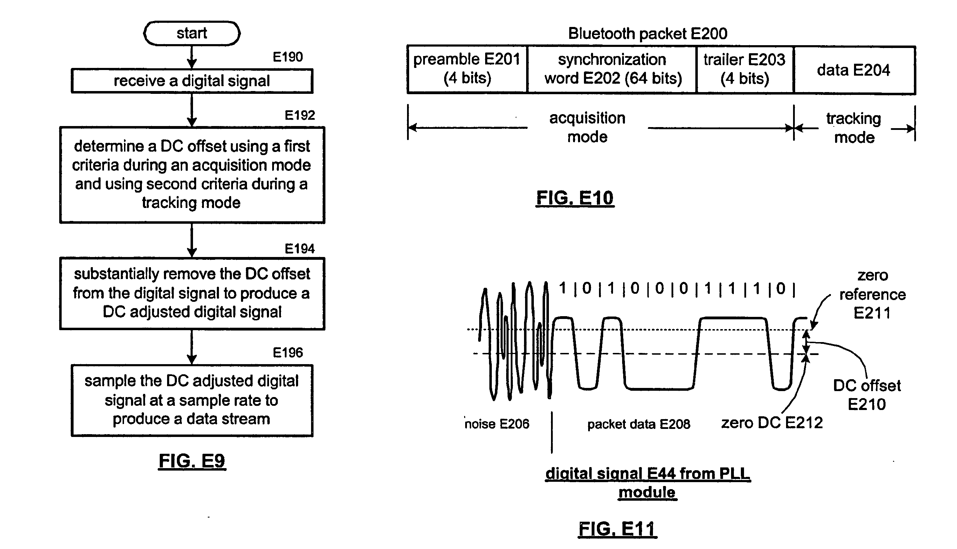

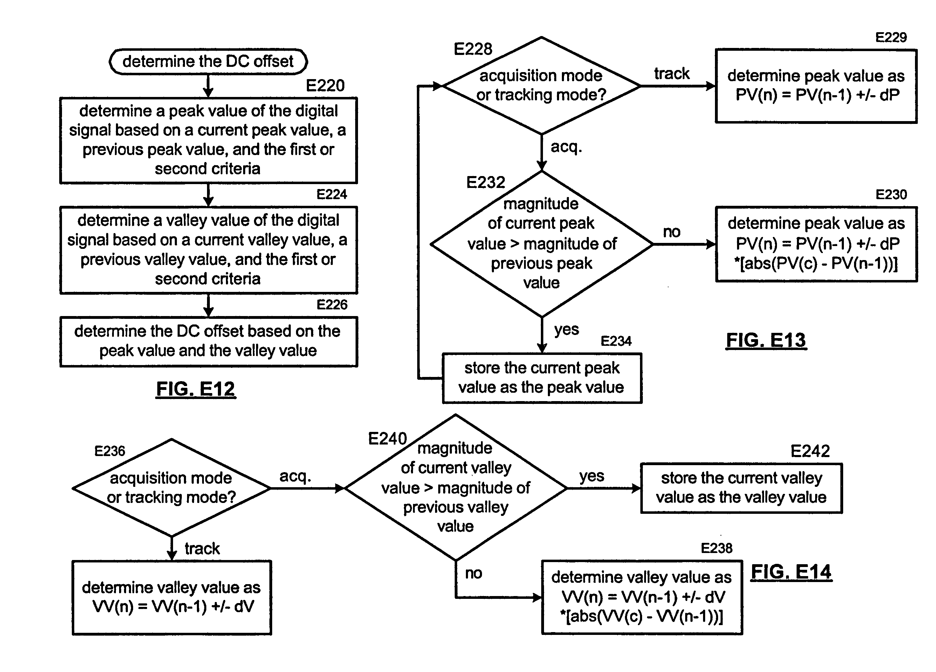

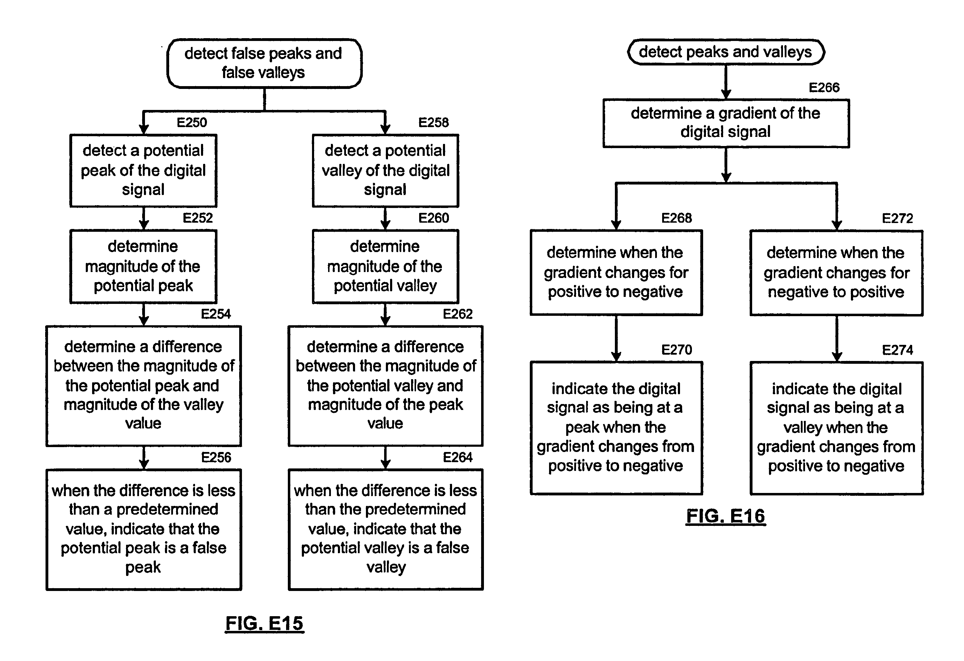

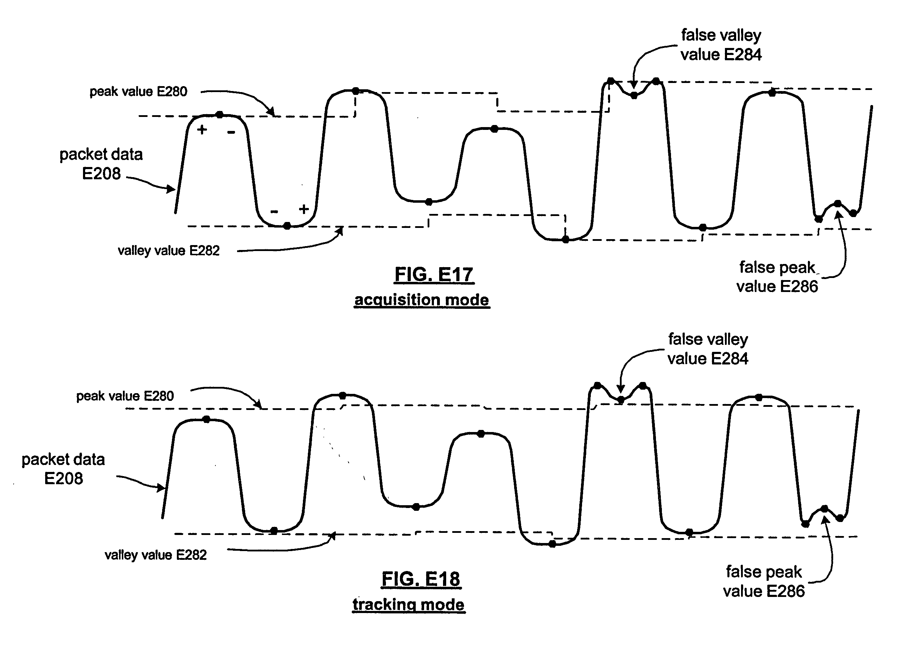

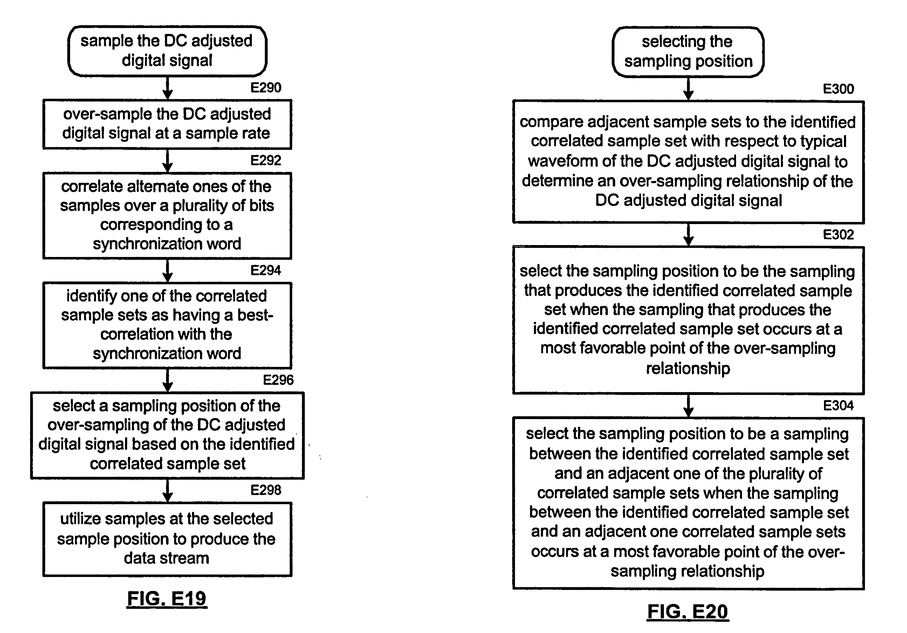

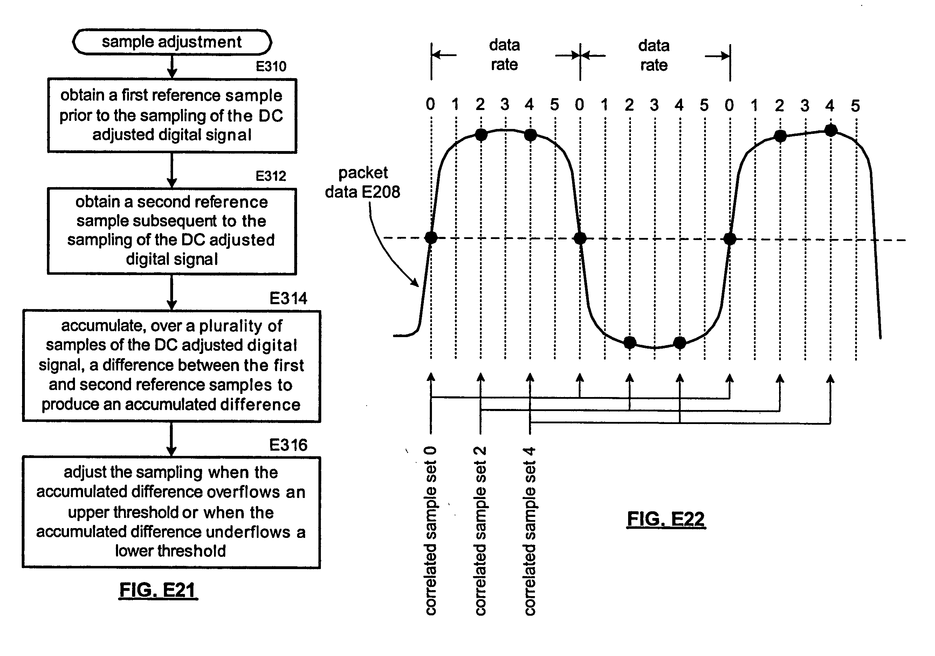

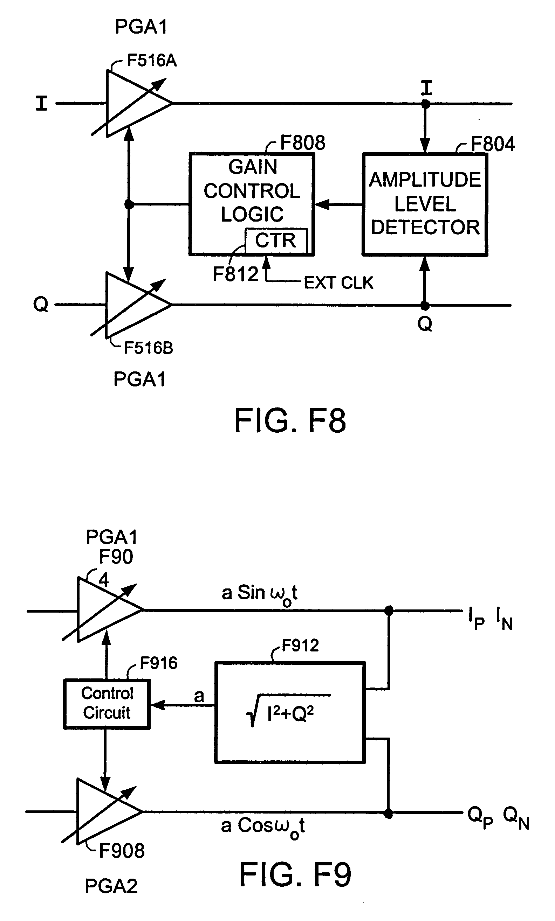

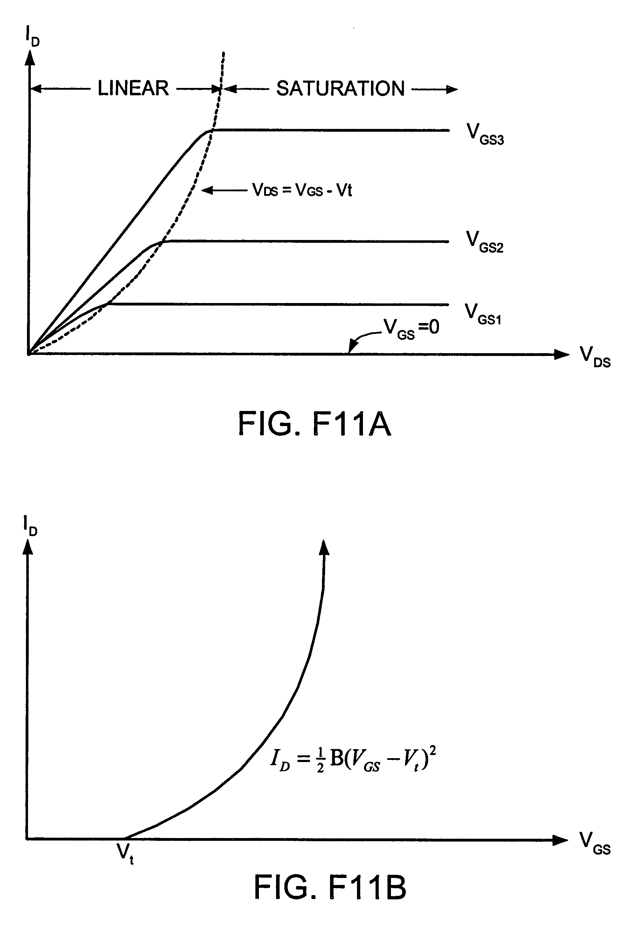

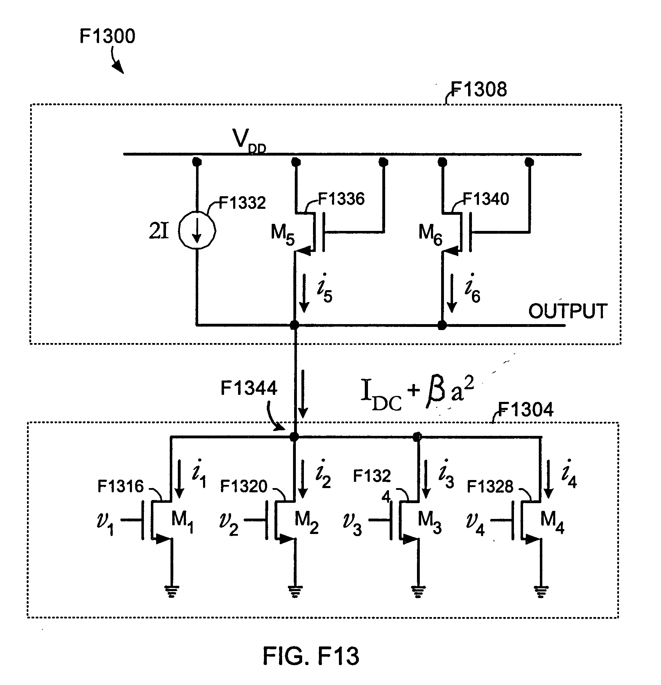

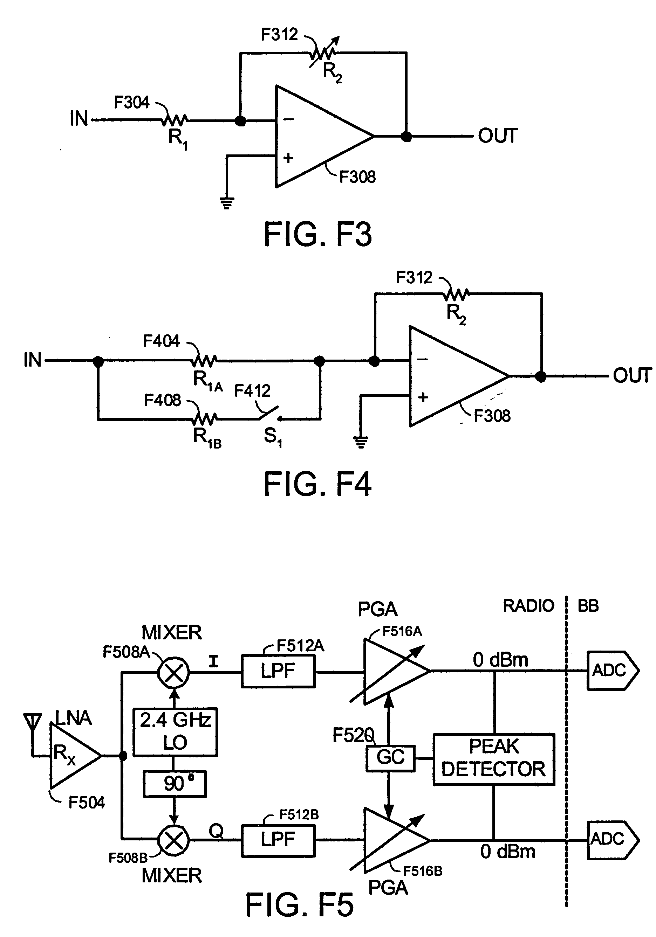

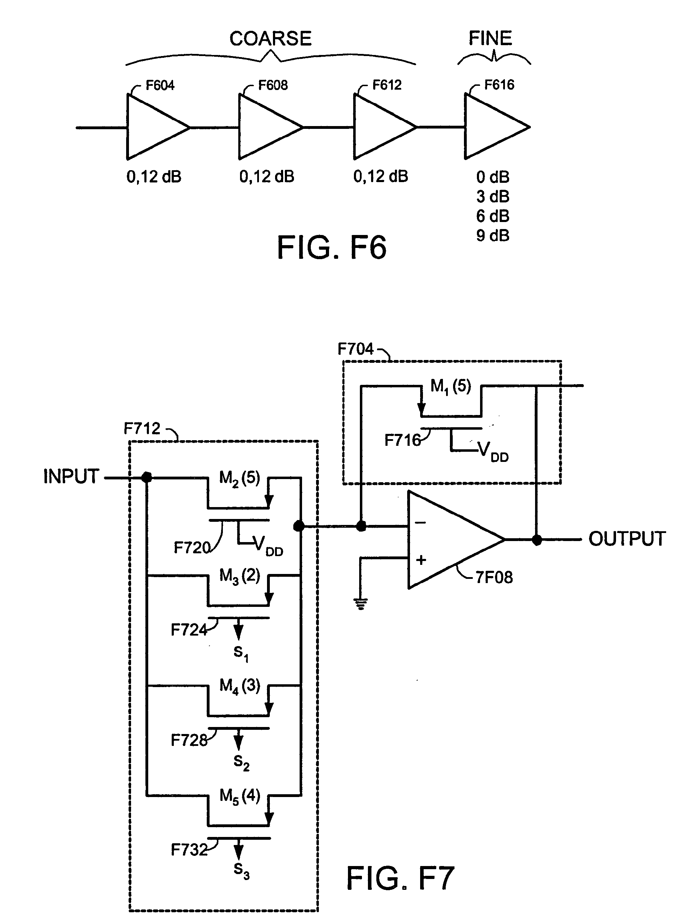

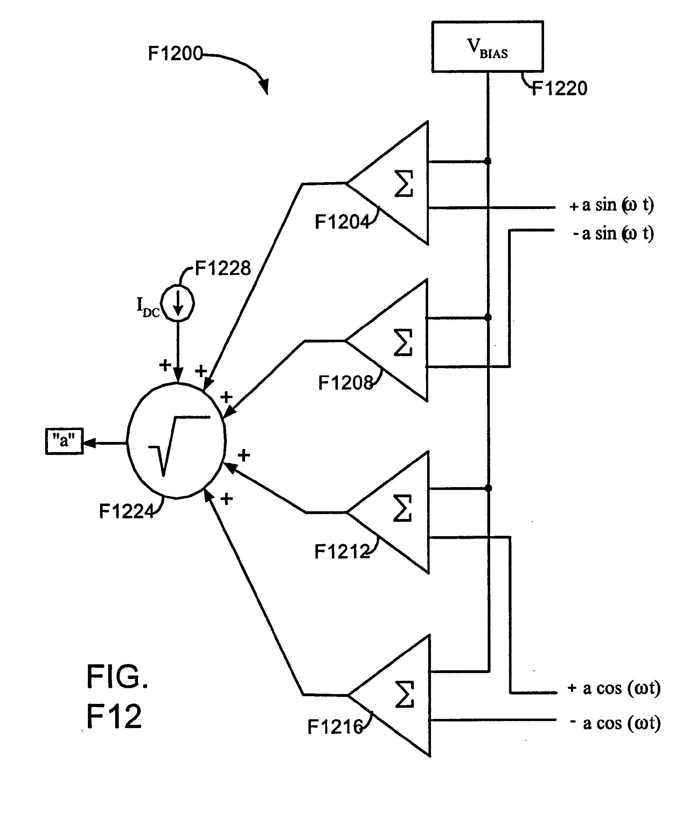

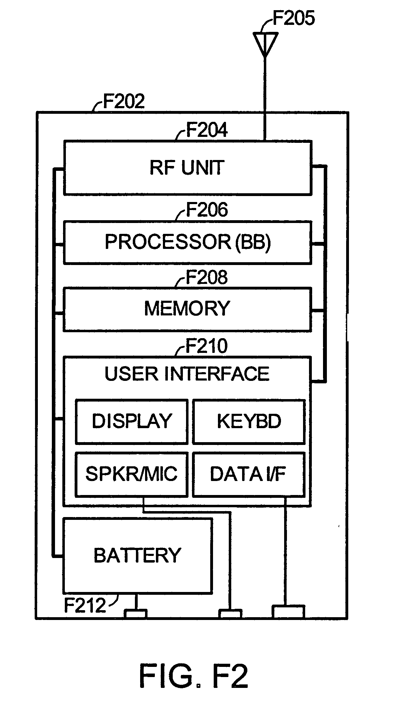

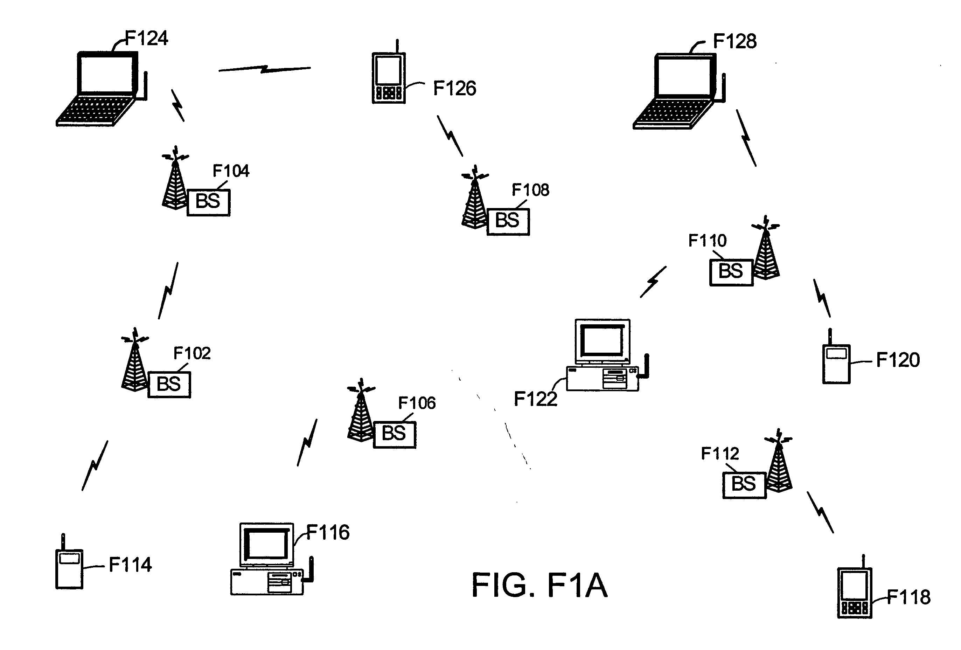

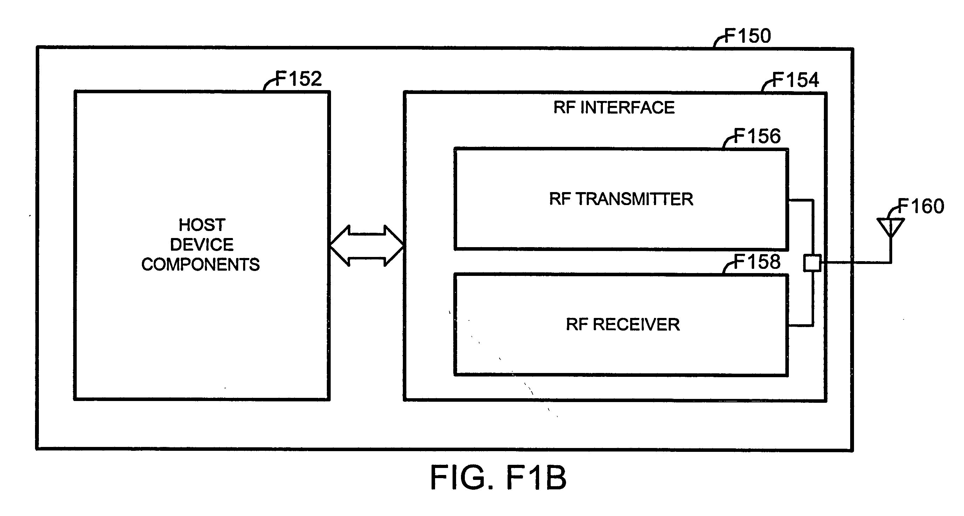

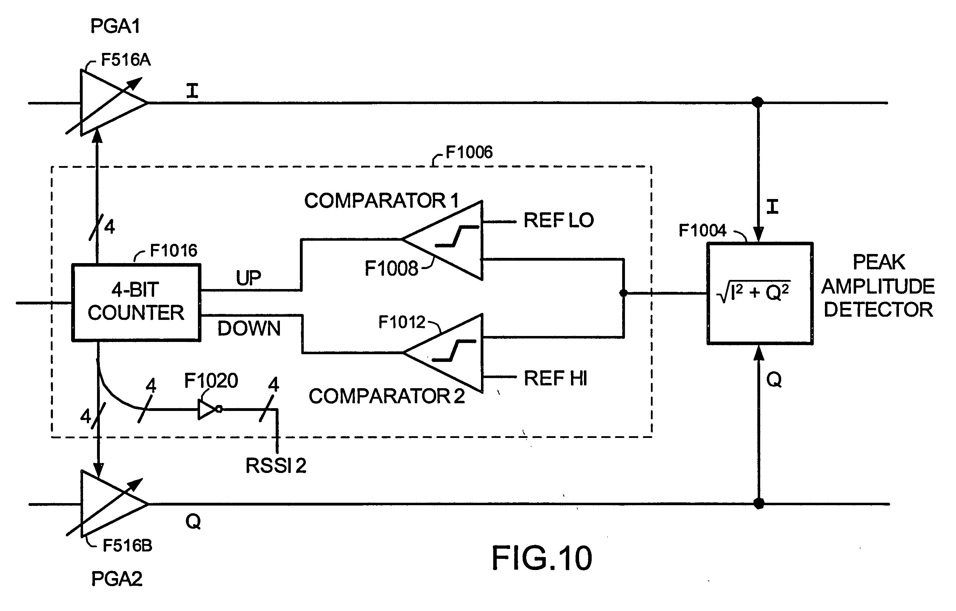

Figure 10 illustrates a schematic block diagram of a multiple IF stage analog receiver 77. In this embodiment, the analog receiver 77 includes low noise amplifier 72, the down-conversion module 70, and the filter/gain module 68. The low noise amplifier 72 may be programmable in accordance with Section I. The down-conversion module 70 includes a 1st IF stage that includes mixing modules 220 and 222, which produce an IF signal having a low IF carrier frequency in the range of 0 hertz to a few megahertz, and a 2nd IF stage, which converts the low IF signal into a baseband signal. The low IF to baseband portion of the down-conversion module 70 includes a 1st differentiator 252, 2nd differentiator 254, mixing module 256, mixing module 258 and summing module 260.

The filter/gain module 68 includes bandpass filters 240 and 242, programmable gain amplifiers 244 and 246 and bandpass filters 248 and 250. The programmable gain amplifiers may be constructed in accordance with the teachings of Section G, J, and/or K. The mixing modules 220 and 222 may programmable and constructed in accordance with the teachings of Section L.

In operation, the low noise amplifier 72 receives inbound RF signals 88 and provides amplified versions thereof to the 1st and 2nd mixing modules 220 and 222. The 1st and 2nd mixing modules mix their respective signals with the receiver local oscillation 81. The bandpass filters 240 and 242 filter the outputs of mixers 220 and 222 and provide the filter signals to programmable gain amplifiers 244 and 246. The programmable gain amplifiers 244 and 246 adjust the gain of the signal, which are then filtered via bandpass filters 248 and 250.

The filtered low IF signals are then provided to the low IF to baseband portion of down-conversion module 70, which differentiates the signals via differentiators 252 and 254 and then mixes the differentiated signals with the opposite signals in mixers 256 and 258 to produce difference signals that once summed via 260 produce a baseband representation of the inbound low IF signal 90.

The analog receiver 77 may be constructed to be compliant with the Bluetooth standard where the 1st and 2nd mixing modules 220 and 222 step-down the carrier frequency of the inbound RF signal 88 from approximately 2.4 gigahertz to approximately 2 megahertz. In addition, the low noise amplifier and mixing modules 220 and 222 may be shared in a wide bandwidth system as disclosed in Section A.

As an alternative embodiment, the down-conversion module 70 may omit the low IF to baseband section and transmit the low IF signals having a carrier frequency of a few megahertz directly to the digital receiver section. The digital receiver section then would perform the low IF to baseband conversion before performing the demodulation functions and decoding functions, et cetera as previously described in Figures 7 and 8.

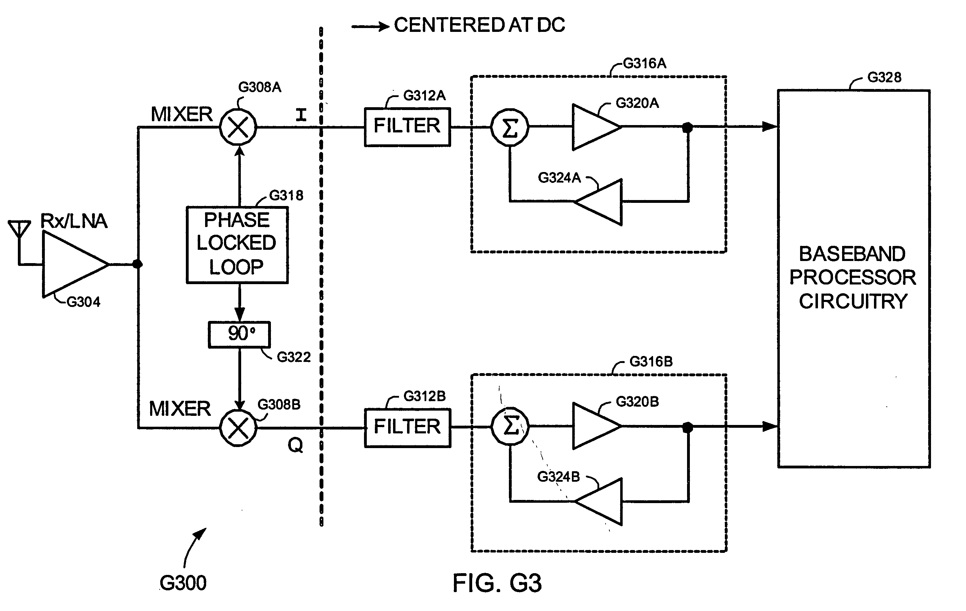

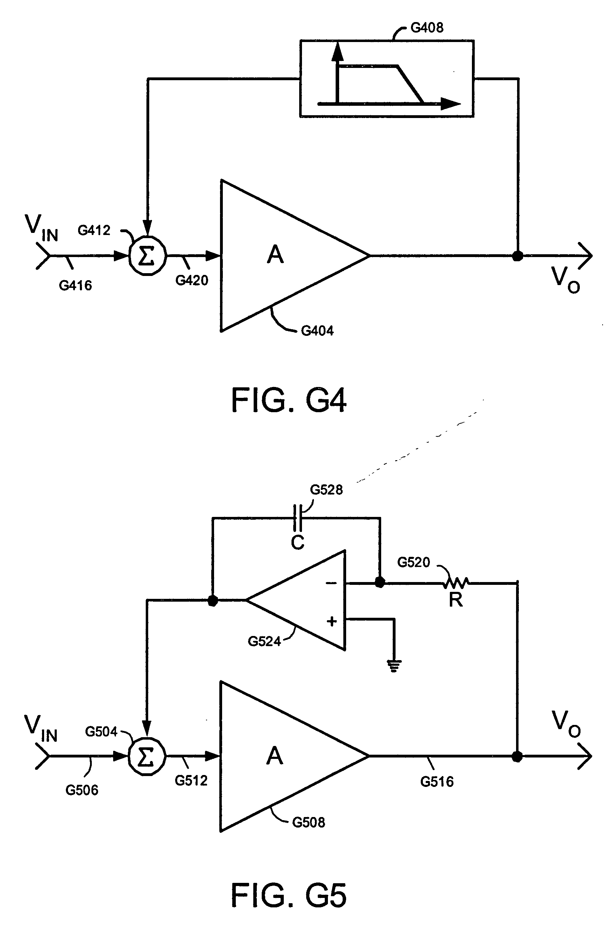

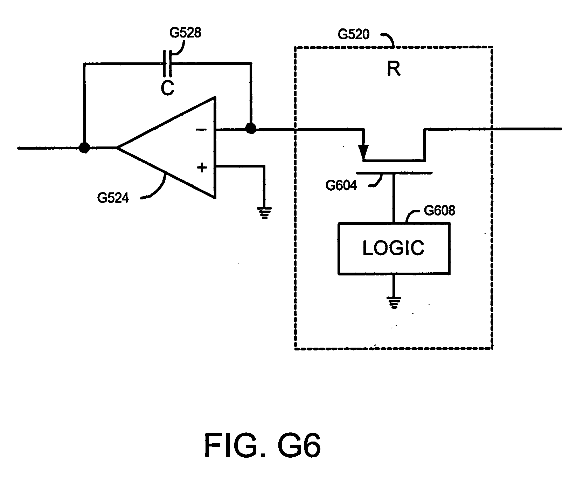

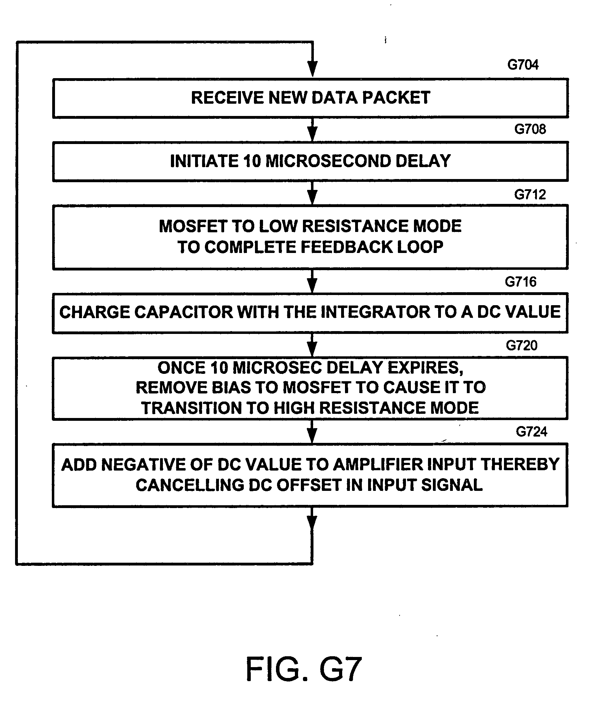

Figure 11 illustrates a schematic block diagram of an analog radio transmitter 79 that may be constructed in accordance with an IEEE 802.11B standard to perform direct conversion and/or in accordance with the Bluetooth standard to convert a low IF signal into an RF signal. In either embodiment, the analog radio transmitter 79 may be a self-calibrating transmitter as disclosed in Section K.

During normal operation, the digital optimization module 85 causes multiplexors 270 and 272 to pass I and Q components of outbound low IF signal 96 to the filter/gain module 80. The filter/gain module 80 includes low pass filters 274 and 276 and variable gain stages 278 and 280. The resulting filtered and gained I and Q signals are provided to the up-conversion module 82, which includes a 1st mixing module 282, a 2nd mixing module 284 and a summing module 286. Note that the mixing modules 282 and 284 may be programmable mixers as disclosed in Section L. The 1st and 2nd mixing modules 282 and 284 mix their respective inputs with the transmitter local oscillation to produce 1st and 2nd mixed signals. The summing module sums the 1st and 2nd mixed signals to produce a summed signal.

The power amplifier receives the output from the up-conversion module 82 and amplifies it. The power amplifier 84 may be implemented as disclosed in accordance with the teachings of Section J. The resulting amplified signal is provided to a bandpass filter 284 and subsequently transmitted as the outbound RF signals 98.

During test mode, the digital optimization module 85 causes the multiplexors 270 and 272 to provide a test signal to the filtering/gain module 80. Section K discloses the self-calibration operation for an analog radio transmitter.

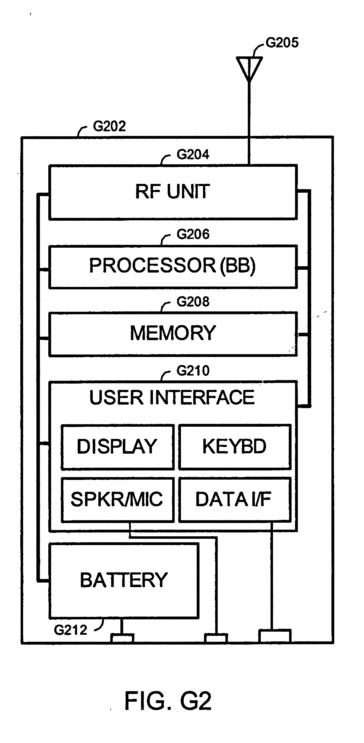

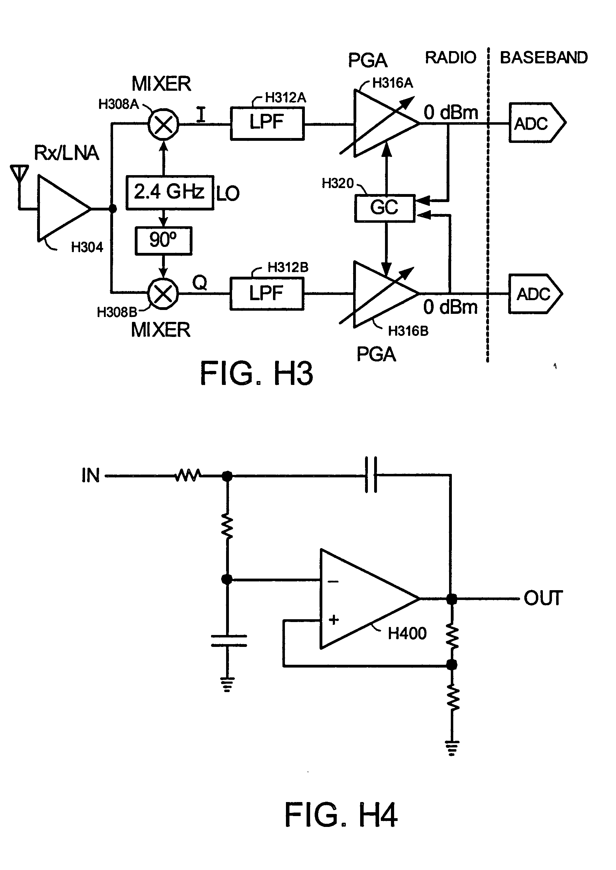

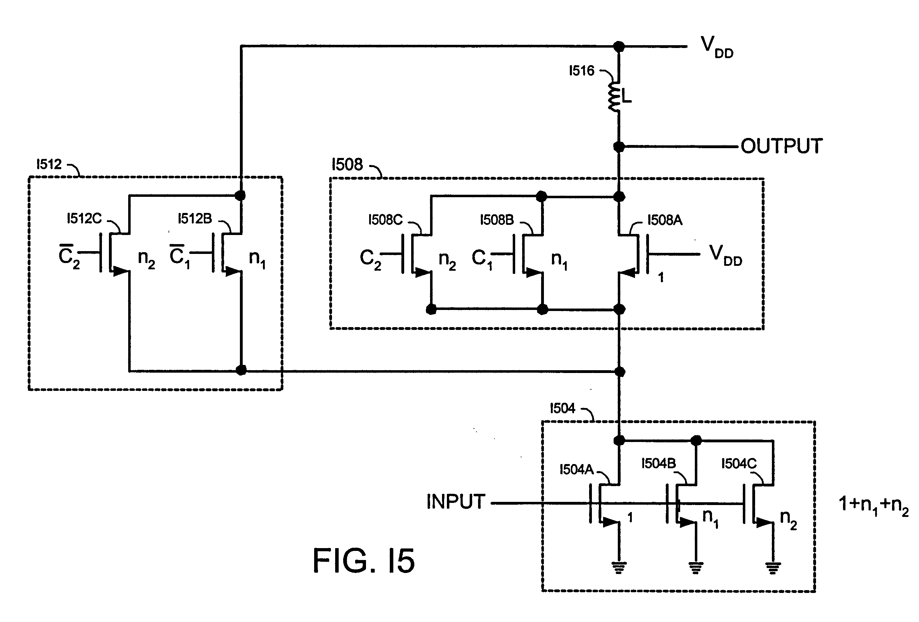

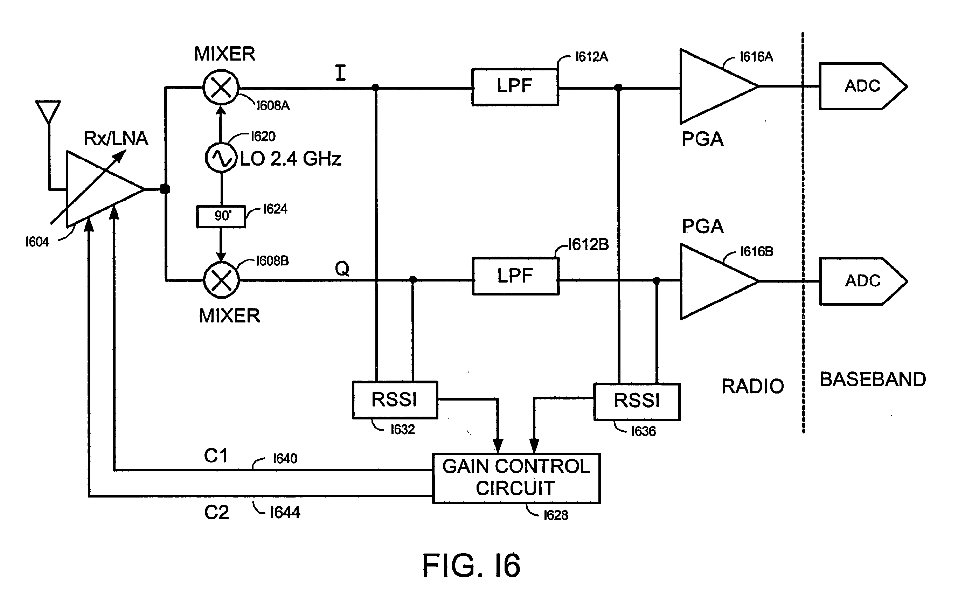

Figure 12 illustrates an alternate schematic block diagram of radio 60 operably coupled to host device 18-32. In this embodiment, the radio 60 includes a 1st integrated circuit 290 and a 2nd integrated circuit 292. The 1st integrated circuit 290 includes the analog receiver section 77, the local oscillation module 74, the analog transmitter section 79, a compensation module 294 and a proprietary interface 296. The 2nd integrated circuit 292 includes the digital receiver processing module 64, the memory 75, the digital optimization module 85, the digital transmitter processing module 76, and a proprietary interface 298. In this embodiment, the compensation performed within the analog receiver section 77, the local oscillation module 74 and/or the analog transmitter section 79 is performed via the compensation module 294. The monitoring data collected regarding the performance of the analog receiver section 77, the local oscillation module 74 and/or the analog transmitter section 79 is provided to the 2nd integrated circuit 294 via the proprietary interface 296.

The digital optimization module 85 receives the monitoring data via the proprietary interface 298 and produces the corresponding compensation control signals therefrom. The digital optimization module 85 provides the compensation control signals back to the 1st integrated circuit 290 via the proprietary interfaces 298 and 296.

By including the proprietary interfaces 296 and 298, the flexibility of the digital signal processing within the 2nd integrated circuits 292 may be leveraged to optimize the performance of the analog circuitry within the 1st integrated circuit 290. As one of average skill in the art will appreciate, if the 1st and 2nd integrated circuits 290 and 292 were implemented on the same piece of silicon, the proprietary interfaces 296 and 298 may be omitted.

## SECTION A

Figure A1 illustrates a schematic block diagram of an integrated multimode radio A10 that includes a multimode receiver A12 and a multimode transmitter A14. The multimode receiver A12 includes a shared receiver front-end A16, a receiver multiplexor A18, and a plurality of receiver IF stages A20 and A22. The multimode transmitter A14 includes a shared transmitter front-end A42, a transmitter multiplexor A40, and a plurality of transmitter IF stages A36 and A38.

The shared receiver front-end A16 receives a radio frequency (RF) signal A24 and a selection signal A34. The selection signal A34 indicates the particular operational mode used to generate the RF signal A24. The RF signal A24 is a modulated signal in accordance with a particular operation mode, i.e., wireless communication standard. Such wireless communication standards include, but are not limited to, Bluetooth, IEEE 802.11a, IEEE 802.11b analog mobile phone service (AMPS), digital AMPS (D-AMPS), global system for mobile (GSM), code division multiple access (CDMA), wireless application protocol (WAP), local multipoint distribution services (LMDS), and multi channel multipoint distribution system (MMDS).

The shared receiver front-end A16, based on the selection signal A34, generates an intermediate frequency (IF) signal A26 from the RF signal A24. For example, if the RF signal A24 is modulated in accordance with the Bluetooth specification, the selection signal A34 is indicative of the Bluetooth specification. Accordingly, the shared receiver front-end A16 configures itself to produce an IF signal A26 having an intermediate frequency of 2 megahertz. Alternatively, if the RF signal A24 is modulated in accordance with the IEEE 802.11b standard, the selection signal A34 is indicative of IEEE 802.11b. Accordingly, the shared receiver front-end A16 configures itself to produce an IF signal A26 that has an intermediate frequency at base-band. The construct and internal operations of the shared receiver front-end A16 will be described in greater detail with reference to Figures A4 and A8.

The receiver multiplexor A18 receives the IF signal A26 and selection signal A34. Based on the particular operation of mode indicated by the selection signal A34, the receiver multiplexor A18 provides the IF signal A26 to one of the plurality of receiver IF stages A20 and A22. As one of average skill in the art will appreciate, the multimode receiver A12 may include more receiver IF stages than the two depicted. However, if the integrated multimode radio A10 is designed to provide both Bluetooth and 802.11b applications, the multimode receiver A12 would include two receiver IF stages. One receiver IF stage would be configured for Bluetooth operations while the other is configured for 802.11b operations.

When the 1st receiver IF stage A20 receives the IF signal A26 it produces a 1st receiver IF signal A28. If the 2nd IF stage receives the IF signal A26 it produces a 2nd received IF signal A30. The construct and functionality of the receiver IF stages A20 and A22 will be described in greater detail with reference to Figures A3, A4, and A8.

As such, the multimode receiver A12 may be designed to meet the performance requirements of multiple wireless standards. For example, if the multimode receiver A12 is designed to meet the performance requirements of both Bluetooth and 802.11b specifications, the shared components of receiver A12 are designed to meet the more stringent requirements of 802.11b. By designing to the more stringent requirements, the less stringent requirements of Bluetooth will inherently be met.

The multimode transmitter A14 receives an input signal A44 via one of the plurality of transmitter IF stages A36 or A38. The number of transmitter IF stages included within transmitter A14 will depend on the number of different types of wireless specifications supported by the integrated multimode radio A10. For example, if the integrated multimode radio A10 supports Bluetooth and 802.11b, the transmitter A14 will include one transmitter IF stage for the Bluetooth mode (e.g., stage A36) and one for the 802.11b mode (e.g., IF stage A38). As one of average skill in the art will appreciate, when the selection signal A34 is indicative of one mode of operation, the IF stage A36 or A38 that corresponds to the other mode of operation may be disabled. This is equally applicable to the receiver IF stages A20 and A22. For example, if the selection signal A34 is indicative of Bluetooth operation, the transmitter IF stage and the receiver IF stage corresponding to the 802.11b operation would be disabled.

The enabled transmitter IF stage A36 or A38 generates a transmitter IF signal A46 or A48 dependent on the particular mode of operation. The operation of the 1st transmitter IF stage A36 and 2nd transmitter IF stage A38 will be described in greater detail with reference to Figures A3, A5, and A8.

The transmitter multiplexor A40 passes either the 1st transmit IF signal A46 or the 2nd transmit IF signal A48 to the transmitter front-end A42 as the selected IF signal A50 based on the selection signal A34. The transmitter front-end A42 up-converts the frequency of the selected IF signal A50 and amplifies it to produce the outbound RF signal A52. Note that the outbound RF signal A52 will be modulated in accordance with the particular operational mode of the particular operation of mode selected. For example, if the operational mode is Bluetooth, the outbound RF signal A52 will be in accordance with the Bluetooth standard. Alternatively, if the mode of operation is 802.11b, the outbound RF signal A52 will be in accordance with the 802.11b standard.

Figure A2 illustrates a schematic block diagram of an alternate integrated multimode radio A60 that includes a multimode receiver A62 and a multimode transmitter A64. The multimode receiver A62 includes a shared receiver front-end A66, a 1st receiver multiplexor A68, a receiver low pass filter A70, a receiver bandpass filter A72, a 2nd receiver multiplexor A74, and a receiver amplifier module A76. The multimode transmitter A64 includes a transmitter amplifying module A88, a 1st transmitter multiplexor A90, a first transmitter low pass filter A92, a second transmitter low pass filter A94, a 2nd transmitter multiplexor A96, and a shared transmitter front-end A98.

The shared receiver front-end A66 is operably coupled to receive the RF signal A24. As previously mentioned, the RF signal A24 may be modulated in accordance with one of a plurality of operational modes (e. g., Bluetooth, 802.11a, 802.11b, et cetera). The receiver front-end A66 generates an IF signal A26 based on the selection signal A34. As previously mentioned, the selection signal A34 is indicative of the particular mode of operation for the multimode receiver A62.

As shown, the IF signal A26 includes an in-phase component (I) and a quadrature component (Q). The particular frequency for the IF signal A26 is dependent on the particular mode of operation. For example, if the mode of operation is Bluetooth, the intermediate frequency signal A26 may have an intermediate frequency of 2 MHz. If, however, the mode of operation is 802.11b, the intermediate frequency signal A26 may have an intermediate frequency at base-band.

The 1st receiver multiplexor A68, based on the selection signal A34, provides the I and Q components of the IF signal A26 to either the receiver low pass filter A70 or the receiver band-pass filter A72. When the mode of operation is 802.11b, the selection signal A34 instructs the 1st receiver multiplexor A68 to provide the I and Q components of IF signal A26 to the receiver low pass filter A70. Conversely, if the mode of operation is Bluetooth, the 1st receiver multiplexor A68 provides the I and Q components of the IF signal A26 to the receiver band-pass filter A72.

The low pass filter A70 filters the I component and Q component of IF signal A26 to produce a low pass filtered I signal A78 and a low pass filtered Q signal A80. These signals are then provided to the 2nd receiver multiplexor A74. The receiver band-pass filter A72 filters the I and Q components of the IF signal A26 to produce band-pass filtered Q signal A82 and band-pass filtered I signal A84. These signals are also provided to the 2nd receiver multiplexor A74. As one of the average skill in the art will appreciate, the frequency response of the low pass filter A70 and the band pass filter A72 will be in accordance with known filtering operations to adequately pass the frequencies of interest and attenuate other frequencies.

Based on the selection signal A34, the 2nd receiver multiplexor A74 outputs either the low pass filtered I and Q signals A78 and A80 or the band-pass filtered I and Q signals A82 and A84 to the receiver amplifier module A76. The receiver amplifying module A76 amplifies the I and Q components to produce amplified I and Q components A86. As one of average skill in the art will appreciate, if the multimode receiver A62 is designed to support both Bluetooth operations and 802.11b operations, the amplifying circuitry within the receiver amplifying module A76 in combination with the amplifier within the receiver front-end A66 will be designed to meet the more stringent requirements of the 802.11b specification. By designing these components for the more stringent 802.11b requirements, the requirements for Bluetooth will be inherently met. The multimode receiver A62 will be described in greater detail with reference to Figure A6.

The multimode transmitter A60 is operably coupled to receive an I and Q component of an input signal A100. The I and Q components of the input signal are representative of a modulated signal at an IF frequency based on the particular mode of operation. For example, if the mode of operation is Bluetooth, thefrequency of the I and Q components of the input signal will be approximately 0 MHz. Alternatively, if the mode of operation is 802.11b, the input signal A100 will have a frequency at base-band.

The transmitter amplifying module A88 receives the I and Q components of input signal A100 and amplifies them. The transmitter amplifying module A88 provides the amplified input signal A100 to the 1st transmitter multiplexor A90. Based on the selection signal

A34, the 1st transmitter multiplexor A90 outputs the I and Q components to either the transmitter low pass filter A92 (e.g., for Bluetooth operation) or the transmitter low pass filter A94 (e.g., for 802.11b operation). If the selection signal A34 indicates that the low pass filter A92 is to receive the signals, the low pass filter A92 filters the I and Q components to produce low pass filtered Q signal A102 and low pass filtered I signal A104. Alternatively, if the selection signal A34 indicates that low pass filter A94 filters is to receive the signals, the filter A94 filters the signal to produce low pass filtered Q signal A106 and low pass filtered I signal A108. As one of average skill in the art will appreciate, the frequency response of filters A92 and A94 will be based on the particular mode of operation. For example, filter A92 will have a frequency response to pass baseband signals, while filter will have a frequency response to pass 2 MHz signals.

The 2nd transmitter multiplexor A96 outputs either the low pass filtered I and Q signals A102 and A104 or the low pass filtered I and Q signals A106 and A108 based on the selection signal A34. The 2nd transmitter multiplexor A96 provides the selected IF signal A100 to the transmitter front-end A98. Based on the selection signal A34, the transmitter front-end A98 up-converts the frequency of the IF signal A110 and amplifies it to produce the outbound RF signal A52. The multimode transmitter A64 will be described in greater detail with reference to Figure A7.

Figure A3 illustrates a schematic block diagram of another integrated multimode radio A120 that includes a multimode receiver A122 and a multimode transmitter A124. The multimode receiver A122 includes a receiver front-end A124, a receiver multiplexor A130, a 1st receiver IF section A126, and a 2nd receiver IF section A128. The multimode transmitter A124 includes a 1st transmitter IF section A174, a 2nd transmitter IF section A176, a transmitter multiplexor A172, and a transmitter front-end A170.

In operation, the receiver front-end A124 is operably coupled to receive the RF signal A24. As previously mentioned, the RF signal A24 is modulated in accordance with a particular wireless communication standard (e.g., Bluetooth, IEEE 802.11a, IEEE 802.11b, et cetera). The front-end receiver A124 includes a low noise amplifier A132 and a mixing module A134. The low noise amplifier A132 receives the RF signal A24 and a gain setting signal A146. The gain setting signal A146 sets the gain of the low noise amplifier A132 at a particular gain within a range of gain of the low noise amplifier. As such, the low noise amplifier A132 has a programmable gain, which is set in accordance with the gain setting signal A146. Based on the selected gain, the low noise amplifier A132 produces an amplified RF signal A144 from the RF signal A24.

The mixing module A134, which will be described at greater detail with reference to Figure A4, receives the amplified RF signal A144 and an operational selection signal A148. The mixing module A134 produces an intermediate frequency signal from the amplified RF signal A144 based on the operational selection signal A148. The receiver multiplexor A130 receives the intermediate frequency signal from the front-end A124 and provides it as either intermediate frequency signal A150 to the 1st receiver IF section A126 or as another IF signal A152 to the 2nd receiver IF section A128. As one of average skill in the art will appreciate, the multimode receiver A122 may include additional receiver IF sections. Such additional IF sections would correspond to different modes of operation for the integrated multimode radio A120. For example, one mode may be in accordance with 802.11a, another mode in accordance with 802.11b, and another mode in accordance with Bluetooth.

The 1st receiver IF section A126 includes a 1st receiver filter module A136, and a 1st receiver amplifier module A138. The receiver filter module A136 is operably coupled to receive the IF signal A150 and filters it to produce a 1st filtered IF signal A158. The 1st receiver amplifying module A138 receives the 1st filtered IF signal A150 and a gain A156 that is set in accordance with the gain setting signal A146. Based on the gain A156, the 1st receiver amplifier module A138 amplifies the 1st receiver IF signal A158 to produce a 1st IF signal A150. The gain of the 1st receiver amplifying module is programmed over an IF gain range that is based on the IF gain setting signal A154. As one of average skill in the art will appreciate, the gain selected for the low noise amplifier A132, the 1st receiver filter module A136, and the 1st receiver amplifier module A138 are chosen to meet the requirements of the particular mode of operation supported by this path and on the power level of the received RF signal A24. For example, if this path supports 802.11b, the gain for these modules is set to meet the noise requirements and hence performance requirements for 802.11b for a given power level of the received RF signal A24.

The 2nd receiver IF section A128 includes a 2nd receiver filter module A140 and a 2nd receiver amplifying module A142. The 2nd receiver filter module A140 is operably coupled to filter the IF signal A152 to produce the 2nd filtered IF signal A162. The 2nd receiver amplifying module A142, based on gain A156, amplifies the 2nd filtered IF signal A162 to produce the 2nd IF signal A164. In this illustration, the 1st receiver IF section A126 supports a more stringent performance requirement based wireless communication standard than the 2nd receiver IF section A128. As such, the gain setting signal A146 and gain A156 are set to meet the more stringent requirements for the 1st receiver IF section. As such, the gain of the 2nd receiver IF section A128 is set as if the 1st receiver IF section A126 were actively processing the IF signal A150.

The multimode transmitter A124 is operably coupled to receive a 1st input signal A190 or a 2nd input signal A192. The 1st input signal A190 is representative of a modulated signal in accordance with a particular mode of operation of the integrated multimode radio A120. The 2nd input signal A192 is a modulated signal in accordance with another operational mode of the integrated multimode radio A120. For example, the 1st input signal A190 may be a modulated signal in accordance with 802.11b while the 2nd input signal A192 is a modulated signal in accordance with Bluetooth.

The 1st transmitter IF section A174 includes a 1st transmitter filter module A178 and a 1st transmitter amplifying module A180. The 1st transmitter filter module A178 filters the 1st input signal A190 to produce a 1st filtered IF signal A194. The 1st transmitter amplifier module A180 receives the 1st filtered IF signal A194 and the gain A156. The 1st transmitter amplifying module A180 amplifies the 1st filtered signal A194 based on gain A156 to produce the 1st IF signal A190.

Similarly, the 2nd transmitter IF section A176 includes a 2nd transmitter filter module A182 and a 2nd transmitter amplifying module A184. The 2nd transmitter filter module A182 filters the 2nd input signal A192 to produce the 2nd filtered IF signal A196. The 2nd transmitting amplifying module A184 amplifies the 2nd filtered IF signal A196 in accordance with gain A156 to produce the 2nd IF signal A200.

As one of average skill in the art will appreciate, when the 1st transmitter IF section A174 is processing a modulated signal of a wireless communication standard that has more stringent performance requirements than the signals processed by the 2nd transmitter IF section A176, the gain setting signal A146 and gain A156 will be selected based on the performance requirements of the 1st path. By setting the gain to meet the performance requirements of the more stringent path, the less stringent requirements of the other path or paths will be met. As one of average skill in the art will also appreciate, the multimode transmitter A124 may include more transmitter IF sections than the two shown. For example, the transmitter A124 may include three sections: one for processing Bluetooth signals, one for processing 802.11a signals, and one for processing 802.11b signals.

The transmitter multiplexor A172 receives the 1st IF signal A198 and/or the 2nd IF signal A200. Based on the operational selection signal A148, the transmitter multiplexor A172 outputs either the 1st IF signal A198 or the 2nd IF signal A200 to the transmitter front-end A170.

The transmitter front-end A170 includes a mixing module A186 and a power amplifier A188. The mixing module A186 receives the IF signal A198 or A200 and, based on the operational selection signals A148, up-converts the frequency to produce a representative RF signal A202. The power amplifier A188 based on a gain setting signal A146 amplifies the representative RF signal A202 to produce an outbound RF signal A52. Note that the gain setting signal A146, gain A156, and IF gain setting signal A154 are selected to meet the more stringent requirements of the 1st transmitter RF section A174. As such, by setting the gains to meet the more stringent requirements of a particular wireless communication protocol, the less stringent performance requirements of other wireless communication protocols will be met.

Figure A4 illustrates a more detailed schematic block diagram of the multimode receiver A12 of the integrated multimode radio A10 of Figure A1. The multimode receiver A12 includes the receiver front-end A16, the 1st IF stage A20, the multiplexor A18, the 2nd IF stage A22, a power detection logic circuit A258 and may further include a 3rd IF stage A246. The receiver front-end A16 includes a low noise amplifier A132 and mixing module A134. The mixing module A134 includes an I mixer A214 and a Q mixer A216.

The low noise amplifier A132 is operably coupled to amplify the RF signal A24 to produce an amplified RF signal A144. The I mixer A214 is operably coupled to mix (i.e., multiply) an I component of the amplified RF signal 144 with an I oscillation A220. The I oscillation A220 is representative of an I component of a local oscillation. The frequency of the local oscillation will be dependent upon the desired intermediate frequency. For example, if the frequency of the RF signal A24 is 2.402 GHz and the desired intermediate frequency is 2 MHz, the frequency of the local oscillation will be 2.400 GHz. Alternatively, if the RF signal A24 has a frequency of 2.400 GHz and the desired IF is 0, or baseband, the local oscillation will have a frequency of 2.400 GHz.

The Q mixer A216 mixes (e.g., multiples) a Q component of the amplified RF signal A144 and a Q oscillation A222 of a local oscillator. The outputs of Q mixer A216 and I mixer A214 are provided to the multiplexor A18. Note that, in general, the local oscillation selected for the I and Q oscillations A220 and A222 are based on the selection signal A34, which is indicative at the particular mode of operation.

The multiplexor A18 outputs the IF signal A26 to one of the IF stages A20, A22 or A246. If the multimode receiver A12 is supporting only two modes of operation, the 3rd IF stage A246 may be omitted. For example, the multimode receiver A12 may support only Bluetooth and 802.11b. Alternatively, if the multimode receiver A12 supports three different modes, for example 802.11a, 802.11b and Bluetooth, the 3rd IF stage A246 will be included.

The 1st IF stage A20 includes the 1st filter module A136, the 1st amplifying module A138, a DC feedback circuit A228, an analog to digital converter A230, and a demodulator A232. The 1st filtering module A136 and 1st amplifying module A138 perform as previously discussed with reference to Figure A3. The DC feedback circuit A228 is operably coupled to remove a DC component from the output of the 1st amplifying module A138. The DC offset may result from the local oscillation coupling into the receiver section, which is then self mixed. As mentioned with reference to Figure A3, the gains set within the low noise amplifier A132, the 1st filtering module A136 and the 1st amplifying module A138 are determined based on meeting the performance requirements of the more stringent wireless communication specification.

To determine the particular gains to be used, the power detection logic A258 determines the power level of the IF signal A24 to produce a gain adjustment signal A260. Accordingly, the gains of the low noise amplifier A132, the 1st filtering module A136 and the 1st amplifying module A138 are set in accordance with the gain adjustment signal A260. As one of average skill in the art will appreciate, the power level of the RF signal may be determined by monitoring the output of the 1st amplifier module A138 to determine the magnitude of the signals. Based on the magnitude of the signal and the known operating parameters of the 1st IF stage A20, the power level of the RF signal may be readily determined.

The analog to digital converter A230 receives the 1st IF signal A160 (i.e., the output of the 1st amplifying module A138) and converts it into a digital signal. The demodulator A232 receives the digital signal and demodulates it to produce recaptured data A234. The demodulator A232 utilizes a demodulation scheme in accordance with the particular function supported by the 1st IF stage A20. For example, if the 1st IF stage A20 corresponds to 802.11b, the demodulator A232 performs an 8-bit CCK demodulation.

The 2nd IF stage A22 includes the 2nd filter module A140, the 2nd amplifying module A142, a DC feedback circuit A238, an analog to digital converter A240 and a demodulator A242. The functionality of the 2nd filtering module A140 and 2nd amplifying module A142 are as previously discussed in Figure A3. The DC feedback circuit A238 performs a similar function as DC feedback circuit A238 to remove DC offset that may be present in the IF signal.

The analog to digital converter A240 receives the 2nd IF signal A164 (i.e., the output of the 2nd amplifying module A142) and converts it into a digital signal. The demodulator A242 demodulates the digital signal to recapture data A234. The particular demodulation scheme is dependent on the wireless communication standard supported by the 2nd IF stage A22.

The 3rd IF stage A246 includes a 3rd filtering module A248, a 3rd amplifying module A250, a DC feedback circuit A252, an analog to digital converter A254, and a demodulator A258. The functionality of the 3rd IF stage A246 is comparable to the functionality of the 1st and 2nd IF stages. The 3rd amplifying module A250 produces a 3rd IF signal that is converted to a digital signal by the analog to digital converter A254. The demodulator A256 demodulates the digital signal to recapture data A234 based on the demodulation scheme of the wireless communication specification supported by the 3rd IF stage A246.

Figure A5 illustrates a more detailed schematic block diagram of multimode transmitterA14. In this illustration, the multimode transmitterA14 includes the transmitter front-end A42, multiplexor A40, the 1st IF stage A36, the 2nd IF stage A38 and may further include a 3rd IF stage A304. The three IF stages A36, A38 and A304 are operably coupled to receive data A294. Depending on the particular mode of operation of the multimode transmitter, one of the IF stages will be activated. For example, in a two mode transmitter, the 1st IF stage A36 may correspond to 802.11b, the 2nd IF stage A38 may correspond to Bluetooth. If the multimode transmitterA14 is further to process 802.11a data, the 3rd IF stage may be in accordance with 802.11a. In each of the IF stages, the data A294 is modulated via modulator A292, A302 or A312. The particular type of modulation performed is dependent upon the particular operational mode supported by the particular IF stage. For example, if the 1st IF stage A36 is supporting 802.11b the modulation scheme used by modulator A292 may be 8-bit CCK.

The modulated signal in each of the IF stages A36, A38 and A304, is converted to an analog signal by the digital to analog converter A290, A300 or A310. The corresponding analog signal is then filtered by the 1st filtering moduleA178, the 2nd filtering moduleA182 or the 3rd filtering module A308. The filtered signal is then amplified either by the 1st amplifying moduleA180, the 2nd amplifying moduleA184 or the 3rd amplifying module A306. The functionality of the 1st and 2nd amplifying modules and filtering modules are as previously discussed with reference to Figure A3. The 3rd amplifying module A306 and the 3rd filtering module A308 will perform in a similar fashion as the amplifying and filtering modules of the 1st and 2nd IF stages A36 and A38 but in accordance with the particular mode of operation that it supports.

The multiplexor A40 provides the IF signal from the 1st, 2nd or 3rd IF stages A36, A38 or A304 to the transmitter front-end A42 based on the selection signal A34. The transmitter front-end A42 includes the power amplifierA188 and the mixing moduleA186. The mixing moduleA186 includes an I mixer A274, a Q mixer A276, and a summation module A278. The I mixer A274 mixes and I component A280 of the selected IF signal with an I component of a local oscillator. The Q mixer A276 mixes a Q component of the selected IF signal with a Q component A282 of the local oscillator. The outputs of the I and Q mixers A274 and A276 are summed together via by summation module A278. The resulting up-converted RF signal A284 is an amplified via power amplifierA188 to produce the outbound RF signal A52.

Figure A6 illustrates a more detailed schematic block diagram of the multimode receiver A62 of the integrated multimode radio A60 of Figure A2. The multimode receiver A62 includes the receiver front-end A66, the 1st multiplexor A68, the receiver low pass filter A70, the receiver band-pass filter A72, the 2nd multiplexor A74, the receiver amplifying module A76, an analog to digital converter A334 and a demodulator A338. The receiver front-end A66 includes a low noise amplifier A320 and a mixing module A322. The mixing module A322 includes an I mixer A324 and a Q mixer A326.

The low noise amplifier A320 amplifies the RF signal A24 to produce an amplified RF signal A332. The I mixer A324 mixes an I component of the amplified RF signal A332 with an I component A328 of a local oscillator. The resulting I component of the mixed signal is provided to the 1st multiplexor A68. The Q mixer A326 mixes a Q component A330 of the local oscillation with a Q component of the amplified RF signal A332. The resulting mixed Q component is provided to the 1st multiplexor A68.

Based on the selection signal A34, the 1st multiplexor A68 outputs the I and Q components to either the received low pass filter A70 or the received band-pass filter A72. For example, if the mode of operation is in accordance with 802.11b, the 1st multiplexor A68 would provide the I and Q components to the low pass filter A70. If, however, the mode of operation is Bluetooth, the 1st multiplexor A68 would provide the I and Q components to the band-pass filter A72.

The 2nd multiplexor A74 outputs either the low pass filtered I and Q signals A78 and A80 or the band-pass filtered I and Q signals A82 and A84 to the receiver amplifying module A76 based on the mode of operation. As one of average skill in the art will appreciate, the gain set within the amplifying module A76 and the gain of the low noise amplifier A320 are set in accordance with the more stringent performance requirements of the multiple wireless communication protocol supported by the multimode receiver A62 and the power level of the RF signal. For example, if multimode receiver A62 is supporting 802.11b and Bluetooth, the more stringent performance requirements are in accordance with 802.11b. As such, the gain set within the low noise amplifier A320 and within the receiving amplifying module A76 will be in accordance with the performance requirements of 802.11b. The determination of the gains for these devices will be in accordance with the gain adjustment signals A260 previously described with reference to Figure A4.

The I and Q components A86 outputted by the receiver amplifying module A76 are converted to digital signals via analog to digital converter A334. The digital I and Q signals are demodulated by demodulator A338 to produce recaptured data A234. As one of average skill in the art will appreciate, the demodulator A338 demodulates the data in accordance with the particular mode of operation.

Figure A7 illustrates a more detailed schematic block diagram of multimode transmitter A64 that was illustrated in the integrated multimode radio A60 of Figure A2. The multimode transmitter A64 includes the front-end A98, multiplexor A96, low pass filter A90, band-pass filter A92, multiplexor A90, amplifying module A88, two digital to analog converters A342 and A344 and a modulator A340.

Depending on the particular mode of operation, the modulator A340 modulates data A346 to produce a digital I signal and a digital Q signal. For example, if the mode of operation is Bluetooth, the modulator A340 modulates the data in accordance with FSK. The digital to analog converters A342 and A344 convert the digital I and Q signals into the I and Q components of input signalA100. The performance of amplifying module A88, multiplexor A90, band-pass filter A92, low pass filter A90 and multiplexor A96 are as previously discussed with reference to Figure A2.

The front-end A98 includes a power amplifier A272 and mixing module A270. The mixing module includes an I mixer A274, a Q mixer A276 and a summation module A278. The I mixer A274 mixes an I component of the selected IF signal with an I component A280 of the local oscillator. The Q mixer A276 mixes a Q component of the selected IF signal with a Q component A282 of the local oscillation. The resulting mixed signals are summed together by summation module A278 to produce an up-converted signal that is a representative RF signal A284. The power amplifier A272 amplifies the representative RF signal A284 to produce an outbound RF signal A52. Note that the I and Q components of the local oscillators A280 and A282 are based on the particular mode of operation.

Figure A8 illustrates a schematic block diagram of an integrated multimode radio A350. The radio A350 includes the multimode receiverA12, the multimode transmitterA14 and a local oscillator A352. The multimode receiverA12 includes the shared front-endA16, a $1^{st}$ IF stage A20, and the $2^{nd}$ IF stage A22. The multimode transmitterA14 includes the $1^{st}$ transmitter IF stage A36, the $2^{nd}$ transmitter IF stage A38, multiplexor A40 and the shared transmitter front-end A42. The local oscillator section A352 produces the I and Q components A220 and A222 that are used within the shared front-endA16 of multimode receiver A12 and the I and Q components A280 and A282 that are used within the shared front-end within the multimode transmitter A14. As one of average skill in the art will appreciate, the local oscillation used for the receiver may be the same or a different local oscillation than is used for the transmitter.

The implementation of the integrated multimode radio A350 includes low pass filters (LPF), programmable gain amplifiers (PGA), DC offset cancellation circuitry in the receive paths, fixed and/or variable gain buffers in the transmitter path and multiplexor circuits within the receive and transmit paths. The variable low noise amplifiers (LNA) and down converter mixers in the receive path are shared for both IF stages. The up-converter mixers in the transmit path and the variable power amplifier are shared for both IF stages A36 and A38.

In operation, the receiver path receives a radio frequency signal via an external antenna and is amplified by a high performance low noise amplifier. The amplified signal is then down-converted by the receiver mixer either to an intermediate frequency (IF) for Bluetooth operation or directly to base-band (zero IF) for 802.11b operation. For Bluetooth operations, the IF signal is filtered via the band-pass filters (BPF) to reject noise and interference and then through a differentiator that extracts the frequency signal. The peak detector and slicer finish the frequency demodulation signal extraction.

For 802.11b applications, the base-band signal from the down-converter mixer is passed through the low pass filters (LPF) to reject noise and interference out of the signal band. The filtered signals are then amplified by programmable gain amplifiers (PGA) before being buffered through the base-band digitization and processing circuits, which are either integrated on the same chip or off chip on another base-band chip. The DC cancellation circuits (e.g., amplifiers and resistors) are used to cancel DC offset that results from direct conversion to base-band.

In the transmitter path for Bluetooth operation, the modulated signal from the digital demodulator goes through low pass filters to band limit the signal to a useful signal bandwidth. The signal is then buffered by a fixed or variable gain buffer prior to reaching the multiplexor A40. The signal is then up-converted by the transmit mixer to a desired radio frequency, which is then amplified by the power amplifier.

SECTION B

Figure B 1 illustrates a schematic block diagram of an integrated radio B10 that may be implemented on an integrated circuit. The integrated radio B10 includes a radio frequency receiver section B12, a radio frequency transmitter section B14, an oscillation module B16, and a local oscillator B19. The RF receiver section B12 is operably coupled to convert an inbound radio frequency signal B34 into an inbound IF signal B36. For example, the RF receiver section B12 may be converting an RF signal B34 into an inbound IF signal B36 in accordance with the Bluetooth specification, IEEE 802.11a specification, IEEE802.11b, code division multiple access (CDMA), analog mobile phone service (AMPS), digital amps, global system for mobile (GSM), wireless application protocol (WAP) and/or any other wireless communication standard. Note that the RF receiver section B12 may include multiple receivers each operable to convert the RF signal into an IF signal B36 in accordance with a particular one of the previously mentioned wireless communication standards.

The RF transmitter section B14 is operably coupled to convert an outbound IF signal B38 into an outbound RF signal B40. Such a conversion is dependent on the particular wireless communication standard being implemented by the integrated radio B10. As previously mentioned, the wireless communication specification may be Bluetooth, IEEE 802.11a, IEEE802.11b, et cetera. Accordingly, the outbound IF signal B38 would be produced in accordance with one of the specifications and up-converted to the RF transmitter section B14 in accordance with the particular standard. As one of average skill in the art will appreciate, the RF transmitter section B14 may include multiple transmitter sections for implementing multiple wireless communication standards.

The oscillation module B16 may include a crystal oscillator that produces a B10 to 20 MHz reference frequency B28. The oscillation module B16 may also include a sine-wave generator to produce the reference frequency B28. As one of average skill in the art will appreciate, the oscillation module B16 is a device that produces a sinusoidal reference frequency B28.

The local oscillator B19 includes a fractional-N synthesizer B18, a divider module B21, and a summing module B23. The fractional-N synthesizer B18 includes a forward path B20 and a configurable path B22. The configurable path B22 includes a 1st feedback path B24 and a 2nd feedback path B26. The forward path B20, which will be described in greater detail with reference to Figure B2, compares the reference frequency B28 with the feedback reference frequency B30 to produce an output frequency B25. The divider module B21 divides the output frequency B25 to produce a divided frequency. The summing module B23 sums the output frequency with the divided frequency to produce a clock signal B32, i.e., a local oscillation. In one embodiment, the output frequency is 2/3 of the frequency of the clock signal B32 and the divider module B21 is a divide by 2 module. As such, the divided frequency is 1/3 of the frequency of the clock signal B32. Thus, when the output frequency and divided frequency are summed together, the clock signal B32 is produced. The clock signal B32 is provided to both the RF receiver section B12 and the RF transmitter section B14. For example, for a Bluetooth application, which requires a local oscillation (i.e., clock signal B32), of 2400 MHz to 2484 MHz, the output frequency B25 will range from 1600 MHz to 1654.66 MHz.

The configurable feedback path B22, based on a divider value B42, produces the feedback reference frequency B30. In many applications, the divider value B42 will be a whole number that includes an integer portion and a fractional portion. When the fractional portion is very small or very large (e.g., the divider value B42 includes a fractional portion of 0.03 or less or includes a fractional portion of 0.97 or greater, i.e., is very close to an integer value) the 2nd feedback path B26 will be utilized. When the divider value B42 is not substantially close to an integer value (e.g., the fractional portion is in the range of 0.03 to 0.97) the 1st feedback path B24 will be utilized. As will be discussed in greater detail with reference to Figures B2 through B10, the 1st feedback path B24 includes a fixed divider and a selectable divider to produce the feedback reference frequency B30 directly from the divider value B42.

The 2nd feedback path B26 includes a configurable divider section, which allows components of the divider value B42 to be modified to include a fractional portion that is within an acceptable range of fractional values. The resulting feedback reference frequency B30 is the same whether the 1st feedback path B24 or the 2nd feedback path B26 is utilized. However, the divider components of the 2nd feedback path B26 are different than the divider components of the 1st feedback path B24, which allows the divider value to be modified such that the fractional spurs that result when the fraction portion of the divider value is very large or very small are substantially avoided.

Figure B2 illustrates a schematic block diagram of the fractional-N synthesizer B18, which includes the forward path B20 and the configurable path B22. The forward path B20 includes a phase/frequency detector B50, a charge pump B52, a low pass filter B54 and a controlled oscillator B56, which may be a voltage controlled oscillator or current controlled oscillator. The components of the forward path B20 function in a similar manner to those in a phase locked loop. As such, the phase/frequency detector B50 receives the reference frequency B20 and the feedback reference frequency B30 and produces a difference signal B58 therefrom. The difference signal B58 indicates a phase and/or frequency difference between the reference frequency B28 and the feedback reference frequency B30. The charge pump B52 converts the difference signal B58 into either a charge-up signal B60 or a charge-down signal B62. The low pass filter B54 filters the charge-up signal B60 or the charge-down signal B62 to produce a filtered signal B64. The controlled oscillator B56 generates the output frequency B25 based on the filtered signal B64.

The configurable feedback path B22 generates the feedback reference frequency B30 from the output frequency B25. The configurable feedback path B22 includes the 1st feedback path B24, the 2nd feedback path B26, a multiplexor B74, control module B72, Sigma Delta modulator B70, summing module B68, and a selectable divider B66. The 1st feedback path B24 includes a fixed divider B76. The 2nd feedback path B26 includes a 2nd selectable divider B26, a Q mixer B84, an I mixer B80, and a summing module B82.

The control module B72 is operably coupled to receive and/or determine the divider value B42 based on the reference frequency B28, the output frequency B25, the divider value of the fixed divider B76, and/or the selectable divider value of the 2nd selectable divider B78. When the fractional component of divider value B42 is with the range of fractional values (e.g., between 0.03 and 0.97), the control module B72 generates select signal B94 and provides the fractional value B86 to Sigma Delta modulator B70 and the integer value of the divider value to summing module B68. In addition, the control module B72 provides a select signal to multiplexor B74, which selects the output of the 1st feedback path B24. When the fractional component of divider value B42 is not with the range of fractional values (e.g., outside of 0.03 to 0.97), the control module B72 generates select signal B90 and B94 and provides a modified fractional value B88 to Sigma Delta modulator B70 and the integer value of the modified divider value to summing module B68. In addition, the control module B72 provides a select signal to multiplexor B74, which selects the output of the 2$^{nd}$ feedback path B26.

As an example of the functionality of the configurable feedback path, assume that the reference frequency B28 is a 20 MHz signal and the desired output frequency B25 is 1654.66 MHz. As such, to achieve a 1654.66 MHz output frequency from a 20 MHz reference frequency B28, a divider value of 82.733 is needed. Further assume that the fixed divider B76 provides a divide by 2. As such, the needed divider value B42 is 82.733/2 = 41.367. In this instance, the control module B72 interprets the divider value B42 (e.g., 41.367) to determine whether it is substantially equal to an integer value. The control module B72 analyzes the fraction of the portion of the divider value to determine whether it is less than 0.03 or greater than 0.97. For this particular example, the fractional value is 0.367, which is within the range of acceptable values. Recall that if the divider value B42 is substantially equal to an integer value (i.e., the fractional value is 0.03 or less or is 0.97 or greater), the modulation produced by the Sigma Delta modulator B70 is relatively small, which can cause fractional spurs in the output frequency B25.

For this example, the control module B72 determines that the divider value B42 of 41.367 is substantially different from an integer value. As such, the control module B72 enables multiplexor B74 to output the feedback from the 1$^{st}$ feedback path B24. As shown, the 1$^{st}$ feedback path B24 includes the fixed divider B76, which, for this example is a divided by 2 divider. As such, the multiplexor B74 outputs, as a partial feedback frequency B100, the output of fixed divider B76. In addition, the control module B72 provides the fractional value B86 (e. g., 0.367) to the Sigma Delta modulator B82 and the integer value B92 of the divider value B42 (e.g., 41) to the summing module B68.

The Sigma Delta modulator B70 produces a modulation, or reference digital signal B96, that is a bit stream of zeros and ones, which, over time, averages to the fractional value B86 (for this example, 0.367). The summing module B68 sums the reference digital signal B96 with the integer value B92 to produce a 1$^{st}$ divider select signal B98. The selectable divider B66, which may have a divider range from divide by 32 to divide by B127, receives the 1$^{st}$ divider select signal B98. Based on the 1$^{st}$ divider select signal B98, the particular divider value of the selectable divider B66 is chosen. Since the divider value needed for selectable divider B66 includes a fractional portion, the selectable divider B66 will toggle between two divider values. For example, with the fixed divider B76 providing a divide by 2, the selectable divider B66 needs to produce a divide by 41.367 to achieve the desired divide by 82.733. As such, the 1$^{st}$ divider selects signal B98 will cause the selectable divider B66 to toggle between divide by 41 and divide by 42 such that the average divider produced by selectable divider B66 is 41.367.

As an alternate example, assume that the frequency of the reference frequency B28 is 19.999 MHz and the desired output frequency B25 is 1600 MHz. To achieve this, the configurable feedback path B20 needs to divide the output frequency by 80.004. The control module B72 interprets the divider value B42 if the first path were used, which for this example is 40.002 (assuming the fixed divider is a divide by 2 divider), and determines that it is too close to an integer value. As such, the control module B72 will generate select signal B90 and enables the multiplexor B74 to output, as the partial feedback frequency B100, the output of the 2$^{nd}$ feedback path B26. The control module B72 selects one of a variety of divider values within the 2$^{nd}$ selectable divider B78 via the select signal B90. For example, the select signal B90 may cause the 2$^{nd}$ selectable divider B78 to function as a divide by 4, divide by 5, or divide by 6 divider.

The control module B72 selects the divide by value to insure that the modified divider value B42 includes a fractional value within the desired range (e.g., 0.03 - 0.97). In this example, if divide by 4 is selected, the divider value is 20.001 (e.g., 80.004/4). As such, the divide by 4 does not provide a desirable fractional portion, thus it is not chosen. If the divide by 5 is selected, the divider value B42 is 16.0008 (80.004/5). As such, the divide by 5 does not provide a desirable fractional portion, thus it is not chosen. If the divide by 6 is selected, the divider value is 13.334 (e.g., 80.004/6). This selection provides an acceptable fractional value. Accordingly, the select signal causes the 2$^{nd}$ selectable divider to function as a divide by 6 divider. Note that if the reference clock B28 produces a 20 MHz clock and the desired output frequency is 1600 MHz, the overall divider is B80. In this instance, the sigma delta modulator B70 could be disabled, such that the 1$^{st}$ feedback path B24 is configured to provide the divide by B80 value.

With the divider value selected for example of 19.999 MHz reference clock, the 2$^{nd}$ selectable divider B78 divides the Q component B104 and the I component B106 of the output frequency, which may be produced by the fixed divider B76, to generate a reference I frequency B108 and a reference Q frequency B106. The frequency of the reference I and reference Q will be, for this example, 1/6$^{th}$ of the frequency of the I and Q components B102 and B104 of the output frequency. The I mixer B80 mixes the reference I frequency B108 with the I component B102 of the output of fixed divider B76. The Q mixer B84 mixes the reference Q frequency B106 with the Q component B104. The summing module B82 sums the outputs of the I mixer B80 and Q mixer B84 to produce the partial feedback frequency B100. In this instance, the partial feedback frequency B100 represents a divide by 6 representation of the output frequency B25.

As such, the selectable divider B66 needs to produce a 13.334 divisor to achieve the desired divide by 80.004.

To produce the divide by 13.334 value, the control module B72 provides a modified fractional value B88 (e.g., 0.334) to the Sigma Delta modulator B70 and the integer value of 13 to the summing module B68. The Sigma Delta modulator B70 produces the reference signal B96 from the modified fraction value B88. The summing module sums the reference digital signal B96 and the integer value of the modified divider value to produce the 1st divider select signal B98. Based on this input, the selectable divider B66 produces a divider value of 13.334. As such, utilizing the 2nd feedback path B26 and modifying the divider values provided to the Sigma Delta modulator B70, the selectable divider B66 outputs the feedback reference frequency B30 without the potential of producing fractional spurs as would have been the case if the 1st feedback path B24 had been used for this particular example.

Figure B3 illustrates a schematic block diagram of an alternate fractional-N synthesizer B18. The fractional-N synthesizer B18 includes the forward path, which operates as previously discussed with reference to Figure B2, and the configurable feedback path B22. In this example, the configurable feedback path B22 includes the control module B72, multiplexor B74, selectable divider B66, summing module B68 and Sigma Delta modulator B70. These components function as previously described with reference to Figure B2. The 1st feedback path B24 includes the fixed divider B76, which also functions as previously described with reference to Figure B2. The 2nd feedback path B26 includes a quadrature module B110, the 2nd selectable divider B78, the Q mixer B84, the summing module B82 and the I mixer B80.

The quadrature module B110 is operably coupled to receive the output frequency B25 and produce an I component B102 and a Q component B104 of the output frequency. At this point, the functionality of the 2nd feedback path B26 is as previously discussed with reference to Figure B2.

Figure B4 illustrates a schematic block diagram of another fractional-N synthesizer B18 and includes the forward path B20 and the configurable feedback path B22. The forward path B20 functions as previously described with reference to Figure B2. The configurable feedback path includes the fixed divider B76, multiplexor B74, control module B72, Sigma Delta modulator B70, summing module B68 and selectable divider B66. These components function as previously described with reference to Figure B2.

The 2nd feedback path B26 includes the quadrature module B110, the selectable divider B78, the I mixer B80, summing module B82 and Q mixer B84. The quadrature module B110 is operably coupled to produce an I component B102 and a Q component B104 of output frequency B25. The selectable divider B78 is operably coupled to divide, or multiple, the reference frequency B28 to produce the reference I frequency B108 and reference Q frequency B106. The I mixer B80 and Q mixer B84 sums the I and Q components of the quadrature module B110 with the reference I and Q frequencies B106 and B108, which are then summed via summing module B82.

Figure B5 illustrates a schematic block diagram of yet another fractional-N synthesizer B120 that includes a processing module B122 and memory B124. The processing module B122 may be a single processing device or a plurality of processing devices. Such a processing device may be a microprocessor, microcomputer, microcontroller, digital signal processor, programmable gate array, programmable logic device, central processing unit, state machine, logic circuitry and/or any device that manipulates signals (analog and/or digital) based on operational instructions. The memory B124 may be a single memory device or a plurality of memory devices. Such a memory device may be read-only memory, random access memory, volatile memory, non-volatile memory, dynamic memory, static memory, flash memory, and/or any device that stores digital information. Note that when the processing module B122 implements one or more of its functions via a state machine or logic circuitry, the memory storing the corresponding operational instruction is embedded within the circuitry comprising the state machine or logic circuitry. The operational instructions stored in memory B124 and executed by processing module B122 are generally illustrated with reference to Figures B6 through B10.

Figure B6 illustrates a logic diagram of a method for fractional-N synthesis. The process begins at Step B130 where a 1st feedback frequency is generated from an output frequency based on a fixed divider value, a fractional value of a divider value and an integer value of the divider value. The divider value and the fixed divider value indicate a ratio between a reference frequency and the output frequency. The process then proceeds to Step B132 where a 2nd feedback frequency is generated from the output frequency based on a selectable divider value, a modified fractional value of the divider value and a modified integer value of the divider value.

The process then proceeds to Step B134 where a determination is made as to whether the fractional value of the divider value is within a range of fractional values. Such a determination indicates whether the divider value is substantially equal to an integer value, which would cause the fractional-N synthesizer to produce fractional spurs. For example, when the divider value is substantially equal to an integer, it includes a fractional value that is outside the range of fractional values that would not cause fractional spurs.

If the fractional value is within the range of fractional values (i.e., would not cause fractional spurs), the process proceeds to Step B136 where the 1st feedback frequency is utilized to produce the output frequency. If, however, the fractional value is not within the range of fractional values (i.e., would produce fractional spurs), the process proceeds to Step B138 where the 2nd feedback frequency is used to produce the output frequency. As such, the 2nd feedback frequency is produced utilizing a selected divider value and a modified divider value, which has a fractional portion that is within the range of fractional values. As such, the 2nd feedback frequency produces the desired feedback frequency using a modified divider value to avoid the generation of fractional spurs.

Figure B7 illustrates a logic diagram for generating the 1st feedback frequency. The process begins at Step B140 where a 1st partial feedback frequency is generated by dividing the output frequency by a fixed divider value. The process then proceeds to Step B142 where the fractional value of the divider value is Sigma Delta modulated to produce a digital reference signal. The process then proceeds to Step B144 where the digital reference signal is summed with the integer value to produce a divider signal. The process then proceeds to Step B146 where the 1st partial feedback frequency is divided in accordance with the divider signal to produce the 1st feedback frequency from the output frequency. Such a process was graphically illustrated and described with reference to Figure B2.

Figure B8 illustrates a logic diagram for generating the 2nd feedback frequency. The process begins at Step B150 where the output frequency is divided by a fixed integer value to produce an I component and a Q component of the output frequency. The process then proceeds to Step B152 where the I and Q components of the output frequency are divided by a selectable divider value to produce a reference I frequency and a reference Q frequency. The process then proceeds to Step B154 where the reference I frequency is mixed with the I component of the output frequency to produce a 1st mixed frequency.

The process then proceeds to Step B156 where the reference Q frequency is mixed with the Q component of the output frequency to produce a 2nd mixed frequency. The process then proceeds to Step B158 where the 1st and 2nd mixed frequencies are summed to produce a partial feedback frequency. The process then proceeds to Step B160 where the partial feedback frequency is divided based on a divider signal to produce the 2nd feedback frequency from the output frequency. The divider signal may be generated by Sigma Delta modulating the modified fractional value to produce a digital reference signal. The digital reference signal may then be summed with the modified integer value of the modified divider value to produce the divider signal. The modified fractional value and the modified integer value may be determined based on the selected divider. This was previously illustrated and described with reference to Figure B2.

Figure B9 illustrates a logic diagram of an alternate method for generating the 2nd feedback frequency. The process begins at Step B170 where the reference frequency is divided by a fixed integer value to produce an I component and a Q component of the reference frequency. The process then proceeds to Step B172 where the output frequency is divided by a 2nd fixed integer value to produce an I component and a Q component of the output frequency. The process then proceeds to Step B174 where the I component of the output frequency is mixed with the I component of the reference frequency to produce a 1st mixed frequency.

The process then proceeds to Step B176 where the Q component of the output frequency is mixed with the Q component of the reference frequency to produce a 2nd mixed frequency. The process then proceeds to Step B178 where the 1st and 2nd mixed frequencies are summed to produce a partial feedback frequency. The process then proceeds to Step B180 where the partial feedback frequency is divided based on a divider signal to produce the 2nd feedback signal, which is used to produce the 2nd feedback frequency.

Figure B10 illustrates a logic diagram of an alternate method for fractional-N synthesis. The process begins at Step B190 where a fractional value of a divider value is determined. Note that the divider value represents at least a portion of a ratio between a reference frequency and the desired output frequency. The process then proceeds to Step B192 where a determination is made as to whether the fractional value is outside a range of fractional values. When the fractional value is outside of the range, i.e., the divider value is substantially similar to an integer value, which may cause the fractional-N synthesizer to produce fractional spurs, the process proceeds to step B194. When the fractional value is within the range of fractional values, the fractional-N synthesizer will not generate fractional spurs, the process proceeds to step B202.

At Step B202, the feedback frequency is generated based on a fixed divider value, the fractional value and an integer value of the divider value. This may be done in accordance with the logic diagram illustrated in Figure B7. Having generated the feedback frequency, it is compared with the reference frequency via a forward path, which subsequently produces the output frequency.

At Step B194, a partial divider value is selected. The process then proceeds to Step B196 where a modified fractional value and a modified integer value are determined for the divider value based on the partial divider value. The process then proceeds to Step B198 where a feedback frequency is generated based on the partial divider value, the modified fractional value and the modified integer value. This may be done utilizing the Steps illustrated in Figures B8 or B9. The process then proceeds to Step B200 where the output frequency is generated from the reference frequency and the feedback frequency.

SECTION C

Figure C1 illustrates a schematic block diagram of an integrated radio receiver C10 that includes an RF receiving section C12 and a self-correcting local oscillator C14. The RF receiver section C12 is operably coupled to receive an inbound RF signal C16 and a local oscillation C20. From these inputs, the RF receiver section C12 produces an inbound intermediate frequency (IF) signal C18. For example, the inbound RF signal C16 may be modulated in accordance with the IEEE 802.11a standard such that it has a frequency range of 5.15 gigahertz to 5.35 gigahertz and another range of 5.725 gigahertz to 5.825 gigahertz. Accordingly, the local oscillation C20 will have a frequency range of 5.18 gigahertz to 5.32 gigahertz and 5.745 gigahertz to 5.805 gigahertz. The inbound IF signal C18 will be at base-band. A demodulator, which is not shown, will process the inbound IF signal C18 to retrieve data from the modulated data.

The self-correcting local oscillator C14 includes a frequency synthesizer C22, a divider module C24, a 1st mixing module C28, a 2nd mixing module C30, and an auxiliary frequency control module C26. The frequency synthesizer C22 generates a synthesized frequency C34 from a reference frequency C32. For example, a crystal oscillator may generate the reference frequency C32 to have a frequency in the range of 10 to 20 megahertz. The frequency synthesizer C22 may be a phase locked loop (PLL) that produces the synthesized frequency C34 to be approximately 2/3rds the desired frequency of the local oscillation C20.

In an embodiment, the phase locked loop incorporates a 3rd order mash Delta Sigma modulator to provide fractional divisors that allow for a large range of reference crystal selections and a wide phase locked loop bandwidth for faster loop locking time and better noise suppression. The PLL includes a phase/frequency detector, a charge pump, a low pass filter, voltage controlled oscillator that generates the synthesized frequency C34 and a multi-modulus divider. The multi-modulus divider, which provides the reference frequency to the phase frequency detector, has its inputs determined by the Delta Sigma modulator and a constant factor corresponding to the channel selected for transmission of data.

The multi-modulus divider dynamically changes the divisor value based on the output of the Delta Sigma modulator such that the average output over several reference cycles is the fractional value necessary to generate the correct output frequency. The multi-modulus divider may be implemented using 6 stages of divide by 2/3rds dividers, which provides a divisor range between the values of 64 and 127. Such a divisor range allows for a reference crystal range of 16 megahertz to 24 megahertz to produce the desired synthesized frequency C34 for use in an IEEE 802.11a compliant radio receiver.

The divider module C24 divides the synthesized frequency C34 by a divider value C36. Accordingly, the divider module C24 produces a divided frequency C38. If the synthesized frequency C34 is generated to be 2/3rds of the local oscillation, the divider value C36 will be 2. As such, the divided frequency C38 will be of half the frequency as that of the synthesized frequency C34 and 1/3 of the frequency of the local oscillation.

The auxiliary frequency control module C26 generates an auxiliary frequency C40 in the 100 kilohertz to 300 kilohertz range. The auxiliary frequency control module C26 generates the auxiliary frequency C40 to compensate for frequency spectrum errors within the local oscillator C14 and/or generates the auxiliary frequency based on a fine tuning frequency selection. The fine tuning of the auxiliary frequency C40 allows for the local oscillation C20 to be centered within desired channels of an IEEE 802.11a transmission. The details of the auxiliary frequency control module C26 will be described in greater detail with reference to Figures C3 and C6 through C12.

The 1st mixing module C28 mixes the divided frequency C38 with the auxiliary frequency C40 to produce a corrected frequency C42. If the self-correcting local oscillator C24 is to generate a local oscillation C20 for use in an IEEE802.11a compliant radio receiver, the synthesized frequency will be in the range of 3.45 gigahertz to 3.87 gigahertz. Accordingly, the divided frequency C38 will be 1.72 gigahertz to 1.94 gigahertz. Since the auxiliary frequency C40 is in the range of 100 to a few hundred kilohertz, the corrected frequency C42 is a small fraction greater than the divided frequency C38.

The 2nd mixing module C30 mixes the synthesized frequency C34, which has a frequency that is 2/3rds of the local oscillation, with the corrected frequency C42, which has a frequency of approximately 1/3rd the local oscillation. Thus, when the synthesized frequency C34 is summed with the corrected frequency C42 the local oscillation C20 is produced. By generating the local oscillation C20 from the synthesized frequency and the divided frequency C38, the affects of the local oscillator pulling on the phase locked loop output are substantially reduced.

Figure C2 illustrates a more detail schematic block diagram of the self-correcting local oscillator C14. The local oscillator C14 includes the frequency synthesizer C22, the divider module C24, the auxiliary frequency control module C26, which produces an I component C58 and a Q component C60 of the auxiliary frequency C40, the 1st mixing module C28 and the 2nd mixing module C30. The divider module C24 includes a divide by N module C50 and a phase shift module C52. In this embodiment, the divider module C24 produces an I component C54 and a Q component C56 of the divided frequency C38.

The 1st mixing module C28 includes a 1st mixer C62, a 2nd mixer C64, a 3rd mixer C66, a 4th mixer C68, a 1st summing module C78 and a 2nd summing module C80. The 1st mixer C62 is operably coupled to mix the Q component C56 of the divided frequency C38 with the I component C58 of the auxiliary frequency C40 to produce a 1st mixed frequency C70. The 2nd mixer C64 is operably coupled to mix the Q component C56 of the divided frequency C38 with the Q component C60 of the auxiliary frequency C40 to produce a 2nd mixed frequency C72. The 3rd mixer C66 is operably coupled to mix the I component C54 of the divided frequency C38 with the I component C58 of the auxiliary frequency C40 to produce a 3rd mixed frequency C74. The 4th mixer C68 is operably coupled to mix the I component C54 of the divided frequency C38 with the Q component C60 of the auxiliary frequency C40 to produce a 4th mixed frequency C76.

The 1st summing module C78 is operably coupled to sum the 1st mixed frequency C70 with the 4th mixed frequency C76 to produce a Q component C84 of the corrected frequency C42. The 2nd summing module C80 is operably coupled to sum the 2nd mixed frequency C72 with the 3rd mixed frequency C74 to produce an I component C82 of the corrected frequency C42.

While the 1st mixing module C28 allows for mixing of the auxiliary frequency C40 into the local oscillation C20, it introduces unwanted tones due to the DC offset in the mixers and the phase/gain mismatches of the mixers. The DC offset causes a local oscillation feed through tone at approximately ½ the synthesized frequency and the phase/gain mismatches create an unwanted image tone at ½ the synthesized frequency minus the auxiliary frequency. The auxiliary frequency control module C26, as will be discussed in greater detail with reference to Figures C3 and C6 through C10, minimizes the affects of these unwanted tones to achieve the desired benefits of mixing the auxiliary frequency into the local oscillation. As previously mentioned, by adding the auxiliary frequency into the local oscillation, the local oscillation can be finely tuned with accuracies greater than 0.1%.

The 2nd mixing module C30 includes a 5th mixer C94 and a 6th mixer C96. The 5th mixer C94 is operably coupled to mix the Q component C84 of the corrected frequency C42 with a Q component of the synthesized frequency C34. The resultant is the Q component C86 of the local oscillation C20. The 6th mixer C96 is operably coupled to mix the I component C82 of the corrected frequency C42 with an I component of the synthesized frequency C34 to produce an I component C88 of the local oscillation C20.

Figure C3 illustrates a schematic block diagram of the auxiliary frequency control module C26. The auxiliary frequency control module C26 includes an auxiliary frequency synthesizer C92, a processing module C90, and memory C91. The processing module C90 may be a single processing device or a plurality of processing devices. Such a processing device may be a microcontroller, microcomputer, microprocessor, digital signal processor, field programmable gate array, programmable logic device, state machine, logic circuitry, central processing unit, and/or any device that manipulates signals (analog and/or digital) based on operational instructions. The memory C91 may be a single memory device or a plurality of memory devices. Such a memory device may be a read-only memory, random access memory, volatile memory, non-volatile memory, static memory, dynamic memory, flash memory, and/or any device that stores digital information. Note that when the processing module C92 implements one or more of its functions via a state machine or logic circuitry, the memory storing the corresponding operational instructions is embedded within the circuitry comprising the state machine and/or logic circuit. The processing module C90 implements one or more of the processing steps illustrated in Figures C9 through C12.

In general, the processing module C90 generates a frequency correction signal C93 to correct for the tones introduced by the mixers within the 1st mixing module. In addition, the frequency correction signal C93 may include further information to indicate the particular fine tuning required of the local oscillation C20.

The processing module C90 may also produce an input selection signal C140, which places the radio receiver C10 in a test mode or normal mode. The use of the input selection signal C140 will be described in greater detail with reference to Figures C5 and C6.

The auxiliary frequency synthesizer C92, which may be a phase locked loop, direct digital frequency synthesizer, or any other device that generates a sinusoidal reference signal, produces the I component C58 of the auxiliary frequency C40 and the Q component C60 of the auxiliary frequency C40 based on the frequency correction signal C93.

Figure C4 illustrates an alternate schematic block diagram of the 1st mixing module C28. The 1st mixing module C28 includes a 1st mixer C62, a 2nd mixer C64, and a polyphase filter C100. The 1st mixer C62 is operably coupled to mix an I component of the divided frequency C38 with an I component C58 of the auxiliary frequency C40. The 1st mixing module C62 produces an I component of the mixed frequency C100. The 2nd mixer C64 is operably coupled to mix the divided frequency C38 with a Q component C60 of the auxiliary frequency C40 to produce a Q component C102 of the mixed frequency.

The polyphase filter C100, which includes filtering to reject images produces by the 1st and 2nd mixers, generates the I component C82 of the corrected frequency C42 and the Q component C84 of the corrected frequency C42.

Figure C5 illustrates a schematic block diagram of the radio receiver C10 to include the C4 mixers C62 through C64 of the 1st mixing module C28, the 1st and 2nd summing modules C78 and C80 of the 1st mixing module, the 5th and 6th mixers C94 and C96 of the 2nd mixing module C30, the RF receiver section C12, an input selection switch C136 and an adder C138. The functionality of the 1st and 2nd mixing modules C28 and C30 are as previously discussed to produce the I and Q components C88 and C86 of the local oscillation C20.

The RF receiver section C12 includes a 7th mixer C110, an 8th mixer C112, a high-pass filter C114, a high-pass filter C116, an analog to digital converter C118, and an analog to digital converter C120. The 7th mixer C110 is operably coupled to mix the Q component C86 of the local oscillation C20 with either the output of adder C138 or the inbound RF signal C122. The particular input provided to the 7th mixer C110 is based on the input selection signal C140. For normal operations, the input selection signal C140 causes the input selection switch C136, which may be a physical switch, a logical switch, and/or combination thereof, to couple the input RF signal C122 to the 7th and 8th mixers C110 and C112. During test mode, the input selection signal C140 causes the summed local oscillation C142 to be provided to the 7th and 8th mixers C110 and C112. The test mode will be described in greater detail with reference to Figure C6.

When the inbound RF signal C122 is coupled to the 7th and 8th mixers, the functionality of the RF section C12 produces the digital I base-band signal C134 and digital Q base-band signal C132. In operation, the 7th mixer C110 mixes the Q component of local oscillation C20 with a Q component of the inbound RF signal C122 to produce a Q component of base-band signal C124. The high-pass filter C114 filters the Q component of base-band signal C124 to produce a filtered Q base-band signal C128. The analog to digital converter C118 converts the filtered Q base-band signal C128 into the digital Q base-band signal C132. Similarly, the 8th mixer C112 mixes an I component of local oscillation C20 with an I component of the inbound RF signal C122 to produce an I component of base-band signal C126. The high pass filter C116 filters the I component of the base-band signal C126 to produce a filtered I base-band signal C130. The analog to digital converter C120 converts the filtered I base-band signal C130 into the digital I base-band signal C134.

Figure C6 illustrates the radio receiver C10 being configured for test mode. In this configuration, the processing module C90 generates the input selection signal C140 to couple the output of summing module C138 to the 7th and 8th mixers C110 and C112. As is further illustrated in Figure C6, various signals are identified by letters A through G. The frequency response for each of these signals is illustrated in Figure C7. Accordingly, the discussion with respect to Figure C6 will also include a discussion with respect to Figure C7. In this configuration, the voltage controlled oscillator C152 generates a reference frequency C32, which has a designation of A:$f_{vco}$. Referring to Figure C7, the reference frequency C32 has a frequency response at the frequency of the voltage controlled oscillator. For example, if the radio receiver C10 is constructed to be compliant with IEEE 802.11a, the frequency produced by the voltage control oscillator will be in the range of 3.45 gigahertz to 3.87 gigahertz.

The divide by 2 module C150 receives the reference frequency C32 and produces an I and Q component of a divided frequency. The divided frequency is referenced as B:$f_{vco}/2$. Referring to Figure C7, the divided frequency C38 has a frequency at ½ that of the voltage controlled oscillator.

The auxiliary frequency synthesizer C92 based on the frequency correction signal C93, which will be discussed in greater detail below, produces the auxiliary frequency C40, which is designated as C:$f_{AFC}$. Referring to Figure C7, the frequency response for the auxiliary frequency is shown to have a substantially lower frequency than the divided frequency C38 or the reference frequency C32. For this implementation, the auxiliary frequency will range from a few kilohertz to a few hundred kilohertz.

Summing module C80 produces the corrected frequency C42, which is designated as D:$f_{vco}/2 + f_{AFC}$. As shown in Figure C7, the frequency response of the corrected frequency C42 includes the pulse, which corresponds to the ½ VCO frequency plus the AFC frequency and also shows an image tone C152 and a local oscillation feed-through C150. These tones are generated as a result of mixers C62 through C68 having phase/gain mismatches and DC offset. Since these tones cannot be completely eliminated because they are too close to the desired frequency, one of the functions of the processing module C90 in test mode is to minimize the impact of the tones C150 and C152.

The output of mixers C94 and C96 produce the local oscillation which is designed E:$3f_{vco}/2 + f_{AFC}$. The frequency response of the local oscillation is shown in Figure C7 to include a pulse at the local oscillation which is 1.5 times the voltage controlled oscillation frequency plus the automatic frequency control frequency plus the image tone and feed-through tone C150 and C152.

Mixers C110 and C112 mix the summation of the I and Q components of the local oscillation with the I and Q components of the local oscillation to produce a base-band signal. The base-band signal is designed as F:DC. Referring to the frequency response for point F, the base-band signal C124 and C126 has a pulse at 0 (i.e., at DC), and also includes the reflected images of tones C150 and C152.

The base-band signals C124 and C126 are passed through high-pass filters C114 and C116 and then converted to digital signals via ADC's C118 and C120. The resulting digital signal is designated as G: DC. The frequency response for the digital base-band signal is shown in Figure C7 to include only the two tones, C150 and C152.

The processing module C90 is operably coupled to receive the digital representation of tones C150 and C152 and to produce the frequency correction signal C93 to minimize their magnitude. Accordingly, the auxiliary frequency synthesizer C92 may adjust its frequency based on the frequency correction signal C93 in an iterative manner to determine acceptable levels of the tones and/or the find an optimal frequency at which the tones are minimized.

Figure C8 illustrates a schematic block diagram of an alternate self-correcting local oscillator C160 that includes a processing module C162 and memory C164. The processing module C162 may be a single processing device or a plurality of processing devices. Such a processing device may be a microprocessor, microcontroller, microcomputer, digital signal processor, field programmable gate array, programmable logic device, state machine or logic circuitry, and/or any device that manipulates signals (analog and/or digital) based on operational instructions. The memory C164 may be a single memory device or a plurality of memory devices. Such a memory device may be a read-only memory, random access memory, volatile memory, non-volatile memory, static memory, dynamic memory, flash memory, and/or any device that stores digital information. Note that when the processing module C162 implements one or more of its functions via a state machine or logic circuitry, the memory storing the corresponding operational instructions is embedded within the circuitry comprising the state machine or logic circuitry. The operational instructions stored in memory C164 and executed by processing module C162 are generally illustrated in the logic diagrams of Figures C9 through C12.

Figure C9 illustrates a logic diagram of a method for generating a self-correcting local oscillation. The process begins at Step C170 where a synthesized frequency is generated from a reference frequency. This may be done utilizing a digital phase locked loop that up-converts a reference frequency, which may be produced by a crystal oscillator, to a desired frequency. For example, if the self-correcting local oscillator is to be used within a IEEE 802.11a compliant radio receiver or transmitter, the synthesized frequency would be generated to be 2/3rds of the frequency band indicated by the 802.11a specification.

The process then proceeds to Step C172 where the synthesized frequency is divided by a divider value to produce a divided frequency. For example, the divider value may be 2 such that the divided frequency has a frequency of ½ the synthesized frequency. In addition, the divided frequency may include a phase delay such that an I component and a Q component of the divided frequency are produced. The process then proceeds to Step C174 where an auxiliary frequency is generated to emulate frequency spectrum errors and/or to provide fine tuning of the resulting local oscillation. The generation of the auxiliary frequency will be discussed in greater detail with reference to Figure C10.

The process then proceeds to Step C176 where the auxiliary frequency is mixed with the divided frequency to produce a corrected frequency. This may be done by mixing an I component of the auxiliary frequency with a Q component of the divided frequency to produce a 1st mixed frequency; mixing a Q component of the auxiliary frequency with the Q component of the divided frequency to produce a 2nd mixed frequency; mixing the I component of the auxiliary frequency with the I component of the divided frequency to produce a 3rd mixed frequency; mixing the Q component of the auxiliary frequency with the I component of the divided frequency to produce a 4th mixed frequency; summing the 1st mixed frequency with the 4th mixed frequency to produce an I component of the corrected frequency; and summing the 2nd mixed frequency and the 3rd mixed frequency to produce an I component of the corrected frequency.

As an alternative method for producing the corrected frequency, the divided frequency may be mixed with an I component of the auxiliary frequency to produce an I component of a mixed frequency. The divided frequency may also be mixed with a Q component of the auxiliary frequency to produce a Q component of the mixed frequency. The I and Q components of the mixed frequency may be then filtered by a polyphase filter to produce an I and Q component of the corrected frequency.

The process then proceeds to Step C178 where the corrected frequency is mixed with the synthesized frequency to produce a local oscillation.

Figure C10 illustrates a method for generating the auxiliary frequency to provide fine tuning of the local oscillation. The process begins at Step C180 where an I and Q component of the auxiliary frequency are produced based on a frequency correction signal. The process then proceeds to Step C182 where the frequency of an RF signal is determined. The process then proceeds to Step C184 where the determined RF frequency is compared with the frequency of the local oscillation to produce a difference frequency. The process then proceeds to Step C186 where the frequency correction signal is generated to represent the difference frequency. As such, the auxiliary frequency is set to adjust the local oscillation to substantially equal the reference frequency and/or to center the local oscillation within a channel within the spectrum represented by the received RF signal.

Figure C11 illustrates a method for generating the frequency correction signal during test mode. The process begins at Step C190 where the I and Q components of the local oscillation are summed to produce a summed local oscillation. The process then proceeds to Step C192 where the summed local oscillation is mixed with the I component of the local oscillation to produce a 1st test frequency. The process then proceeds to Step C194 where the summed local oscillation is mixed with the Q component of the local oscillation to produce a 2nd test frequency.

The process then proceeds to Step C196 where a 1st error of frequency component that represents a DC offset within the self-correcting local oscillator is determined based on the 1st and 2nd test frequencies. The process then proceeds to Step C198 where a

2nd error component frequency representing an image tone of the self-correcting local oscillator is determined based on the 1st and 2nd test frequencies. The process then proceeds to Step C200 where the frequency correction signal is generated to minimize the 1st and 2nd error frequencies. This was graphically illustrated with reference to Figures C6 and C7.

SECTION D

Figure D1 illustrates a schematic block diagram of a radio receiver D10 that may be implemented in an integrated circuit as a stand-alone device or as part of an integrated radio. The radio receiver D10 includes a low noise amplifier D12, a down conversion module D14, a signal conditioning module D16, and an FSK demodulator D18. The low noise amplifier D12 is operably coupled to receive an RF signal D26 that is modulated in accordance with an FSK modulation scheme. Such an RF signal D26 may be transmitted and subsequently received in accordance with the Bluetooth standard or other wireless communication standard. The low noise amplifier D12 amplifies the RF signal D26 to produce an amplified RF signal D28.

The down conversion module D14 converts the amplified RF signal D28 into an intermediate frequency signal D30. The intermediate frequency signal D30 may have a frequency of approximately 2 MHz. The signal conditioning module D16 receives the intermediate frequency signal D30 and produces a quadrature (Q) component D34 and in-phase (I) component D36 of an FSK input signal D32. The functioning of the signal conditioning module D16 will be described in greater detail with reference to Figure D2.

The FSK demodulator D18 includes a signaling module D20, delta frequency module D22, and a demodulation module D24. The signaling module D20 is operably coupled to receive the Q component D34 and I component D36 of the FSK input signal D32. From these signals, the signaling module D20 generates a charge signal D38, a data acquisition signal D40, and a reset signal D42. The operation of the signaling module D20 will be described in greater detail with reference to Figures D2, D4 and D6 through D10.

The delta frequency module D22 receives the charge signal D38, data acquisition signal D40 and reset signal D42 and produces therefrom a delta frequency signal D44, which is a time based representation of the frequency difference used to indicate a logic 1 or a logic 0. The demodulation module D24 receives the delta frequency signal D44 and produces a stream of data D46 therefrom.

In an embodiment, the FSK demodulator D18 interprets the pulse duration of the FSK input signal D32, on a pulse-by-pulse basis to produce the charge signal D38, data acquisition signal D40, and reset signal D42. Accordingly, these signals D38, D40, and D42 are generated on a pulse-by-pulse basis. By monitoring the duration of pulses (e.g., by monitoring charging of a capacitor within the delta frequency module D22 in accordance with the charge signal and acquiring the particular voltage imposed on the capacitor in accordance with the data acquisition signal D40), the pulse duration of the FSK input signal D32 may be obtained. Since time is inversely proportional to frequency (i.e.,? T is proportional to ? f for small ?), the frequency difference of the FSK input signal D32 may be determined thus allowing the stream of data D46 to be recovered. For instance, f = 1/T ? $f_1$ - $f_2$ = $1/T_1$ - $1/T_2$ = $(T_2 - T_1)/(T_1 T_2)$, where ? f = - ? $t/T^2$ for $T_1$ ~ $T_2$ = T.

Figure D2 illustrates a schematic block diagram of the signal conditioning module D16 and the FSK demodulator D18. The signal conditioning module D16 includes a band-pass filter D50 and an amplitude limiting module D52. The band-pass filter D50 filters the intermediate frequency signal D30 to pass only the frequencies of interest (e.g., in the 2 MHz range) to the amplitude limiting module D52. The amplitude limiting module D52 limits the amplitude of the band-pass filtered signal D72 thus creating a more square-wave type signal to represent the FSK input signal D32.

The signaling module D20 includes a logic module D54, data acquisition module D56, and reset module D58. The delta frequency module D22 includes a capacitor D60, a charge circuit D62, a sample and hold circuit D64, and a discharge circuit D66. The demodulation module D24 includes a low pass filter D68, and a data extraction module D70. The data extraction module D70 includes a data threshold module D73, and a comparator D75.

The logic module D54 performs an exclusive OR function on the I component D36 and Q component D34 of the FSK input signal D32 to produce the charge signal D38. The data acquisition module D56 receives the charge signal D38 and produces therefrom the data acquisition signal D40. Essentially, the data acquisition module D56 produces a pulse of a fixed duration that triggers after the falling edge of the charge signal with some desired delay. The reset module D58 receives the data acquisition signal D40 and produces a reset signal D42 therefrom. The reset signal is subsequent in time to the data acquisition signal D40. As such, the reset module D58 is a pulse generator that produces a particular pulse subsequent to the data acquisition pulse D40.

The capacitor D60 is charged via the charge circuit D62, which may be a current source, when the charge signal D38 is active (e.g., high). Once the charge signal D38 is deactive (e.g., low) and the data acquisition signal D40 is activate, the sample and hold circuit D64 samples the voltage impressed across capacitor D60. On a pulse-by-pulse basis the sample and hold circuit D60 samples the capacitor voltage to produce the delta frequency signal D44. Once the voltage of the capacitor has been sampled, the reset signal D42 enables the discharge circuit D66 to dissipate the energy of the capacitor D60, such the capacitor voltage is reset to a reference voltage. At this point, the next pulse triggers the charge signal D38 to again charge the capacitor D60 via charge circuit D62.

The low pass filter D68 filters the delta frequency signal D44 to produce a filtered signal D74. The filtered signal D74 is provided to the data threshold module D73 and comparator D75. The data threshold module D73 generates a data threshold signal D77, which is provided to comparator D75. The comparator generates the stream of data D46 by comparing the filtered signal D74 with the threshold signal D77.

Figure D3 illustrates an alternate FSK demodulator D18 operably coupled to the signal conditioning module D16. The signaling module D20 includes the logic module D54, reset module D58, and data acquisition module D56 that function as previously described with reference to Figure D2. The delta frequency modulator D22 includes a counter D80 and a register D82. The counter is clocked via clock D84 at a rate that is much greater than the rate of the FSK input signal D32. The counter D80 counts cycles of clock D84 for the duration of the charge signal D38. The data acquisition signal D40 causes the count for the current charge signal D38 to be read into register D82. The reset signal D42 resets counter D80 such that for the next pulse of charge signal D38, the counter restarts at a predetermined starting value.

The demodulation module D24 includes a comparator D86 and a data interpreter D87. The comparator D86 compares the value stored in register D82 with a high count threshold D88 and a low count threshold D90. The output either indicates that the particular count for a given charge signal is substantially equal to the high threshold or the low threshold. The data interpreter D87 receives the output of the comparator D86 to interpret a sequence of comparator D86 outputs to produce the stream of data D46. In essence, the data interpreter, utilizing the count of counter D80, determines the duration of the pulses, which can then be readily used to determine the frequency difference that represents the logic 1 or logic 0 of the modulated data.

Figure D4 illustrates a timing diagram of the FSK demodulation performed by the FSK demodulator of Figure D2. As shown, the I component D36 and Q component D34 are phased shifted by 90 degrees. As further shown, the first cycle of the I component D36 and Q component D34 represents the intermediate frequency plus a delta frequency (IF + $dF$), which may be a modulated representation of a logic 0, and the second pulse shown represents the intermediate frequency less the delta frequency (IF - $dF$), which may be a modulated representation of a logic 1. As one of average skill in the art will appreciate, the IF + $d$F may alternatively represent a logic 1 and the IF - $d$F may alternatively represent a logic 0.

The charge signal D38 represents an exclusive ORing of the I component D36 and the Q component D34. The data acquisition signal D40 is triggered on the trailing edge of the charge signal D38 and may include some delay from the falling edge of the charge signal D38. In addition, the data acquisition signal D40 may be of a fixed duration. The reset signal D42 is triggered on the falling edge of the data acquisition signal D40 or may be triggered with some delay from the falling edge of charge signal D38. The duration of the reset signal D42 is such that the voltage impressed across the capacitor is back at Vref before the next charge signal D38 is initiated.

The capacitor D60 voltage is shown to charge to a first level when the pulse duration corresponds to pulses of the intermediate frequency less the delta frequency and to a larger value when the pulses of the I and Q components D34 and D36 correspond to the intermediate frequency plus the delta frequency. Filtering the capacitor voltage D60 produces filtered signal D74, which, when compared with threshold D77, produces the stream of data D46. Note that the stream of data D46 is produced at the bit rate of the data.

Figure D5 illustrates a schematic block diagram of an FSK demodulator D100 that includes a processing module D102 and memory D104. The processing module D102 may be a single processing device or a plurality of processing devices. Such a processing device may be a microprocessor, microcontroller, microcomputer, digital signal processor, central processing unit, field programmable gate array, programmable logic device, state machine, logic circuitry, and/or any device that manipulates signals (analog and/or digital) based on operational instructions. The memory D104 may be a single memory device or a plurality of memory devices. Such a memory device may be a read-only memory, random access memory, volatile memory, non-volatile memory, static memory, dynamic memory, flash memory, and/or any device that stores digital information. Note that when the processing module D102 implements one or more of its functions via a state machine or logic circuitry, the memory storing the corresponding operational instructions is embedded within the circuitry comprising the state machine and/or logic circuit. The operational instructions stored in memory D104 and executed by processing module D102 are generally described with reference to Figures D6 through D10.

Figure D6 illustrates a logic diagram of a method for FSK demodulation. The process begins at Step D110 where a charge signal, data acquisition signal and a reset signal are generated from an I component and a Q component of an FSK modulated input signal. The generation of the charge signal may be done by exclusive ORing the I component and the Q component. The generation of the data acquisition signal will be described in greater detail with reference to Figure D7 and the generation of the reset signal will be described in greater detail with reference to Figure D8.

The process then proceeds to Step D112 where a delta frequency signal is generated based on the charge signal, the data acquisition signal, and the reset signal. The process then proceeds to Step D114 where the delta frequency signal is demodulated to recapture a stream of data. The processing of Steps D112 and D114 are described in greater detail with reference to Figures D9 and D10.

Figure D7 illustrates a logic diagram for generating the data acquisition signal. The process begins at Step D116 where the charge signal is inverted to produce an inverted signal. The process then proceeds to Step D118 where the inverted signal is delayed to produce a delay signal. The process then proceeds to Step D120 where the delayed signal is truncated to produce the data acquisition signal. This was graphically illustrated in Figure D4.

Figure D8 illustrates a logic diagram for generating the reset signal. The process begins at Step D122 where the delayed signal, which was produced at Step D118 of Figure D7, is inverted to produce the reset inverted signal. The process then proceeds to Step D124 where the reset inverted signal is delayed to produce a reset delayed signal. The process then proceeds to Step D126 where the delayed signal and the reset delayed signal are combined to produce the reset signal. The resulting reset signal in relation to the data acquisition signal was graphically illustrated in Figure D4.

Figure D9 illustrates a logic diagram for a more detailed processing of Steps D112 and D114 of Figure D6. The process begins at Step D128 where a capacitor is charged during the charge signal. The process then proceeds to Step D130 where a voltage on the capacitor is sampled and held in accordance with the data acquisition signal to produce a delta frequency signal. The process then proceeds to Step D132 where the voltage on the capacitor is reset to a reference voltage in accordance with the reset signal. The process then proceeds to Step D134 where the delta frequency signal is low pass filtered to produce a filtered signal. The process then proceeds to Step D136 where the filtered signal is interpreted to produce the stream of data. The interpreting of the filtered signal may be done by generating a data threshold signal from the filtered signal and comparing the filtered signal with the data threshold at a bit rate clock to produce the stream of data.

Figure D10 illustrates a logic diagram of an alternate method for processing steps D112 and D114 of Figure D6. The process begins at Step D138 where cycles of a reference clock are counted during the duration of the charge signal to produce a count. The count is reset in accordance with the reset signal. Note that the reference clock has a much higher rate than the rate of the FSK modulated input signal.

The process then proceeds to Step D140 where the count is stored in accordance with the data acquisition signal. The process then proceeds to Step D142 where the count is compared with a high-count threshold and a low-count threshold at a data bit rate to produce the stream of data. The comparison may further include an interpretation of the resulting comparisons to produce a stream of data.

SECTION E

Figure E1 illustrates a schematic block diagram of a radio receiver E10 that includes a low noise amplifier E12, an intermediate frequency (IF) mixing module E14, and a digital demodulator E16. The digital demodulator E16 includes a mixing section E18, a 1st digital comb filter E20, a 2nd digital comb filter E22, a phase locked loop module E24 and a data recovery module E26. The low noise amplifier E12 is operably coupled to receive a radio frequency (RF) signal E28. The RF signal E28 may be representative of a wireless communication that utilizes a particular wireless standard such as Bluetooth, IEEE 802.11a, IEEE 802.11b, et cetera. The low noise amplifier E12 amplifies the RF signal E28 to produce an amplified RF signal E30.

The IF mixing module E14, which will be described in greater detail with reference to Figure E5, mixes the amplified RF signal E30 with a local oscillation E32 to produce a digital IF signal E34. For example, if the RF signal E28 is in accordance with the Bluetooth standard, the carrier frequency is approximately 2.402 GHz. If the local oscillation E32 is 2.400 GHz, the resulting frequency of the digital IF signal E34 is 2 MHz. The digital IF signal E34 includes an I component and a Q component, where the I component represents the in-phase portion of the digital IF signal and the Q component represents the quadrature portion of the digital IF signal E34.

The mixing section E18, which will be described in greater detail with reference to Figure E6, receives the digital IF signal E34 and produces a digital Q signal E36 and a digital I signal E38, both of which are at base-band. Accordingly, the mixing section E18 includes a local oscillation, which down converts the frequency of the digital IF signal E34 to base-band.

The digital comb filter E20 filters the digital I signal E38 to produce a filtered I signal E42. The digital comb filter E22 filters the digital Q signal E36 to produce a filtered Q signal E40. The 1st and 2nd digital comb filters E20 and E22 are designed using a plurality of delays and corresponding taps to provide a frequency response that has notches at the frequencies which substantially correspond to frequencies of interfering channels of the RF signal. For example, if the RF signal E28 is in accordance with the Bluetooth standard, the interfering channels will be at 1 MHz increments from the frequency of the desired channel. Accordingly, the digital comb filters E20 and E22 are constructed such that the notches of the frequency response correspond to the 1 MHz increments. By utilizing such digital comb filters to provide a low pass filter function, less circuitry is required to implement the low pass filter.

The phase locked loop (PLL) module E24 receives the filtered I signal E42 and the filtered Q signal E40 and produces therefrom a digital signal E44. The phase locked loop module E24, which will be discussed in greater detail with reference to Figure E6, generally performs a frequency to amplitude conversion on the I and Q signals E40 and E42. As such, the digital signal E44 is an amplitude representation of the frequencies corresponding to the filtered I signal E42 and filtered Q signal E40. As is known, if the modulation scheme is frequency shift keying, a 0 is represented by a first carrier frequency and a logic 1 is represented by a second carrier frequency. For example, Bluetooth utilizes 2.402 GHz minus 160 KHz for a logic 0 and 2.402 GHz plus 160 KHz for a logic 1.

The data recovery module E26, which will be described in greater detail with reference to Figure E6, receives the digital signal E44 and recaptures a data stream E46 therefrom. The data recovery module E26, when needed, performs a DC offset of the digital signal and then interprets the resulting waveform to recapture the data that comprises the data stream E46.

Figure E2 illustrates a schematic block diagram of a radio receiver E50 that includes the low noise amplifier E12, the IF mixing module E14, and a digital demodulator E52. The low noise amplifier E12 and IF mixing module E14 function as previously described with reference to Figure E1.

The digital demodulator E52 includes a mixing section E19, the phase locked loop module E24, and a data recovery module E54. The data recovery module E54 includes a DC offset module E56 and a data exhaction module E58. The mixing section E19, which will be described in greater detail with reference to Figure E6, receives the digital IF signal E30 and produces baseband digital Q signal E37 and base-band digital I signal E39. The phase locked loop module E24 receives the digital Q signal E37 and digital I signal E39 and produces the digital signal E44.

The DC offset module E56 receives the digital signal E44 and determines a DC offset E60 therefrom. The DC offset module E56 utilizes a 1st criteria to determine the DC offset when the radio receiver is in an acquisition mode and uses a 2nd criteria to determine the DC offset when the radio receiver is in the tracking mode. Having determined the DC offset E60, the DC offset module E56 removes the DC offset E60 from the digital signal E44 to produce a DC adjusted digital signal E62. As one of average skill in the art will appreciate, the DC offset E60 is a result of the difference in local oscillator frequencies utilized in the transmitter section of a transmitting radio and the local oscillation E32 of radio receiver E50 in the receiving radio. As one of average skill in the art will further appreciate, if the DC offset is not properly accounted for, the ability to accurately extract data from the digital signal is severely impacted. As such, the DC offset E60 needs to be accurately and reliably determined to ensure the accurate extraction of data.

The data extraction module E58 samples the DC adjusted digital signal E62 at a sampling rate to produce samples of the signal. The samples are then interpreted to produce data that comprises the data stream E46. The functionality of the DC offset module and data extraction module will be discussed in greater detail with reference to Figures E9 through E22.

Figure E3 illustrates a schematic block diagram of radio receiver E70 that includes the low noise amplifier E12, the IF mixing module E14, and a digital demodulator E72. The functionality of the low noise amplifier E12 and IF mixing module E14 are as previously discussed with reference to Figure E1.

The digital demodulator E72 includes the mixing section E19, a phase locked loop E25, a low pass filter/equalizer E74 and the data recovery module E26. The mixing section E19, which functions as previously described with reference to Figure E2, produces a base-band digital Q signal E37 and a base-band digital I signal E39. The phase locked loop E25 receives the digital I and digital Q signals E37 and E39 and performs a frequency to amplitude conversion thereon to produce digital signal E44.

The low pass filter/equalizer E74, which will be discussed in greater detail with reference to Figures E7 and E8, includes a combined equalizing and low pass filtering function. The low pass filter/equalizer E74 equalizes and low pass the digital signal E44 to produce an equalized and filtered digital signal E82.

The data recovery module E26, which functions as previously described with reference to Figure E1 receives the filtered digital signal E82 and produces therefrom a data stream E46.

Figure E4 illustrates a schematic block diagram of radio receiver E90 that includes the low noise amplifier E12, an IF mixing module E102, a polyphase filter E104, a limiting module E110, an analog to digital converter E112 and a digital demodulator E92. The digital demodulator E92 includes a mixing section E95, the phase locked loop module E24, and the data recovery module E26.

The low noise amplifier E12 receives the RF signal E28 and produces therefrom the amplified RF signal E30. The IF mixing module E102 mixes the amplified RF signal E30 and the local oscillation E32 to produce an IF Q signal E106 and an I IF signal E104. The IF mixing module E102 may include a pair of mixers to mix the quadrature component of amplified RF signal E30 with the quadrature component of local oscillation E32 to produce the IF Q signal E106. In addition, the IF mixing module E102 may include another mixer that mixes the in-phase component of the amplified RF signal E30 with the in-phase component of the local oscillation E32 to produce IF I signal E104.

The polyphase filter E108 is operably coupled to receive the IF Q signal E106 and the IF I signal E104. The polyphase filter performs a band-pass function that filters the images produced by the IF mixing module such that only the desired tones remain for the filtered I signal E104 and filtered Q signal E116.

Since the polyphase filter E108 rejects the images, only the filtered I signal E114 is utilized to extract the data stream E46. To do this, the limiting module E110 limits the magnitude of the filtered I signal E114 to produce a limited I signal E118. In essence, the limiting module E110 is taking a sinusoidal waveform (i.e., the filtered I signal E114) and producing a square wave representation thereof (i.e., the limited I signal E118).

The analog to digital converter E112 receives the limited I signal E118 and produces a digital I signal E120 therefrom. The analog to digital converter E112 may be a continuous time Sigma Delta analog to digital converter that is of a $2^{nd}$ order and has a quantizing frequency of 24 MHz. In addition, the digital I signal E120 may be a 2-bit value that is provided to the digital demodulator E92.

The mixing section E95 of digital demodulator E92 receives the digital I signal E120 and mixes it with a reference Q signal E96 and a reference I signal E94 to produce a digital base-band Q signal E98 and a digital base-band I signal E100. The reference I and Q signals E94, E96 may be provided by a local oscillator. The phase locked loop module E24 receives the digital base-band Q signal E98 and digital base-band I signal E100 and produces therefrom the digital signal E44. The data recovery module E26 interprets the digital signal E44 to produce the data stream E46.

Figure E5 illustrates a schematic block diagram of the IF mixing module E14 of the radio receivers illustrated in Figures E1 through E3. The IF mixing module E14 includes an image rejection mixer that includes an I mixer E132, a Q mixer E134, a band-pass filter E140, a limiter E142, and an analog to digital converter E144.

In operation, the amplified RF signal E30 (e.g., a cos($?_{RF}$t)) is received by the IF mixing module E14. The amplified RF signal E30 is mixed with a Q local oscillation E148 (e.g., cos($?_{IF}$t)) via Q mixer E134 to produce an IF Q signal E152. The amplified RF signal is also passed through a minus 90 degree phase shift module E130 to produce a phase shifted RF signal (e.g., sin ($?_{RF}$t)). The phase shifted RF signal is mixed with an I local oscillation E146 (e.g., sin ($?_{IF}$t)) via mixer E132 to produce IF I signal E150.

The band pass filter E140 filters the IF I signal E150 and IF Q signal E152 to substantially eliminate image tones and other undesired tones to produce a filtered IF signal E156. Note that the band pass filter E140 may only filter one of the IF I signal E150 and the IF Q signal E152 if the filter E150 is a poly-phase filter. The limiter E142 receives the filtered IF signal E156, which may include an I component and/or a Q component, and limits the amplitude to produce a limited IF signal E158, which will include an I component and/or a Q component. In essence, the limiter E142 is converting the sinusoidal waveform of the filtered IF signal E156 into a square wave signal (i.e., the limited IF signal E158). The analog to digital converter E144 converts the limited IF signal E158 into the digital IF signal E34.

Figure E6 illustrates a schematic block diagram of a digital demodulator E16, E52, E72, and/or E92. The demodulator includes mixing section E19 or E95, the phase locked loop module E24 and the data recovery module E26 or E54. The mixing section E19 or E95 includes mixing section E18, low pass filter E166 and low pass filter E168. The low pass filters E166 and E168 may be implemented utilizing a comb filter wherein the notches of the comb filter are set at frequencies corresponding to undesired tones and/or channels of the received RF signal E28.

The mixing section includes a direct digital frequency synthesizer E160, a $1^{st}$ mixing module E162 and a $2^{nd}$ mixing module E164. The direct digital frequency synthesizer (DDFS) produces a local oscillation having an in-phase component (e.g., cos $?_0$t) and a quadrature local oscillation (e.g., -sin $?_0$t). Accordingly, mixer E162 mixes the in-phase local oscillation with the in-phase component of the digital IF signal E34 or the digital I signal E120 to produce a base-band I signal. The mixer E164 mixes the quadrature local oscillation produced by DDFS E160 with the digital IF signal E34 or the digital I signal E120 to produce a quadrature component to produce a base-band Q signal.

The low pass filters E166 and E168 filter the corresponding I and Q signals, which are then provided to the phase locked loop module E24. As one of average skill in the art will appreciate, the mixing section E18 may be implemented utilizing a state machine that is operably coupled to frequency shift, by a factor of N and phase shift by a factor of (p/2) the digital IF signal to produce the I signal and to frequency shift, by the factor of N and phase shift by (- p) the digital IF signal to produce the digital Q signal.

The phase locked loop module E24 includes the phase locked loop E25, a tapped delay line E172, and the low pass filter/equalizer E74. The phase locked loop E25 receives the filtered I and Q signals from the mixing section E19 or E95 and performs a frequency to amplitude conversion thereon. The resulting signal is provided to the tapped delay line E172, which, based on a delay select signal E178, outputs the signal from the phase locked loop E25 with a desired delay. The delaying of the output of the phase locked loop E25 will be discussed in greater detail with reference to Figures E17 through E22. In general, the delaying of the output of the phase locked loop E25 is used to better align the signal with the data extraction module to enhance the reliability of data extraction.

The data recovery module E26 or E54 includes a processing module E174 and memory E176. The processing module E174 may be a single processing device or a plurality of processing devices. Such a processing device may be a microprocessor, micro-controller, digital signal processor, microcomputer, central processing unit, field programmable gate array, programmable logic device, state machine, logic circuitry, and/or any device that manipulates signals (analog and/or digital) based on operational instructions. The memory E176 may be a single memory device or a plurality of memory devices. Such a memory device may be a read-only memory, random access memory, volatile memory, non-volatile memory, static memory, dynamic memory, flash memory, and/or any device that stores digital information. Note that when the processing module E174 implements one or more of its functions via a state machine or logic circuitry, the memory storing the corresponding operational instructions is embedded with the circuitry comprising the state machine or logic circuitry. The memory E176 stores and the processing module E174 executes at least some of the operational instructions described in with reference to Figures E9 through E22.

The data recovery module E26 or E54 implements the DC offset module E56 and data extraction module E58 to accurately recapture the data stream E46. The general functionality of the DC offset module E56 and data extraction module E58 were previously discussed with reference to Figure E2 and will be described in greater detail with reference to Figures E9 - E22.

Figure E7 illustrates a schematic block diagram of the low pass filter/equalizer E74. The low pass filter/equalizer E74 includes digital logic circuitry, summing module, a 1st comb filter E180, and a 2nd comb filter E182. The 1st comb filter E180 is a 12-tap filter that provides notches at 1 MHz intervals while the 2nd comb filter E182 is an 8-tap filter that provides notches at 1.5 MHz intervals. The frequency step-down converter E184 steps down the frequency of the filtered signal by a factor of 2.

Figure E8 illustrates a graphical representation of the frequency response of the low pass filter/equalizer E74 of Figure E7. The equalizer E76 provides an equalized response E186, which provides gain in the frequency range from 0 to 1 MHz. The comb filter E78 provides the low pass filtering response E188. The 1st comb filter E180 provides the notches at 1, 2, 3, 4, 5 and 6 MHz. The 2nd comb filter E182 provides the notches at 1.5, 3, 4.5, and 6 MHz. As such, by positioning the notches of comb filters E180 and E182 at frequencies of undesired channels and images, a simple comb filter may be utilized in place of a high order low pass filter to obtain the same desired low pass filter response. As such, a digital demodulator that utilizes comb filters in this manner as opposed to high order low pass filters is less complex, thus requires less integrated circuit real estate and is less costly.

Figure E9 illustrates a logic diagram of a method for digital demodulation in accordance with the present invention. The processing begins at Step E190 where a digital signal is received. The digital signal is representative of a received RF signal that has been amplified, frequency down converted, comb filtered, and frequency to amplitude converted. For example, the received RF signal is amplified to produce an amplified RF signal. The amplified RF signal is then mixed with a local oscillation to produce a digital IF signal. The digital IF signal is then mixed with a synthesized frequency to produce a digital baseband Q signal and a digital baseband I signal. The digital baseband Q signal and digital baseband I signal are then comb filtered and processed by a phase locked loop to produce the digital signal.

Alternatively, the digital signal may be produced by amplifying an RF signal and then mixing the amplified RF signal with a local oscillation to produce a digital IF signal. The digital IF signal is then mixed with a reference I signal and a reference Q signal to produce a digital baseband I signal and a digital baseband Q signal. The digital baseband I signal and digital baseband Q signal are processed by a phase locked loop to produce a digital base-band signal. The digital base-band signal may be equalized and then comb filtered to produce the digital signal.

The process then proceeds to Step E192 where a DC offset is determined utilizing a 1st criteria when a radio receiver is in an acquisition mode and using a 2nd criteria when the radio receiver is in a tracking mode. The determination of the DC offset will be described in greater detail with reference to Figures E10 through E18.

The process then proceeds to Step E194 where the DC offset is substantially removed from the digital signal to produce a DC adjusted digital signal. The process then proceeds to Step E196 where the DC adjusted digital signal is sampled at a sampling rate to produce a data stream. The sampling of the DC adjusted digital signal will be described in greater detail with reference to Figures E19 through E22.

Figure E10 illustrates a Bluetooth packet E200 that includes a preamble E201, a synchronization word E202, a trailer word E203, and data E204. The Bluetooth packet E200 is modulated in accordance with an FSK modulation scheme and correspondingly demodulated via the radio receiver of the present invention. As shown, the preamble E201 (e.g., first 4 bits), the synchronization word E202 (e.g., next 64 bits), and the trailer word E203 (e.g., next 3 bits), correspond to the acquisition mode for a Bluetooth packet E200. The tracking mode includes the data section E204 and ends at the end of the packet E200.

Since the acquisition mode is relatively short, the 1st criteria for determining the DC offset must occur very quickly to obtain a good estimation for the DC offset. During the tracking mode, which includes the data E204, the DC offset is fine tuned utilizing the 2nd criteria. As such, the 1st criteria allows for rapid adjustments in the DC offset while the 2nd criteria allows for less dramatic changes in the DC offset.

Figure E11 illustrates a graphical representation of the beginning of Bluetooth packet E200 as the digital signal E44, which is outputted from the PLL module E24. Prior to the reception of the packet, noise E206 is being received. At the commencement of the packet, which corresponds to packet data E208, the DC offset E210 is determined with respect to a zero DC level E212 and a zero reference E211. The zero reference E211 corresponds to a midpoint of the dynamic range of the digital demodulator while the zero DC level E212 corresponds to the midpoint of the data. The DC offset is the difference between the zero reference E211 and the zero DC level E212. In general, to remove the DC offset, the zero DC level E212 needs to be shifted to align with the zero reference E211. The determination of the DC offset and correcting the digital signal to remove the DC offset is further described with reference to Figures E12 through E18.

Figure E12 illustrates a logic diagram for determining the DC offset. The process begins at Step E220 where a peak value of the digital signal is determined based on a current peak value, a previous peak value and the 1st or 2nd criteria. Such a determination will be described in greater detail with reference to Figures E13, E17 and E18.

The process then proceeds to Step E224 where a valley value of the digital signal is determined based on a current valley value, a previous valley value, and the 1st or 2nd criteria. This processing will be described in greater detail with reference to Figures E14, E17 and E18.

The process then proceeds to Step E226 where the DC offset is determined based on the peak value and the valley value. Typically, the DC offset represents the difference between the zero reference E211 (Figure E11) and the center point of the peak value and the valley value.

Figure E13 illustrates a logic diagram for determining the peak value. The process begins at Step E228 where a determination is made as to whether the radio receiver is in the acquisition mode or tracking mode. If the radio receiver is in the acquisition mode, the process proceeds to Step E232 where a determination is made as to whether the magnitude of the current peak value is greater than the magnitude of the previous peak value. If so, the process proceeds to Step E234 where the current peak value is stored as the peak value. Thus, in the acquisition mode (e.g., using the 1st criteria) on a peak-by-peak basis, if the current peak is greater than the previous peak, the current peak value will be used as the peak value. The process then reverts to step E228.

If the magnitude of the current peak value is not greater than the magnitude of the previous peak value, the process proceeds to Step E230. At Step E230, the peak value is determined as a result of the previous peak value less a peak acquisition delta value multiplied by a difference of the current peak value and the previous peak value, wherein the 1st criteria indicates a greater value for the peak acquisition delta value than the 2nd

criteria. In general, if the magnitude of the current peak value is not greater than the magnitude of the previous peak value, the peak value will be exponentially decreased based on the difference between the current peak value and the previous peak value. In general, the determination of the peak value may be done in accordance with the equation: $PV(n) = PV(n-1) +/- [dP*abs(PV(c)-PV(n-1)]$, wherein $PV(n)$ is the peak value, $PV(n-1)$ is the previous peak value, $dP$ is the peak acquisition delta value, and $PV(c)$ is the current peak value

If the radio receiver is in the tracking mode, the peak value is determined as described at Step E229. At Step E229, the peak value is not instantaneously adjusted from peak-to-peak but exponentially changed at a much slower rate than when in acquisition mode. This may be done by using the equation $PV(n) = PV(n-1) +/- dP$, wherein $PV(n)$ is the peak value, $PV(n-1)$ is the previous peak value and $dP$ is the peak acquisition delta value. Based on this equation, if the current peak value is greater than the peak value, the dP term is added to the peak value. If the current peak value is less than the peak value, the dP term is subtracted from the peak value.

Figure E14 illustrates a logic diagram for determining the valley value. The process begins at Step E236 where a determination is made as to whether the radio receiver is in acquisition mode or tracking mode. When in acquisition mode, the process proceeds to Step E240 where a determination as to whether the absolute value of the magnitude of the current valley is greater than the absolute value of the magnitude of the previous valley. If so, the process proceeds to Step E242 where the current valley value is stored as the valley value. As such, from valley to valley if the magnitude of the current valley is greater than the magnitude of the previous valley in acquisition mode, the current valley will be used as the valley value to determine the DC offset. The process then reverts to step E236.

If the magnitude of the current valley value is not greater than the magnitude of the previous valley value, the process proceeds to Step E238. At Step E238, the valley value is determined based on the 1st criteria during the acquisition mode, which utilizes a greater exponential determination decrementing of the valley value from the previous valley value to the current valley value. For example, the degradation may be ½. As such, if the previous valley value was 1 and the current valley value is 0.5, the valley value that will be used is 0.75. In general for acquisition mode, the valley value is determined in accordance with the equation $VV(n) = VV(n-1) +/-[dV*abs(VV(c)-VV(n-1)]$, wherein $VV(n)$ is the valley value, $VV(n-1)$ is the previous valley value, $dV$ is the valley acquisition delta value, and $VV(c)$ is the current valley value. Based on this equation, if the current valley value is greater than the valley value, the $[dV*abs(VV(c)-VV(n-1)]$ is added to the absolute value of the magnitude of the valley value. If the current valley value is less than the valley value, the $[dV*abs(VV(c)$

-VV(n-1)] is subtracted from the absolute value of the magnitude of the valley value.

If the radio receiver is in the tracking mode, the valley value will be determined at Step E237. In this mode, the valley value will be adjusted based on an exponential change factor. The exponential change factor will be significantly smaller than when in the acquisition mode. For example, if the change factor for the acquisition mode is 0.5, the change factor in the tracking mode may be 0.05. In general, the valley value is determined in accordance with the equation $VV(n) = VV(n-1) +/-dV$, wherein $VV(n)$ is the valley value, $VV(n-1)$ is the previous valley value, and $dV$ is the valley acquisition delta value. Based on this equation, if the current valley value is greater than the valley value, the $dV$ term is added to the absolute value of the magnitude of the valley value. If the current valley value is less than the valley value, the $dV$ term is subtracted from the absolute value of the magnitude of the valley value.

Figure E15 illustrates a logic diagram for detecting false peaks and false valleys. The detection of a false peak is described in Steps E250-256. The detection of false valleys is described in Steps E258-264. At Step E250, a potential peak valley of the digital signal is detected. The process then proceeds to Step E252 where the magnitude of the potential peak is determined. The process then proceeds to Step E254 where a difference between the magnitude of the potential peak and the magnitude of a valley value is determined. The process then proceeds to Step E256 where, when the difference is less than a predetermined value, the potential peak is identified as a false peak.

At Step E258, a potential valley of the digital signal is detected. The process then proceeds to Step E260 where the magnitude of the potential valley is determined. The process then proceeds to Step E262 where a difference between the magnitude of the potential valley and the magnitude of the peak valley is determined. The process then proceeds to Step E264 where, when the difference is less than a predetermined value, the potential valley is identified as a false valley.

Figure E16 illustrates a logic diagram of a method for detecting peaks and valleys. The process begins at Step E266 where a gradient of the digital signal is determined. The process then proceeds to Step E268 of Step E272. At Step E268 a determination is made as to when the gradient changes from a positive to a negative. The process then proceeds to Step E270 where the digital signal is indicated as being at a peak when the gradient changes from positive to negative.

At Step E272 a determination is made as to when the gradient changes from negative to positive. The process then proceeds to Step E274 where the digital signal is indicated as being at a valley when the gradient changes from positive to negative. As one of average skill in the art will appreciate, the determination of gradient of a digital signal utilizing digital logic may be done by a differential function that may be easily implemented utilizing delay modules to achieve the desired differentiation. As such, only the sign of the derivative function needs to be analyzed to determine whether a peak or valley is being identified.

Figure E17 illustrates a graphical representation of determining the peak value E280 and the valley value E282 during the acquisition mode. As shown, the packet data E208 varies from multiple levels to other levels. In this illustration, the gradient on the 1st pulse of packet data E208 changes from a positive slope to a negative slope thus indicating a peak. Since this is the 1st peak during the acquisition mode, this value is stored as peak value E280. The gradient of the packet data E208 is continually monitored until it changes from a negative value to a positive value. This value is then used as the valley value E208. At this point in time, the DC offset may be determined as the midway point between the peak value E280 and the valley value E282.

At the next peak, since the peak is greater than the previous peak, the peak value E280 is adjusted to the magnitude of the current peak. Following the waveform, the next valley of packet data E208 is less than the previous valley value. As such, the valley value E282 is reduced based on a valley acquisition delta value of the difference between the previous valley value and the current valley value. In this example, the delta value is 50%.

Continuing with the waveform, the next peak has a magnitude that is less than the previous peak. As such, the peak value E280 is adjusted down by the peak acquisition delta value, which, for this example, is ½ of the difference between the current peak value and the previous peak value for this example.

The waveform then proceeds to the next valley point, which has a greater magnitude than the valley value E282 at that point. As such, the valley value E282 is adjusted to correspond to the magnitude of the current valley.

The next peak includes a false valley value E284. As shown, the gradient detection identifies a peak at the beginning of the pulse, which would cause the peak value E280 to be adjusted to that level since it is greater than the peak value at this point. The gradient detection circuitry would then identify the point, which has been identified as a false valley value E284, as being the next current valley value. Since the difference between the value of the potential next current valley value and the peak value E280 falls below a threshold (which may be set based on the known peak and valley values), this point is identified as a false valley. Similarly, a few pulses further in time, a false peak value E286 is identified during a valley pulse.

Figure E18 illustrates the data packet E208 during the tracking mode. The processing is very similar to the processing described with reference to Figure E17 other than the peak value and valley values E280 and E282, respectively, change at a much slower rate and independently of the magnitude of difference between the current value and the stored value. As shown, the peak value E280 and valley value E282 do not rapidly adjust as the peak and valley values of current pulses change. This results because the 2nd criteria for determining these values has a valley acquisition delta value and peak acquisition delta value that are significantly less than during the acquisition mode.

Figure E19 illustrates a logic diagram for the sampling of the DC adjusted signal as generally described at Step E196 of Figure E9. The process begins at Step E290 where the DC adjusted signal is over sampled at the sampling rate. The process then proceeds to Step E292 where alternating ones of the samples are correlated over a plurality of bits that correspond to the synchronization word of the current packet being processed. For example, if the over sampling rate is 6, the alternating sample points of 0, 2, and 4, or 1, 3, 5 of the DC adjusted digital signal may be correlated with the known synchronization word.

The process then proceeds to Step E294 where one of the correlated sample sets is identified as having the best correlation with the synchronization word. For example, each pulse of the DC adjusted digital signal is sampled 6 times. Three of these samples are correlated. The correlated results are then compared with the known synchronization word. The correlated sets of samples that best matches the known synchronization word is the one identified at Step E294.

The process then proceeds to Step E296 where a sampling position of the over sampling of the DC adjusted digital signal is selected based on the identified correlated sampling set. For example, if it is determined that the 2nd over sampling position produces the best correlation with the synchronization word, then the 2nd sampling position will be utilized to sample the digital signal word to accurately retrieve the desired digital information.

The process then proceeds to Step E298 where samples at the selected sample position are utilized to produce the data stream.

Figure E20 illustrates a logic diagram for selecting the particular sampling position. This begins at Step E300 where adjacent sample sets are compared to the identified correlated sample set with respect to a typical waveform of the DC adjusted signal to determine an over sampling relationship of the DC adjusted digital signal. The process then proceeds to Step E302 where the sampling position is selected to be the sampling position that provides the identified correlated sample set when the sampling that produces the identified correlated sampling set occurs at a most favorable point of the over sampling relationship (e.g., sampling point 2). The process then proceeds to Step E304 where the sampling position is selected to be the sampling between the identified correlated sampling set and an adjacent one of the plurality of correlated sampling sets when the sampling between the identified correlated sampling set and an adjacent one correlated sampling sets occurs at a most favorable point of the over sampling relationship (e.g., sample point 3, when sampling points 2 and 4 were correlated). The sampling described in Figures E19 and E20 will be described graphically with reference to Figure E22.

Figure E21 illustrates a logic diagram that adjusts the sampling position via the tapped delay line E172 of the phase locked loop module E24. The process begins at Step E310 where a 1st reference sample is obtained prior to the sampling of the DC adjusted signal. The process then proceeds to Step E312 where a 2nd reference sample is obtained subsequent to the data sampling of the DC adjusted digital signal. The process then proceeds to Step E314 where over a plurality of sampling of the DC adjusted digital signals a difference between the 1st and 2nd reference samples are accumulated to produce an accumulated difference. The process then proceeds to Step E316 where the sampling is adjusted when the accumulated difference overflows an upper threshold or when the accumulated difference underflows a lower threshold.

Figure E22 illustrates a graphical representation of the processing described in Figures E19 through E21. As shown, a data packet E208 is over sampled at 6 times the data rate. Of the 6 over sampling points, only 3 per data rate are used to produce the correlated sample sets. As shown in this example, correlated sample set that occurs with the 0th over sampling, 2nd over sampling, and 4th over sampling are utilized. As such, correlated sample sets 0, 2 and 4 are the sample sets being referenced in Step E292 of Figure E19.

The particular sampling point, which corresponds to one of the 6 over sampling positions, is determined in the 1st pulse based on the known wave shape of the data packet. In essence, the known wave shape of the data packet is a rounded square wave. As such, it will have a particular peak and a particular valley as graphically shown. For the 1st interval, the correlated sample set 2 and correlated sample set 4 will accurately represent the data such that the correlation to the synchronization word may be readily obtained. However, as shown, the peak of the 1st pulse actually occurs more closely in time with the 3rd sampling interval. Thus, as described in Figure E20, the 3rd sampling interval would be selected since based on the known relationship of the data packet, point 3 would occur at a larger magnitude than points 2 or 4, thus providing a better sampling point.

At some point later in time, and for this example as shown as the 3rd data pulse, the 4th sampling set has a magnitude greater than the 2nd or 0th sampling points. As such, as also described in Figure E20 at Step E302, point 4 would be used as the sampling interval since based on the known wave shape of the data packet, the magnitude at point 4 is greater than the magnitude at point 2. Thus, the magnitude at point 4 is most likely the greatest magnitude of the data packet.

The processing described in Figure E21 allows for the over sampling intervals to be time shifted left or right with relationship to the data packet E208 to better position the sampling intervals with the peak of the waveform. The time adjustment may shift the data packet E208, with respect to the over sampling intervals such that the peak either occurs at 2 or 4 or at over sampling point 3. For example, the 1st pulse shown in the waveform of data packet E208 has its peak occurring exactly at the 3rd over sampling point. As such, the timing of the sampling is very good. If, however, the peak of the waveform occurred between sampling intervals 2 and 3, the over sampling rate may be delayed with respect to the packet data E208 such that the peak either occurs at over sampling point 2 or over sampling point 3.

SECTION F

Figure F1A is a system diagram illustrating a cellular system within which the present invention is deployed. The cellular system includes a plurality of base stations F102, F104, F106, F108, F110, and F112 that service wireless communications within respective cells, or sectors. The cellular system services wireless communications for a plurality of wireless subscriber units. These wireless subscriber units include wireless handsets F114, F118, F120, and F126, mobile computers F124 and F128, and desktop computers F116 and F122. During normal operations, each of these subscriber units communicates with one or more base stations during handoff among the base stations F102 through F112. Each of the subscriber units F114 through F128 and base stations F102 through F112 include RF circuitry constructed according to the present invention.

The RF circuitry formed according to the present invention may be formed to operate with any one of a number of different protocols and networks. For example, the network of Figure F1A may be formed to be compatible with Bluetooth wireless technology that allows users to make effortless, wireless and instant connections between various communication devices such as notebook computers, desktop computers and mobile phones. Because Bluetooth systems use radio frequency transmissions to transfer both voice and data, the transmissions occur in real-time.

The Bluetooth specification provides for a sophisticated transmission mode that ensures protection from interference and provides security of the communication signals. According to most designs that implement the Bluetooth specifications, the Bluetooth radio is being built into a small microchip and is designed to operate in frequency bands that are globally available. This ensures communication compatibility on a worldwide basis. Additionally, the Bluetooth specification defines two power levels.

A first power level covers the shorter, personal area within a room and a second power level is designed for covering a medium range. For example, the second power level might be used to cover communications from one end of a building, such as a house, to the other. Software controls and identity coding are built into each microchip to ensure that only those units preset by the owners can communicate with each other. In general, it is advantageous to utilize low power transmissions and components that draw low amounts of power (especially for battery operated devices). The Bluetooth core protocols include Bluetooth-specific protocols that have been developed for Bluetooth systems. For example, the RFCOMM and TCS binary protocols have also been developed for Bluetooth but they are based on the ETSI TS 07.10 and the ITU-T recommendations Q.931 standards, respectively. Most Bluetooth devices require the Bluetooth core protocols, in addition to the Bluetooth radio, while the remaining protocols are only implemented when necessary.

The baseband and link control layers facilitate the physical operation of the Bluetooth transceiver and, more specifically, the physical RF link between Bluetooth units forming a network. As the Bluetooth standards provide for frequency-hopping in a spread spectrum environment in which packets are transmitted in continuously changing defined time slots on defined frequencies, the baseband and link control layer utilizes inquiry and paging procedures to synchronize the transmission of communication signals at the specified frequency and clock cycles between the various Bluetooth devices.

The Bluetooth core protocols further provide two different types of physical links with corresponding baseband packets. A synchronous connection-oriented (SCO) physical link and an asynchronous connectionless (ACL) physical link may be implemented in a multiplexed manner on the same RF link. ACL packets are used for data only while the SCO packets may contain audio, as well as a combination of audio and data. All audio and data packets can be provided with different levels of error correction and may also be encrypted if required. Special data types, including those for link management and control messages, are transmitted on a specified channel.

There are other protocols and types of networks being implemented and that may be used with the network of Figure F1A. For example, wireless networks that comport with service premises-based Wireless Local Area Network (WLAN) communications, e.g., IEEE 802.11a and IEEE 802.11b communications, and ad-hoc peer-to-peer communications, e.g., Bluetooth (as described above). In a WLAN system, the structure would be similar to that shown in Figure F1A, but, instead of base stations F102 through F112, the WLAN system would include a plurality of Wireless Access Points (WAPs). Each of these WAPs would service a corresponding area within the serviced premises and would wirelessly communicate with serviced wireless devices. For peer-to-peer communications, such as those serviced in Bluetooth applications, the RF transceiver of the present invention would support communications between peer devices, e.g., mobile computer F124 and wireless handset device F126. The fast growth of the mobile communications market and for networks as shown in Figure F1A require the development of multi-band RF transceivers that are small in size, low in cost, and have low power consumption. These RF transceivers should be suitable for a high level of system integration on a single chip for reduced cost and miniaturized mobile device size. Low power consumption is very critical for increasing mobile device battery life, especially for mobile devices that include small batteries.

Generally, Bluetooth facilitates the fabrication of a low-cost and low-power radio chip that includes some of these protocols described herein. The Bluetooth protocol operates in the unlicensed 2.4 GHz Industrial Scientific Medical (ISM) band and, more specifically, transmits and receives on 79 different hop frequencies at a frequency in the approximate range of 2400 to 2480 MHz, switching between one hop frequency to another in a pseudo-random sequence. Bluetooth, in particular, uses Gaussian Phase Shift Keyed (GFSK) modulation. Its maximum data rate is approximately 721 kbits/s and the maximum range is up to 20-30 meters.

Even though Bluetooth has a much lower range and throughput than other known systems, its consequently significantly reduced power consumption means it has the ability to be much more ubiquitous. It can be placed in printers, keyboards, and other peripheral devices, to replace short-range cables. It can also be placed in pagers, mobile phones, and temperature sensors to allow information download, monitoring and other devices equipped with a Bluetooth access point. Nonetheless, it is advantageous to improve the low power consumption of Bluetooth devices to improve battery life for portable applications.

Similarly, wireless LAN technologies (such as those formed to be compatible with IEEE 802.11b) are being designed to complement and/or replace the existing fixed-connection LANs. One reason for this is that the fixed connection LANs cannot always be implemented easily. For example, installing wire in historic buildings and old buildings with asbestos components makes the installation of LANs difficult Moreover, the increasing mobility of the worker makes it difficult to implement hardwired systems. In response to these problems, the IEEE 802 Executive Committee established the 802.11 Working Group to create WLAN standards. The standards specify an operating frequency in the 2.4 GHz ISM band.

The first IEEE 802.11 WLAN standards provide for data rates of 1 and 2 Mbps. Subsequent standards have been designed to work with the existing 802.11 MAC layer (Medium Access Control), but at higher frequencies. IEEE 802.11a provides for a 5.2 GHz radio frequency while IEEE 802.11b provides for a 2.4 GHz radio frequency band (the same as Bluetooth). More specifically, the 802.11b protocol operates in the unlicensed 2.4 GHz ISM band. Data is transmitted on Binary Phase Shift Keyed (BPSK) and Quadrature Phase Shift Keyed (QPSK) constellations at 11 Mbps. 802.11b data rates include 11 Mbits/s, 5.5, 2 and 1 Mbits/s, depending on distance, noise and other factors. The range can be up to 100 m, depending on environmental conditions.

Because of the high throughput capability of 802.11b devices, a number of applications are more likely to be developed using 802.11b for networks such as that shown in Figure F1A. These technologies will allow the user to connect to wired LANs in airports, shops, hotels, homes, and businesses in networks even though the user is not located at home or work. Once connected the user can access the Internet, send and receive email and, more generally, enjoy access to the same applications the user would attempt on a wired LAN. This shows the success in using wireless LANs to augment or even replace wired LANs.

The RF circuitry of the present invention is designed to satisfy at least some of the above mentioned standard-based protocols and may be formed in any of the subscriber units F114 through F128, base stations F102 through F112 or in any other wireless device, whether operating in a cellular system or not. The RF circuitry of the present invention includes low power designs that utilize CMOS technology and that support the defined protocols in a more efficient manner. Thus, for example, the teachings of the present invention may be applied to wireless local area networks, two-way radios, satellite communication devices, or other devices that support wireless communications. One challenge, however, with CMOS design in integrated circuits is that they typically utilize voltage sources having low values (e.g., 3 volts) and are generally noisy. It is a challenge, therefore, to develop receiver and transmitter circuitry that have full functionality while meeting these lower power constraints and while providing good signal quality. The system of Figures F1A and F1B include the inventive gain circuitry gain control disclosed herein to provide discrete gain steps to avoid over amplification and under amplification of a down converted signal prior to delivery to a baseband processor. More specifically, , the receiver circuitry formed within the system of Figures F1A and F1B includes analog peak detection circuitry that allows for gain control circuitry to determine what gain adjustments should be made.

Figure F1B is a block diagram generally illustrating the structure of a wireless device F150 constructed according to the present invention. The general structure of wireless device F150 will be present in any of wireless devices F114 through F128 illustrated in Figure F1A. Wireless device F150 includes a plurality of host device components F152 that service all requirements of wireless device F150 except for the RF requirements of wireless device F150. Of course, operations relating to the RF communications of wireless device F150 will be partially performed by host device components F152.

Coupled to host device components F152 is a Radio Frequency (RF) interface F154. RF interface F154 services the RF communications of wireless device F150 and includes an RF transmitter F156 and an RF receiver F158. RF transmitter F156 and RF receiver F158 both couple to an antenna F160. One particular structure of a wireless device is described with reference to Figure F2. Further, the teachings of the present invention are embodied within RF transmitter F156 of RF interface F154.

The RF interface F154 may be constructed as a single integrated circuit. However, presently, the RF interface F158 includes an RF front end and a baseband processor. In the future, however, it is anticipated that many highly integrated circuits, e.g., processors, system on a chip, etc., will include an RF interface, such as the RF interface F154 illustrated in Figure F1B. In such case, the receiver structure of the present invention described herein may be implemented in such devices. The RF receiver portion F158 includes the inventive analog peak detector or an alternate or equivalent embodiment of that which is disclosed herein.

Figure F2 is a block diagram illustrating a subscriber unit F202 constructed according to the present invention. Subscriber unit F202 operates within a cellular system, such as the cellular system described with reference to Figure F1A. Subscriber unit F202 includes an RF unit F204, a processor F206 that performs baseband processing and other processing operations, and a memory F208. RF unit F204 couples to an antenna F205 that may be located internal or external to the case of subscriber unit F202. Processor F206 may be an Application Specific Integrated Circuit (ASIC) or another type of processor that is capable of operating subscriber unit F202 according to the present invention. Memory F208 includes both static and dynamic components, e. g., Dynamic Random Access Memory (DRAM), Static Random Access Memory (SRAM), Read Only Memory (ROM), Electronically Erasable Programmable Read Only Memory (EEPROM), etc. In some embodiments, memory F208 may be partially or fully contained upon an ASIC that also includes processor F206. A user interface F210 includes a display, a keyboard, a speaker, a microphone, and a data interface, and may include other user interface components, as well. RF unit F204, processor F206, memory F208, and user interface F210 couple via one or more communication buses or links. A battery F212 is coupled to, and powers, RF unit F204, processor F206, memory F208, and user interface F210.

RF unit F204 includes the RF transceiver components and operates according to the present invention to adjust the amplification or gain level of a programmable gain amplifier prior to delivery of a down converted signal to a baseband processor. More specifically, RF unit F204 includes the gain control circuitry as described herein receives detected peak values from an analog peak detector and generates gain control commands responsive thereto. Further, the RF unit F204 provides circuitry that generates a received signal strength indication as a part of providing gain control commands thereby eliminating a need for a discrete received signal strength indicator circuit for determining the signal strength of a received and down converted RF signal. The structure of subscriber unit F202, as illustrated, is only one particular example of a subscriber unit structure. Many other varied subscriber unit structures could be operated according to the teachings of the present invention. Further, the principles of the present invention may be applied to base stations, as are generally described with reference to Figure F1A. In general, however, RF unit F204 includes the inventive analog peak detector.

Figure F3 is a functional schematic diagram of an amplifier system. Traditionally, the gain of an operational amplifier is determined by the value of the ratio of a pair of resistors. Specifically, an input resistor is coupled to a negative input of an operational amplifier (Op Amp) and another resistor is placed across the input and output of the Op Amp in a feedback loop. The ratio of the resistive values then determines the gain. Here in the example of Figure F3, a resistor F304 is coupled the input of an Op Amp F308. A resistor F312 is coupled across the output of Op Amp F308 and to the input node of Op Amp F308 that is also coupled to resistor F304. The gain of the amplifier of Figure F3, meaning the ratio of the output signal to the input signal, is defined by the ratio of resistor F312 to resistor F304. Typically, to make the gain of the amplifier of Figure F3 programmable, a variable resistance is coupled to the input of Op Amp F308 so that the ratio of resistor F312 to resistor F304 may be modified. For amplifiers such as that shown in Figure F3 to be adjustable, the resistance values are varied according to detected peak values from a peak detector.

Figure F4 is an amplifier formed to have programmable gain. Referring now to Figure F4, it may be seen that Op Amp F308 has resistor F312 coupled from its output to its negative input. Resistor F304, however, is replaced by a resistor F404 that is in parallel with the combination of a resistor F408 and a switch F412. As is understood, the branch including resistor F408 and switch F412 may represent a plurality of such resistor and switch combinations so that the overall resistance on the input side of Op Amp F308 may be modified, thereby modifying the ratio of resistor F312 to the total resistance represented by resistors F404 and F408 of Figure F4.

The example of Figure F4 is one that may be implemented with any number of resistors on the input side coupled to a switch, wherein the number of resistors is a function of the number of gain settings that a designer wishes to implement in his or her system. The solution of Figure F4 has two inherent problems, however. First, resistors formed within integrated circuit devices require a relatively large amount of semiconductor area and, accordingly, are not design efficient Second, the resistance of the switches is not constant and can vary as much as 20% due to the switches being typically formed by MOSFET devices. Accordingly, because the resistance in any one branch is a function of the MOSFET switch, as well as the resistor which itself may have a 20% fluctuation in resistive value, the gain accuracy can be significantly degraded to a point that the amplifier does not meet design specifications. Because many radio transceiver devices have multiple amplification stages, however, it is important to control the amount of amplification at various stages of the radio transceiver so as to avoid saturation and maintain satisfactory operation. Thus, it is desirable to accurately predict output gain. Ana analog peak detector may be used with such an amplifier to determine the gain steps.

Figure F5 is a functional schematic block diagram of an RF processing unit of a radio transceiver formed according to one embodiment of the present invention. An RF receiver unit initially receives a radio frequency signal at a receiver/low noise amplifier (LNA) F504 that is coupled to receive wireless communications by way of an antenna. As is known by those of average skill in the art, radio communications typically employ one of many different modulation techniques, including Quadrature Phase Shift Keying (QPSK). In the described embodiment, QPSK modulation is utilized. Accordingly, receiver/LNA F504 produces RF with I and Q components for processing. Within each of the branches carrying the I and Q components, the signal is produced to a mixer oscillator that down converts the received signal from radio frequencies to a baseband channel and extracts the I and Q components.

In the described embodiment of the invention, the radio transceiver is formed to satisfy 802. design requirements. Accordingly, the input signal is tuned to a 2.4 GHz frequency of oscillation and then is down converted to baseband. Mixers F508A and F508B produce the down converted signal to a low pass filter F512A and a low pass filter F512B for the I and Q modulated channels, respectively.

As is known, low pass filters F512A and F512B are for blocking all communication signals above a specified frequency. The outputs of low pass filters F512A and F512B are then produced to programmable gain amplifiers (PGAs) F516A and F516B. The outputs of PGAs F516A and F516B are adjusted by gain control circuitry F520 to produce approximately 0 dBm of swing for the amplified signal that is then transmitted into baseband processing circuitry. In the described embodiment, the analog-to-digital converters (ADCs) are within the baseband processing circuitry external to the IF radio integrated circuit.

Each of the components in this path thus far, namely, receiver/LNA F504, mixers F508A and F508B, and low pass filters F512A and F512B, add gain to the received signals. Because the power of the received signal can vary dramatically, however, the gain of the programmable gain amplifier is adjusted so that the gain of the output signal being provided to the baseband radio circuitry is of a constant level. Unfortunately, many common programmable gain amplifiers provide a very limited number of amplification steps, if any. Accordingly, the present invention includes a programmable gain amplifier whose gain can be incremented in 3 dB increments from 0 dB to 45 dB. Additionally, the invention includes circuitry to determine an appropriate amount of gain that should be added to the signal received by the PGA F516A so that it is amplified up to 0 dBm with a tolerance of +/- 2 dBm.

Figure F6 is a functional schematic diagram illustrating one embodiment of the programmable gain amplifiers used in the present invention. More specifically, as may be seen, a PGA, for example, PGA F516A of Figure F5, includes four amplification stages that collectively provide up to 45 dB of gain. An amplifier F604 provides either 0 or 12 dB of gain. Its output is produced to an amplifier F608 that also produces 0 or 12 dB of gain. The output of amplifier F608 is then provided to an amplifier F612 that, again, provides either 0 or 12 dB of gain. The output of amplifier F612 is then provided an amplifier F616 that provides gain in finer increments, namely, 3 dB. Thus, amplifier F616 provides either 0 dB, 3 dB, 6 dB or 9 dB of gain.

Accordingly, by selecting which of the four amplifiers F604, F608, F612 or F616 is providing gain, and in the case of amplifier F616 how much gain is generated therefrom, the amount of gain provided collectively can be varied in incremental steps of 3 dB all the way from 0 dB of gain to 45 dB of gain (16 logic states). In general, each of the amplifiers F604, F608 and F612 receive a binary signal specifying whether it should provide 0 dB of gain or 12 dB of gain. Amplifier F616, however, receives a four-state signal in one embodiment of the invention, which specifies whether it is to provide 0 dB, 3 dB, 6 dB or 9 dB of gain. As is known by those of average skill in the art, four bits is sufficient to generate the required 16 logic states for this embodiment of the invention. A plurality of logic gates may be used to generate the required amplifier control signals from the four bits as generally described.

Figure F7 is a functional schematic diagram of an amplifier that provides gain in 3 dB steps. More specifically, the amplifier of Figure F7 may be used for providing the functionality described in association with amplifier F616 of Figure F6. As is known by those of average skill in the art, the gain of an operational amplifier is the ratio of the resistance in the feedback loop divided by the resistance at the input stage. Accordingly, the amount of resistance provided by a second group of MOSFETs F712 that are coupled to the input of an Op Amp F708 is divided into the resistance provided by a first plurality of MOSFETs F704 that are coupled in the feedback loop of Op Amp F708.

In the described embodiment, the first group of MOSFETs F704 comprise five matched MOSFETs that are coupled in parallel within the feedback loop of Op Amp F708 and are shown as one MOSFET F716 coupled to operate as a resistor when biased in its linear region.

In the second group of MOSFETs F712, a total of fourteen MOSFETs are coupled in parallel to provide the incremental gain steps for the amplifier of Figure F7. A first group of five transistors, which is represented by MOSFET F720, is biased to ground and each of the five transistors is always biased in the linear region. The remaining MOSFETs of the second group of MOSFETs F712, however, are selectively biased so as to modify the gain of the amplifier of Figure F7.

More specifically, two transistors, shown as MOSFET F724, are biased by a first selectable bias voltage $S_1$. Similarly, three transistors, shown as MOSFET F728, are all biased by a second selectable bias voltage $S_2$. Finally, four transistors, represented as MOSFET F732, are biased by a third selectable bias voltage $S_3$. Thus, the five transistors represented by MOSFET F720, will always be on, while the MOSFETs that receive bias voltages $S_1$, $S_2$ and $S_3$, shown herein as MOSFET F724, F728 and F732, respectively, may be selectively biased according to the desired output gain level.

As is understood by those of average skill in the art, the gain of the amplifier (in dB) in Figure F7 is defined by the equation of 20 log (R2/R1). In this example, R1 comprises the transistors of the second group of MOSFETs F712, and R2 comprises the first group of MOSFETs F704. Because the gain is a function of the logarithm of the resistive values R2/R1, the gain is modified for the amplifier of Figure F7 to create the 3 dB steps by modifying the resistive ratios according to the biasing of the transistors in the second group of MOSFETs F712.

For example, if MOSFETs F724, F728 and F732 are biased to an off state, then the gain is 0 dB because the log of the resistance of the five MOSFETs F716 divided by the resistance of five matched MOSFETs F720 is equal to 0 because the log of 1 is equal to 0. To provide 3 dB of gain, seven of the transistors from the second group of MOSFETs F712 must be biased in the linear region. This is because 20 log (7/5) is equal to 2.92 dB, which is approximately equal to 3 dB. Similarly, for 6 dB of gain, ten of the MOSFETs F712 must be biased in the linear region because 20 log (10/5) is equal to 6.02 dB, which is approximately equal to 6 dB. Finally, for 9 dB of gain, all fourteen MOSFETs of the MOSFETs F712 must be biased in the linear region because 20 log (14/5) is equal to 8.94 dB, which is approximately equal to 9 dB.

Thus, to achieve the desired gain steps, the fourteen MOSFETs of the second group of MOSFETs F712, must be operationally biased so that either 5, 7, 10 or 14 transistors are on according to the desired step size. Moreover, as was described before, the five MOSFETs represented by MOSFET F720 are always biased in the linear region by virtue of the gate terminal coupled to ground. Thus, for 0 dB of gain, the remaining transistors are merely biased off by the logic signals. Whenever 3, 6 or 9 dB of output is desired, logic signal $S_1$ is used to operationally bias the MOSFETs represented by MOSFETs F724. Whenever 6 dB of gain is desired, both $S_1$ and $S_2$ are used to bias the transistors represented by MOSFETs F724 and F728 in the linear region. Finally, if all fourteen transistors were to be biased on to provide 9 dB of gain, then $S_1$, $S_2$ and $S_3$ are all set to bias the MOSFETs represented by MOSFETs F724, F728 and F732 of the MOSFETs F712 of Figure F7.

Figures F6 and F7 illustrate the operation of the programmable gain amplifier itself according to one embodiment of the invention. Additionally, however, one aspect of the present embodiment of the invention is the control of the programmable gain amplifier to achieve the desired 3 dB increment steps.

Figure F8 is a functional block diagram that illustrates one embodiment of the present invention for controlling the programmable gain amplifiers for the I and Q modulated channels. With respect to the I channel, PGA F516A of Figure F5 receives the I channel communication signals for amplification. The output of PGA F516A is then provided to an amplitude level detector F804. Similarly, PGA F516B receives the communication signals over the Q channel for amplification and produces an amplified output to an amplitude level detector F804. Amplitude level detector F804 provides an output that may be represented by the square root of the sum of the I channel amplitude squared and the Q channel amplitude squared. This output signal represents a peak level of the I and Q modulated channels.

Amplitude level detector F804 is coupled to receive the output of PGA F516B, as well as PGA F516A, to produce the amplitude peak detection. Based upon the detected gain level of the I and Q modulated channels, amplitude level detector F804 produces an indication to a gain control logic block F808 which responds by generating control commands to PGA F516A and PGA F516B to increment or decrement the output gain level. In the described embodiment of the invention, gain control logic block F808 includes a 4-bit counter F812 that is driven by an external clock signal for producing the increment and decrement control bits to PGAs F516A and F516B.

Figure F9 is a functional schematic block diagram that illustrates an analog peak detector circuit formed according to one embodiment of the present invention. PGAs F904 and F908 each produce an amplified output signal. The output of PGA F904 is a differential output signal that may be represented by (a)sin ($\omega$t). The output of PGA F908 is a differential output signal that may be represented by (a)cos ($\omega$t). The outputs of PGAs F904 and F908 are fed into a peak detector F912 formed according to the described embodiments of the invention. Responsive to receiving the outputs of PGAs F904 and F908, peak detector F912 determines the peak amplitude of the outputs of PGAs F904 and F908, provides the determined output to a control circuit F916 which then generates control signals back to PGAs F904 and F908 to reduce or increase the output gain therefrom.

In the described embodiment of the present invention, peak detector F912 comprises analog circuitry for fast determination of the peak amplitude of the outputs of the PGAs F904 and F908. In general, peak detector F912 takes advantage of a square law current to voltage function for MOS devices to determine that peak of the amplified signal. By utilizing a circuit that takes advantage of the square law function for MOS devices, the present invention is able to square the received inputs, thereby eliminating the sine and cosine elements of the signals because of the known equation that holds that $\sin^2 + \cos^2 = 1$. Thus, by also taking the square root of the sum of the squared signals, the peak amplitude "a" of the received quadrature signals may be determined.

Figure F10 is a functional schematic block diagram that illustrates one embodiment of the present invention. The PGAs F516A and F516B described above, may be seen in the schematic block diagrams of Figure F8 and Figure F9. A peak amplitude detector F1004 is coupled to provide an indication of a detected peak amplitude to gain control circuitry F1006. Gain control circuitry F1006 includes a pair of comparators F1008 and F1012. Peak amplitude detector F1004 is coupled to receive the I and Q channel amplified outputs of PGAs F516A and F516B, respectively. Peak amplitude detector F1004 provides an output that represents the square root of the sum of the squared amplitude components of each of the I and Q channels (an overall peak value). The peak value from peak amplitude detector F1004 is provided to comparators F1008 and F1012. Comparator F1008 compares the output of peak amplitude detector F1004 to a low reference voltage value while comparator F1012 compares the output of peak amplitude detector F1004 to a high reference voltage value.

With respect to comparator F1008, if the peak amplitude received from peak amplitude detector F1004 is below the low reference voltage, it generates a signal to 4-bit counter F1016 to increment the 4-bit count value and, thus, increase the gain of PGAs F516A and F516B. Similarly, comparator F1012 will generate a signal to decrease the gain if the detected peak amplitude from peak amplitude detector F1004 is higher than the high reference voltage.

Correspondingly, the gain control circuitry F1006, and, more specifically, the 4-bit counter F1016 generates control signals to PGAs F516A and F516B to increase or decrease the gain. As was described earlier, each of the PGAs F516A and F516B will amplify a signal up to 45 dB in the described embodiment of the invention. 4-bit counter F1016 will set the four control bits to adjust the gain, as has been described herein, in 3 dB increments in the described embodiment of the invention.

The inventor herein has further recognized that the output of 4-bit counter F1016 also describes the inverse of the signal strength for the received signal. Accordingly, by adding an inverter F1020 to the output of 4-bit counter F1016, the output may serve as a received signal strength indicator (RSSI) that is common in these types of radio circuits.

Generally, an RSSI is coupled to the input stage of the programmable gain amplifiers, such as PGAs F516A and F516B, to provide an indication of the received signal strength. The circuitry used to control the gain of PGAs F516A and F516B may also be used to provide an indication of the received signal strength in place of a received signal strength indicator by merely inverting the output of 4-bit counter F812. Accordingly, the output of 4-bit counter F1016 is provided to inverter F1020, whose output serves as the output of a received signal strength indicator.

As is understood by those of average skill in the art, typical radio transceiver designs include two RSSIs so that a determination may be made about the amount of interference as well as the signal strength of the received signal. This information is used for controlling gain at the various stages of the radio transceiver. RSSI 1 (a first RSSI) is usually coupled at the input of a low pass filter to measure the signal strength of the combination of the received signal and interferers in the same and in adjacent channels. RSSI 2 (the second RSSI) is usually coupled at the output of the low pass filters and at the input of the PGA and is used to measure the signal strength of the desired signal. The output of inverter F1020 serves to provide the received signal strength indicator of RSSI 2, meaning the signal strength of the signal only.

Figures F11A and F11B are signal response curves illustrating the operation of a MOSFET when biased properly in the inventive peak detector. Referring first to Figure F11A, a family of curves represents the relationship between $I_D$ with respect to $V_{DS}$ for increasing levels of $V_{GS}$. As may be seen, for any given $V_{GS} > Vt$, the drain current ID increases approximately linearly with increasing drain to source voltage $V_{DS}$. The name for this region of the response curve is the linear region. Once the drain to source voltage $V_{DS}$ is greater than the gate to source voltage minus the threshold voltage ($V_{GS} - V_t$), the MOSFET operates in the saturation region in which the drain current $I_D$ is approximately constant for increasing drain to source voltage $V_{DS}$ and is responsive to changes in the gate to source voltage $V_{GS}$. is The actual relationship of the drain current to the gate to source voltage is better seen in Figure F11B. Thus, as may be seen, $I_D = \frac{1}{2}$ Beta $(V_{GS} - V_t)^2$. Because the threshold voltage $V_t$ and Beta are constants, the current $I_D$ is merely a function of the square of the gate to source voltage $V_{GS}$.

Figure F12 is a functional block diagram that illustrates a system and method for extracting a peak amplitude of a received signal in one embodiment of the present invention. A circuit F1200 receives a differential quadrature signal, represented by (a)sin(? t) and (a)cos (? t), where "a" is the peak amplitude of the signal, and wherein the "sin" and "cos" functions represent that the signals are ninety degrees out of phase relative to each other. It is understood that the signals are actually received by way of a wireless transmission in the described embodiment of the invention. The quadrature signals are provided to the first input of transconductance amplifiers F1204 through F1216. A DC bias ($V_{BIAS}$) F1220 is provided to the second input of transconductance amplifiers F1204 through F1216 wherein the resulting voltage is converted to a current that is presented to the input of output device F1224. Output device F1224 further is coupled to receive a constant current $I_{DC}$ from a constant current source F1228.

The received voltage signals are converted to a signal current by transconductance amplifiers F1204 through F1216 after the quadrature input signals are summed with a DC bias voltage ($V_{BIAS}$). In the described embodiment of the invention, the transconductance amplifiers F1204 through F1216 are formed with MOS devices whose current is proportional to the square of the gate to source voltage for the MOS devices within. In effect, therefore, the amplitude components are squared and the sine and cosine components are removed (as will be described in greater detail below in the discussion of Figure F13). The output of the transconductance amplifiers then is merely a constant Beta times the amplitude squared.

Output device F1224 receives the outputs from each of the transconductance amplifiers and sums them with a constant current received from current source F1228 whose current is formed to be equal to $I_{DC}$ and is for compensating for the bias voltages. The output device F1224 then effectively performs a square root on the sum of its inputs to produce a signal that represents the peak amplitude for the received signals. More specifically, taking advantage again of the current to voltage relationship described above for MOS devices, the output device F1224 converts a plurality of received currents back into a voltage. Thus, the voltage is merely the square root of the sum of the squared current components received from the transconductance amplifiers F1204 through F1216. Thus, the square root of the sum of the squares for each of the outputs from the transconductance amplifiers F1204 through F1216 produces the magnitude "a" for the received quadrature signals. While Figure F12 is functional in nature, comprehending its operation is helpful in understanding the circuit operation for the circuit of Figure F13.

Figure F13 is a schematic diagram of one embodiment of the present invention. A circuit shown generally at F1300 comprises a first circuit portion F1304 that is coupled to receive an input from a second circuit portion F1308. The first circuit portion F1304 comprises at least 4 MOSFETs F1316 through F1328 configured to generate a current proportional to a voltage presented to each of the MOSFET gate terminals. Each of the MOSFETs F1316 through F1326 compare to amplifiers F1204 through F1216 of Figure F12.

The second circuit portion F1308 comprises at least one current source F1332 and at least two MOSFETs F1336 and F1340 wherein the current generated by the second circuit portion F1308 is proportional to the current sinked by the first circuit portion F1304. In the described embodiment of the invention, the first plurality of MOSFETs consists of four MOSFETs. Generally, the number of MOSFETs in first circuit portion F1304 is an even multiple of four since, in the described embodiment, a differential quadrature phase shift keyed signal is being received. Thus, at least four MOSFETs are connected so that the drain terminals are coupled to a first current node F1344 and the source terminals are connected circuit ground. The gate terminals of the first circuit portion F1304 are coupled to receive the differential quadrature signals from a plurality of upstream programmable gain amplifiers (PGAs).

The differential quadrature signals that are received by each of the MOSFETs F1316-1328 of the first circuit portion F1304 effectively are the same signal but are differentiated in phase. Each of the four signals is separated by either 90 degrees or 180 degrees from each of the other three signals received by the other MOSFETs. Thus, MOSFET F1316 is coupled to receive a voltage equal to a DC bias voltage ($V_{BIAS}$) plus (a)sin (? t) where "a" is the peak voltage of the sinusoid signal. MOSFET F1320 is coupled to receive a voltage equal to $V_{BIAS}$ minus (a)sin(? t). MOSFET F1324 is coupled to receive a voltage equal to $V_{BIAS}$ plus (a)cos(? t). MOSFET F1328 is coupled to receive a voltage equal to $V_{BIAS}$ minus (a)cos(? t).

MOSFETs F1316-1328 of the first circuit portion F1304 are biased by the DC bias voltage, provided to the gate terminals, to cause the MOSFETs to operate in the saturation region wherein the drain current is equal to $\frac{1}{2}*\beta(V_{GS} -V_t)^2$. $\beta$ and $V_t$ are device characteristics determined by device geometry and MOSFET design as is known by those of average skill in the art. The drain current is, therefore, a function of the square of the voltage provided or coupled to the gate terminal. The current drawn by MOSFET F1316 in the first circuit portion F1304 is equal to $\frac{1}{2}*\beta(V_{BIAS} + \sin(? t) -V_t)^2$. Similarly, the current drawn by MOSFET F1320 in first circuit portion F1304 is equal to $\frac{1}{2}*\beta(V_{BIAS} - \sin(? t) -V_t)^2$. As may be seen, the difference between the current drawn by each of the signals is merely a function, at a given moment of the phase of the signal. More specifically, for example, the difference in the current between the first and second MOSFETs F1316 and F1320, respectively, is a function of the difference in the input signals, namely the polarity of sin(? t) (meaning they are 180 degrees out of phase relative to each other).

The current drawn by the third and fourth MOSFETs F1324 and F1328 in the first circuit portion F1304 is equal to $\frac{1}{2}*\beta(V_{BIAS} + \cos(? t) -V_t)^2$ and $\frac{1}{2}*\beta(V_{BIAS} - \cos(? t) - V_t)^2$, respectively. Once again, the difference in the current between the third and fourth MOSFETs is a function of the difference in the input signals, namely the polarity of $\cos(? t)$ (meaning they are 180 degrees out of phase relative to each other). Additionally, because the sine and cosine of a signal merely reflects a ninety-degree difference in phase, the current drawn by the third and fourth MOSFETs is ninety degrees out of phase with the current drawn by the first and third MOSFETs.

The total current is presented at a current node shown generally at F1344 and is equal to the sum of the currents drawn by the first plurality of MOSFETs F1316-1328. By taking advantage of the square law response of MOSFETs in their saturation region and by noting that $Sin^2 + Cos^2 = 1$, the total current drawn by the MOSFETs in the first circuit portion F1304, after completing the squares, is equal to:

$$2* \beta(V_{BIAS} -V_t)^2 + \frac{1}{2} *2\beta a^2.$$

The first term is a constant and is equal to 4 times the standard equation for the drain current, i.e., $I_{DRAIN} = \frac{1}{2}*\beta(V_{GS} -V_t)^2$ where the bias voltage has been set, by design, equal to $V_{GS}$. The first term can therefore be represented as a direct current ($I_{DC}$). The second term, $\beta a^2$ is the fluctuating current proportional to the square of the peak voltage of the quadrature inputs.

The second circuit portion F1308 further includes at least one current source F1332 and at least two matched MOSFETs F1336 and F1340. The current source is coupled between a supply voltage $V_{DD}$ and current node F1344 and is formed so the current supplied is equal to twice the current ($I_{DC}$) of any one MOSFET of the MOSFETs F1316-1328 of circuit portion F1304. Additionally, the DC current through each of the MOSFETs F1336 and F1340 is equal to the DC current of any one MOSFET of MOSFETs F1316-1328 of circuit portion F1304. Additionally, the MOSFETs of circuit portion F1308 are coupled in parallel wherein their drain terminals connected to $V_{DD}$. The source terminals of the MOSFETs F1336 and F1340 of circuit portion F1308 are connected to current node F1344. Additionally, the gate terminals of MOSFETs F1336 and F1340 of circuit portion F1308 are coupled to the drain terminals (and to $V_{DD}$).

The total current provided to the output node by the second circuit portion F1308 is equal to the total current drawn by the first circuit portion F1304, namely $I_{DC} + \beta a^2$. Here, $I_{DC}$ is equal to all of the DC current provided by current source F1332 and the DC current that is also conducted through MOSFETs F1336 and F1340. Thus, the current $I_{DC}$ also is equal to 4I if "I" is the DC current through any one of the MOSFETs shown in Figure F13. It can be seen that the additional (fluctuating) current conducted through the MOSFETs F1336 and F1340 is equal to $\beta a^2$. In the present embodiment of the invention, each of the two MOSFETs F1336 and F1340 will supply one half of the current $\beta a^2$. Moreover, the gate to source voltage ($V_{GS}$) of the MOSFETs F1336 and F1340 is equal to VDD - the output voltage ($V_{out}$). The drain current of the MOSFETs F1336 and F1340 is equal to $\frac{1}{2} \beta*( V_{DD} -V_{out}-V_t)^2$. This current is also equ to $\frac{1}{2} \beta a^2$. It can be seen, therefore, that $V_{out}$ is equal to $V_{DD} -V_t-a$, where "a" is the peak amplitude of the received signal. MOSFETs F1336 and F1340 have effectively performed the required square root function.

SECTION G

Figure G3 is a functional schematic block diagram of a received portion of an RF processing unit of a radio transceiver formed according to one embodiment of the present invention. An RF receiver processing unit, shown generally at G300, initially receives a radio frequency signal, for example, a 2.4 GHz signal, at a receiver/low noise amplifier (receiver/LNA) G304 that it produces to a pair of mixers G308A and G308B, respectively. They are also coupled to receive a reference signal from a local oscillator for mixing with the signals produced by the receiver/LNA G304 to down convert the signals received from receiver/LNA G304 to a baseband frequency. The output of mixers G308A and G308B is a down converted signal whose carrier signal is converted from the received frequency to a baseband frequency that is approximately centered at DC (0 Hertz) in the frequency domain. More specifically, mixer G308A receives a reference signal directly from a local oscillator G318 and extracts the I component therefrom and down converts the I component to a baseband frequency. Mixer G308B receives the reference signal from a phase shifter G322 that introduces a ninety degree phase shift to the reference signal and, as such, extracts the Q component therefrom and down converts the Q component to a baseband frequency. Local oscillator G318 produces a reference signal and typically comprises a phase locked loop. Phase shifters such as phase shifter G322 are known by those of average skill in the art and merely produce a ninety degree phase shift to the reference signal output by the local oscillator G318.

The down converted signals are then produced from mixers G308A and G308B to a pair of low pass filters G312A and G312B, respectively. As is known, low pass filters G308A and G308B are for attenuating/blocking all signals above a specified corner frequency.

The signals that have not been attenuated by low pass filters G312 are then produced to an amplification stage prior to being transmitted to a baseband processor. More specifically, the filtered output from low pass filters G312A and G312B are produced to amplification circuitry G316A and G316B, respectively. Amplification circuitry G316A and G316B, each, further include variable gain amplifiers G320A and G320B, as well as high pass filters G324A and G324B in a feedback loop about variable gain amplifiers G320A and G320B. In the described embodiment of the present invention, voltage integrator circuits G324A and G324B comprise an integrator that, when configured properly, provides infinite rejection of DC signals. Thereafter, the amplified and filtered signal is produced from amplification circuitry G316A and G316B to a baseband processor circuitry G328.

Figure G4 is a functional schematic block diagram illustrating an amplifier for removing a DC offset in a radio receiver formed within an integrated circuit. As may be seen, an amplifier G404 produces an output to a low pass filter G408. The output of low pass filter G408 is then coupled to an adder G412 that mixes the output of low pass filter G408 with an input signal received by way of a line G416. The output of adder G412 is produced to the input of amplifier G404 by way of a line G420. Typically, low pass filter G408 comprises a capacitor and a resistor as is known by one of ordinary skill in the art. While the system of Figure G4 provides for the removal of a DC offset, the rejection of the DC offset is not perfect or infinite. Thus, it is advantageous to have a circuit that provides maximal or infinite rejection of the DC offset signal.

Figure G5 is a functional schematic block diagram illustrating circuitry for rejecting or removing a DC offset signal formed according to one embodiment of the present invention. An input signal is produced to an adder G504 by way of a line G506 that then produces a summed signal containing the original input signal to an amplifier G508 by way of a line G512. The output of amplifier G508 on a line G516 is generated to an input stage of an integrator. More specifically, a resistor G520 is coupled to receive the output of amplifier G508 and to provide the input signal to a negative input of an operational amplifier (Op Amp) G524. The input signal is also produced to a capacitor G528 that is coupled across the output of Op Amp G524 and the negative input of Op Amp G524. The output of Op Amp G524 further is coupled to adder G504 wherein the output is summed with the input signals received on line G506 and is then produced to amplifier G508 on line G512.

The present invention includes an integrator in a feedback loop of amplifier G508 for quickly charging a capacitor with the DC offset value. As will be explained in greater detail below, after capacitor G528 has been charged with the DC offset value, the integrator is electrically removed from the circuitry thereby facilitating normal operation of amplifier G508. However, because capacitor G528 has been charged with the DC offset signal, and that signal is subtracted from the input signal at adder G504, the DC offset in the input signal is effectively cancelled. While the integrator is charging to the DC component of a down converted signal, it also passes at least some of the alternating current (communications signal) back to the amplifier input. Accordingly, a two-part amplification process in which a first part comprises passing AC and charge from the integrator to the amplifier and a second part in which only a charge is passed to the input of the amplifier. The two-part amplification process transitions from the first part to the second part whenever the bias voltage is removed from the MOSFET on the integrator input thereby effectively opening the circuit and terminating the charging of the capacitor of the voltage integrator.

Figure G6 is a functional schematic block diagram of integrator circuitry coupled in a feedback loop across an amplifier according to one embodiment of the present invention. Referring now to Figure G6, Op Amp G524 and capacitor G528 described in relation to Figure G5 may be seen here. Resistor G520 of Figure G5, however, is replaced by the circuitry shown herein. More specifically, resistor G520 of Figure G5 comprises a MOSFET G604 biased and coupled to act as a resistor in its linear mode of operation. Furthermore, logic circuitry G608 is coupled to provide a bias voltage to the gate of MOSFET G604 under specified conditions. As will be described in greater detail below, logic circuitry G608 produces a voltage to the gate of MOSFET G604 to reduce the resistance of the channel within the MOSFET only for a specified amount of time. Typically, the specified amount of time is one that is sufficiently long enough to allow capacitor G528 to charge up to the DC offset value, but short enough to allow the system to be electrically removed within any settling time requirements according to the requirements for the transceiver circuitry. For example, 802.11b provides for a 10 microsecond settling time. Accordingly, logic circuitry G608 will remove the voltage from the gate of MOSFET G604 within 10 microseconds after "power on" or the initial receipt of a packet. Logic circuitry G608 may comprise any known design approach for defining such operational logic. For example, the logic may readily be performed by a processor or by circuitry that defines a time constant in hardware. The logic circuitry G608 typically provides a voltage equal to VDD to turn the MOSFET G604 completely off (because MOSFET G604 is a p-channel enhancement MOSFET) after the settling time is achieved (approximately 10 microseconds) and as a consequence, open the DC offset loop during the receive mode. However, the logic block can be modified to produce a bias voltage to set the resistance of MOSFET G604 to some high value, rather than an open. By adjusting the bias voltage, the overall loop provides a high-pass behavior whose 3 dB bandwidth is a function of this bias, and is adjustable.

Figure G7 is a flowchart that illustrates a method for removing a DC component from a signal that is to be amplified according to one embodiment of the present invention. Initially, an amplification circuit receives a new data packet (step G704). Thereafter, a 10 microsecond period is initiated during which a bias voltage is generated (step G708). While step G708 describes the generation of a bias voltage upon the receipt of a new data packet in step G704, other events may trigger the 10 microsecond generation of the biasing voltage. Generally, the 10 microsecond generation of the bias voltage occurs each time that the amplification circuitry transitions from a low power mode of operation to an operational state or mode of operation, meaning that signal processing and amplification is occurring.

Once the amplification circuitry generates the bias voltage for the 10 microsecond period, the bias voltage is applied to a MOSFET that is configured as a resistor to drive it to a low resistance value to complete a feedback loop (step G712). While the MOSFET is in a low resistance mode and the feedback loop is completed, a capacitor coupled across an input port and an output port of an integrator is charged to a DC value (step G716). Generally, while the feedback loop is present during which the MOSFET is coupled to a low resistance state, the capacitor charges to a DC value that equals the DC component of a received signal at the input port of the amplification circuitry. The 10 microsecond delay expires, thereby causing the amplification circuit to stop generating the bias voltage to the MOSFET. Accordingly, the MOSFET transitions to a high resistance mode to open the feedback loop (step G720). After the high resistance mode is achieved and the feedback loop is open, the DC value across the capacitor is provided to the amplification circuitry input, thereby canceling the DC offset (step G724).

The invention disclosed herein is susceptible to various modifications and alternative forms. Specific embodiments therefore have been shown by way of example in the drawings and detailed description. It should be understood, however, that the drawings and detailed description thereto are not intended to limit the invention to the particular form disclosed, but on the contrary, the invention is to cover all modifications, equivalents and alternatives falling within the spirit and scope of the present invention as defined by the claims.

SECTION H

Figure H3 is a functional schematic block diagram of an RF processing unit of a radio transceiver implemented according to one embodiment of the present invention. An RF receiver unit initially receives a radio frequency signal at a receiver/low noise amplifier (LNA) H304 that is coupled to receive wireless communications by way of an antenna. As is known by those of average skill in the art, radio communications typically employ one of many different modulation techniques, including Quadrature Phase Shift Keying (QPSK). Accordingly, receiver/LNA H304 produces an amplified RF signal containing I and Q components to mixers H308A and H308B for separation into the I and Q modulated channels. The mixers H308A and H308B also down convert the received amplified RF signals from radio frequencies to baseband frequencies.

In the described embodiment of the invention, the radio transceiver is formed to satisfy 802.11b design requirements. Accordingly, the RF input signal to a low noise amplifier has a 2.4 GHz carrier frequency that is amplified, produced to the mixers H308A and H308B and then is down converted to baseband. Thereafter, mixers H308A and H308B produce the down converted signal to low pass filters H312A and H312B for the I and Q modulated channels, respectively.

As is known, low pass filters H312A and H312B are for attenuating frequency components of signals above a specified frequency. The outputs of low pass filters H312A and H312B are then produced to programmable gain amplifiers (PGAs) H316A and H316B. The outputs of PGAs H316A and H316B are adjusted by gain control circuitry H320 to produce approximately 0 dBm of gain for the amplified signal that is then transmitted into baseband processing circuitry. In the described embodiment, the analog-to-digital converters (ADCs) are within the baseband processing circuitry external to the IF radio integrated circuit.

Each of the components in this path thus far, namely, receiver/LNA H304, mixers H308A and H308B, and low pass filters H312A and H312B, add gain to the received signals. Because the gain of the received signal can vary dramatically, however, the gain of the programmable gain amplifier is adjusted so that the gain of the output signal being provided to the baseband radio circuitry is of a constant level. Unfortunately, many common programmable gain amplifiers provide a very limited number of amplification steps. Accordingly, the present invention includes a programmable gain amplifier whose gain is adjusted according to input signal strength. Additionally, the invention includes circuitry to determine an appropriate amount of gain that should be added to the signal received by the PGAs H316A and H316B so that it is amplified up to 0 dBm with a tolerance of H3 dBm.

Figure H4 is a schematic diagram of an operational amplifier configured as an RC filter that provides fast response and good attenuation above a specified frequency corner. Modern transmitter and receiver designs require active RC filters to meet operational requirements and often incorporate active RC filters similar to the active filter shown in Figure H4. Using active RC filters is desirable because they have a wide dynamic range compared to other filters. Active RC filters, however, require Op Amps that have high gain with resistive loads so they must have the ability to drive current into resistive loads but at the same time they must be fast enough so the filter shape is not distorted. Typically Op Amps can have high gain and drive resistive loads or be fast but usually not both. The filter configuration of Figure H4 is known by one of average skill in the art and may readily be modified with other filter designs that include an amplifier such as amplifier H400. The filter configuration of Figure H4 is advantageous in that it provides a sharp corner and fast response. Utilizing the inventive amplifier as amplifier H400 in conjunction with the filter circuitry shown, a filter is formed that is able to provide the desired response and also drive current through a load. It should be understood that the circuitry shown in Figure H4 is for only one of the two outputs of the differential amplifier disclosed herein for the sake of simplicity. The circuitry, in one embodiment, is duplicated for both output stages of the differential amplifier.

Standard 802.11b requires filter corners at 8 MHz, which is high for filters that typically have high frequency corners around 100 kHz. Op Amps have bandwidth above 8 MHz but typically cannot drive resistive loads. The circuit of Figure H4 is exemplary of prior designs that provide fast response but also that do not have the ability to drive a load. Accordingly, common designs include using Op Amp designs having two stages wherein a first stage provides the necessary gain and a second stage provides the ability to drive resistors and other loads. The problem with two stage designs, however, is that they typically are slow.

One problem, however, is that the source follower causes level shifting in the output due to the addition of an extra $V_{GS}$ drop. Present day mobile devices are battery operated which limits the maximum operating voltages to approximately 3 volts or less. Typical $V_{GS}$ values are approximately one volt, which is a severe limitation for low voltage devices so ubiquitous in today's market place.

There exits, therefore, a need in the art for a high speed Op Amp design that does not limit low voltage devices yet can drive resistive loads while maintaining a high gain-bandwidth product. The present invention addresses these problems by the inserting a voltage follower in the second stage output. The voltage follower configuration is very fast and can drive resistive loads but do not have the "extra" $V_{GS}$ drop in the output stage and, therefore, do not suffer from the voltage limitation found in other designs.

Figure H5 is a schematic diagram of a two-stage differential amplifier, wherein the second stage comprises a source follower configuration The two-stage Op Amp discussed previously can be improved by replacing the second stage with a MOSFET source follower as shown in Figure H5. A source follower second stage does not provide any gain but it can drive resistive loads and is faster than a traditional Op Amp. Additionally, source followers have a wide bandwidth and thus do not affect the specified high frequency corners. The circuit of Figure H5 also is advantageous in that it provides fast response while providing the ability to drive current through a load. More specifically, a differential pair of input MOSFETs H504 and H508 is coupled to receive a differential input signal. As may be seen, MOSFETs H504 and H508 are n-channel devices that are operably coupled to receive and amplify a differential signal. MOSFET H508 also is a p-channel device for conducting current and providing amplification during the alternate half of a signal cycle. The source terminals of input MOSFETs H504 and H508 are coupled to a current sink H512 that is terminated to circuit common and is for biasing the MOSFETs into their saturation region of operation.

The drain terminals of the MOSFETs H504 and H508 are coupled to at least two MOSFETs H516 and H520 that are themselves coupled and biased to provide a resistive load for each portion of a signal cycle. While not specifically shown herein Figure H5, the source to gate voltages are set to bias the MOSFETs H516 and H520 into an active region of operation (e.g., either the linear or saturation regions of operation) to facilitate using the MOSFETs in place of a resistive load. A drain terminal of MOSFET H516 is connected to a drain terminal of input MOSFET H504. A gate terminal of an output MOSFET H524 is coupled to the drain terminal of MOSFETs H516 and H504. A drain terminal of output MOSFET H524 is coupled to a voltage source and a source terminal of output MOSFET H524 is coupled to an output node and to a current sink H532 that is also coupled to circuit common.

Similarly, MOSFET H520 has a source terminal coupled to the voltage source and a drain terminal coupled to a drain terminal of input MOSFET H508. Additionally, a gate terminal of output MOSFET H536 is coupled to the drain terminals of MOSFETs H508 and H520. The drain of output MOSFET H536 also is coupled to the voltage source while the source terminal is coupled to a current sink H540 by way of an output node shown generally at H544.

In operation, the circuit of Figure H5 is advantageous in that it provides a fast response meaning that it provides reasonably sharp corner frequencies if the amplifier of Figure H5 is used in a filter. Moreover, because of the source follower, the circuit of Figure H5 is able to drive current through a load. One drawback with a solution shown in Figure H5, however, is that the output MOSFETs H524 and H536 both have a gate to source voltage drop that is in the order of 1.0 volt or more. Accordingly, because many CMOS devices are low voltage devices with a supply voltage that is approximately equal to 3 volts D.C., losing one volt of potential across the gate to source terminals of an output MOSFET that is for driving a load is undesirable. Thus, what is needed is a fast amplifier that is able to drive current through a load and that does not reduce or limit the output potential.

Figure H6 is a schematic diagram of a two-stage differential amplifier formed according to one embodiment of the present invention. Similar to the circuit of Figure H5, the circuit of Figure H6 comprises a differential amplifier pair coupled to receive an input signal and to amplify alternating portions of the signal. More specifically, an input MOSFET H604 and an input MOSFET H608 both have gate terminals coupled to receive the differential input signal, a source terminal coupled to a current sink H612 that, itself, is coupled to circuit common and a drain terminal coupled to the drain terminals of an active load shown generally at H614 comprising MOSFETs H616 and H620. The source terminals of MOSFETs H616 and H620 are coupled to a supply voltage source and the gate terminals are coupled to each other and are further biased by a common mode feedback bias circuit H622. In the described embodiment of the invention, an active load is used to bias MOSFETs H616 and H620 into an active region of operation. Typically, in discrete MOSFET amplifier design, a resistive load is used to define a bias point for a MOSFET transistor. Because resistors have a high IC real estate expense, however, it is desirable to utilize MOSFETs configured as resistors whenever possible. Using an active load serves as a good substitute for a resistive load. Additionally, using an active load increases the amount of gain of the amplifier as well.

Each set of drain terminals of MOSFETs H604 and H616 and MOSFETS H608 and H620, respectively, are coupled to a voltage follower configuration that further includes a current mirror. More specifically, the drain terminals of MOSFETs H604 and H616 are coupled to a gate terminal of a first MOSFET H624 of a first voltage follower pair shown generally at H626. A second MOSFET H628 of the first voltage follower pair H626 has a source terminal that is coupled to a source terminal of the first MOSFET H624 of the first voltage follower pair H626 and to a current sink H632 that is also coupled to circuit common. Current sink H632 is for biasing the MOSFETs of voltage follower H626 into an operational state (e.g., the saturation mode of operation). The gate terminal of second MOSFET H628 is coupled to an output node H636 that also is coupled to a drain terminal of second MOSFET H628. The drain terminals of both the first and second MOSFETs H624 and H628 of the first voltage follower pair H626 are coupled to a pair of drain terminals of a first current mirror H638 that includes MOSFETS H638A and H638B whose source terminals are coupled to the voltage source and whose gate terminals are coupled to each other as well as to the drain of MOSFET H624.

In operation, an output voltage from the differential amplifier appears across the gate to source terminals of voltage follower circuit H626. As the $V_{GS}$ of MOSFET H624 increases, the current flow through the MOSFET H624 increases and is reflected by the first current mirror H638 through MOSFET H628. Because the gate terminal of MOSFET H628 is coupled to its own drain terminal, any increased voltage at node H636 increases the $V_{GS}$ of MOSFET H628, thereby reflecting the $V_{GS}$ of MOSFET H624 that also is equal to the output of the differential amplifier. As may be seen, therefore, the output voltage is maintained by voltage follower circuit H626 that also is able to drive a load from output node H636.

Similarly, the drain terminals of MOSFETs H608 and H620 are coupled to a gate terminal of a first MOSFET H640 of a second voltage follower pair shown generally at H642. A second MOSFET H644 of the second voltage follower pair H642 has a source terminal that is coupled to a source terminal of the first MOSFET H640 of the second voltage follower pair H642 and to a current sink H648 that is also coupled to circuit common. The gate terminal of second MOSFET H644 is coupled to an output node H652 that also is coupled to a drain terminal of second MOSFET H644. The drain terminals of both the first and second MOSFETs H640 and H644 of the second voltage follower pair H642 are coupled to a pair of drain terminals of a second current mirror H656 whose source terminals are coupled to the voltage source and whose gate terminals are coupled to each other and to the drain of MOSFET H640. The operation and configuration of voltage follower H642 is similar to voltage follower H626.

With respect to the operation of the amplifier of circuit of Figure H6, a differential input signal is received at the gate terminals of MOSFETs H604 and H608. For the sake of simplicity, the operation for a positive cycle of a signal received at the gate terminal of MOSFET H604 shall be discussed although it is understood that similar signal response occurs for the input of MOSFET H608 for the alternate cycle portion of the signal when IN "N" is positive. As a positive signal cycle is received at the gate terminal of n-channel enhancement MOSFET H604, the n-channel MOSFET H104 conducts more current thereby drawing more current through MOSFET H616 (a p-channel MOSFET) of the active load H614 thereby causing a proportionate decrease in current through MOSFET H608. Because the current through MOSFET H608 decreases, the voltage at the drain of MOSFET H608 increases proportionately due to the decreasing voltage drop across active load H620. The increase in voltage at the drain of MOSFET H608 and, therefore, the gate of MOSFET H640 results in an increase in the output voltage at node H652 because, for the voltage follower configuration shown at H642, the gate to source voltage of MOSFET H644 follows the gate to source voltage of MOSFET H640 (as described for the similar configuration of voltage follower circuit H626). Because the two MOSFETs H640 and H644 have source terminals coupled to a current sink (for bias) and drain terminals coupled to a current mirror, the gate voltage of MOSFET H644 increases as the gate voltage of MOSFET H640 increases and the output voltage increases. As may be seen, therefore, the two stage amplifier disclosed herein provides voltage follower circuits that may be used to drive a current load while also providing a fast response when required for a particular function (e.g., filtering as a part of a filter circuit).

The described embodiment of the invention assumes MOSFETs H624 and H628 as well as the MOSFETs of the current mirror H638 are matched to create a current mirror. Thus, a current that is generated through MOSFET H624 as a result of a $V_{GS}$ across the gate to source terminals is duplicated by the current mirror for conduction into node H636 where it is conducted either through MOSFET H628 or through a load. The current conducted into node H636 is equal to the current through MOSFET H624 if the devices a matched and scaled. The gate to source voltage of MOSFET H628 is equal to the gate to source voltage of MOSFET H624 under these conditions as well. In one embodiment of the invention, however, the MOSFETs are all matched but not scaled. More specifically, a fixed scaling ratio is defined in terms of channel dimensions between MOSFETs H628 and H624 and their respective MOSFETs of current mirror H638. For example, if MOSFET H628 is formed to have channel dimensions that are twice that of MOSFET H624, and the channel dimensions of the left hand MOSFET of current mirror H638 is formed to have channel dimensions that are twice that of the right hand MOSFET of current mirror H638, then the current through node H636 will be twice the current through MOSFET H624. Even in this case, however, the circuit is still a voltage follower meaning that the $V_{GS}$ of MOSFET H624 and H628 will remain equal in part because the components are matched (though not scaled). It is understood, of course, that the same level of scaling and matching should be present in the second current mirror H656 among the various MOSFETs H640, H644 and current mirror H656 thereof.

SECTION I

Figure I4 is a functional schematic diagram that illustrates one embodiment of the present invention. As may be seen, an impedance device, here an inductive load I404, is coupled in series with a pair of MOSFETs I408 and I412. As may be seen, MOSFETs I408 and I412 are coupled in parallel. Additionally, the series combination of inductive load I404 and MOSFETs I408 and I412 are coupled in parallel to a MOSFET I416.

The described circuitry is further coupled in series with a pair of amplification MOSFETs I420A and I420B. The gates of amplification MOSFETs I420A and I420B are coupled to receive an input signal that is to be amplified, while the gate of MOSFET 1408 is coupled to a voltage source, for example, $V_{DD}$. The gates of MOSFETs I412 and I416, however, are coupled to receive opposite states of a control logic signal $C_1$. Accordingly, one of the two MOSFETs I412 and I416 will be biased to the on position, while the other is biased to the off position.

In operation, MOSFET I408 is always biased on and acts as a resistive load in series with inductive load I404. The output node of the circuit is the node between inductive load I404 and MOSFET I408. Accordingly, if MOSFET I416 is turned off, meaning that MOSFET I412 is turned on, then all of the current from $V_{DD}$ to ground that flows through amplification MOSFETs I420A and I420B will also flow through inductive load I404 and through the parallel combination of MOSFETs I408 and I412. This configuration maximizes the output voltage at the node between inductive load I404 and MOSFET I408 as it maximizes the current flowing through the inductive load I404. However, if $C_1$, the control signal for MOSFETs I412 and I416, is set to 0, then the gate voltage for MOSFET I416 is biased high (due to the inverter), thereby turning on MOSFET I416 and turning off MOSFET I412. Here, half of the current that flows through amplification MOSFETs I420A and I420B will continue to flow through MOSFET I408 and inductive load I404, while approximately half of the current flows through MOSFET I416. Accordingly, as may be seen, the output signal is steered in to and out of inductive load I404 thereby modifying the output at the defined output node. An advantage of the configuration of Figure I4 is that a constant number of nearly identical MOSFET are kept on at any instant. Thus, the capacitance introduced by the MOSFETs remains constant and the output load remains constant as the amplifier gain is being modified.

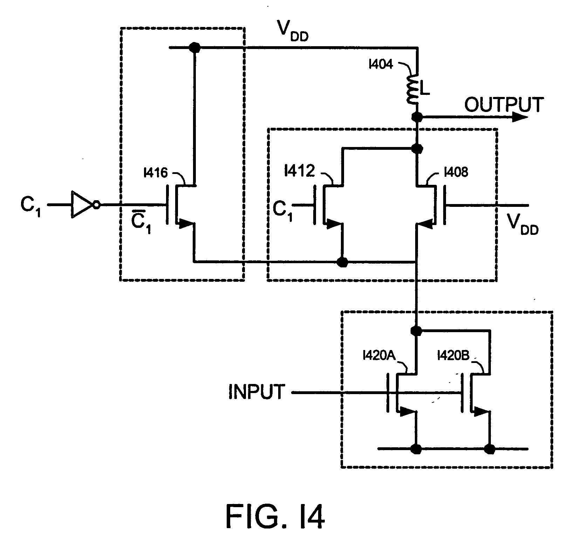

In the example of Figure 14, the number of transistors in parallel to MOSFET I408 is equal to "n", where "n minus 1" is the desired number of gain steps. The number of transistors, therefore, that are coupled in parallel to inductive load I404 and MOSFETs I408 and I412 also is equal to "n". The number of transistors that are coupled to receive the input signal, however, is equal to "n + 1" which, in the example shown, is equal to 2. Only one transistor is shown in parallel with MOSFET I408 and only one transistor is shown in parallel with the combination of inductive load I404 and MOSFETs I408 and I412. However, as may be seen, two MOSFETs are coupled to receive the input signal. It is understood, however, that "n" represents one more transistors and a reference to MOSFET I412 or I416 is a reference to "n" transistors.

The circuit of Figure I4, therefore, is advantageous in that amplification MOSFETs I420A and I420B receive the input signal and determine the amount of current that flows through MOSFETs I408, I412 and I416. The current that flows through amplification MOSFETs I420A and I420B flows through either MOSFETs I412 or I416, according to which one is biased on, and through MOSFET I408. Thus, an approximately equal amount of current flows through each of the MOSFETs I420A and I420B that flows through each of the MOSFETs I408 and I412 or I416 according to which one is biased on.

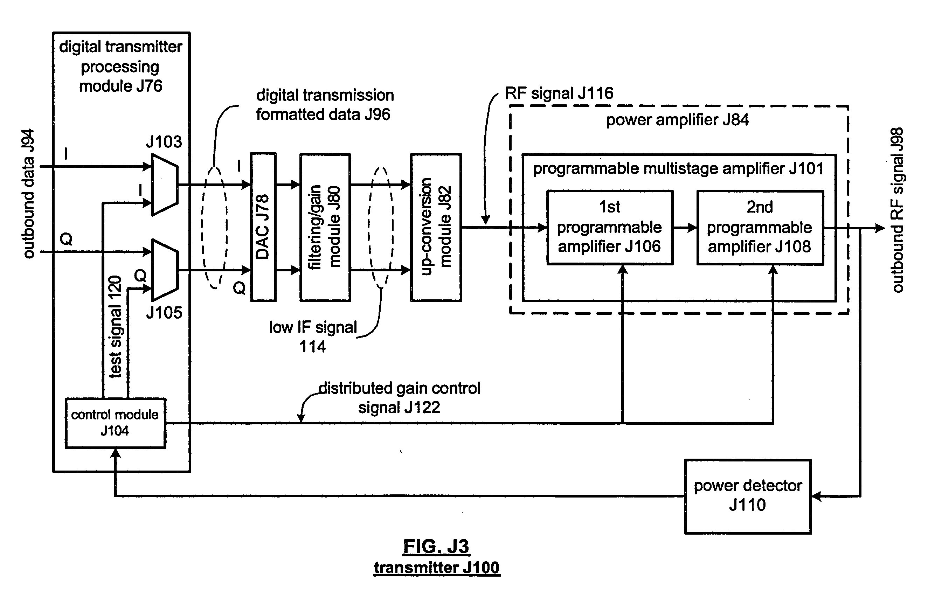

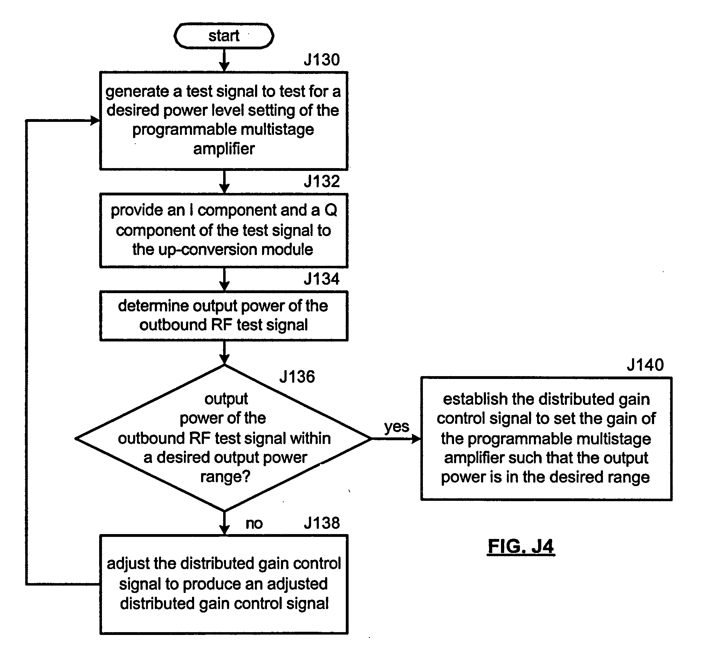

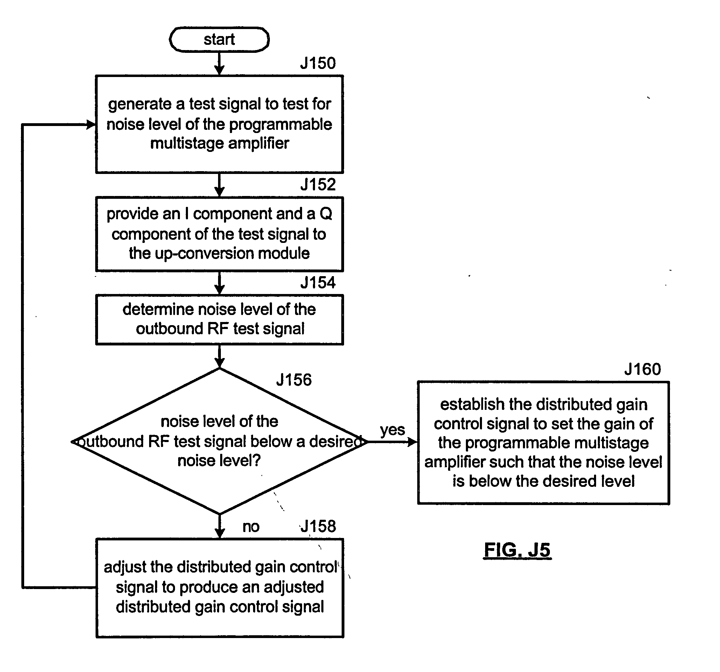

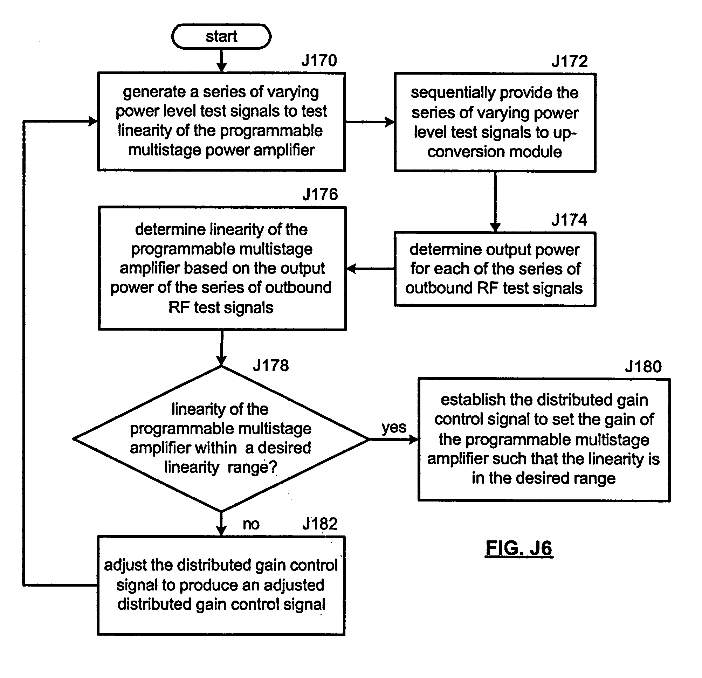

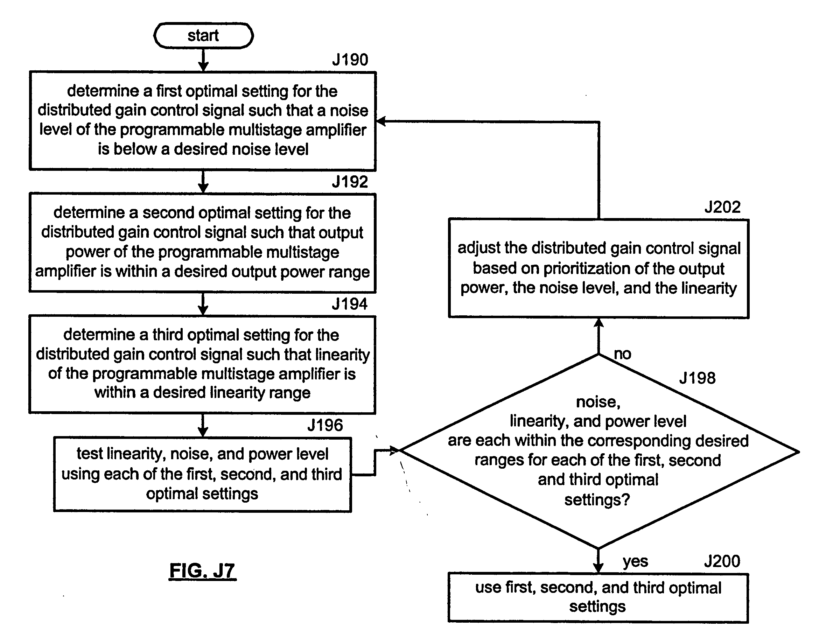

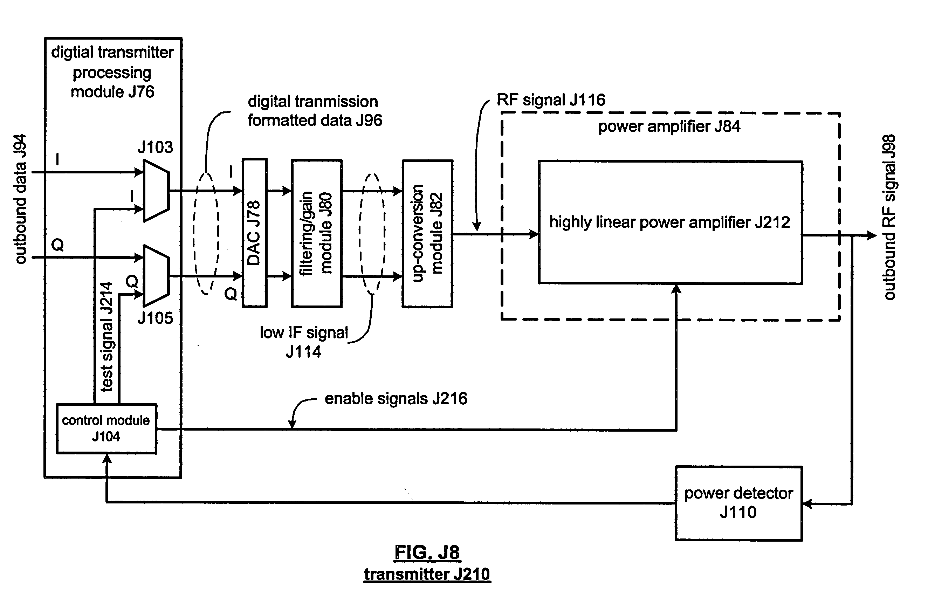

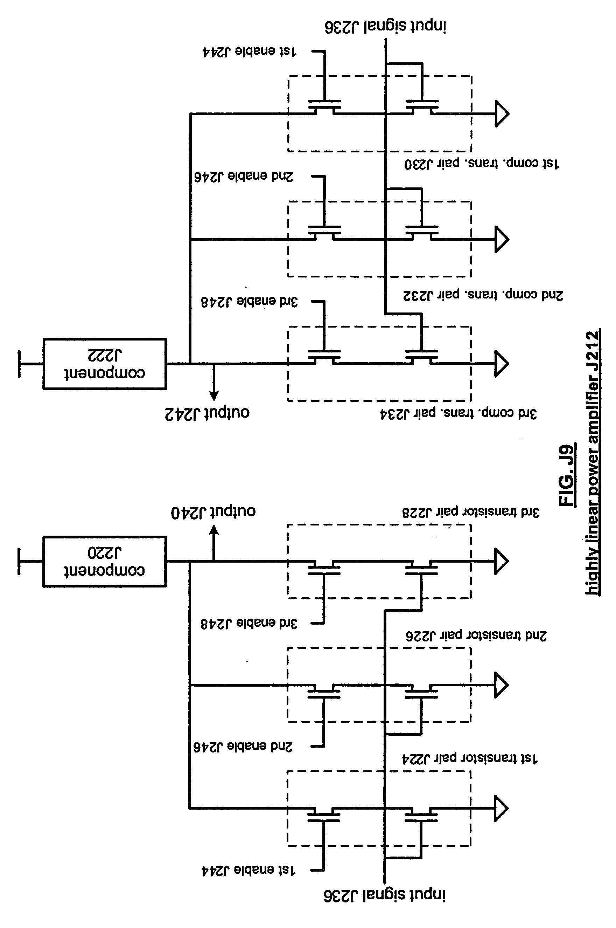

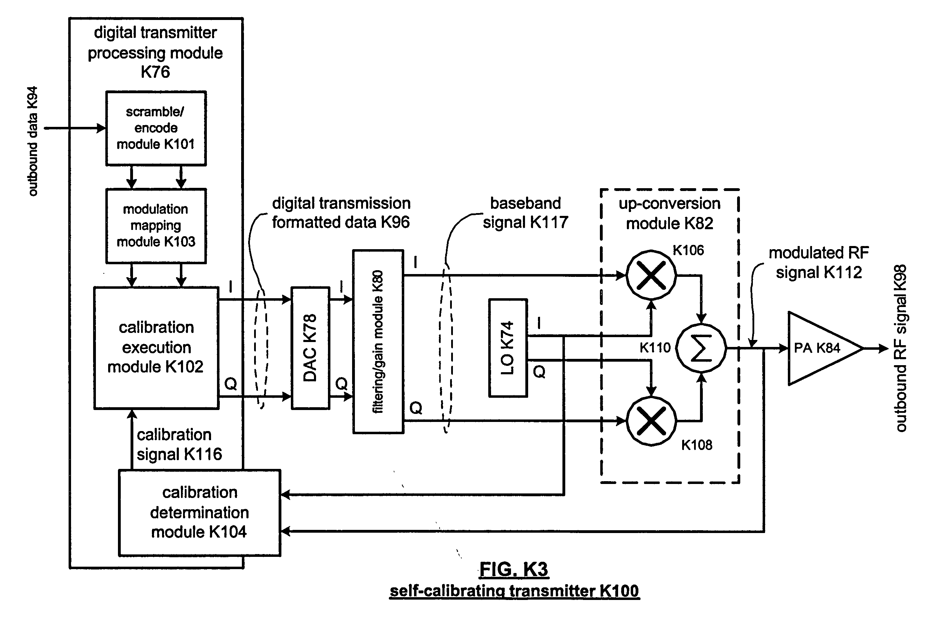

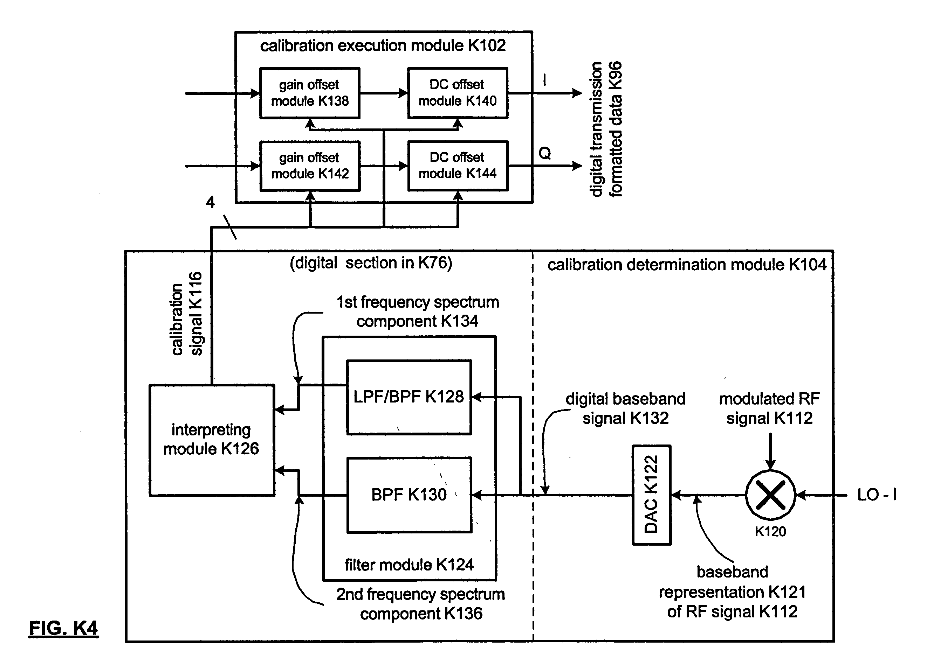

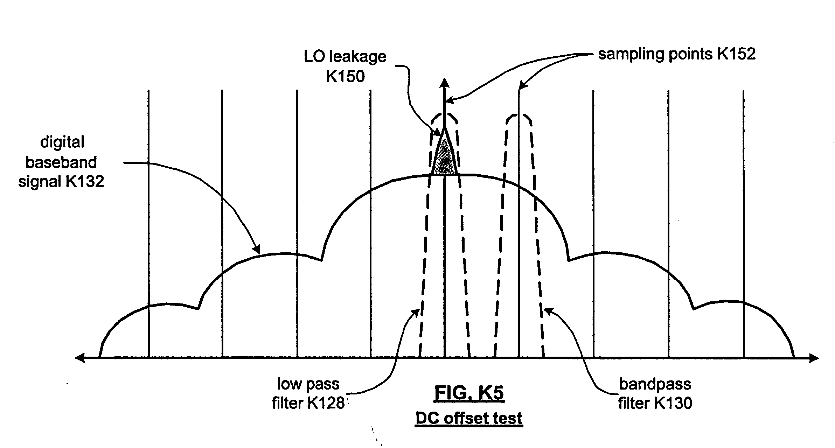

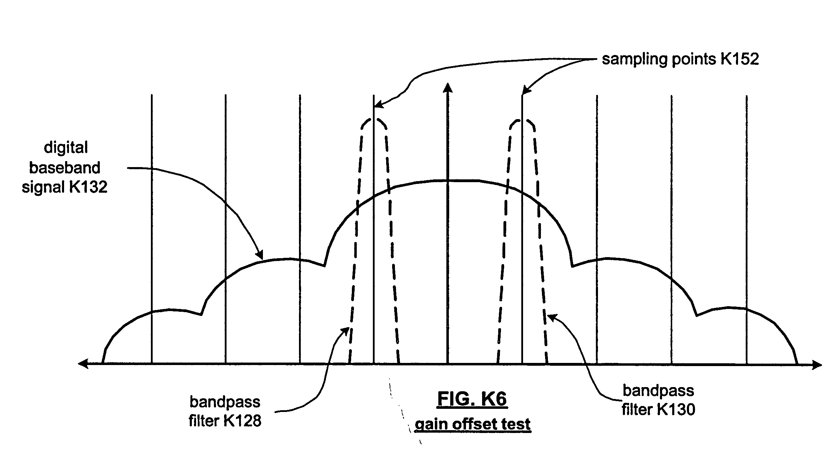

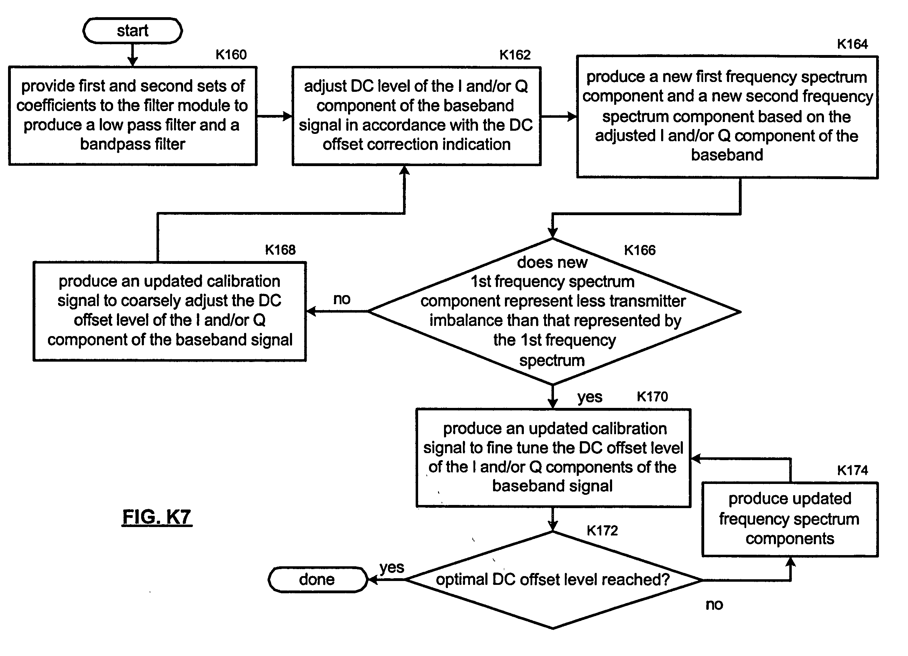

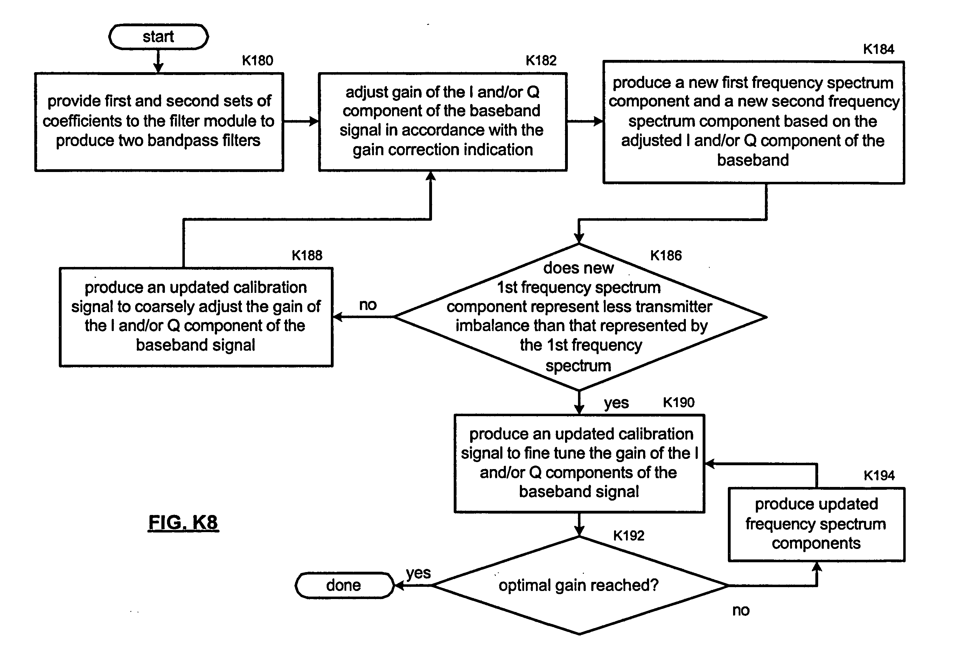

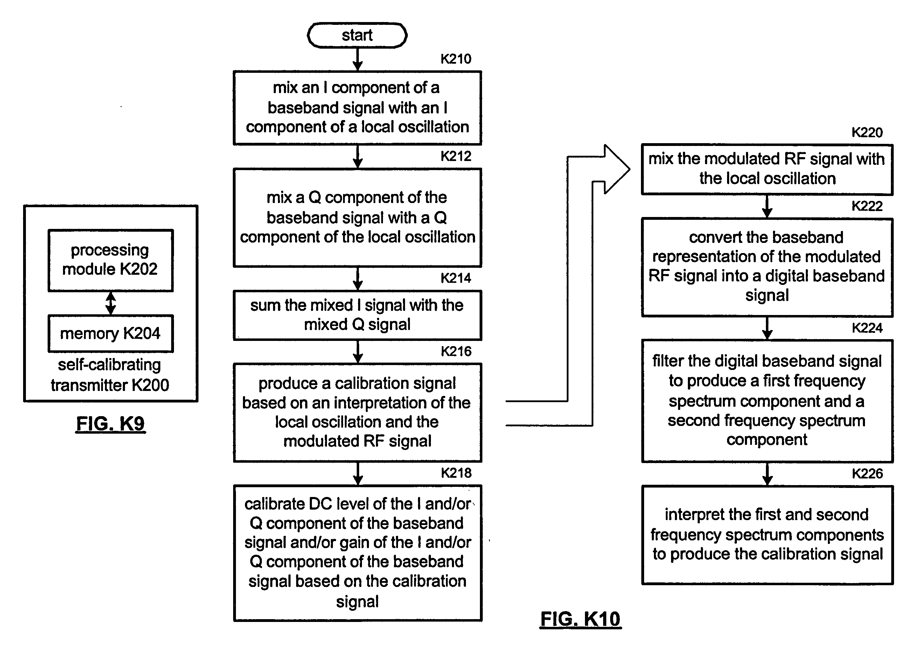

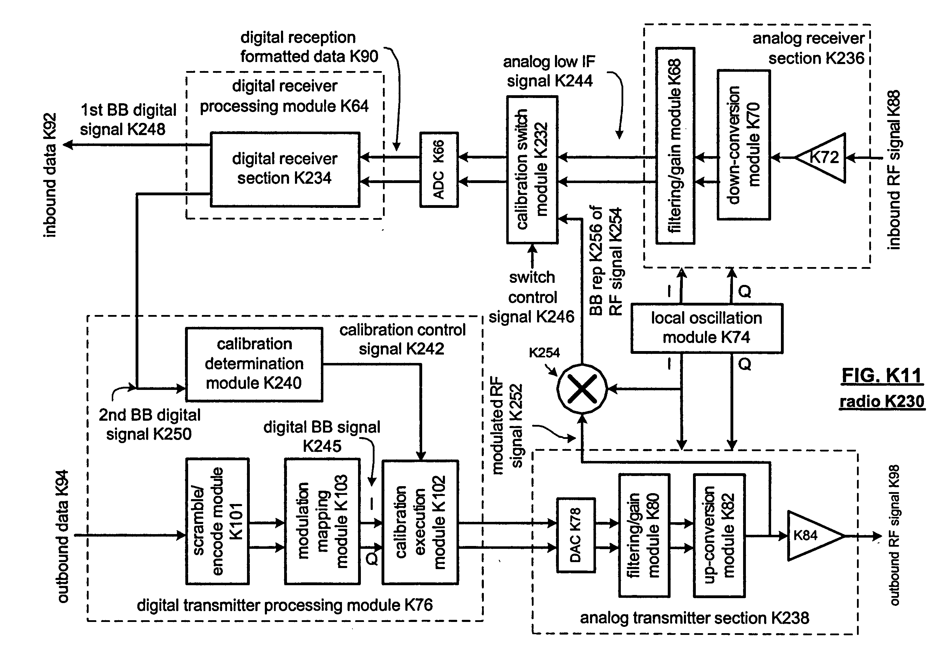

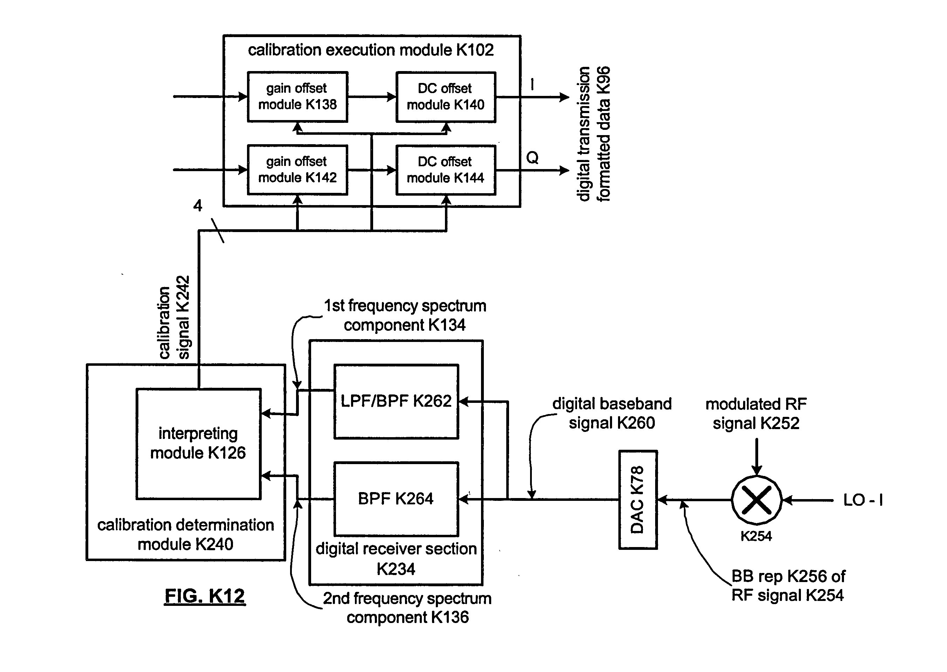

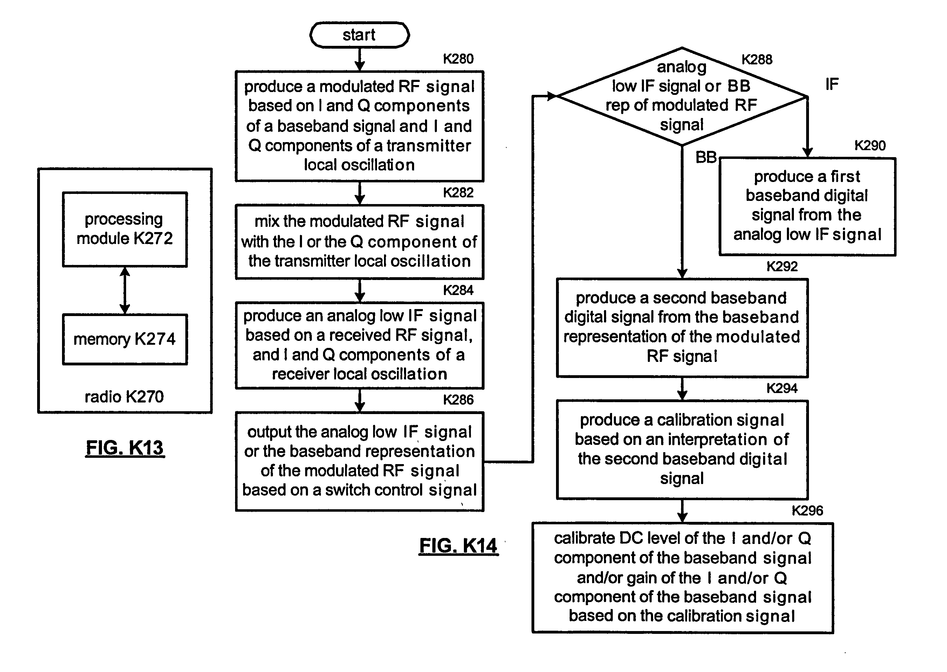

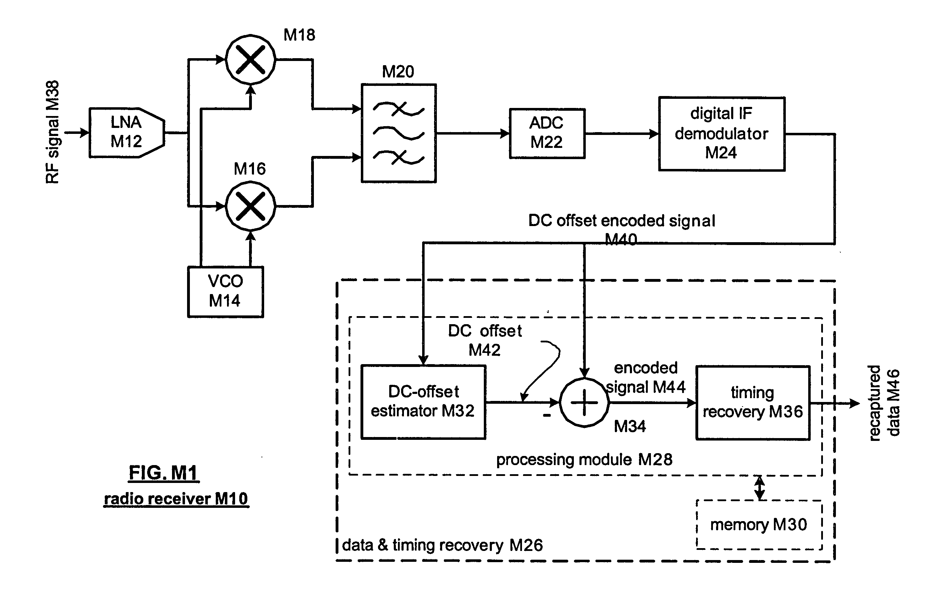

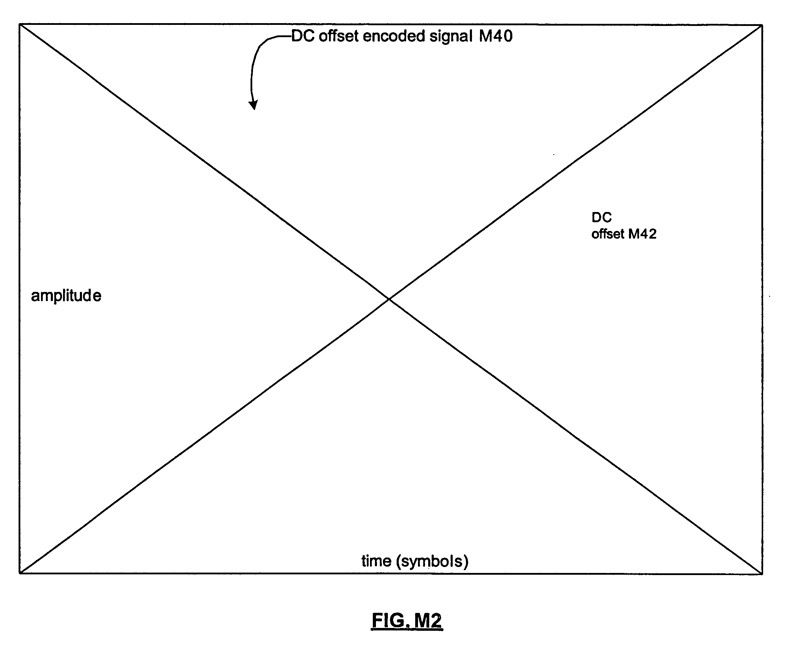

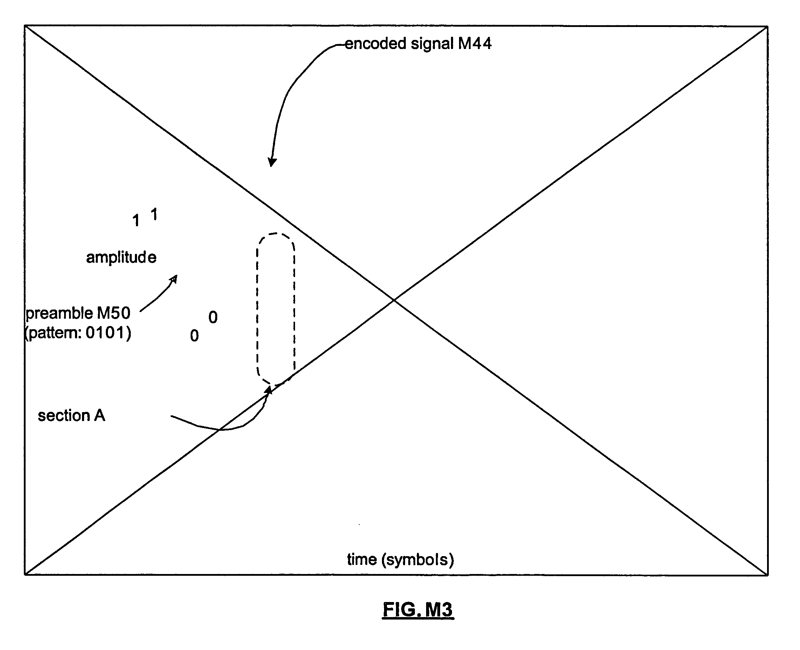

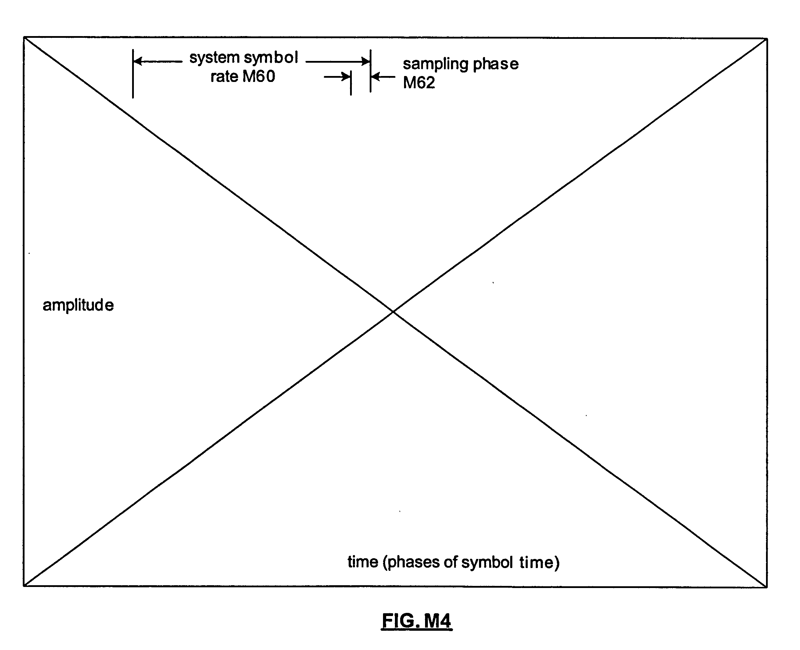

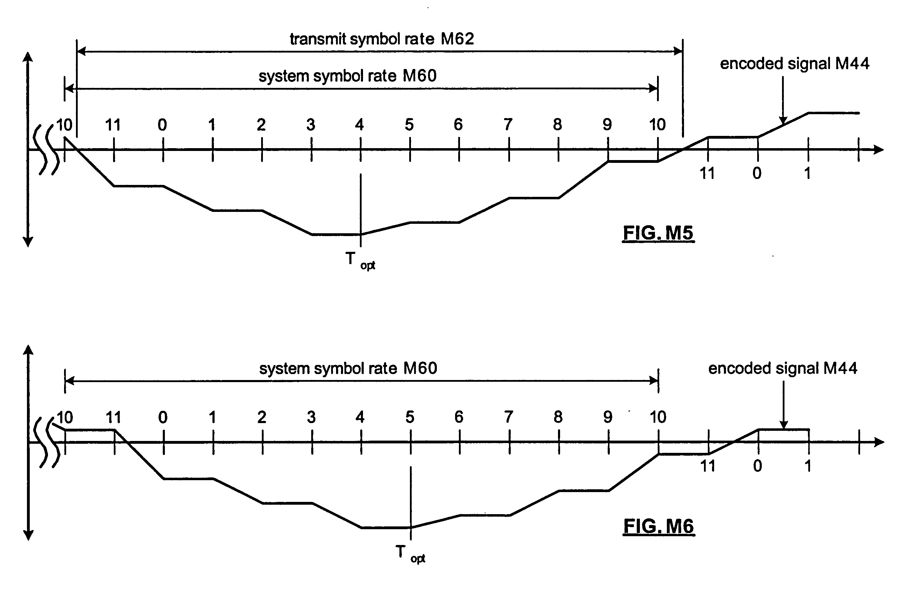

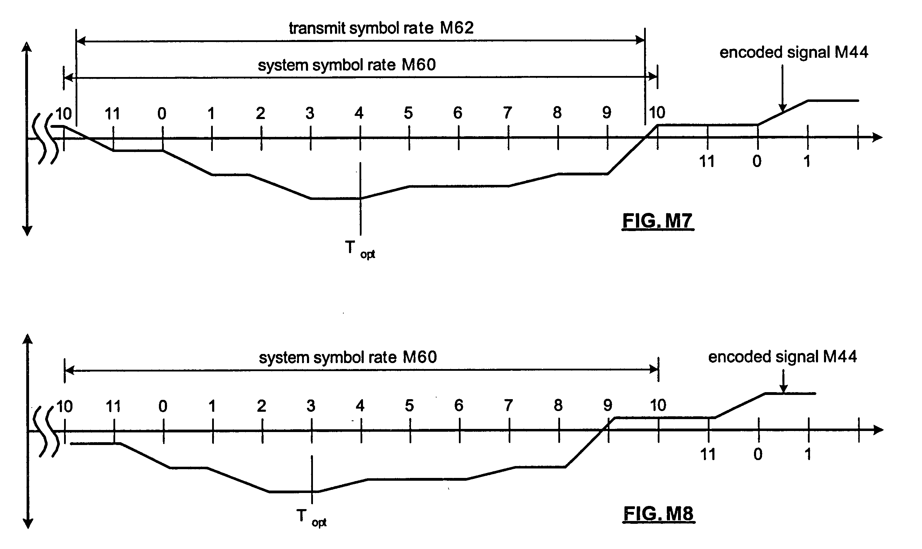

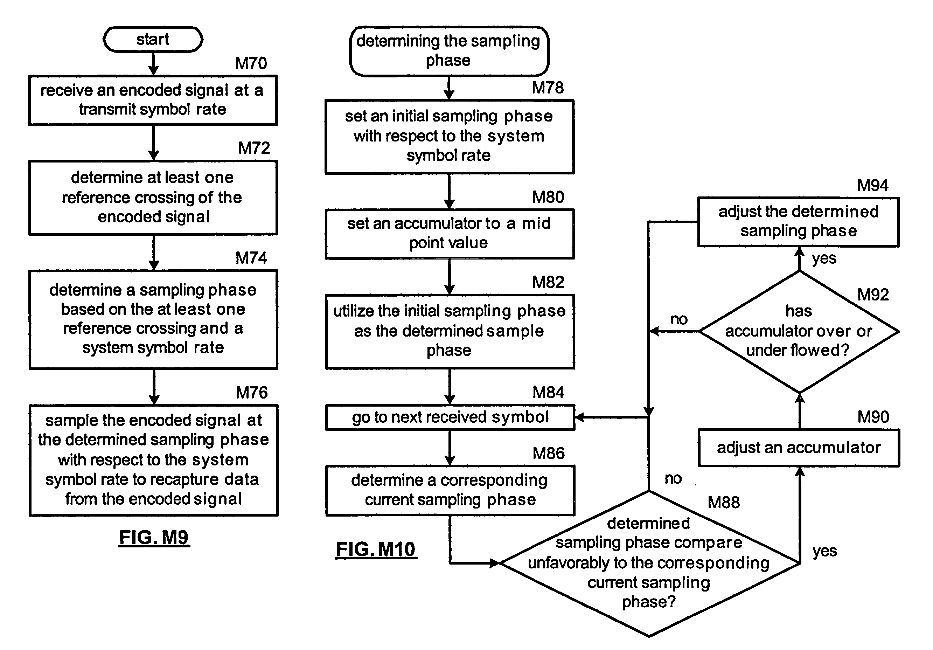

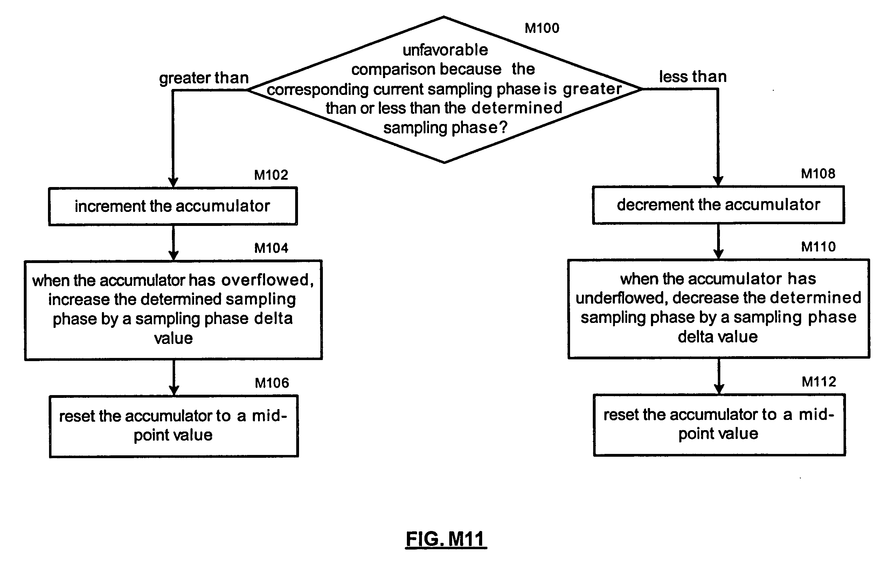

Figure 15 is a functional schematic diagram that illustrates another embodiment of the described invention. A first group of MOSFETs I504 include a plurality of matched MOSFETs I504A, I504B and I504C, wherein the number of transistors matches the number of gain steps desired. More specifically, the number of transistors within the first group of MOSFETs I504 is equal to "$1+n_1+n_2$" in which "$n_1$" and "$n_2$" reflect that a number of transistors may be used in place of the one that is shown.

A second group of MOSFETs I508 also include a plurality of MOSFETs I508A, I508B and I508C. More specifically, the number of transistors of the second group of MOSFETs I508 is equal to "$1+n_1+n_2$." A third group of MOSFETs I512 includes "$n_1+n_2$" transistors shown here in Figure I5 as I512B and I512C. As may be seen, the source of each of the transistors of the second and third groups of MOSFETs I508 and I512 are coupled to a common node with the transistors of the first group of MOSFETs I504. The drains of the second group of MOSFETs I508 are coupled to an output node and also to one end of an inductor I516. In the described embodiment, inductor I516 is an inductive load, although other impedance load devices may be used.

The drains of the transistors of the third group of MOSFETs I512 are merely coupled to a voltage source, here, $V_{DD}$, and to a second end of inductor I516. Effectively, the third group of transistors is coupled in parallel to the series combination of inductor I516 and the second group of MOSFETs I508. Both the second and third groups of transistors are coupled in series within the first group of transistors.

As was stated before, the first group of transistors has a total number of "$1+n_1+n_2$" transistors. This number reflects the number of desired amplifier gain stages. This number also reflects the number of transistors that are operationally biased at any given instant given the biasing logic of the transistors in the second and third groups of transistors. More specifically, for each of the $n_1$ MOSFETs I508B of the second group of MOSFETs I508, there is an equal number of $n_1$ MOSFETs I512B of the third group of MOSFETs I512. However, MOSFETs I508B are biased with a signal that is the logical opposite of the biasing signal for the group of MOSFETs I512B. Similarly, for each of the $n_2$ MOSFETs I508C of the second group of MOSFETs I508, there is an equivalent number of $n_2$ MOSFETs I512C of the third group of MOSFETs I512. The MOSFETs I508C are biased with a logically opposite signal to that of the group of MOSFETs I512C so that at any one time only the $n_2$ transistors of the second group of MOSFETs I508, or the $n_2$ transistors of the third group of MOSFETs IS 12, are biased on.

According to the biasing signals $C_1$ and $C_2$, current is steered into or out of the impedance device, here inductor I516. Because MOSFET I508A is always biased by a supply voltage VDD, MOSFET I508A is always on. If $C_1$ and $C_2$ are biased to a logic 1, all of the current being drawn by the first group of MOSFETs I504 is conducted through each of the transistors of the second group of MOSFETs I508, thereby maximizing the voltage drop across inductor I516. According to the logic setting of $C_1$ and $C_2$ and the number of transistors forming $n_1$ and $n_2$, the steps in the gain size may be controlled at the output shown here in Figure 15. For example, if $n_1$ is equal to 2 and $n_2$ is equal to 4, then each of the first and second groups of MOSFETs I504 and I508, respectively, include seven transistors total. If $C_2$, in this example, is biased to logic 0, then $3/7^{th}$ of the current is propagated through inductor I516 and $4/7^{th}$ of the current is propagated through the third group of MOSFETs I512. Accordingly, the reduction in current through inductor I516 reduces the voltage drop across inductor I516 and, therefore, the output signal magnitude.

Regardless of the logic settings of $C_1$ and $C_2$, there are always exactly 14 transistors that are biased and operational at any given instant. For the example described herein, wherein $n_2$ is equal to 4 transistors and $n_1$ is equal to 2 transistors, if $C_1$ and $C_2$ are both a logic 0, MOSFET I508A is always biased on and, therefore, $1/7^{th}$ of the signal is applied thereto. In that case, $6/7^{th}$ of the signal is applied to the 6 transistors of the third group of MOSFETs I512.

Figure I5 illustrates that signal step sizes may be varied in a non-linear manner. Additionally, because a constant number of transistors are always biased on, parasitic capacitance that is introduced by the MOSFETs remain constant, thereby enabling the tuning of the circuit of Figure 15 to remain constant. Additionally, it is understood that additional groups of transistors may be included in the described manner to increase the number of gain settings or steps. Finally, the example herein assumes a constant biasing voltage thereby causing a constant effective resistance since the MOSFETs are biased in the linear (non-saturated) region. Alternatively, the effective resistance and, therefore, current steering, may be provided by changing the bias voltage on the gate terminal while the MOSFETs are operating in the linear region.

Figure I6 is a functional schematic block diagram of an RF processing unit of a radio transceiver formed according to one embodiment of the present invention. An RF receiver unit includes a receiver/low noise amplifier (LNA) I604 that is coupled to receive wireless radio communications by way of an antenna. As is known by those of average skill in the art, radio communications typically employ one of many different modulation techniques, including QPSK, et al. Accordingly, receiver/LNA I604 produces an amplified signal containing I and Q modulated channels to mixers I608A and I608B for separation into the I and Q modulated channels. In the described embodiment of the invention, the radio transceiver is formed to satisfy 802.11b design requirements. Accordingly, at any time, the RF input signal is centered on a particular RF channel within the 2.4 GHz carrier frequency band. The RF input signal then is down converted to a baseband signal.

The mixers I608A and I608B both receive the RF input signal from receiver/LNA 1604. Mixers I608A and I608B also receive I and Q phases, respectively, of an LO signal having a specified frequency component from phase-locked loop circuit I620. Mixer I608B, as may be seen, receives the Q phase of the LO signal from a local oscillator I620 by way of a phase shift circuit I624 that provides a 90° phase shift to the LO signal. Accordingly, mixer I608B produces the Q component of the baseband signal, while mixer I608A produces the I component of the baseband signal. Thereafter, mixers I608A and I608B provide the I and Q components of baseband signal to low pass filters I612A and I612B for the I and Q modulated channels, respectively.

As is known, low pass filters I612A and I612B are for blocking all communication signals above a specified frequency. The outputs of low pass filters I612A and I612B are then produced to programmable gain amplifiers (PGAs) I616A and I616B. Additionally, a gain control circuit I628 receives signal strength indications from received signal strength indicator (RSSI) circuits I632 and I636. RSSI I632 produces a signal strength indication for a wide band signal (signal plus interference) for an amplified signal received from an input node of the filters I612A and I612B. RSSI I636 produces a signal strength indication from an output node of filters I616A and I616B. Accordingly, gain control circuit implements logic to set a gain level for the received/ LAN I604 according to the relative strengths of the outputs of RSSIs I632 and I636. As may be seen, in the described embodiment of the invention, gain control circuit I628 produces two logic signals C1 and C2 on lines I640 and I644, respectively, that serve to operatively bias MOSFETs within the receiver/LNA as described herein. Finally, in the described embodiment, the analog-to-digital converters (ADCs) are within the baseband processing circuitry external to the IF radio integrated circuit.

In operation, the low noise amplifier from the receiver portion of a radio transceiver, receives a wireless communication signal from an antenna and amplifies the signal, as well as separate it, into the I and Q channels of the circuitry (in QPSK systems). For the sake of simplicity, the I channel will be described herein. The communication signals on the I channel are then produced to mixer I608A that adjusts the frequency of the received signals or communication channel to a specified frequency. Here, because the receiver is an 802.11b receiver, the frequency channel for the received RF signals is centered about 2.4 GHz. Thereafter, the signal is down converted to a baseband channel that is approximate to DC (e.g., 5 MHz) relative to the received RF. The baseband channel is then produced to low pass filter I612A that defines an upper corner frequency and filters (attenuates) all signals above that frequency.

Each of the circuit elements of the radio receiver in this path thus far, namely, receiver/LNA I604, mixer I608A, and low pass filter I612A, add gain to the received signals. Because the gain of the received signal can vary dramatically, however, the gain of the LNA programmable gain amplifier is adjusted so that the gain of the output signal being provided to the baseband radio circuitry is of a constant level. Unfortunately, many common LNA programmable gain amplifiers provide a very limited number of amplification steps, if any. Moreover, those that do provide for gain steps often change the resonant frequency of the circuit, changing the circuit's total capacitance by at least a small amount whenever the MOSFETs biased to act as resistors are switched in and out of the circuit.

SECTION J

Figure J3 illustrates a more detailed schematic block diagram of a transmitter J100 that may be used in radio J60. In this embodiment, the digital transmitter processing module J70 includes multiplexors J103 and J105 and control module J104. The power amplifier J84 is implemented utilizing a programmable multi-stage amplifier J101 that includes a 1st programmable amplifier J106 and a 2nd programmable amplifier J108. The transmitter J100 also includes a power detector J110 that determines the output power of the outbound RF signal J98 utilizing a transmitter signal strength indication and/or any other technique for determining output power levels of RF signals. As one of average skill in the art will appreciate, the programmable multi-stage amplifier J101 may include more than two programmable amplifiers.

During normal operation, the control module enables multiplexors J103 and J105 to pass the I and Q components of outbound data J94 to the digital-to-analog converter J78. The digital-to-analog converter J78 converts the I and Q components of the digital transmission formatted data J96 into corresponding analog signals. The filtering/gain module J80 converts the analog transmission formatted data into a low IF signal J114, which has an intermediate frequency ranging from zero Hertz to a few megahertz. The up-conversion module J82, based on a transmitter local oscillation provided by the local oscillator module J74, converts the low IF signal J114 into an RF signal J116.

The power amplifier J84, via the programmable multi-stage amplifier J101 amplifies the RF signal J116, based on a distributed gain control signal J122, to produce the outbound RF signal J98. The distributed gain control signal J122 provides a gain control signal to the 1st programmable amplifier J106 and a gain control signal to the 2nd programmable amplifier J108. Note that the 1st and/or 2nd programmable amplifiers J106 and/or J108 may be implemented in accordance with the highly linear power amplifier illustrated in Figure J9.

To determine the distributed gain control signal J122, the control module J104 places the transmitter J100 in a test mode by enabling multiplexors J103 and J105 to respectively output an I and Q component of a test signal J120. During test mode, the digital-to-analog converter J78 converts the I and Q components of the test signal J120 into corresponding analog signals, which are subsequently filtered and/or gain adjusted by the filtering and gain module J80. The up-conversion module J82 converts the analog representation of the test signal J120 into a test RF signal based on the transmitter local oscillation. The power amplifier J84, via the programmable multi-stage amplifier J101 amplifies the RF test signal to produce an outbound RF test signal. The power detector J110 detects the power level of the outbound RF test signal and provides it back to the control module J104. Depending on what aspect the control module is currently testing (i.e., for noise level, linearity, or power levels), the control module determines whether the current setting for the gain of the 1st programmable amplifier and 2nd programmable amplifier J108 meets the desired limits. If so, the control module J104 switches back to normal operating mode by enabling the multiplexors J103 and J105 to pass the I and Q components of the outbound data J94.

If, however, the current gain settings for the 1st and 2nd programmable amplifiers J106 and J108 do not produce an output within the desired performance levels, the control module J104 changes the distributed gain control signal thus changing the gain of the 1st and/ or 2nd programmable amplifiers. Having changed the gain, the control module J104 again provides test signal J120 to the transmitter and again determines its output power for this signal. This process continues until the outbound RF test signal is within the desired parameters.

Figure J4 illustrates a logic diagram of a method for establishing a desired power level setting for the programmable multi-stage amplifier J101 which may be executed by control module J104. The process begins at Step J130 where the control module generates a test signal to test for a desired power level setting of the programmable multi-stage amplifier. The process then proceeds to Step J132 where the control module provides an I component and a Q component of the test signal to the up-conversion module. The up-conversion module produces an RF test signal that is amplified by the programmable multi-stage amplifier to produce an outbound RF test signal.

The process then proceeds to Step J134 where the control module determines output power of the outbound RF test signal. The process then proceeds to Step J136 where the control module determines whether the output power of the outbound RF test signal is within a desired output power range. For instance, depending on the mode of operation, the output power may be in a power conservation mode, sleep mode, or max power mode, and/or any other mode of operation that would affect the output level of the transmitter. If the output power is within the desired output range, the process proceeds to Step J140 where the distributed gain control signal is established to set the gain of the programmable multi-stage amplifier to maintain the output power in the desired range. In many instances, the gain will remain as set for the current test.

If, however, the output power of the outbound RF test signal is not within the desired output power range, the process proceeds to Step J138. At Step J138, the control module adjusts the distributed gain control signal (i.e., adjust the gain provided to the 1st and/or 2nd programmable amplifiers) to produce an adjusted distributed gain control signal. At this point, the process reverts back to Step J130 and repeats until the output power of the outbound RF test signal is within a desired output power range.

Figure J5 illustrates a logic diagram of a method for determining noise level for the programmable multi-stage amplifier, which may be executed by control module J104. The process begins at Step J150 where the control module generates a test signal to test for noise level of the programmable multi-stage amplifier. The process then proceeds to Step J152 where the control module provides an I and Q component of the test signal to the up-conversion module. The up-conversion module converts the I and Q components of the test signal based on a local oscillation to produce an RF test signal. The programmable multi-stage amplifier amplifies the RF test signal to produce an outbound RF test signal.

The process then proceeds to Step J154 where the control module determines the noise level of the outbound RF test signal. The process then proceeds to Step J156 where the control module determines whether the noise level of the outbound RF test signal is below a desired noise level. If so, the process proceeds to Step J160 where the control module establishes the distributed gain control signal to set the gain of the programmable multi-stage amplifier such that the noise level is below the desired noise level.

If, however, the noise level of the outbound RF test signal is not below the desired noise level, the process proceeds to Step J158. At Step J158, the control level adjusts the distributed gain control signal (i.e., changes the gain control signal provided to the 1st and/ or 2nd programmable amplifier) to produce an adjusted distributed gain control signal. The process then reverts back to Step J150 where the process repeats until the noise level of the outbound RF test signal is below a desired noise level. Note that the test signal may be a zero signal wherein all outputted signals is representative noise, the test signal may be a test signal having a fixed frequency and fixed amplitude such that any deviation therefrom is reflective of noise, and/or any other type of signal such that noise can be readily distinguished from the signal. As one of average skill in the art will appreciate, the noise level may be detected by a signal-to-noise ratio, and/or any other mechanism for measuring noise components of a signal.

Figure J6 illustrates a logic diagram of a method that may be executed by the control module J104 to determine linearity of the programmable multi-stage amplifier. The process begins at Step J170 where the control module generates a series of varying power level test signals to test the linearity of the programmable multi-stage amplifier. The process then proceeds to Step J172 where the control module sequentially provides the series of varying power level test signals to the up-conversion module. The up-conversion module converts each of the test signals into RF test signals, which are subsequently amplified by the programmable multi-stage amplifier to produce a plurality of outbound RF test signals.

The process then proceeds to Step J174 where the control module determines output power for each of the series of outbound RF test signals. The process then proceeds to Step J176 where the control module determines linearity of the programmable multi-stage amplifier based on the output power of the series of output RF test signals. For instance, if the programmable multi-stage amplifier is linear, the ratio between the input power and output power for each of the test signals should be the same, within reasonable engineering tolerances.

The process then proceeds to Step J178 where the control module determines whether the linearity of the programmable multi-stage amplifier is within a desired linearity range. If so, the process proceeds to Step J180 where the control module establishes the distributed gain control signal to set the gain of the programmable multi-stage amplifier such that the linearity is within the desired range. Typically, this entails setting the gain for the 1st and/or 2nd programmable amplifiers at the gain used when the linearity was determined to be within the desired range.

If, however, the linearity of the programmable multi-stage amplifier is not within a desired linearity range, the process proceeds to Step J182. At Step J182, the control module adjusts the distributed gain control signal to produce an adjusted distributed gain control signal. As such, the control module is adjusting the gain of the 1st and/or 2nd programmable amplifier. At this point, the process repeats at Step J170 until the linearity of the programmable multi-stage amplifier is within the desired linearity range.

Figure J7 illustrates a logic diagram of a method that may be implemented by the control module to balance the distributed gain setting signal for power levels, linearity and/or noise. The process begins at Step J90 where the control module determines a 1st optimal setting or the distributed gain control signal such that the noise level of the programmable multi-stage amplifier is below the desired noise level. This may be done as discussed with reference to Figure J5. The process then proceeds to Step J192 where the control module determines a 2nd optimal setting for the distributed gain control signal such that the output power of the programmable multi-stage amplifier is within a desired output power range. This may be done in accordance with the process illustrated in Figure J4. The process then proceeds to Step J194 where the control module determines a 3rd optimal setting for the distributed gain control signal such that the linearity of the programmable multi-stage amplifier is within a desired linearity range. This may be done as described in Figure J6.

The process then proceeds to Step J196 where the control module tests the linearity, noise, and power level using each of the 1st, 2nd and 3rd optimal settings. As such, the control module, utilizing the 1st optimal setting, tests the linearity and power levels to determine whether they are within the respective ranges. Similarly, the control module uses the 2nd optimal setting to determine whether the noise and linearity are at desired levels or within desired ranges. Also, the control module utilizing the 3rd optimal setting to determine whether the power level and noise are within their respective ranges.

The process then proceeds to Step J198 where the control module determines whether, for any of the 1st, 2nd or 3rd optimal settings, the noise, the linearity and/or the power level is not within its desired range and/or level. If the noise, linearity and power level for all three optimal settings are within their respective ranges, the process proceeds to Step J200. At Step J200, the control module uses one, or more in combination, of the 1st, 2nd or 3rd optimal settings for the distributed gain control signal.

If, however, at Step J198, the response was negative, the process proceeds to Step J202. At Step J202, the control module adjusts the distributed gain control signal based on prioritization of output power, noise level or linearity. Such a prioritization would be based on the particular application and/or wireless communication standard being implemented by the radio. For example, noise and output power are of greater importance than linearity for a Bluetooth application. Conversely, linearity is a primary concern in an 802.11.a or .b application

After adjusting the distributed gain control signal, the process reverts to Step J190. The processing continues until a distributed gain control signal can be determined which satisfies the desired noise level requirements, desired output level requirements and the desired linearity requirements. If such an optimal setting cannot be obtained, one or more of the desired output power, noise level or linearity is adjusted to reach a compromised setting.

Figure J8 illustrates a schematic block diagram of an alternate transmitter J210 that may be utilized in radio J60. The transmitter J210 includes the digital transmitter processing module J76, the digital-to-analog converter J78, the filtering/gain module J80, up-conversion module J82, the power amplifier J84, and the power detector J110. The digital transmitter processing module J76 is configured to include control module J104 and multiplexors J103 and J105. The power amplifier J84 is implemented using highly linear power amplifier J212. The gain of the highly linear power amplifier J212 may be adjusted in accordance with enable signals J216 while having negligible effect on the linearity of power amplifier J212. The details of power amplifier J212 will be discussed in greater detail with reference to Figure J9.

In operation, the control module J104 enables multiplexors J103 and J105 to output an I and Q component of outbound data J94 to the digital-to-analog converter J78. The digital-to-analog converter J78, filtering/gain module J80 and up-conversion module J82 perform as previously discussed. The highly linear power amplifier J212 amplifies the RF signal J116 at a particular gain setting, which is established via enable signals J216 to produce the outbound RF signal J98.

To determine the enable signals J216, and thus the particular gain setting for the highly linear power amplifier J212, the control module J104 provides a test signal J214 to the transmitter J210. To do this, the control module J104 enables multiplexors J103 and J105 to output an I and Q component of test signal J214. The test signal J214 propagates through the transmitter until an outbound RF test signal is produced. The power detector J110 detects the power level of this test signal and provides an indication back to control module J104. If the power level of the RF test signal is at a desired level, the control module J104 utilizes the current settings for enable signals J216.

If, however, the power level is not at the desired level, the control module J104 adjusts the enable signals to change the gain of the highly linear power amplifier J212. After making the gain adjustments, the control module J104 provides test signal J214 to transmitter J210. The test signal J214 is again propagated through transmitter J210 until its output power is detected via power detector J110. This process continues until the control module J104 determines that it has the proper settings for the gain of the highly linear power amplifier J212.

Figure J9 illustrates a schematic block diagram of the highly linear power amplifier J212. In this illustration, the highly linear power amplifier J212 is a differential implementation. For a single implemented implementation, the complimentary transistor pairs J230, J232 and J234 and component J222 would be omitted.

The highly linear power amplifier J212, in a differential mode, includes 1st and 2nd components J220 and J222, which may be resistors, inductors and/or linearly loaded transistors and may further include a capacitor in parallel, a plurality of transistor pairs J224-228 and a plurality of complimentary transistor pairs J230-234. Each of the transistor pairs includes an enable transistor and an input transistor. The input transistors for the 1st, 2nd and 3rd transistor pairs J224-226 are operably coupled to one leg of a differential input signal J236. The input transistors of the 1st, 2nd and 3rd complimentary transistor pairs J230-234 are operably coupled to another leg of differential input signal J236. The enable transistors for the 1st, 2nd and 3rd transistor pairs J224-228 are operably coupled to individual enable signals J244, J246 and J248. The enable transistors of the complimentary transistor pairs J230-234 are also individually coupled to the 1st, 2nd and 3rd enable signals J244-248.

By sizing the input transistors and corresponding enable transistors of the transistor pairs with a given ratio with respect to each other, the gain of the power amplifier J212 may be adjusted while having negligible effects on the linearity. For instance, by having the input

transistor of the 1st transistor pair being twice as big as the input transistor of the 2nd transistor pair, the gain of the 1st transistor pair will be twice that of the 2nd transistor pair. Yet, by matching the input transistors and enable transistors from pair to pair, with only the size changing, the gain of the amplifier may be readily changed with negligible affects on the amplifier's linearity.

As one of average skill in the art will appreciate, the 1st, 2nd and 3rd enable signals may be enabled in any combination to produce a desired gain for the power amplifier. As one of average skill in the art will further appreciate, the gain is cumulative as transistors are enabled within the power amplifier J212. As one of average skill in the art will further appreciate, the linearity of the device remains relatively constant as the gain changes since the bias level for the input transistors of the transistor pairs is not varied.

## SECTION K

Figure K3 illustrates a schematic block diagram a self-calibrating transmitter K100 that may be incorporated into radio K60. The self-calibrating transmitter K100 includes the digital transmitter processing module K76, the digital-to-analog converter K78, the filtering/gain module K80, the up-conversion module K82 and the power amplifier K84. In an IEEE 802.11a compliant embodiment, the digital transmitter processing module K76 is configured to produce a scramble and/or encode module K101, and a modulation mapping module K103. For any embodiment of the self-calibrating transmitter (i.e., transmitter embodiments that are compliant with various ones of the plurality of wireless communication standards) is further configured to include a calibration execution module K102 and a portion of the calibration determination module K104. The up-conversion module K82 includes a 1st mixer K106, a 2nd mixer K108 and a summing module K110.

To implement the self-calibrating function, the self-calibrating transmitter K100 places itself in a calibration mode. During calibration mode, the digital transmitter processing module K76 receives a square-wave signal as the outbound data K94. The scramble/encode module K101 of the digital processing module K76 scrambles and/or encodes the square-wave signal and provides the scrambled and/or encoded signal to the modulation mapping module K103. The modulation mapping module K103 maps the scrambled and/or encoded signal to a constellation symbol, which includes an I component and a Q component. In the illustration of Figure K3, the constellation symbol is designated as the digital transmission formatted data K96.

The digital-to-analog converter K78 converts the I and Q components of the digital transmission formatted data K96 (i.e., the encoded and constellation mapped calibration signal) into an analog I component of the calibration signal and an analog Q component of the calibration signal. The filtering/gain module K80 filters and/or adjusts the gain of the analog I component and/or the analog Q component of the calibration signal to produce an I component and a Q component of a baseband signal K117.

The up-conversion module K82 receives the I and Q components of the baseband signal K117 and mixes them with the I and Q components of the local oscillation K74 and sums the mixed signals to produce the modulated RF signal K112. In particular, the 1st mixer K106 mixes an I component of the base-band signal K117 with an I component of the local oscillation K74 to produce a first mixed signal. The 2nd mixer K108 mixes a Q component of the base-band calibration signal K117 with a Q component of the local oscillation K74 to produce a second mixed signal. Summing module K110 sums the resulting mixed signals to produce the modulated RF calibration signal K112.

The calibration determination module K104 receives the modulated RF signal K112 and the I or Q component of the local oscillation K74. Based on these inputs, the calibration determination module K104 determines DC offset within the transmitter and may further determine gain imbalances within the transmitter. In general, the calibration determination module K104 produces baseband representation of the modulated RF signal K112 from the local oscillation and the modulated RF signal K112. The calibration determination module K104 then filters the baseband representation of the modulated RF signal K112 to isolate frequency spectrum components. Next, the calibration determination module K104 interprets the frequency spectrum components with respect to anticipated frequency spectrum components that are derived based on the known input signal and an assumption that the transmitter has no DC offsets and no gain imbalances to determine DC offset and/or gain imbalances of the I and/or Q paths of the transmitter. Based on the interpretation, the calibration determination module K104 generates a calibration signal K116 to compensate for DC offsets and/or gain imbalances.

The calibration determination module K104 provides the calibration signal K116 to the calibration execution module K102, which adjusts the DC offset and/or gain of the I and/or Q component of the digital transmission formatted data K96 in accordance with the calibration signal K116. Having made this adjustment, the calibration mode may be repeated to optimize the calibration signal or concluded, returning the transmitter to normal operation. In normal operation (e.g., in compliance with IEEE 802.11a) the scramble/encoder module K101 scrambles and/or encodes the outbound data K94 received from the host device to produce encoded data. The modulation mapping module K103 maps the encoded data to constellation symbols to produce I and Q components of non-calibrated digital transmission formatted data. The calibration execution module K102 adjusts the DC offset and/or gain of the I and/or Q component of the non-calibrated digital transmission formatted data based on the calibration signal to produce the digital transmission formatted data K96. The digital-to-analog converter K78, filtering gain module K80 and up-conversion module K82 operate to produce an RF signal representing the digital transmission formatted data K96. The power amplifier K84 amplifies the RF signal to produce outbound RF signal K98.

Figure K4 illustrates a schematic block diagram of the calibration determination module K104 and calibration execution module K102 of the self-calibrating transmitter of Figure K3. The calibration determination module K104 includes a down-converting mixing module K120, a digital-to-analog converter K122, a filtering module K124, and an interpreting module K126. The filtering module K124 and interpreting module K126 are implemented in the digital transmitter processing module K76. As shown, the filtering module K124 may include a low-pass filter/band-pass filter K128 and a band-pass filter K130. The calibration execution module K102 includes a 1st gain offset module K138, a 1st DC offset module K140, a 2nd gain offset module K142, and a 2nd DC offset module K144.

To establish the calibration signal K116 for each of the modules K138 - K144 of the calibration execution module K102, the calibration determination module K104 separately calibrations the transmitter K100 for DC offset and gain imbalances. To calibration for DC offset, the filter module K124 receives coefficients for the LPF/BPF module K128 such that it functions as a low pass filter.

In DC offset calibration mode, the down-converting mixing module K120 mixes the modulated RF signal K112 with the I component of the local oscillation to produce a base-band representation K121 of the modulated RF signal K112. The digital-to-analog converter K122 converts the base-band representation K121 into a digital base-band signal K132. The low-pass/band-pass filter K128 passes a 1st frequency spectrum component K134 of the digital baseband signal K132 (which represents the carrier leakage at DC) to the interpreting module K126. The band-pass filter K130 passes a 2nd frequency spectrum component K136 of the digital base-band signal K132 (which represents the desired transmitted signal) to the interpreting module K126.

Referring simultaneously to Figures K4 and K5, Figure K5 illustrates the frequency spectrum of the digital baseband signal K132, which has a sinX/X waveform, and the corresponding filtering of the filter module K124. The low pass filtering of LPF K128 isolates the transmitted signal component at DC of the digital baseband signal K132 plus any DC offset, which is represented by LO leakage K150. The bandpass filtering of BPF K130 isolates the desired transmitted signal at a known sampling frequency point.

The filtering module K124 provides the 1st frequency spectrum component (i.e., the transmitted signal component at DC of the digital baseband signal K132 plus any DC offset) and the 2nd frequency spectrum component (i.e., the desired transmitted signal at the known sampling point) to the interpreting module K126. The interpreting module K126 interprets the 1st and 2nd frequency spectrum components K134 and K136 with respect to each other and with respect to known properties of the digital baseband signal K132 (i. e., in the frequency domain it is a sinX/X waveform) to determine the LO leakage component K150.

As one of average skill in the art will appreciate, there is a variety of ways in which the interpreting module K126 may interpret the 1st and 2nd frequency spectrum components to produce the calibration signal. For instance, the 1st and/or 2nd frequency spectrum components are compared with each other. If they do not sufficient match, (e.g., the difference is less than a threshold value), the interpreting module K126 generates the calibration signal K116 to correct for DC offset.

Alternatively, the interpreting module K126 may calculate an ideal 1st frequency spectrum component based on the 2nd frequency spectrum component K136 and known properties of the digital baseband signal K132 (i.e., that it is a sinX/X waveform). The interpreting module K126 compares the ideal 1st frequency spectrum component with the actual 1st frequency spectrum component to determine the LO leakage K150. Having determined the LO leakage, the interpreting module K126 generates the calibration signal to adjust the DC level of the I and/or Q paths of the transmitter via DC offset module K140 and/or DC offset module K144, respectively.

DC offset module K140 and/or K144, which, in one embodiment, may be summing modules, receives the calibration signal K116, which represents a DC offset adjustment voltage, and either adds or subtracts the DC offset adjustment voltage to/from its corresponding input. If both DC offset modules K140 and K144 are to offset their respective inputs, the calibration signal K116 includes a DC offset adjust voltage for DC offset module K140 and another one for DC offset module K144. At this point, the process may be repeated to further optimize the calibration signal K116.

In a gain offset calibration mode, the calibration determination module K104 is determining gain imbalances between the I path and the Q path of the transmitter. To do this, a calibration signal is provided to the transmitter such that a modulated RF signal K112 is produced for the calibration signal. The down-converting mixing module K120 mixes the modulated RF calibration signal K112 with the I component of the local oscillation to produce a base-band representation K121 of the RF calibration signal K112. The digital-to-analog converter K122 converts the base-band representation K121 into a digital base-band signal K132.

The filtering module K124 receives filtering coefficients that configure the low-pass filter/band-pass filter K128 to function as a band-pass filter centered at a particular frequency and centers the band-pass filter K130 at a complimentary frequency as shown in Figure K6. The band-pass filter K128 filters the digital baseband signal K132 to produce a 1st frequency spectrum component K134 while band-pass filter K130 filters the digital base-band signal K132 to produce a 2nd frequency spectrum component K136. The interpreting module K128 interprets the 1st and 2nd frequency spectrum components K134 and K136 to determine an imbalance. If an imbalance exists, i.e., the magnitudes of the 1st and 2nd frequency spectrum components K134 and K136 do not sufficiently match (e.g., greater than a pre-stored threshold) the interpreting module K126 generates the calibration signal K116 to compensate for the imbalance.

The interpreting module K126 provides the calibration signal K116 to gain offset module K138 and/or gain offset module K142, which adjusts the gain of the I and/or Q path in accordance with the calibration signal K116. In one embodiment, the gain offset modules K138 and K142 include multipliers that multiple a gain offset value indicated by the calibration signal K116 with a corresponding input signal. As such, the calibration signal is reflective of the amount of gain offset and may be a value that is less than, equal to, or greater than one.

Figure K7 illustrates a logic diagram of a method performed by the calibration determination module to establish the calibration signal to adjust the DC offset. The process begins at Step K160 where 1st and 2nd sets of coefficients are provided to the filtering module to produce a low-pass filter and a band-pass filter. The process then proceeds to Step K162 where the DC level of the I and/or Q components of the base-band signal are adjusted in accordance with the DC offset correction indication, which is indicated by the calibration signal.

The process then proceeds to Step K164 where a new 1st frequency spectrum component and a new 2nd frequency spectrum components are produced based on the adjusted I and/or adjusted Q components of the base-band signal. The process then proceeds to Step K168 where the calibration determination module determines whether the new 1st frequency spectrum component represents less transmitter DC offset than that represented by the 1st frequency spectrum. If so, the process proceeds to Step K170 where the calibration determination module produces an updated calibration signal to fine-tune the DC offset level of the I and/or Q components of the base-band signal.

Having updated the calibration signal, the calibration determination module determines whether the DC offset level has reached an optimal point. If so, the process is complete. If not, the process proceeds to Step K174 where the calibration determination module produces updated frequency spectrum components by tweaking the calibrating signal and repeating the calibration. The process then reverts to Step K170 and remains in this loop until an optimal DC offset level is reached.

If, at Step K166, the new frequency spectrum components do not represent less transmitter DC offset than the previous frequency spectrum components, the process proceeds to Step K168. At Step K168, the calibration determination module produces an updated calibration signal that coarsely adjusts the DC offset level of the I and/or Q components of the base-band signal. Having done this, the process repeats at Step K162 until an optimal DC offset level is reached. As such, the calibration determination module selects an initial set of DC offset values for the I and/or Q component. Based on this initial setting, the calibration determination module increases or decreases the corresponding DC offsets. If this produces less transmitter DC offset, the calibration determination module fine-tunes these values until an optimal DC offset is reached. If the initially adjusted values produce more transmitter DC offset, the calibration determination module makes a coarse adjustment in the opposite direction with respect to the initial settings and then repeats the calibration.

Figure K8 illustrates a logic diagram that may be performed by the calibration determination module to determine the calibration signal for adjusting the gain of the I and/or Q components of the base-band signal. The process begins at Step K180 where the calibration determination module provides 1st and 2nd sets of coefficients to the filtering module to produce two band-pass filters. The process then proceeds to Step K182 where the calibration determination module adjusts the gain of the I and/or Q component of the base-band signal in accordance with the gain correction indication, which is indicated within the calibration signal.

The process then proceeds to Step K184 where the calibration determination module produces a new 1st frequency spectrum component and a new 2nd frequency spectrum component based on the adjusted I and/or Q components of the base-band signal. The process then proceeds to Step K186 where the calibration determination module determines whether the new 1st frequency spectrum components represent less transmitter imbalance than that represented by the initial frequency spectrum. If not, the process proceeds to Step K188. At Step K188, the calibration determination module produces an updated calibration signal to coarsely adjust the gain of the I and/or Q components of the base-band signal. At this point, the process repeats at Step K182.

When the new 1st frequency spectrum components represent less transmitter imbalance than that represented by the 1st frequency spectrum, the process proceeds to Step K190. At Step K190, the calibration determination module produces an updated calibration signal to fine-tune the gain of the I and/or Q components of the base-band signal. The process then proceeds to Step K192 where the calibration determination module determines whether an optimal gain setting has been reached. If so, the process is complete. If not, the process proceeds to Step K194. At Step K194, the calibration determination module produces updated frequency spectrum components based on a further fine-tuning of the gain of the calibration signal. At this point, the process repeats at Step K190 until an optimal gain setting is reached.

Figure K9 illustrates a schematic block diagram of a self-calibrating transmitter K200 and includes processing module K202 and memory K204. The processing module K202 may be a single processing device or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on operational instructions. The memory K204 may be a single memory device or a plurality of memory devices. Such a memory device may be a read-only memory, random access memory, volatile memory, non-volatile memory, static memory, dynamic memory, flash memory, and/or any device that stores digital information. Note that when the processing module K202 implements one or more of its functions via a state machine, analog circuitry, digital circuitry, and/or logic circuitry, the memory storing the corresponding operational instructions is embedded with the circuitry comprising the state machine, analog circuitry, digital circuitry, and/or logic circuitry. The memory K204 stores, and the processing module K202 executes, operational instructions corresponding to at least some of the steps illustrated in Figure K10.

Figure K10 illustrates a logic diagram of a method that may be executed by the self-calibrating transmitter K200 of Figure K9. The process begins at Step K210 where the transmitter mixes an I component of a base-band signal with an I component of a local oscillation to produce a mixed I signal. The process then proceeds to Step K212 where the transmitter mixes a Q component of the base-band signal with a Q component of the local oscillation to produce a mixed Q signal. The process then proceeds to Step K214 where the transmitter sums the mixed I signal with the mixed Q signal to produce a modulated RF signal.

The process then proceeds to Step K216 where the transmitter produces a calibration signal based on an interpretation of the local oscillation and the modulated RF frequency. This may be done as illustrated with respect to Steps K220-226.

At Step K220, the transmitter mixes the modulated RF signal with the local oscillation to produce a base-band representation of the modulated RF signal. The process then proceeds to Step K222 where the transmitter converts the base-band representation of the modulated RF signal into a digital base-band signal. The process then proceeds to Step K224 where the transmitter filters the digital base-band signal to produce a 1st frequency spectrum component and a 2nd frequen-

cy spectrum component. Note that for determining DC offset, the filtering includes low pass filtering and band pass filtering and, when determining gain offset, the filtering includes complimentary band pass filtering. The process then proceeds to Step K226 where the transmitter interprets the 1st and 2nd frequency spectrum components to produce the calibration signal. The interpretation and subsequent generation of the calibration signal may be performed as previously illustrated and discussed with reference to Figures K4 - K6.

Returning to the main flow of the diagram, the process then proceeds to Step K218 where the transmitter calibrates the DC level of the I and/or Q components of the base-band signal and/or calibrates the gain of the I and/or Q components of the base-band signal based on the calibration signal. The corresponding calibration reduces imbalances within the transmitter thereby enhancing performance of the transmitter and radios incorporating such transmitters.

Figure K11 illustrates a schematic block diagram of a radio K230 that includes an analog receiver section K236, calibration switch module K232, analog-to-digital converter K66, digital receiver processing module K64, digital transmitter processing module K76, analog transmitter section K238, mixing module K254, and a local oscillation module K74. The analog receiver section K236 receives an inbound RF signal K88 via a low-noise amplifier K72. The low-noise amplifier K72 amplifies the RF signal K88 and provides the amplified signal to the down-converting module K70. The down-converting module K70 removes the RF carrier from the signal and provides the down-converted signal to filtering/gain module K68. The filtering/gain module K68 filters and/or adjusts the gain of the down-converted signal to produce an analog low IF signal K244. Note that the low IF signal may have a carrier frequency in the range of 0 Hertz to a few megahertz.

The calibration switching module K232 is operably coupled to pass either the analog low IF signal K244 or a base-band representation K256 of the RF signal K254 to the analog to digital converter K66 based on a switch control signal K246. The calibration switch module K232 will pass the analog low IF signal K244 during normal operations (i.e., when the radio K230 is receiving RF signals) and passes the base-band representation K256 of the RF signal K254 when the radio K230 is in a transmitter calibration mode.

Mixing module K254 produces the base-band representation K256 of the RF signal K254 by mixing a modulated RF signal K252, which is produced by the analog transmitter section K238, with an I or Q component of a local oscillation for the transmitter section. The analog transmitter section K238 includes the digital to analog converter K78, the filtering/gain module K82, the up-converting module K82, and the power amplifier K84. Each of these modules K78 - K84 operate as previously discussed to produce the modulated RF signal K252 from a digital baseband signal, which is received from the digital transmitter processing module K76.

During normal operations, the digital transmitter processing module K76 converts outbound data K94, which is received from the host device, into digital baseband signals, which may have a carrier frequency of 0 to a few megahertz. As shown, the digital transmitter processing module K76 includes a scramble/encode module K101, modulation mapping module K103, and a calibration execution module K102. As previously discussed, the calibration execution module K102 adjusts gain and/or DC offset of an I component and/or Q component of the digital base-band signal.

Also during normal operations, the analog-to-digital converter K66 converts the analog low IF signal K244 into a digital reception formatted data K90. A digital receiver section K234 within the digital receiver processing module K64 processes, in accordance with one of a plurality of wireless communication standards, the digital reception formatted data K90 to produce a 1st baseband digital signal K248, which is provided as inbound data K92 to the host device.

During calibration mode for DC offset, the analog-to-digital converter K66 converts the base-band representation K256 of the RF signal K254 into the digital reception formatted data K90. The digital receiver section K234 is configured to include a low pass filter and a band pass filter which filter the digital reception formatted data K90 to produce a 2nd base-band digital signal K250. The 2nd baseband digital signal K250 includes a 1st frequency spectrum component and a 2nd frequency spectrum component and is provided to the calibration determination module K240.

The calibration determination module K240 within the digital transmitter processing module K76 interprets the 1st and 2nd frequency spectrum components to determine the presence of a DC offset. If a DC offset is present, the calibration determination module K240 generates the calibration signal K242 to reduce and/or eliminate the DC offset.

During calibration mode for gain offset, the analog-to-digital converter K66 converts the base-band representation K256 of the RF signal K254 into the digital reception formatted data K90. The digital receiver section K234 is configured to include complimentary band pass filters that filter the digital reception formatted data K90 to produce a 2nd base-band digital signal K250. The 2nd baseband digital signal K250 includes a 1st frequency spectrum component and a 2nd frequency spectrum component and is provided to the calibration determination module K240.

The calibration determination module K240 interprets these 1st and 2nd frequency spectrum components for the presence of a gain offset, or imbalance. If a gain offset exists, the calibration determination module K240 generates the calibration signal K242 to reduce and/or eliminate the gain offset.

The calibration determination module K240 provides the calibration control signal K242 to the calibration execution module K102, which adjusts gain and/or DC offset of an I and Q component of the base-band digital signal K245 based on the calibration control signal K242. Accordingly, the self-calibrating transmitter of Figure K11 is capable of self correcting DC offsets, which produces local oscillation leakage if not corrected, and is capable of self correcting gain imbalances, which causes transmission errors, increased power consumption, etc. if not corrected.

Figure K12 illustrates a more detailed schematic block diagram of the calibration circuitry of radio K230. As illustrated, the calibration circuitry includes mixing module K254, digital-to-analog converter K78, the digital receiver section K234, the calibration determination module K240 and the calibration execution module K102. The digital receiver section K234 includes a low-pass/band-pass filter K262 and a band-pass filter K264. The calibration determining module K240 includes the interpreting module K126. The calibration execution module K102 includes the gain offset module K138, DC offset module K140, gain offset module K142 and DC offset module K144. As configured, the components perform similarly to the circuitry illustrated and discussed with reference to Figures K4 - K6 to produce the calibration signal K242. In this embodiment, however, the calibration circuitry is taking advantage of portions of the receiver to facilitate the self calibration of the transmitter section.

Figure K13 illustrates a schematic block diagram of radio K270 that includes processing module K272 and memory K274. The processing module K272 may be a single processing device or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on operational instructions. The memory K274 may be a single memory device or a plurality of memory devices. Such a memory device may be a read-only memory, random access memory, volatile memory, non-volatile memory, static memory, dynamic memory, flash memory, and/or any device that stores digital information. Note that when the processing module K272 implements one or more of its functions via a state machine, analog circuitry, digital circuitry, and/or logic circuitry, the memory storing the corresponding operational instructions is embedded with the circuitry comprising the state machine, analog circuitry, digital circuitry, and/or logic circuitry. The memory K274 stores, and the processing module K272 executes, operational instructions corresponding to at least some of the steps illustrated in Figure K14.

Figure K14 illustrates a logic diagram of a method for self calibrating a transmitter within the radio K270. The process begins at Step K280 where the radio produces a modulated RF signal based on I and Q components of a base-band signal and I and Q components of a transmitter local oscillation. The process then proceeds to Step K282 where the radio mixes the modulated RF signal with the I or Q component of the transmitter local oscillation to produce a base-band representation of the modulated RF signal.

The process then proceeds to Step K284 where the radio produces an analog low IF signal based on a received RF signal and I and Q components of a received local oscillation. The process then proceeds to Step K286 where the radio outputs the analog low IF signal or base-band representation of the modulated RF signal based on a switch control signal. The switch control signal will enable the outputting of the analog low IF signal during normal mode and the outputting of the base-band representation of the modulated RF signal during transmitter calibration mode.

The process then proceeds to Step K288 where a determination is made as to whether the analog low IF signal or base-band representation of the RF signal is being outputted. When the low IF signal is being outputted, the process proceeds to Step K290 where the radio K270 produces a 1st base-band digital signal from the analog low IF signal, which is subsequently provided to the host device as inbound data.

If the base-band representation of the RF signal is being outputted, the process proceeds to Step K292 where the radio produces a 2nd base-band digital signal from the base-band representation of the modulated RF signal. The process then proceeds to Step K294 where the radio produces a calibration signal based on an interpretation of the 2nd base-band digital signal. This may be done as previously described with reference to Figures K11 and K12. The process then proceeds to Step K296 where the radio calibrates the DC level of the I and/or Q components of the base-band signal and/or calibrates the gain of the I and/or Q components of the base-band signal based on the calibration signal.

SECTION L

Figure L3 illustrates a schematic block diagram of an up-conversion module L82 that may be used in the transmit path of a wireless communication device. The up-conversion module L82 includes a 1st programmable mixer L100, a second programmable mixer L102 and a summing module L104. The 1st programmable mixer L100 mixes a differential I input signal L106 with a differential local oscillation L110 to produce a 1st mixed signal L112. The second programmable mixer L102 is operably coupled to mix a differential Q input signal L108 with the differential local oscillation L110 to produce a second mixed signal L114. The differential I and Q signals L106 and L108 correspond to the analog inphase and quadrature components representation of the digital transmission formatted data L96 after processing by digital-to-analog converter L78 and the filtering/gain module L80.

The summing module L104 sums the 1st mixed signal L112 with the second mixed signal L114 to produce an RF signal L116. The RF signal L116 is provided to power amplifier L84 to produce outbound RF signal L98. The programmable mixer L100 and L102 will be described in greater detail with reference to Figures L5-10.

Figure L4 illustrates a schematic block diagram of the down-conversion module L70 that includes the programmable mixer L100, programmable mixer L102 and summing module L104. In this embodiment, the programmable mixer L100 mixes the differential I component of an RF signal L120 with the differential local oscillation L110 to produce a 1st mixed signal L126. The second programmable mixer L102 mixes a differential Q component of the RF signal L120 with the differential local oscillation L110 to produce a second mixed signal L128.

The summing module L104 sums the 1st mixed signal L126 with the second mixed signal L128 to produce a low IF signal L124. Note that the output of summing module L104 would be band-pass filtered or low-pass filtered to produce the low IF signal L124. In an alternate embodiment of down-conversion module L70, the summing module L104 would be omitted and the 1st and second mixing signals L126 and L128 would be provided to a polyphase filter which would produce the low IF signal L124.

Figure L5 illustrates a schematic block diagram of programmable mixer L100 or L102. The programmable mixer includes a 1st mixing stage L130, a second mixing stage L132, compensation module L134 and coupling element L136. The 1st mixing stage L130 is operably coupled to mix one leg of a differential input signal L140A (which may be one leg of the I or Q component of signals L106, L108, L112 or L122) with the differential local oscillation L110 (LO and LO-bar). The mixing performed by the 1st mixing stage L130 may be altered based on compensation provided by compensation module L134.

The second mixing stage L132 is operably coupled to mix the other leg of a differential input L140B with the differential local oscillation L110. The mixing performed by the second mixing stage L132 may be altered by compensation module L134.

The 1st and second mixing stages L130 and L132 are operably coupled together via coupling element L136, which may be a resistor and/or inductor. The 1st mixing stage L130 as configured, produces a 1st leg of differential output L138 and the second mixing stage L132 produces the other leg of differential output L138.

The compensation module L134 is operably coupled to receive a control signal L142 from the digital receiver and/or digital transmitter processing module L64 and/or L76. The compensation module L134, based on control signal L142, compensates the operational characteristics of the 1st mixing stage L130 and/or the second mixing stage L132 such that the operational characteristics of the 1st mixing stage L130 more closely matches the operational characteristics of the second mixing stage L132. For example, the compensation module L132 may affect the gain of the 1st mixing stage and/or second mixing stage, the impedance of the 1st mixing stage and/or second mixing stage, the current flowing through the 1st mixing stage and/or second mixing stage, et cetera.

Figure L6 illustrates a more detailed schematic block diagram of an embodiment of programmable mixer L100 or L102. As shown, the 1st mixing stage L130 includes a 1st component L150, which may be a resistor or inductor, a pair of local oscillation transistors L152 and L154, an input transistor L156 and a current source L158. The second mixing stage L132 includes a second component L160, which may be a resistor or inductor, a pair of local oscillation transistors L162 and L164, an input transistor L166 and a current source L168.

With the compensation module L134 disabled, the 1st and second mixing stages 130 and 132 mix a differential input signal 140A and B with the differential local oscillation 110 (LO and LO_) to produce differential output 138.

The compensation module 134 is illustrated to include a gated current source 170 coupled in parallel with current source 158 of the 1st mixing stage 130 and a second gated source 172 coupled in parallel with current source 168 of the second mixing stage 132. Based on control signal 142, the compensation module 134 will enable gated current source 170, and/or gated current source 172. As such, when gated current source 170 is enabled, current through the input transistor 156 is increased by the ratio of current through current source 158 and current through current source 170. Similarly, the current through input transistor 166 of the second mixing stage 132 may be increased when the gated current source 172 is enabled. As such, by enabling gated current source 170 or gated current source 172, the current through the 1st mixing stage 130 or the second mixing stage 132 may be increased to more closely match the current through the other mixing stage. For example, if the current through the input transistor 166 is determined to be greater than the current through transistor 156 of the 1st mixing stage, the control signal 142 would enable gated current source 170 to be enabled. With gated current source 170 enabled, the current through input transistor 156 is increased thereby allowing it to more closely match the current through transistor 166. By more closely matching the currents through the 1st mixing stage and second mixing stage, imbalances within the mixer are reduced. By reducing imbalances within the mixer, local oscillation leakage of a transmitter is reduced.

Figure L7 illustrates a schematic block diagram of an alternate embodiment of the compensation module 134. In this embodiment, the compensation module 134 includes a 1st plurality of gated current sources coupled to current source 158 of the 1st mixing stage and a second plurality of gated current sources coupled to the current source 168 of the second mixing stage. In this embodiment, any one of the gated current sources 170, 180 and 182 may be individually enabled to more finely adjust the current through input transistor 156. Similarly, any one of the plurality of gated current sources 172, 184 and 186 may be individually activated to more finely tune the current through transistor 166. As one of average skill in the art will appreciate, any number of gated current sources may be added within the compensation module 134 and enabled in any combination to finely tune the current through transistor 156 and/or through transistor 166.

Figure L8 illustrates a schematic block diagram of another embodiment of the compensation module 134. In this embodiment, gated current sources 192 and 194 of the compensation module 134 are coupled to subtract current from input transistors 156 or 166.

When gated current source 192 is activated, the current through transistor 156 is reduced by the ratio of current source 192 with respect to current through current source 158. Similarly, the current through transistor 166 is reduced when the gated current source 194 is activated. As one of average skill in the art will appreciate, the compensation module embodiment of Figure L8 may be implemented in combination with the embodiments illustrated in Figure L6 and/or L7.

Figure L9 illustrates a logic diagram for the processing module L64 or L76 to determine the control signal that adjusts the compensation module 134. Note that processing module L64 and L76 may be separate processing devices, a shared processing device, or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on operational instructions. The memory L75 may be a single memory device or a plurality of memory devices. Such a memory device may be a read-only memory, random access memory, volatile memory, non-volatile memory, static memory, dynamic memory, flash memory, and/or any device that stores digital information. Note that when the processing module L64 or L76 implements one or more of its functions via a state machine, analog circuitry, digital circuitry, and/or logic circuitry, the memory storing the corresponding operational instructions is embedded with the circuitry comprising the state machine, analog circuitry, digital circuitry, and/or logic circuitry. The memory L75 stores, and the processing module L64 or L75 executes, operational instructions corresponding to at least some of the steps in Figures L9 and 10.

As shown in Figure L9, the processing begins at Step L200 where the processing module determines DC offset of the input signal and/or process mismatches

between the 1st mixing stage and the second mixing stage. The process then proceeds to Step L202 where the processing module determines operational characteristic mismatches between the 1st mixing stage and the second mixing stage based on the DC offset and/or process mismatches. For example, the processing module may determine the current imbalances between the 1st mixing stage and the second mixing stage.

The process then proceeds to Step L204 where the processing module generates a control signal to enable the compensation module to substantially compensate for the operational characteristic mismatches. For example, the control signal may indicate that one of the current sources within the compensation module is to be enabled thereby compensating for current of the respective mixing stage.

Figure 10 illustrates a logic diagram of an alternate method for determining the control signal, which may be performed by processing module L64 and/or L76. The process begins at Step L210 where the processing module enables the 1st and second gated current sources in a plurality of combinations. The processing then proceeds to Step L212 where the processing module determines current mismatches between the 1st and second mixing stages for each of the plurality of combinations. The process then proceeds to Step L214 where the processing module identifies one of the plurality of combinations as providing the least current mismatch (i.e., a best match situation). The process then proceeds to Step L216 where the processing module enables the 1st and second gated current sources based on one of the plurality of combinations.

For example, in the embodiment illustrated in Figure L7, the processing module would sequentially enable the gated current sources in a variety of combinations and correspondingly measure the current through transistors 156 and 166. The combination of gated current sources that provide the closest match of currents through transistor 156 and 166 would be used for the programmable mixer.

SECTION M

Figure M1 illustrates a schematic block diagram of a radio receiver M10 that includes a low noise amplifier M12, voltage controlled oscillator M14, mixers M16 and M18, band-pass filter M20, analog-to-digital converter M22, digital intermediate frequency demodulator M24, and a data and timing recovery module M26. The data and timing recovery module M26 includes a processing module M28 and memory M30. In one embodiment, the processing module M28 is configured to provide a DC offset estimator M32, a summing module M34 and a timing recovery module M36. The processing module M28 may be a single processing device or a plurality of processing devices. Such a processing device may be a microprocessor, micro-controller, digital signal processor, microcomputer, central processing unit, field programmable gate array, programmable logic device, state machine, logic circuitry, and/or any device that manipulates signals (analog and/or digital) based on operational instructions. The memory M30 may be a single memory device or a plurality of memory devices. Such a memory device may be a read-only memory, random access memory, volatile memory, non-volatile memory, static memory, dynamic memory, flash memory, and/or any device that stores digital information. Note that when the processing module M28 implements one or more of its functions via a state machine or logic circuitry, the memory storing the corresponding operational instructions is embedded with the circuitry comprising the state machine or logic circuitry. The memory M30 stores, and the processing module M28 executes, operational instructions corresponding to at least some of the steps illustrated in Figures M9 - M11 and graphically represented in Figures M2 - M8.

In operation, the low noise amplifier M12 receives an RF signal M38 and provides an in-phase and quadrature representation of the RF signal M38 to mixers M16 and M18, respectively. The voltage controlled oscillator M14 provides an in-phase component and a quadrature component of a local oscillation to the mixers M16 and M18, respectively. The mixers M16 and M18 mix the corresponding in-phase and quadrature signals to produce complex signals.

The band-pass filter M20 receives the complex signals from mixers M16 and M18 and band-pass filters them to produce an intermediate frequency signal. For example, for a Bluetooth application, the voltage controlled oscillator M14 may produce a local oscillation that is approximately 2MHz less than the carrier frequency of RF signal M38, or the specified carrier frequency of RF signal M38. Accordingly, the band-pass filter M20 passes the portions of the complex signal that are in the frequency range of the difference between the local oscillator and the incoming carrier frequency of the RF signal. For a Bluetooth application, the intermediate frequency may be approximately 2MHz.

The analog-to-digital converter M22 converts the IF signal from the analog domain to the digital domain. The digital IF demodulator M24 steps down the frequency of the digital signal to a base-band signal producing a DC offset encoded signal M40.

The DC offset encoded signal M40 is represented in Figure M2 as having a varying amplitude that has a DC offset M42. The varying amplitudes represent either a logic 1 or a logic 0. Alternatively, the DC offset encoded signal M40 may be a multi-level encoded signal such that data is encoded not only based on the sign of the pulse but its magnitude as well.

Returning to the description of Figure M1, the data and timing recovery module M26 receives the DC offset encoded signal M40 via the DC offset estimator M32 and the summing module M34. The DC offset estimator M32 determines the DC offset M42 of the DC offset encoded signal M40. The summing module M34 subtracts the DC offset M42 from the DC offset encoded signal yielding the encoded signal M44.

The encoded signal M44 is graphically depicted in Figure M3. As shown, the encoded signal M44 is centered around an amplitude of 0 and has data represented by 1's and 0's. For example, the first series of positive and negative pulses may correspond to a preamble M50 of a Bluetooth encoded message. As shown, the 0 is represented by a negative pulse while a 1 is represented by a positive pulse. Typically, when the preamble M50 is received, the radio receiver is in an acquisition mode. After the preamble has been received, the radio receiver switches to a tracking mode. The use of the acquisition mode and tracking mode will be discussed below with reference to Figures M5 - M11.

Returning to the discussion of Figure M1, the timing and recovery module M36 receives the encoded signal M44 and recaptures data M46 therefrom. The operation of the timing recovery module M36 may be generally described with reference to Figures M4-8 and discussed in greater detail with reference to Figures M9-11.

Figure M4 illustrates an expanded view of section A of the encoded signal M44 of Figure M3. As shown, a system symbol rate M60 includes a plurality of sampling phases M62. In this illustration, a system symbol rate M60 is divided into M12 sampling phases. The system symbol rate corresponds to the specified rate at which symbols are encoded and subsequently decoded. For example, the system symbol rate for one version of Bluetooth is 1 Mbps.

As illustrated, the sampling phases M62 of the system symbol rate M60 represent the phase of the symbol time modulus oversampling ratio of a timing recovery algorithm and not absolute time. To begin recapturing the data, zero crossing points (i.e., the reference crossings) are determined. Having determined at least one zero crossing, the optimum sampling time $T_{opt}$ can be found with respect to a sampling phase of the system symbol rate, wherein the optimum sampling time corresponds to the point of maximum signal swing for a particular symbol. In accordance with the timing recovery algorithm, the optimum sampling time $T_{opt} = T_z - T_s/2$, $T_s$ represents the system symbol time (i.e., 1/system symbol rate M60), and $T_z$ represents the zero crossing point. For the example encoded signal of Figure M4, the optimum sampling time occurs at the $4^{th}$ sampling phase of the system symbol rate.

Accordingly, each zero crossing may be utilized to re-evaluate and, if necessary, adjust the optimum sampling time. However, to reduce erroneous adjustments of the optimum sampling time, which may be caused by system noise, a threshold mechanism is incorporated. Such a threshold mechanism includes an accumulator that maintains an accumulated account of every difference between a current estimation of the optimal sampling time and the sampling time being used. Once the accumulator overflows or underflows, the optimum sampling time is adjusted. A graphical representation of the need to adjust the optimum sampling time is illustrated in Figures M5 and M6 and in Figures M7 and M8.

Figure M5 illustrates the encoded signal M44 of Figure M4 where the optimum sampling time was determined to occur at sampling phase 4. As further shown, the rate of the encoded signal M44 per symbol is represented by the transmit symbol rate M62, which is the rate at which a transmitting device encoded the signal. In an ideal world, the rate of encoding by the transmitter would be identical to the rate at which the radio receive will decode the device. However, since electronic circuits, especially clock circuits, cannot be perfectly created and reproduced in mass, the rate at which the transmitting device encoded the data will be slightly different than the rate at which the radio receiver will decode the data. In this example, the rate of the radio receiver, which is represented by the system symbol rate M60, is slightly faster than the rate of the transmitting device. As such, the encoded signal M44, with respect to the system symbol rate M60 will "walk" over time. As such, at some later time, the optimum sampling point will change from the 4$^{th}$ sampling phase to the 5$^{th}$ sampling phase as shown in Figure M6.

As previously mentioned, the optimum sampling point for each symbol may be determined, however, to reduce erroneous adjustments of the optimum sampling time, the rate is not changed until an accumulator overflows or underflows. In the example of Figure M6, when the first detection of the optimum sampling time occurs at sampling phase 5 instead of sampling phase 4, the accumulator is incremented from its initial mid point setting. If the accumulator is continually incremented, without a decrement, it will eventually overflow.

When the accumulator overflows, the optimum sampling time is adjusted to sampling phase 5, or another sampling phase, for the example of Figure M6. Note that, if after the accumulator was incremented because the optimum sampling phase for one symbol was sampling phase 5, the accumulator would be decremented if, for the next symbol, the optimum sampling time was determined to be at sampling phase 4. As such, several consecutive determinations that the optimum sampling time is something other than what is being used are required before the optimum sampling time is changed. The number of consecutive determinations is dependent on whether the radio receiver is in an acquisition mode or a tracking mode.

If the radio receiver is in an acquisition mode (i.e., when a Bluetooth compliant receiver is in a mode to acquire an access code), the accumulator may have a range of 0 to 4, with a midpoint of 2. For the example of Figures M5 and M6, when the optimum sampling time is determined to occur at sampling phase 5, or a larger sampling phase, instead of sampling phase 4 for two consecutive symbols, the accumulator overflows. Accordingly, the optimum sampling time will be adjusted to sampling phase 5 or some other large sampling phase.

If, however, the radio receiver is in tracking mode (i.e., when a Bluetooth compliant receiver has acquired the access code), the accumulator may have a range of 0 - M32, with a midpoint value of M16. For the example of Figures M5 and M6, when the optimum sampling time is determined to occur at sampling phase 5, or a larger sampling phase, instead of sampling phase 4 for sixteen consecutive symbols, the accumulator overflows. Accordingly, the optimum sampling time will be adjusted to sampling phase 5 or some other large sampling phase.

For the example illustrated in Figures M5 and M6, the initial optimum sampling time occurred at sampling phase 4, which resulted from the application of the system symbol rate M60 to the transmit symbol rate M62. Since the system symbol rate is not required to be synchronized with the transmit symbol rate, any of the sampling phases may be determined to be the initial optimum sampling time based on how the system symbol rate aligns with the transmit symbol rate. As one of average skill in the art will appreciate, the number of sampling phases within the system symbol rate may vary from the twelve shown, and the size of the accumulator in the tracking or acquisition modes may be larger or smaller than the one described above.

Figure M7 illustrates the encoded signal M44 of Figure M4 where the optimum sampling time was determined to occur at sampling phase 4. As further shown, the rate of the encoded signal M44 per symbol is represented by the transmit symbol rate M62, which is the rate at which a transmitting device encoded the signal. In this example, the rate of the radio receiver, which is represented by the system symbol rate M60, is slightly slower than the rate of the transmitting device. As such, the encoded signal M44, with respect to the system symbol rate M60 will "walk" to the left over time. As such, at some later time, the optimum sampling point will change from the 4$^{th}$ sampling phase to the 3$^{rd}$ sampling phase as shown in Figure M8.

As previously mentioned, the optimum sampling point for each symbol may be determined, however, to reduce erroneous adjustments of the optimum sampling time, the rate is not changed until an accumulator overflows or underflows. In the example of Figure M8, when the first detection of the optimum sampling time occurs at sampling phase 3 instead of sampling phase 4, the accumulator is decremented from its initial mid point setting. If the accumulator is continually decremented, without an increment, it will eventually underflow.

When the accumulator underflows, the optimum sampling time is adjusted to sampling phase 3, or a lower numbered sampling phase, for the example of Figure M8. As with the overflow condition, several consecutive determinations that the optimum sampling time is something less than what is being used are required before the optimum sampling time is lowered. The number of consecutive determinations is dependent on whether the radio receiver is in an acquisition mode or a tracking mode.

If the radio receiver is in an acquisition mode, the accumulator may have a range of 0 to 4, with a midpoint of 2. For the example of Figures M7 and M8, when the optimum sampling time is determined to occur at sampling phase 3, or a smaller sampling phase, instead of sampling phase 4 for two consecutive symbols, the accumulator underflows. Accordingly, the optimum sampling time will be adjusted to sampling phase 3 or some other smaller sampling phase.

If, however, the radio receiver is in tracking mode, the accumulator may have a range of 0 - 32, with a midpoint value of 16. For the example of Figures M7 and M8, when the optimum sampling time is determined to occur at sampling phase 3, or a smaller sampling phase, instead of sampling phase 4 for sixteen consecutive symbols, the accumulator underflows. Accordingly, the optimum sampling time will be adjusted to sampling phase 3 or some other smaller sampling phase.

As an alternative to continuous adjustments of the optimal sampling time, the optimal sampling time may be fixed (e.g., identically 0), and an algorithm made to force the optimal sampling time to occur at a fixed phase. In this embodiment, the occurrence of zero crossings is compared to a fixed reference point and the plurality of the accumulator adjustment determined accordingly. For every overflow or underflow of the accumulator, the phase counter is held or advanced one or several phases, respectively, depending on the mode of the algorithm (e.g., acquisition or tracking).

Figures M9-11 illustrate a logic diagram of a method for data recovery within a radio receiver. The process begins at Step M70 where an encoded signal is received at a transmit symbol rate. The encoded signal may include first data values having a first positive magnitude with respect to a reference crossing (e.g., 0, 2.5 volts for a 5 volt source, etc.) and a second data value having a negative magnitude with respect to the reference crossing. Such an encoded signal was graphically represented in Figure M3. Alternatively, the encoded signal may be a multi-level encoded signal that includes first data values having a first positive magnitude with respect to the reference and 3rd data values having a second positive magnitude with respect to the reference. In addition, the multi-level encoded signal would have second data values at a first negative magnitude and 4th data values having a second negative magnitude with respect to the reference. Note that the encoded signal may be received as a DC offset encoded signal (which was illustrated in Figure M2), which has a DC offset subtracted therefrom to produce the encoded signal.

The process then proceeds to Step M72 where at least one reference crossing (e.g., 0 crossing) of the encoded signal is determined. Note that depending on the supply voltages used for the radio receiver, the reference crossing may be 0 volts, if the supply voltage includes a + and - supply or may be, for example, 2-1/2 volts if the radio receiver includes a 5 volt supply.

The process then proceeds to Step M74 where a sampling phase is determined based on the at least one reference crossing and the system symbol rate. The system symbol rate may be known (e.g., for a Bluetooth application) to be 1MHz, or may need to be determined from one of a plurality of symbol rates for a particular type of wireless communication system (e.g., 6 Mbps, 9 Mbps, etc.). A determination of the sampling phase may be done by determining a sampling time of the sampling phase based on a time of at least one reference crossing less ½ of the symbol time of the system symbol rate. The symbol time includes a plurality of over sampling times, wherein the plurality of over sampling times corresponds to a plurality of sampling phases of the system symbol rate. In essence, the symbol time corresponds to 1/(system symbol rate) and the sampling time corresponds to 1/(a sampling phase). This was graphically illustrated and described with reference to Figure M4.

The process then proceeds to Step M76 where the encoded signal is sampled at the determined sampling phase with respect to the system symbol rate to recapture data from the encoded signal.

The determining of the sampling phase may be further described with reference to Figure M10. The processing begins at Step M78 where an initial sampling phase is set with respect to the system symbol rate. This was depicted in Figure M4 where the initial sampling rate phase was selected to be sampling phase 4 due to the zero crossing of the encoded signal with respect to the system symbol rate. The process then proceeds to Step M80 where an accumulator is set to a mid-point value. As previously discussed, the mid-point value for acquisition mode may be 2 on a scale from 0 to 4 and in tracking mode may be M16 on a scale from 0 to 32.

The process then proceeds to Step M82 where the initial sampling phase is utilized as a determined sampling phase. In other words, the initial sampling phase is used as the sampling phase to sample the encoded signal to recapture the data. The process then proceeds to Step M84 where the next symbol is sampled at the determined sampling phase. The processing then continues for the next received symbol by determining, at Step M86, a corresponding current sampling phase. This was graphically illustrated in Figures M6 and M8. The process then proceeds to Step M88 where a determination is made as to whether the determined sampling phase (i.e., the one used to sample the encoded signal) compares unfavorably to the current sampling phase determined for this particular sample. If not, the process reverts to Step M84 and processing of the next symbol commences.

If, however, the comparison is unfavorable (i.e., the current sampling phase is either greater than or less than the determined sampling phase, the process proceeds to Step M90 where an accumulator is adjusted. The process then proceeds to Step M92 where a determination is made as to whether the accumulator has overflowed or underflowed. If not, the process reverts to Step M84. If the accumulator has underflowed or overflowed, the process proceeds to Step M94 where the determined sampling phase (i.e., the sampling phase used to sample the encoded signal) is adjusted.

Figure M11 illustrates a logic diagram of whether the determined sampling phase compares unfavorably to the current sampling phase. The process begins at Step M100 where the comparison is unfavorable because the corresponding current sampling rate is either greater than or less than the determined sampling rate. If greater than, the process proceeds to Step M102 where the accumulator is incremented. The process then proceeds to Step M104 where, when the accumulator has overflowed, the determined sampling phase is increased by one or more sampling phases. Note that the overflowing of the accumulator depends on the particular mode of the radio receiver. In tracking mode, the accumulator is initially set to 8 and overflows at a value of 16. In acquisition mode, the accumulator is set to 2 and overflows at a value of 4. The process then proceeds to Step M106 where the accumulator is reset to the midpoint value.

If the current sampling phase is less than the determined sampling phase, the process proceeds to Step M108 where the accumulator is decremented. The process then proceeds to Step M110 where, when the accumulator has underflowed, the determined sampling phase is decreased by a sampling phase Delta value. The process then proceeds to Step M112 where the accumulator is reset to a midpoint value.

The preceding discussion has presented a radio frequency integrated circuit that leverages the digital processing to optimize performance of the analog sections of a radio. Accordingly, direct conversion radio transceivers utilizing the teachings of the present invention are more reliable in wireless communication devices, consume less power, produce less errors, and are more cost effective than previous radio frequency integrated circuits. As one of average skill in the art will appreciate, other embodiments may be derived from the teaching of the present invention, without deviating from the scope of the claims.

**Claims**

1. An integrated radio system comprises:

local oscillation module operably coupled to produce at least one local oscillation;
analog radio receiver operably coupled to directly convert inbound radio frequency (RF) signal into inbound low intermediate frequency (IF) signal based on the at least one local oscillation;

analog radio transmitter operably coupled to directly convert outbound low IF signal into outbound RF signal based on the at least one local oscillation;
digital receiver module operably coupled to produce inbound data by processing the inbound low IF signal in accordance with one of a plurality of radio transceiving standards;
digital transmitter module operably coupled to produce the outbound low IF signal by processing outbound data in accordance with the one of the plurality of radio transceiving standards; and
digital optimization module operably coupled to optimize performance of at least one aspect of at least one of the local oscillation module, the analog radio receiver, and the analog radio transmitter for the one of the plurality of radio transceiving standards.

2. The integrated radio system of claim 1 further comprises:

first CMOS integrated circuit that includes the local oscillation module, the analog radio receiver, and the analog radio transmitter, and second CMOS integrated circuit that includes the digital receiver module, the digital transmitter module, and the digital optimization module.

3. The integrated radio system of claim 1, wherein the local oscillation module further comprises:

clock source operably coupled to generate a controlled oscillation from a reference clock; and
oscillation generating module operably coupled to produce the at least one local oscillation based on the controlled oscillation, wherein the oscillation generating module includes:

phase shift module operably coupled to produce a Q component of the controlled oscillation by shifting phase of the controlled oscillation;
first divider operably coupled to produce a first divided by two oscillation by dividing frequency of the controlled oscillation by a factor of two;
second divider operably coupled to produce a second divided by two oscillation by dividing frequency of the Q component of the controlled oscillation by a factor of two;
local oscillation compensation module operably coupled to produce first and second compensated oscillations by compensating the first and second divided by two oscillations in accordance with a local oscillation compensation signal to at least compensate for DC offset within the analog receiver section;

first mixing module operably coupled to mix the controlled oscillation with the first compensated oscillation to produce an I component of the at least one local oscillation; and

second mixing module operably coupled to mix the Q component of the controlled oscillation with the second compensated oscillation to produce a Q component of the at least one local oscillation.

4. The integrated radio system of claim 3, wherein the clock source further comprises:

phase and frequency detector operably coupled to produce a difference signal by comparing phase and frequency differences between the reference clock and a feedback clock;

charge pump operably coupled to produce charge signal from the difference signal;

low pass filter operably coupled to produce a filtered signal by filtering the charge signal;

voltage controlled oscillator operably coupled to generate the controlled oscillation from the filtered signal;

fixed module operably coupled to divide the controlled oscillation by a selectable value to produce a feedback oscillation; and

phase locked loop compensation operably coupled to produce the feedback clock by compensating the feedback oscillation in accordance with a clock compensation control signal.

5. The integrated radio system of claim 1, wherein the digital transmitter module further comprises:

encoding module operably coupled to produce encoded outbound data by encoding outbound data in accordance with the one of the plurality of radio transceiver standards; and

modulation module operably coupled to produce digital outbound low IF signal by modulating the encoded outbound data in accordance with the one of the plurality of radio transceiver standards.

6. The integrated radio system of claim 1, wherein the digital receiver module further comprises:

reduced complexity demodulation module operably coupled to produce demodulated inbound data by demodulating the inbound low IF signal in accordance with the one of the plurality of radio transceiver standards; and

decoding module operably coupled to produce inbound data by decoding the demodulated inbound data in accordance with the one of the plurality of radio transceiver standards.

7. The integrated radio system of claim 1, wherein the analog radio receiver further comprises:

low noise amplifier operably coupled to amplify the inbound RF signal to produce an amplified inbound RF signal;

down-conversion module operably coupled to convert the amplified inbound RF signal into an I component down-converted signal and a Q component down-converted signal;

first filter operably coupled to filter the I component of the down-converted signal to produce a filtered I component;

second filter operably coupled to filter the Q component of the down-converted signal to produce a filtered Q component;

first programmable gain amplifier operably coupled to produce an I component of the inbound low IF signal by amplifying the filtered I component in accordance with a gain control signal; and

second programmable gain amplifier operably coupled to produce a Q component of the inbound low IF signal by amplifying the filtered Q component in accordance with the gain control signal.

8. The integrated radio system of claim 1, wherein the analog radio receiver further comprises:

programmable low noise amplifier operably coupled to produce an amplified inbound RF signal by amplifying the inbound RF signal in accordance with an LNA gain control signal;

down-conversion module operably coupled to convert the amplified inbound RF signal into an I component down-converted signal and a Q component down-converted signal;

first low pass filter operably coupled to filter the I component of the down-converted signal to produce a filtered I component;

second low pass filter operably coupled to filter the Q component of the down-converted signal to produce a filtered Q component;

first amplifier operably coupled to produce an I component of the inbound low IF signal by amplifying the filtered I component; and

second amplifier operably coupled to produce a Q component of the inbound low IF signal by amplifying the filtered Q component.

9. The integrated radio system of claim 1, wherein the analog radio receiver further comprises:

low noise amplifier operably coupled to amplify the inbound RF signal to produce an amplified inbound RF signal;

first programmable mixer operably coupled to produce an I component down-converted signal by mixing an I component of the amplified inbound RF signal with an I component of the at least one local oscillation in accordance with a first mixing compensation control signal;

second programmable mixer operably coupled to produce a Q component down-converted signal by mixing a Q component of the amplified inbound RF signal with a Q component of the at least one local oscillation in accordance with a second mixing compensation control signal;

first filter operably coupled to filter the I component of the down-converted signal to produce a filtered I component;

second filter operably coupled to filter the Q component of the down-converted signal to produce a filtered Q component;

first amplifier operably coupled to produce an I component of the inbound low IF signal by amplifying the filtered I component; and

second amplifier operably coupled to produce a Q component of the inbound low IF signal by amplifying the filtered Q component.

10. The integrated radio system of claim 1, wherein the analog radio transmitter further comprises:

first filter operably coupled to produce a filtered I component of the outbound low IF signal by filtering the outbound low IF signal;

second filter operably coupled to produce a filtered Q component of the outbound low IF signal by filtering the outbound low IF signal;

up-conversion module operably coupled to produce an up-converted signal by up-converting the filtered I and Q components with respect to the at least one local oscillation; and

programmable amplifier operably coupled to produce the outbound RF signal by amplifying the up-converted signal in accordance with an amplifier compensation control signal.

11. The integrated radio system of claim 1, wherein the analog radio transmitter further comprises:

offset compensation module operably coupled to produce compensated outbound IF signal by compensating the outbound low IF signal in accordance with an offset compensation control signal;

first filter operably coupled to produce a filtered I component of the outbound low IF signal by filtering the compensated outbound IF signal;

second filter operably coupled to produce a filtered Q component of the outbound low IF signal by filtering the compensated outbound IF signal;

up-conversion module operably coupled to produce an up-converted signal by up-converting the filtered I and Q components with respect to the at least one local oscillation; and

amplifier operably coupled to produce the outbound RF signal by amplifying the up-converted signal.

12. The integrated radio system of claim 1, wherein the analog radio transmitter further comprises:

first filter operably coupled to produce a filtered I component of the outbound low IF signal by filtering the outbound low IF signal;

second filter operably coupled to produce a filtered Q component of the outbound low IF signal by filtering the outbound low IF signal;

first programmable mixer operably coupled to produce a first mixed signal by mixing the filtered I component of the outbound low IF signal with an I component of the at least one local oscillation in accordance with a first mixer compensation control signal;

second programmable mixer operably coupled to produce a second mixed signal by mixing the filtered Q component of the outbound low IF signal with a Q component of the at least one local oscillation in accordance with a second mixer compensation control signal;

summing module operably coupled to produce an up-converted signal by summing the first mixed signal with the second mixed signal; and

amplifier operably coupled to produce the outbound RF signal by amplifying the up-converted signal.

13. A radio chip set comprises:

first integrated circuit and second integrated circuit,

wherein the first integrated circuit includes:

local oscillation module operably coupled to produce a local oscillation;

analog radio receiver operably coupled to directly convert inbound radio frequency (RF) signal into inbound low intermediate frequency (IF) signal based on the local oscillation;

analog radio transmitter operably coupled to directly convert outbound low IF signal into outbound RF signal based on the local oscillation;

compensation module operably coupled at least one of the local oscillation module, the analog radio receiver, and the analog radio transmitter, wherein the compensation module monitors operation of the at least one of the local oscillation module, the analog radio receiver, and the analog radio transmitter to produce monitoring data, and wherein the compensation module compensates for at least one of DC offset, local oscillation leakage, noise, non-linearity, power consumption, and performance limits for the at least one of the local oscillation module, the analog radio receiver, and the analog radio transmitter based on a compensation control signal; and

proprietary interface operably coupled to convey the monitoring data and the compensation control signal between the first and second integrated circuits;

wherein the second integrated circuit includes:

digital receiver module operably coupled to produce inbound data by processing the inbound low IF signal in accordance with one of a plurality of radio transceiving standards; digital transmitter module operably coupled to produce the outbound low IF signal by processing outbound data in accordance with the one of the plurality of radio transceiving standards; digital optimization module operably coupled to produce the compensation control signal by interpreting the monitoring data to determine optimal performance of the at least one of the local oscillation module, the analog radio receiver, and the analog radio transmitter for the one of the plurality of radio transceiving standards; and

second proprietary interface operably coupled to convey the monitoring data and the compensation control signal between the first and second integrated circuits.

**14.** The radio chip set of claim 13 further comprises:

the local oscillation module including:

clock source operably coupled to generate a controlled oscillation from a reference clock; and oscillation generating module to produce the at least one local oscillation based on the controlled oscillation;

the compensation module including:

local oscillation compensation module operably coupled to determine the at least one of DC offset, local oscillation leakage, noise, non-linearity, power consumption, and performance limits of the oscillation generating module and operably coupled to compensation for the at least one of DC offset, local oscillation leakage, noise, non-linearity, power consumption, and performance limits of the oscillation generating module based on a LO compensation control signal;

the digital compensation module including:

processing module and memory operably coupled to the processing module, wherein the memory includes operational instructions that cause the processing module to:

determine compensation for the determined at least one of DC offset, local oscillation leakage, noise, non-linearity, power consumption, and performance limits of the oscillation generating module; and generate the LO compensation control signal based on the determined compensation.

**15.** The radio chip set of claim 14 further comprises:

the clock source including a phase locked loop having a selectable feedback divider value; the compensation module operably coupled to determine at least one of DC offset, local oscillation leakage, noise, non-linearity, power consumption, and performance limits of the phase locked loop and operably coupled to compensate feedback of the phase locked loop in accordance with a PLL compensation control signal; the digital compensation module including:

processing module and memory operably coupled to the processing module, wherein the memory includes operational instructions that cause the processing module to:

determine compensation based on the at least one of DC offset, local oscillation leakage, noise, non-linearity, power consumption, and performance limits of the phase locked loop; and generate the PLL compensation control signal based on the determined compensation.

**16.** The radio chip set of claim 13 further comprises:

the analog radio receiver including:

low noise amplifier operably coupled to amplify the inbound RF signal to produce an amplified inbound RF signal;

down-conversion module operably coupled to convert the amplified inbound RF signal into a down-converted signal;

filtering module operably coupled to filter the down-converted signal to produce a filtered down-converted signal;

gain amplifier operably coupled to produce the inbound low IF signal by amplifying the filtered down-converted signal;

the compensation module operably coupled to determine at least one of DC offset, local oscillation leakage, noise, non-linearity, power consumption, and performance limits of the analog radio receiver and operably coupled to compensate the at least one of DC offset, local oscillation leakage, noise, non-linearity, power consumption, and performance limits of at least one of the low noise amplifier, the down-conversion module, and the gain amplifier based on a receiver compensation control signal; and the digital compensation module including:

processing module and memory operably coupled to the processing module, wherein the memory includes operational instructions that cause the processing module to:

determine compensation based on the at least one of DC offset, local oscillation leakage, noise, non-linearity, power consumption, and performance limits of the at least one of the low noise amplifier, the down-conversion module, and the gain amplifier; and generate the receiver compensation control signal based on the determined compensation.

17. The radio chip set of claim 13 further comprises:

the analog radio transmitter including:

filtering module operably coupled to produce a filtered outbound low IF signal by filtering the outbound low IF signal;

up-conversion module operably coupled to produce an up-converted signal by up-converting the filtered outbound low IF signal with respect to the at least one local oscillation; and

amplifier operably coupled to produce the outbound RF signal by amplifying the up-converted signal in accordance with an amplifier compensation control signal;

the compensation module operably coupled to determine at least one of DC offset, local oscillation leakage, noise, non-linearity, power consumption, and performance limits of the analog radio transmitter and operably coupled to compensate the at least one of DC offset, local oscillation leakage, noise, non-linearity, power consumption, and performance limits of at least one of based on a transmitter compensation control signal; and

the digital compensation module including:

processing module and memory operably coupled to the processing module, wherein the memory includes operational instructions that cause the processing module to:

determine compensation based on the at least one of DC offset, local oscillation leakage, noise, non-linearity, power consumption, and performance limits of the at least one of the up-conversion module and the amplifier, and generate the transmitter compensation control signal based on the determined compensation.

FIG. 1

EP 1 331 742 A2

FIG. 2

host device 18-32

display, speakers, etc.

keyboard, keypad, microphone, etc.

output interface 56

input interface 58

processing module 50

memory 52

radio interface 54

radio 60

86

inbound RF signal 88

Rx filter 87

T/R switch 91

Tx filter 89

outbound RF signal 98

analog Rx 77

LNA 72

down-conversion module 70

Rx LO 81

local oscillation module 74

Tx LO 83

PA 84

up-conversion module 82

analog Tx 79

filtering/gain module 68

inbound low IF signal 90

outbound low IF signal 96

filtering/gain module 80

ADC 66

DAC 78

digital receiver processing module 64

digital optimization module 85

digital transmitter processing module 76

inbound data 92

memory 75

outbound data 94

host interface 62

71

**FIG. 3**

**FIG. 4**

EP 1 331 742 A2

**FIG. 5**
**digital transmitter section 160**

**FIG. 6**
**digital transmitter section 170**

EP 1 331 742 A2

inbound
data 92

digital receiver processing module 64

data decoding
module 194

demodulated
data 196

demodulation
module 192

I

Q

ADC 66

FIG. 7
digital receiver section 190

inbound low IF
signal 90

inbound data 92

digital receiver processing module 64

descramble
module 208

decoding
module 206

decoded
data 214

depuncture
module 204

depunctured
data 212

coding rate 216

demodulation
demapping
module 202

demodulated
data 210

I

Q

ADC 66

FIG. 8
digital receiver section 200

inbound low IF
signal 90

inbound RF
signal 88

LNA
72

down
conversion
module 70

222

220

Rx LO
81

LO 74

digital optimization module 85

analog receiver 77

**FIG. 9**

filter/gain module 68

226

224

LPF
230

DC offset
correction
module 238

LPF
228

DC offset
correction
module 236

PGA
234

PGA
232

inbound low IF signal 90

FIG. 10
analog receiver 77

outbound RF signal 98

288

PA 84

LO 74 — Tx LO 83

282  284

286

up-conversion module 82

digital optimization module 85

278  280

LPF 274  LPF 276

filtering/gain module 80

270  272

outbound low IF signal 96

**FIG. 11**
analog radio transmitter 79

**FIG. 12**

FIG. H5

FIG. H6

**FIG. A1**
**integrated multi-mode radio A10**

EP 1 331 742 A2

one A26 of a plurality of IF signals

RF signal A24

receiver front-end A66

1st receiver multiplexor A68

receiver low pass filter A70

LPF I A78

LPF Q A80

receiver band pass filter A72

BPF Q A82

BPF I A84

2nd receiver multiplexor A74

receiver amplifying module A76

amplified I and Q components A86

selection signal A34

multi-mode receiver A62

multi-mode transmitter A64

LPF or BPF IF signal A110

LPF Q A102

transmitter low pass filter A92

LPF I A104

2nd transmitter multiplexor A96

outbound RF signal A52

transmitter front-end A98

LPF Q A106

transmitter low pass filter A94

LPF I A108

1st transmitter multiplexor A90

transmitter amplifying module A88

I and Q components of input signal A100

selection signal A34

FIG. A2
integrated multi-mode radio A60

EP 1 331 742 A2

one A150 of a plurality of IF signals

1st filtered IF signal A158

1st receiver IF section A126

amplified RF signal A144

| 1st receiver filter module A136 | 1st receiver amplfying module A138 | 1st IF signal A160 |

receiver front-end A124

RF signal A24 → low noise amplifier A132 → mixing module A134 → receiver multiplexor A130

gain 156 per gain setting signal

| 2nd receiver filter module A140 | 2nd receiver amplfying module A142 | 2nd IF signal A164 |

gain setting signal A146

operational selection signal A148

2nd filtered IF signal A162

2nd receiver IF section A128

another one A152 of a plurality of IF signals

**multi-mode receiver A122**

**multi-mode transmitter A124**

1st IF signal A198

1st filtered signal A194

1st transmitter IF section A174

rep. RF signal A202

| 1st transmitter amplfying module A180 | 1st transmitter filter module A178 | 1st input signal A190 |

transmitter front-end A170

outbound RF signal A52 ← power amplifier 188 ← mixing module 186 ← transmitter multiplexor A172

gain A156 per gain setting signal

| 2nd transmitter amplfying module A184 | 2nd transmitter filter module A182 | 2nd input signal A192 |

gain setting signal A146

operational selection signal A148

2nd IF signal 200

2nd filtered IF signal A196

2nd transmitter IF section A176

<u>**FIG. A3**</u>        <u>**integrated multi-mode radio A120**</u>

EP 1 331 742 A2

FIG. A4    multi-mode receiver A12

RF signal A24 → LNA A132 → amplified RF signal A225

receiver front-end A16

mixing module A134
- I mixer A214
- Q mixer A216
- I oscillation A220
- Q oscillation A222

multiplexer A18

selection signal A34

one A26 of a plurality of IF signals

power detection logic A258 → gain adjustments A260

**1st IF stage A20**
- 1st filter module A136
- 1st amplifying module A139
- DC feedback circuit A228
- ADC A230
- demodulator A232 → recaptured data A234

**2nd IF stage A22**
- 2nd filter module A140
- 2nd amplfying module A142
- DC feedback circuit A238
- ADC A240
- demodulator A242 → recaptured data A234

**3rd IF stage A246**
- 3rd filter module A248
- 3rd amplifying module A250
- DC feedback circuit A252
- ADC A254
- demodulator A256 → recaptured data A234

data A294

modulator A292

DAC A290

1st filter module A178

1st amplifying module A180

1st IF stage A36

data A294

modulator A302

DAC A300

2nd filter module A182

2nd amplifying module A184

2nd IF stage A38

data A294

modulator A312

DAC A310

3rd filter module A308

3rd amplifying module A306

3rd IF stage A304

multiplexor A40

I mixer A274

I oscilliation A280

Q oscilliation A282

Q mixer A276

rep. RF signal A284

PA A188

A278

mixing module A186

transmitter front-end A42

outbound RF signal A52

selection signal A34

**FIG. A5**

**multi-mode transmitter A14**

EP 1 331 742 A2

87

**FIG. A6**

multi-mode receiver A62

recaptured data A234 ← demodulator A338 ← ADC A334 ← amplifying module A76

amplified I and Q components A86

2nd multiplexor A74

BPF I A84 ← band pass filter A72
BPF Q A82 ←

LPF I A78 ← low pass filter A70
LPF Q A80 ←

1st multiplexor A68

selection signal A34

mixing module A322

front-end A66

Q mixer A326 ⊗ ← Q oscillation A330

I oscillation A328

I mixer A324 ⊗ ← LNA A320 ← amplified RF signal A332

RF signal A24

data A346

modulator A340

DAC A342

DAC A344

I and Q components of input signal A100

amplifying module A88

multiplexor A90

I

Q

low pass filter A90

band pass filter A92

LPF Q A102

LPF I A104

BPF Q A106

BPF I A108

multiplexor A96

I mixer A274

I oscilliation A280

Q oscilliation A282

Q mixer A276

rep. RF signal A284

PA A272

A278

outbound RF signal A52

mixing module A270

front-end A98

selection signal A34

**FIG. A7**

**multi-mode transmitter A64**

**FIG. A8**

**integrated multi-mode radio A350**

EP 1 331 742 A2

**FIG. B1**
**integrated radio B10**

EP 1 331 742 A2

FIG. B2

**FIG. B3**

fractional-N synthesizer B18

FIG. B4

B130 generate a first feedback frequency from an output frequency based on a fixed divider value, a fractional value of a divider value, and an integer value of the divider value

B132 generate a second feedback frequency from the output frequency based on a selectable divider value, a modified fractional value of the divider value, and a modified integer value of the divider value

B134 fractional value within a range of fractional values?

no

yes

B138 utilize the second feedback frequency to produce the output frequency

B136 utilize the first feedback frequency to produce the output frequency

**FIG. B6**

processing module B122

memory B124

fractional-N synthesizer B120

**FIG. B5**

## FIG. B7

```
( generating the first
      feedback )
            │
            ▼            B140
┌─────────────────────────┐
│ generate a first partial feedback │
│ frequency by dividing the output  │
│ frequency by a fixed divider value│
└─────────────────────────┘
            │
            ▼            B142
┌─────────────────────────┐
│   sigma delta modulate the      │
│  fractional value to produce a  │
│   digital reference signal      │
└─────────────────────────┘
            │
            ▼            B144
┌─────────────────────────┐
│ sum the digital reference signal │
│ with the integer value to produce │
│       a divider signal           │
└─────────────────────────┘
            │
            ▼            B146
┌─────────────────────────┐
│  divide the first partial feedback │
│  frequency in accordance with the │
│  divider signal to produce the first│
│       feedback frequency          │
└─────────────────────────┘
```

**FIG. B7**

## FIG. B8

```
( generating the second
   feedback frequency )
            │
            ▼            B150
┌───────────────────────────────┐
│ divide the output frequency by a fixed integer │
│ value to produce an I component and a Q        │
│  component of the output frequency             │
└───────────────────────────────┘
            │
            ▼            B152
┌───────────────────────────────┐
│  divide the I and Q components by   │
│   the selectable divider value to   │
│  produce a reference I frequency and│
│     a reference Q frequency         │
└───────────────────────────────┘
            │
            ▼            B154
┌───────────────────────────────┐
│ mix the reference I frequency with  │
│ the I component to produce a first  │
│        mixed frequency              │
└───────────────────────────────┘
            │
            ▼            B156
┌───────────────────────────────┐
│ mix the reference Q frequency with  │
│   the Q component to produce a      │
│      second mixed frequency         │
└───────────────────────────────┘
            │
            ▼            B158
┌───────────────────────────────┐
│   sum the first and second mixed    │
│   frequencies to produce a partial  │
│        feedback frequency           │
└───────────────────────────────┘
            │
            ▼            B160
┌───────────────────────────────┐
│ divide the partial feedback frequency based │
│ on a divider signal to produce the second    │
│       feedback frequency            │
└───────────────────────────────┘
```

**FIG. B8**

**FIG. B9**

generating the second feedback frequency

B170
divide the reference frequency by a fixed integer value to produce an I component and a Q component of the reference frequency

B172
dividing the output frequency by a second fixed integer value to produce an I component and a Q component of the output frequency

B174
mix the I component of the output frequency with the I component of the reference frequency to produce a first mixed frequency

B176
mix the Q component of the output frequency with the Q component of the reference frequency to produce a second mixed frequency

B178
sum the first and second mixed frequencies to produce a partial feedback frequency

B180
divide the partial feedback frequency based on a divider signal to produce the second feedback signal

start

B190
determine a fractional value of divider value

B192
fractional value outside a range of fractional values?

no

yes B194
select a partial divider value

B196
determe a modified fractional value and a modified integer value of the divider value based on the partial divider value

B198
generate a feedback frequency based on the partial divider value, the modified fractional value, and the modified integer value

B200
generate the output frequency from the reference frequency and the feedback frequency

B202
generate the feedback frequency based on a fixed divider value, the fractional value, and an integer value of the divider value

**FIG. B10**

96

EP 1 331 742 A2

inbound RF
signal C16 → **RF receiver section C12** → inbound IF
signal C18

local oscillation
C20

**2nd mixing
module C30**

reference
frequency C32

divided
frequency C38

corrected
frequency C42

**frequency
synthesizer C22**

synthesized
frequency C34

**divider module C24
(divider value C36)**

**1st mixing
module C28**

auxiliary
frequency C40

**auxiliary frequency
control module C26**

self-correcting local oscillator C14

**FIG. C1** **integrated radio receiver C10**

EP 1 331 742 A2

FIG. C2

self-correcting local oscillator C14

98

frequency correction
signal C93

processing
module C90

input selection
signal C140

auxiliary frequency
synthesizer C92

I component C58 of
auxiliary frequency C40

Q component C60 of
auxiliary frequency C40

memory C91

**FIG. C3**

**auxiliary frequency control module C26**

I component C58 of
auxiliary frequency C40

I component of mixed
frequency C100

divided
frequency C38

1st mixer
C62

poly phase filter
C100

I component C82 of
corrected frequency C42

2nd mixer
C64

Q component of mixed
frequency C102

Q component C84 of
corrected frequency C42

Q component C60 of
auxiliary frequency C40

**FIG. C4**

**1st mixing module C28**

FIG. 5

**FIG. C6**

FIG. C7
frequency response of FIG. C6

## FIG. C10

- generating the auxiliary frequency — C180
- produce an I component and a Q component of the auxiliary frequency based on a frequency correction signal — C182
- determine frequency of an RF signal to produce a determined RF frequency — C184
- compare the determined RF frequency with the local oscillation to produce a difference frequency — C186
- generate the frequency correction signal to represent the difference frequency

## FIG. C9

- start
- generate a synthesized frequency from a reference frequency — C170
- divide the synthesized frequency by a divider value to produce a divided frequency — C172
- generate an auxiliary frequency that emulates frequency spectrum error — C174
- mix the auxiliary frequency with the divided frequency to produce a corrected frequency — C176
- mix the corrected frequency with the synthesized frequency to produce a local oscillation — C178

## FIG. C8

- processing module C162
- memory C164

self correcting local oscillator C160

EP 1 331 742 A2

```
        ┌─────────────────────────┐
        │  generating the frequency │
        │     correction signal     │
        └─────────────────────────┘
                     │  C190
                     ▼
        ┌─────────────────────────┐
        │  sum I and Q components of the │
        │      local oscillation    │
        └─────────────────────────┘
                     │  C192
                     ▼
      ┌───────────────────────────────┐
      │   mix the summed local oscillation │
      │ frequency with the I component of the │
      │        local oscillation       │
      └───────────────────────────────┘
                     │  C194
                     ▼
      ┌───────────────────────────────┐
      │   mix the summed local oscillation │
      │ frequency with the Q component of the │
      │        local oscillation       │
      └───────────────────────────────┘
                     │  C196
                     ▼
    ┌───────────────────────────────────┐
    │ determine a first error frequency component │
    │ that represents a DC offset within the self- │
    │ correcting local oscillator based on the first │
    │        and second test frequencies     │
    └───────────────────────────────────┘
                     │  C198
                     ▼
    ┌───────────────────────────────────┐
    │ determine a second error component freq │
    │  representing an image tone of the self- │
    │ correcting local oscillator based on the first │
    │        and second test frequencies     │
    └───────────────────────────────────┘
                     │  C200
                     ▼
      ┌───────────────────────────────┐
      │   generate the frequency correction │
      │   signal based on the first and second │
      │          error frequencies      │
      └───────────────────────────────┘
```

**FIG. C11**

EP 1 331 742 A2

FIG. D1
radio receiver D10

EP 1 331 742 A2

signal conditioning module D16

IF signal D30 → BPF D50 → amplitude limiting module D52

BPF signal D72

Q component D34

FSK input signal D32

I component D36

reset signal D42

FSK demodulator D18

$V_{ref}$    Vdd

charge signal D38

discharge circuit D66    charge circuit D62

data acquisition signal D40    data acquisition module D56

logic module D54 (exclusive OR)

D60

sample and hold circuit D64

reset module D58

delta-frequency module D22

signaling module D20

delta-frequency signal D44

demodulation module D24

LPF D68

filtered signal D74

threshold D77

bit rate clock D71

clk D79

data threshold module D73

comparator D75

stream of data D46

data extractor D70

**FIG. D2**

IF signal D30

signal conditioning module D16

BPF D50

BPF signal D72

amplitude limiting module D52

FSK demodulator D18

Q component D34

FSK input signal D32

I component D36

logic module D54 (exclusive OR)

signaling module D20

charge signal D38

data acquisition module D56

reset module D58

reset signal D42

data acquisition signal D40

clock D84

delta-frequency module D22

count

counter D80

reset

register D82

delta-frequency signal D44

demodulation module D24

data interpreter D87

comparator D86

stream of data D46

low count threshold D90

high count threshold D88

FIG. D3

IF + dF
IF - dF

I component D36

Q component D34

charge signal D38

data acquisition signal D40

reset signal D42

capacitor D60 voltage

filtered signal D74

threshold D77

stream of data D46

0    1    1    1    0

**FIG. D4**    timing diagram for FIG. D2

## FIG. D5

```
┌─────────────────────────────┐
│  ┌───────────────────────┐  │
│  │   processing          │  │
│  │   module D102         │  │
│  └───────────┬───────────┘  │
│              ↕              │
│  ┌───────────┴───────────┐  │
│  │   memory D104         │  │
│  └───────────────────────┘  │
│                             │
│  FSK demodulator D100       │
└─────────────────────────────┘
```

**FIG. D5**

---

( start )

│ D110

generate a charge signal, a data acquisition signal, and a reset signal from an I component and a Q component of an FSK modulated input signal

│ D112

generate a delta-frequency signal based on the charge signal, the data acquisition signal, and the reset signal

│ D114

demodulate the delta-frequency signal to recapture a stream of data

**FIG. D6**

---

( generating the data acquisition signal )

│ D116

invert the charge signal to produce an inverted signal

│ D118

delay the inverted signal to produce a delayed signal

│ D120

truncate the delayed signal to produce the data acquisition signal

**FIG. D7**

---

( generating the reset signal )

│ D122

invert the delayed signal to produce a reset inverted signal

│ D124

delay the reset inverted signal to produce a reset delayed signal

│ D126

combine the delayed signal and the reset delayed signal to produce the reset signal

**FIG. D8**

EP 1 331 742 A2

EP 1 331 742 A2

( steps D112 and D114 )

↓ D128

charge a capacitor during the charge signal

↓ D130

sample and hold a voltage of the capacitor in accordance with the data acquisition signal

↓ D132

reset the voltage of the capacitor to a reference voltage in accordance with the reset signal

↓ D134

low pass filter the delta-frequency signal to produce a filtered signal

↓ D136

interpret the filtered signal to produce the stream of data

**FIG. D9**

( steps D112 and D114 )

↓ D138

count cycles of a reference clock during duration of the charge signal to produce a count

↓ D140

store the count in accordance with the data acquisition signal

↓ D142

compare the count with a low count threshold and a high count threshold at a data bit rate to produce the stream of data

**FIG. D10**

**FIG. E1**
radio receiver E10

RF signal E28

low noise amplifier E12

amplified RF signal E30

local oscillation E32

IF mixing module E14

digital IF signal E34

mixing section E18

digital Q signal E36

digital I signal E38

digital comb filter E20

digital comb filter E22

filtered I signal E42

filtered Q signal E40

phase locked loop module E24

digital signal E44

data recovery module E26

data stream E46

digital demodulator E16

111

EP 1 331 742 A2

FIG. E2
radio receiver E50

112

**FIG. E3**

radio receiver E70

RF signal E28 → low noise amplifier E12

amplified RF signal E30

IF mixing module E14 ← local oscillation E32

digital IF signal E34

mixing section E19

digital Q signal E37

digital I signal E39

phase locked loop E25

digital signal E44

LPF/equalizer E74

equalized and filtered digital signal E82

data recovery module E26

data stream E46

digital demodulator E72

FIG. E4
radio receiver E90

digital demodulator E92

EP 1 331 742 A2

I mixer E132

IF I signal E150

- 90 degree phase shift E130

I local oscillation E146

amplified RF signal E30

LO generator E136

Q local oscillation E148

band pass filter E140

filtered IF signal E156

limiter E142

limited IF signal E158

IF Q signal E152

Q mixer E134

analog to digital converter E144

**IF mixing module E14**

**FIG. E5**

digital IF signal E34

EP 1 331 742 A2

EP 1 331 742 A2

FIG. E6

digital demodulator E16,
E52, E72, or E92

EP 1 331 742 A2

frequency step
down E184

$$\left(\frac{1-z^{-16}}{1-z^{-1}}\right)^2$$

2

$z^{-1}$

−

Σ

$$\frac{1-z^{-12}}{1-z^{-1}}$$

E180

$$\frac{1-z^{-8}}{1-z^{-1}}$$

E182

↓2

E256

3

$z^{-16}$

**FIG. E7**

**LPF/equalizer E74**

dB

10

0

−10

−20

−30

−40

−50

−60

equalize
response E186

LPF response E188

0    1    2    3    4    5    6

frequency
(MHz)

**FIG. E8**

EP 1 331 742 A2

start

E190
receive a digital signal

E192
determine a DC offset using a first criteria during an acquisition mode and using second criteria during a tracking mode

E194
substantially remove the DC offset from the digital signal to produce a DC adjusted digital signal

E196
sample the DC adjusted digital signal at a sample rate to produce a data stream

**FIG. E9**

Bluetooth packet E200

| preamble E201 (4 bits) | synchronization word E202 (64 bits) | trailer E203 (4 bits) | data E204 |
|---|---|---|---|

acquisition mode | tracking mode

**FIG. E10**

1 | 0 | 1 | 0 | 0 | 0 | 1 | 1 | 1 | 0 |

zero reference E211

DC offset E210

noise E206    packet data E208    zero DC E212

**digital signal E44 from PLL module**

**FIG. E11**

determine the DC offset

E220

determine a peak value of the digital signal based on a current peak value, a previous peak value, and the first or second criteria

E224

determine a valley value of the digital signal based on a current valley value, a previous valley value, and the first or second criteria

E226

determine the DC offset based on the peak value and the valley value

**FIG. E12**

E228

acquisition mode or tracking mode?

track

E229

determine peak value as PV(n) = PV(n-1) +/- dP

acq.

E232

magnitude of current peak value > magnitude of previous peak value

no

E230

determine peak value as PV(n) = PV(n-1) +/- dP *[abs(PV(c) - PV(n-1))]

yes E234

store the current peak value as the peak value

**FIG. E13**

E236

acquisition mode or tracking mode?

acq.

E240

magnitude of current valley value > magnitude of previous valley value

yes

E242

store the current valley value as the valley value

track

determine valley value as VV(n) = VV(n-1) +/- dV

no

E238

determine valley value as VV(n) = VV(n-1) +/- dV *[abs(VV(c) - VV(n-1))]

**FIG. E14**

EP 1 331 742 A2

**FIG. E16**

detect peaks and valleys

E266 — determine a gradient of the digital signal

E268 — determine when the gradient changes for positive to negative

E270 — indicate the digital signal as being at a peak when the gradient changes from positive to negative

E272 — determine when the gradient changes for negative to positive

E274 — indicate the digital signal as being at a valley when the gradient changes from positive to negative

**FIG. E15**

detect false peaks and false valleys

E250 — detect a potential peak of the digital signal

E252 — determine magnitude of the potential peak

E254 — determine a difference between the magnitude of the potential peak and magnitude of the valley value

E256 — when the difference is less than a predetermined value, indicate that the potential peak is a false peak

E258 — detect a potential valley of the digital signal

E260 — determine magnitude of the potential valley

E262 — determine a difference between the magnitude of the potential valley and magnitude of the peak value

E264 — when the difference is less than the predetermined value, indicate that the potential valley is a false valley

**FIG. E17**
acquisition mode

**FIG. E18**
tracking mode

EP 1 331 742 A2

```
┌─────────────────────┐
│  sample the DC adjusted  │
│     digital signal        │
└─────────────────────┘
            │
            ▼            E290
┌─────────────────────┐
│  over-sample the DC adjusted  │
│  digital signal at a sample rate  │
└─────────────────────┘
            │
            ▼            E292
┌─────────────────────┐
│  correlate alternate ones of the  │
│  samples over a plurality of bits  │
│      corresponding to a            │
│    synchronization word            │
└─────────────────────┘
            │
            ▼            E294
┌─────────────────────┐
│  identify one of the correlated  │
│  sample sets as having a best-   │
│        correlation with the       │
│      synchronization word         │
└─────────────────────┘
            │
            ▼            E296
┌─────────────────────┐
│  select a sampling position of the  │
│  over-sampling of the DC adjusted   │
│  digital signal based on the identified  │
│      correlated sample set          │
└─────────────────────┘
            │
            ▼            E298
┌─────────────────────┐
│  utilize samples at the selected  │
│  sample position to produce the   │
│           data stream              │
└─────────────────────┘
```

**FIG. E19**

```
┌─────────────────────┐
│     selecting the        │
│   sampling position      │
└─────────────────────┘
            │
            ▼            E300
┌─────────────────────────┐
│  compare adjacent sample sets to the identified  │
│  correlated sample set with respect to typical   │
│  waveform of the DC adjusted digital signal to   │
│  determine an over-sampling relationship of the  │
│        DC adjusted digital signal                 │
└─────────────────────────┘
            │
            ▼            E302
┌─────────────────────────┐
│  select the sampling position to be the sampling  │
│  that produces the identified correlated sample   │
│      set when the sampling that produces the      │
│       identified correlated sample set occurs at a  │
│      most favorable point of the over-sampling    │
│              relationship                          │
└─────────────────────────┘
            │
            ▼            E304
┌─────────────────────────┐
│  select the sampling position to be a sampling    │
│  between the identified correlated sample set     │
│       and an adjacent one of the plurality of     │
│     correlated sample sets when the sampling      │
│   between the identified correlated sample set    │
│      and an adjacent one correlated sample sets   │
│     occurs at a most favorable point of the over- │
│             sampling relationship                  │
└─────────────────────────┘
```

**FIG. E20**

## sample adjustment

**E310**
obtain a first reference sample prior to the sampling of the DC adjusted digital signal

**E312**
obtain a second reference sample subsequent to the sampling of the DC adjusted digital signal

**E314**
accumulate, over a plurality of samples of the DC adjusted digital signal, a difference between the first and second reference samples to produce an accumulated difference

**E316**
adjust the sampling when the accumulated difference overflows an upper threshold or when the accumulated difference underflows a lower threshold

**FIG. E21**

data rate    data rate

0 1 2 3 4 5   0 1 2 3 4 5   0 1 2 3 4 5

packet data E208

correlated sample set 0
correlated sample set 2
correlated sample set 4

**FIG. E22**

EP 1 331 742 A2

PGA1

F516A

I

I

F808

GAIN
CONTROL
LOGIC

CTR

F812

EXT CLK

F804

AMPLITUDE
LEVEL
DETECTOR

Q

F516B

PGA1

Q

## FIG. F8

PGA1
F90

4

a Sin $\omega_o$t

$I_P$ $I_N$

F916

F912

Control
Circuit

a

$\sqrt{I^2+Q^2}$

a Cos$\omega_o$t

$Q_P$ $Q_N$

F908

PGA2

## FIG. F9

**FIG. F11A**

$$I_D = \tfrac{1}{2}\mathrm{B}(V_{GS} - V_t)^2$$

**FIG. F11B**

F1300

F1308

$V_{DD}$

2I ↓ F1332

F1336

$M_5$

$i_5$

F1340

$M_6$

$i_6$

OUTPUT

F1344

$I_{DC} + \beta a^2$

F1304

F1316 ↓ $i_1$

$v_1$ ┤ $M_1$

F1320 ↓ $i_2$

$v_2$ ┤ $M_2$

F132 4 ↓ $i_3$

$v_3$ ┤ $M_3$

F1328 ↓ $i_4$

$v_4$ ┤ $M_4$

FIG. F13

FIG. F3

FIG. F4

FIG. F5

COARSE        FINE

F604      F608      F612      F616

0,12 dB     0,12 dB     0,12 dB     0 dB
                                                              3 dB
                                                               6 dB
                                                               9 dB

## FIG. F6

F704

$M_1$ (5)

F716   $V_{DD}$

F712

INPUT

$M_2$ (5)

F720   $V_{DD}$

$M_3$ (2)

F724   $s_1$

$M_4$ (3)

F728   $s_2$

$M_5$ (4)

F732   $s_3$

OUTPUT

7F08

## FIG. F7

FIG.
F12

FIG. F2

**FIG. F1A**

FIG. F1B

EP 1 331 742 A2

FIG.10

EP 1 331 742 A2

FIG. G3

FIG. G4

FIG. G5

FIG. G6

RECEIVE NEW DATA PACKET — G704

INITIATE 10 MICROSECOND DELAY — G708

MOSFET TO LOW RESISTANCE MODE
TO COMPLETE FEEDBACK LOOP — G712

CHARGE CAPACITOR WITH THE INTEGRATOR TO A DC VALUE — G716

ONCE 10 MICROSEC DELAY EXPIRES,
REMOVE BIAS TO MOSFET TO CAUSE IT TO
TRANSITION TO HIGH RESISTANCE MODE — G720

ADD NEGATIVE OF DC VALUE TO AMPLIFIER INPUT THEREBY
CANCELLING DC OFFSET IN INPUT SIGNAL — G724

# FIG. G7

G205

G202

G204

RF UNIT

G206

PROCESSOR (BB)

G208

MEMORY

G210

USER INTERFACE

DISPLAY | KEYBD

SPKR/MIC | DATA I/F

BATTERY

G212

FIG. G2

FIG. H3

FIG. H4

FIG. I5

FIG. I6

FIG. I4

FIG. J3
transmitter J100

start

J130

generate a test signal to test for a desired power level setting of the programmable multistage amplifier

J132

provide an I component and a Q component of the test signal to the up-conversion module

J134

determine output power of the outbound RF test signal

J136

output power of the outbound RF test signal within a desired output power range?

yes

J140

establish the distributed gain control signal to set the gain of the programmable multistage amplifier such that the output power is in the desired range

no        J138

adjust the distributed gain control signal to produce an adjusted distributed gain control signal

FIG. J4

EP 1 331 742 A2

EP 1 331 742 A2

```
                    ( start )
                       |        J150
                       v
        ┌──────────────────────────────┐
        │ generate a test signal to test for │
        │ noise level of the programmable │
        │     multistage amplifier        │
        └──────────────────────────────┘
                       |        J152
                       v
        ┌──────────────────────────────┐
        │ provide an I component and a Q │
        │ component of the test signal to │
        │    the up-conversion module     │
        └──────────────────────────────┘
                       |        J154
                       v
        ┌──────────────────────────────┐
        │   determine noise level of the  │
        │     outbound RF test signal     │
        └──────────────────────────────┘
                       |
                       v        J156
```

noise level of the outbound RF test signal below a desired noise level?

yes →

J160

establish the distributed gain control signal to set the gain of the programmable multistage amplifier such that the noise level is below the desired level

no    J158

adjust the distributed gain control signal to produce an adjusted distributed gain control signal

**FIG. J5**

```
            ( start )
                |
                v
          ┌──────────────┐  J170              ┌──────────────┐  J172
          │ generate a series of varying │    │ sequentially provide the │
          │ power level test signals to test │ │ series of varying power │
          │ linearity of the programmable │ ──> │ level test signals to up- │
          │ multistage power amplifier │      │ conversion module │
          └──────────────┘                    └──────────────┘
                                                      |
          ┌──────────────┐  J176                      v
          │ determine linearity of the │        ┌──────────────┐  J174
          │ programmable multistage │           │ determine output power │
          │ amplifier based on the output │ <── │ for each of the series of │
          │ power of the series of outbound │   │ outbound RF test signals │
          │ RF test signals │                   └──────────────┘
          └──────────────┘
                |
                v
            /‾‾‾‾‾‾‾‾\  J178                    ┌──────────────┐  J180
           / linearity of the \                │ establish the distributed gain │
          /  programmable multistage \   yes   │ control signal to set the gain of │
          \  amplifier within a desired / ───> │ the programmable multistage │
           \ linearity range? /                │ amplifier such that the linearity is │
            _____/                         │ in the desired range │
                |                              └──────────────┘
               no   J182
                v
          ┌──────────────┐                            FIG. J6
          │ adjust the distributed gain control │
          │ signal to produce an adjusted │
          │ distributed gain control signal │
          └──────────────┘
```

FIG. J6

EP 1 331 742 A2

start

**J190**

determine a first optimal setting for the distributed gain control signal such that a noise level of the programmable multistage amplifier is below a desired noise level

**J192**

determine a second optimal setting for the distributed gain control signal such that output power of the programmable multistage amplifier is within a desired output power range

**J194**

determine a third optimal setting for the distributed gain control signal such that linearity of the programmable multistage amplifier is within a desired linearity range

**J196**

test linearity, noise, and power level using each of the first, second, and third optimal settings

**J202**

adjust the distributed gain control signal based on prioritization of the output power, the noise level, and the linearity

no

**J198**

noise, linearity, and power level are each within the corresponding desired ranges for each of the first, second and third optimal settings?

yes **J200**

use first, second, and third optimal settings

**FIG. J7**

**FIG. J8**
**transmitter J210**

outbound RF signal K98

modulated RF signal K112

PA K84

modulated RF signal K112

up-conversion module K82

K106

K108

K110

LO K74

baseband signal K117

digital transmission formatted data K96

filtering/gain module K80

DAC K78

digital transmitter processing module K76

scramble/ encode module K101

modulation mapping module K103

calibration execution module K102

calibration signal K116

calibration determination module K104

outbound data K94

FIG. K3
self-calibrating transmitter K100

FIG. K4

EP 1 331 742 A2

LO leakage
K150

sampling points K152

digital
baseband
signal K132

low pass
filter K128

**FIG. K5**
**DC offset test**

bandpass
filter K130

EP 1 331 742 A2

**FIG. K6**
gain offset test

FIG. K7

start

K160 — provide first and second sets of coefficients to the filter module to produce a low pass filter and a bandpass filter

K162 — adjust DC level of the I and/or Q component of the baseband signal in accordance with the DC offset correction indication

K164 — produce a new first frequency spectrum component and a new second frequency spectrum component based on the adjusted I and/or Q component of the baseband

K166 — does new 1st frequency spectrum component represent less transmitter imbalance than that represented by the 1st frequency spectrum

no → K168 — produce an updated calibration signal to coarsely adjust the DC offset level of the I and/or Q component of the baseband signal

yes → K170 — produce an updated calibration signal to fine tune the DC offset level of the I and/or Q components of the baseband signal

K172 — optimal DC offset level reached?

no → K174 — produce updated frequency spectrum components

yes → done

FIG. K8

**start**

K210
mix an I component of a baseband signal with an I component of a local oscillation

K212
mix a Q component of the baseband signal with a Q component of the local oscillation

K214
sum the mixed I signal with the mixed Q signal

K216
produce a calibration signal based on an interpretation of the local oscillation and the modulated RF signal

K218
calibrate DC level of the I and/or Q component of the baseband signal and/or gain of the I and/or Q component of the baseband signal based on the calibration signal

K220
mix the modulated RF signal with the local oscillation

K222
convert the baseband representation of the modulated RF signal into a digital baseband signal

K224
filter the digital baseband signal to produce a first frequency spectrum component and a second frequency spectrum component

K226
interpret the first and second frequency spectrum components to produce the calibration signal

**FIG. K10**

---

processing module K202

memory K204

self-calibrating transmitter K200

**FIG. K9**

FIG. K11
radio K230

EP 1 331 742 A2

157

EP 1 331 742 A2

LO - I

modulated RF
signal K252

$\times$ K254

BB rep K256 of
RF signal K254

DAC K78

digital baseband
signal K260

digital transmission
formatted data K96

I

Q

calibration execution module K102

DC offset
module K140

DC offset
module K144

gain offset
module K138

gain offset
module K142

1st frequency spectrum
component K134

LPF/BPF K262

BPF K264

digital receiver section
K234

2nd frequency spectrum
component K136

4

interpreting
module K126

calibration
signal K242

calibration determination
module K240

**FIG. K12**

158

EP 1 331 742 A2

## FIG. K13

```
┌─────────────────────────┐
│  radio K270             │
│  ┌──────────────────┐   │
│  │  processing      │   │
│  │  module K272     │   │
│  └──────────────────┘   │
│           ↕             │
│  ┌──────────────────┐   │
│  │  memory K274     │   │
│  └──────────────────┘   │
│                         │
└─────────────────────────┘
```

**FIG. K13**

( start )

K280
produce a modulated RF signal based on I and Q components of a baseband signal and I and Q components of a transmitter local oscillation

K282
mix the modulated RF signal with the I or the Q component of the transmitter local oscillation

K284
produce an analog low IF signal based on a received RF signal, and I and Q components of a receiver local oscillation

K286
output the analog low IF signal or the baseband representation of the modulated RF signal based on a switch control signal

K288
analog low IF signal or BB rep of modulated RF signal

IF

K290
produce a first baseband digital signal from the analog low IF signal

BB

K292
produce a second baseband digital signal from the baseband representation of the modulated RF signal

K294
produce a calibration signal based on an interpretation of the second baseband digital signal

K296
calibrate DC level of the I and/or Q component of the baseband signal and/or gain of the I and/or Q component of the baseband signal based on the calibration signal

**FIG. K14**

**FIG. M1**
radio receiver M10

DC offset encoded signal M40

DC offset M42

amplitude

time (symbols)

**FIG. M2**

EP 1 331 742 A2

encoded signal M44

1 1

amplitude

preamble M50
(pattern: 0101)

0 0

0

section A

time (symbols)

**FIG. M3**

system symbol rate M60

sampling phase M62

amplitude

time (phases of symbol time)

**FIG. M4**

EP 1 331 742 A2

**FIG. M5**

**FIG. M6**

FIG. M7

FIG. M8

**FIG. M9**

start

M70
receive an encoded signal at a transmit symbol rate

M72
determine at least one reference crossing of the encoded signal

M74
determine a sampling phase based on the at least one reference crossing and a system symbol rate

M76
sample the encoded signal at the determined sampling phase with respect to the system symbol rate to recapture data from the encoded signal

**FIG. M10**

determining the sampling phase

M78
set an initial sampling phase with respect to the system symbol rate

M80
set an accumulator to a mid point value

M82
utilize the initial sampling phase as the determined sample phase

M84
go to next received symbol

M86
determine a corresponding current sampling phase

M88
determined sampling phase compare unfavorably to the corresponding current sampling phase?

no

yes

M90
adjust an accumulator

M92
has accumulator over or under flowed?

no

yes

M94
adjust the determined sampling phase

M100

unfavorable comparison because the corresponding current sampling phase is greater than or less than the determined sampling phase?

greater than

less than

M102
increment the accumulator

M104
when the accumulator has overflowed, increase the determined sampling phase by a sampling phase delta value

M106
reset the accumulator to a mid-point value

M108
decrement the accumulator

M110
when the accumulator has underflowed, decrease the determined sampling phase by a sampling phase delta value

M112
reset the accumulator to a mid-point value

**FIG. M11**